# EUROPEAN PATENT SPECIFICATION

(11) **EP 3 061 763 B1**
(45) Date of publication and mention of the grant of the patent: **19.09.2018**
(21) Application number: 16157629.3
(22) Date of filing: 26.02.2016
(51) Int. Cl.: C09K 11/06, H01L 51/00, C07F 15/00, H01L 51/50

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ET DISPOSITIFS ÉLECTROLUMINESCENTS ORGANIQUES

(30) Priority: 27.02.2015 US 201562121784 P; 22.01.2016 US 201615004374
(43) Date of publication of application: 31.08.2016
(73) Proprietor: Universal Display Corporation, Ewing, New Jersey 08618 (US)
(72) Inventor: LIN, Chun, Ewing, NJ 08618 (US); XIA, Chuanjun, Ewing, NJ 08618 (US)
(74) Representative: Hansen, Norbert

(56) References cited:
- WO-A1-2012/170461
- WO-A2-2012/121936
- ERIC CLOT ET AL: "Double Geminal C-H Activation and Reversible [alpha]-Elimination in 2-Aminopyridine Iridium(III) Complexes: The Role of Hydrides and Solvent in Flattening the Free Energy Surface", JOURNAL OF THE AMERICAN CHEMICAL SOCIETY, vol. 126, no. 28, 1 July 2004 (2004-07-01) , pages 8795-8804, XP55280765, US ISSN: 0002-7863, DOI: 10.1021/ja048473j

## Description

### FIELD OF THE INVENTION

The present invention relates to compounds for use as emitters, and devices, such as organic light emitting diodes, including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs.The white OLED can be either a single EML device or a stack structure. Color may be measured using CIE coordinates, which are well known to the art.

One example of a green emissive molecule is tris(2-phenylpyridine) iridium, denoted Ir(ppy)₃, which has the following structure:

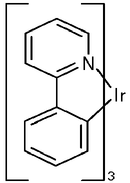

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.
Clot et al. describes double germinal C-H activation and reversible alpha-elimination in 2-aminopyridine iridium (III) complexes and the role of hydrides and solvent in flattening the free energy surface (E Clot et al., J. Am. Chem. Soc., 126 (28), 8795-8804, 2004).
WO 2012/170461 discloses heteroleptic iridium carbene complexes, which contain at least two different carbene ligands. Selective substitution of the carbene ligands provides for phosphorescent compounds that are suitable for use in a variety of OLED devices.
WO 2012/121936 describes organometallic compounds comprising an imidazole carbene ligand having a N- containing ring fused to the imidazole ring. These compounds may demonstrate high photoluminescent (PL) efficiency, Gaussian emission spectra, and/or short excited state lifetimes and may be especially useful as blue phosphorescent emitters.

### SUMMARY

According to an embodiment, a compound having a carbene ligand L_{A} having a structure of Formula I, 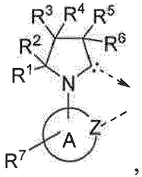 is disclosed wherein ring A is a 5-membered or 6-membered carbocyclic or heterocyclic ring; Z is nitrogen or carbon; R⁷ represents from mono-substitution to the possible maximum number of substitution, or no substitution; R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; any adjacent substituents of R¹, R², R³, R⁴, R⁵, R⁶, and R⁷ are optionally joined or fused into a ring or a double bond; the ligand L_{A} is coordinated to a metal M through the carbene carbon and Z; and the ligand L_{A} is optionally linked with other ligands to comprise a tridentate, tetradentate, pentadentate or hexadentate ligand, except 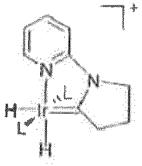 wherein L=PPh₃.

According to another embodiment, an organic light emitting diode/device (OLED) is also provided. The OLED can include an anode, a cathode, and an organic layer, disposed between the anode and the cathode. The organic layer can include the compound having a carbene ligand L_{A} having the structure of Formula I is also disclosed.

According to yet another embodiment, a formulation containing the novel compound of the present disclosure is also provided.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

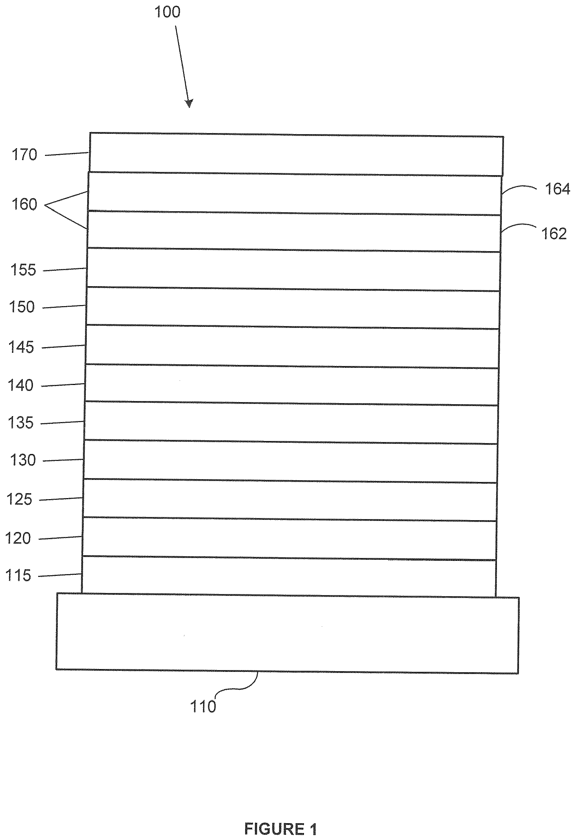

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

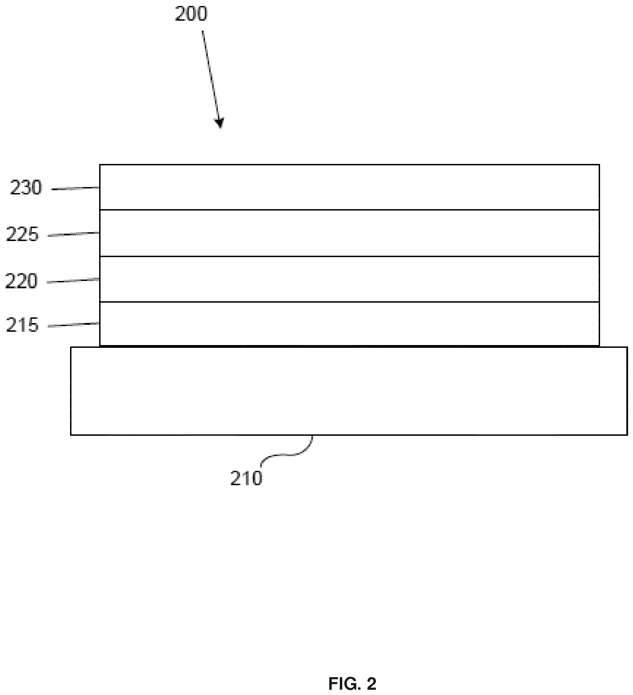

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, cell phones, tablets, phablets, personal digital assistants (PDAs), wearable device, laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C), but could be used outside this temperature range, for example, from -40 degree C to + 80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The term "halo," "halogen," or "halide" as used herein includes fluorine, chlorine, bromine, and iodine.

The term "alkyl" as used herein contemplates both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl,and the like. Additionally, the alkyl group may be optionally substituted.

The term "cycloalkyl" as used herein contemplates cyclic alkyl radicals. Preferred cycloalkyl groups are those containing 3 to 10 ring carbon atoms and includes cyclopropyl, cyclopentyl, cyclohexyl, adamantyl, and the like. Additionally, the cycloalkyl group may be optionally substituted.

The term "alkenyl" as used herein contemplates both straight and branched chain alkene radicals. Preferred alkenyl groups are those containing two to fifteen carbon atoms. Additionally, the alkenyl group may be optionally substituted.

The term "alkynyl" as used herein contemplates both straight and branched chain alkyne radicals. Preferred alkynyl groups are those containing two to fifteen carbon atoms. Additionally, the alkynyl group may be optionally substituted.

The terms "aralkyl" or "arylalkyl" as used herein are used interchangeably and contemplate an alkyl group that has as a substituent an aromatic group. Additionally, the aralkyl group may be optionally substituted.

The term "heterocyclic group" as used herein contemplates aromatic and non-aromatic cyclic radicals. Hetero-aromatic cyclic radicals also means heteroaryl. Preferred hetero-non-aromatic cyclic groups are those containing 3 or 7 ring atoms which includes at least one hetero atom, and includes cyclic amines such as morpholino, piperdino, pyrrolidino, and the like, and cyclic ethers, such as tetrahydrofuran, tetrahydropyran, and the like. Additionally, the heterocyclic group may be optionally substituted.

The term "aryl" or "aromatic group" as used herein contemplates single-ring groups and polycyclic ring systems. The polycyclic rings may have two or more rings in which two carbons are common to two adjoining rings (the rings are "fused") wherein at least one of the rings is aromatic, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" as used herein contemplates single-ring hetero-aromatic groups that may include from one to five heteroatoms. The term heteroaryl also includes polycyclic hetero-aromatic systems having two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, and aza-analogs thereof. Additionally, the heteroaryl group may be optionally substituted.

The alkyl, cycloalkyl, alkenyl, alkynyl, aralkyl, heterocyclic group, aryl, and heteroaryl may be unsubstituted or may be substituted with one or more substituents selected from the group consisting of deuterium, halogen, alkyl, cycloalkyl, heteroalkyl, arylalkyl, alkoxy, aryloxy, amino, cyclic amino, silyl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, and combinations thereof.

As used herein, "substituted" indicates that a substituent other than H is bonded to the relevant position, such as carbon. Thus, for example, where R¹ is mono-substituted, then one R¹ must be other than H. Similarly, where R¹ is di-substituted, then two of R¹ must be other than H. Similarly, where R¹ is unsubstituted, R¹ is hydrogen for all available positions.

The "aza" designation in the fragments described herein, i.e. aza-dibenzofuran, aza-dibenzothiophene, etc. means that one or more of the C-H groups in the respective fragment can be replaced by a nitrogen atom, for example, and without any limitation, azatriphenylene encompasses both dibenzo[*f*,*h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

According to one embodiment, a compound comprising a carbene ligand L_{A} of Formula I shown below is disclosed: 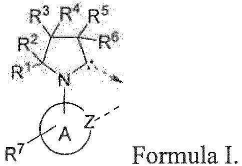
In Formula I, ring A is a 5-membered or 6-membered carbocyclic or heterocyclic ring;
wherein Z is nitrogen or carbon;
wherein R⁷ represents from mono-substitution to the possible maximum number of substitution, or no substitution;
wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein any adjacent substituents of R¹, R², R³, R⁴, R⁵, R⁶, and R⁷ are optionally joined or fused into a ring;
wherein the ligand L_{A} is coordinated to a metal M through the carbene carbon and Z; and
wherein the ligand L_{A} is optionally linked with other ligands to comprise a tridentate, tetradentate, pentadentate or hexadentate ligand, except 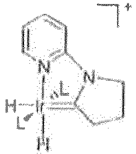 wherein L=PPh₃.

In some embodiments of the compound , ring A in Formula I is aryl or heteroaryl.

In some embodiments of the compound comprising a carbene ligand L_{A} of Formula I, the metal M is selected from the group consisting of Ir, Rh, Re, Ru, Os, Pt, Au, and Cu. In other embodiments M is Ir or Pt.

In some embodiments of the compound comprising a carbene ligand L_{A} of Formula I, the compound is homoleptic. In other embodiments, the compound is heteroleptic.

In some embodiments of the compound comprising a carbene ligand L_{A} of Formula I, ring A is phenyl.

In some embodiments of the compound comprising a carbene ligand L_{A} of Formula I, R¹, R², R³, R⁴, R⁵, and R⁶ are independently selected from the group consisting of hydrogen, deuterium, alkyl, cycloalkyl, aryl, heteroaryl, and combinations thereof.

In some embodiments of the compound comprising a carbene ligand L_{A} of Formula I, R¹, R², R³, R⁴, R⁵, R⁶, and R⁷ are independently selected from the group consisting of hydrogen, deuterium, alkyl, cycloalkyl, and combinations thereof. In other embodiments, any adjacent substituents of R¹, R², R³, R⁴, R⁵, R⁶, and R⁷ are optionally joined or fused into a non-aromatic ring. In some other embodiments, any adjacent substituents of R¹, R², R³, R⁴, R⁵, R⁶, and R⁷ are optionally joined or fused into an aromatic ring. In some embodiments, R¹, R², R⁵, R⁶, and R⁷ are independently selected from the group consisting of alkyl, cycloalkyl, partially or fully deuterated variants thereof, and combinations thereof.

In some embodiments of the compound comprising a carbene ligand L_{A} of Formula I, R³, and R⁴ are hydrogen or deuterium.

In some embodiments of the compound comprising a carbene ligand L_{A} of Formula I, R¹, R², R³, R⁴, R⁵, R⁶, and R⁷ are independently selected from the group consisting of hydrogen, deuterium, methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, cyclohexyl, phenyl, 2,6-dimethylphenyl, 2,4,6-trimethylphenyl, 2,6-diisopropylphenyl, and combinations thereof.

In some embodiments of the compound comprising a carbene ligand L_{A} of Formula I, the ligand L_{A} has the structure: 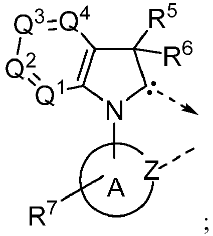 wherein Q¹, Q², Q³, and Q⁴ are each independently selected from the group consisting of N and CR; and wherein each R is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In some embodiments of the compound comprising a carbene ligand L_{A} having the structure of Formula I, the ligand L_{A} is L_{A*i*} selected from the group consisting of L_{A1} to L_{A534}; wherein, for *i* = 1 to 198, the substituents R¹, R², R³, R⁴, R⁵, R⁶, and Ring A in L_{A*i*} are defined as shown in Table 1 below:

**Table 1**

| *i* | R¹ | R² | R³ | R⁴ | R⁵ | R⁶ | Ring A |
|---|---|---|---|---|---|---|---|
| 1 | CH₃ | CH₃ | H | H | CH₃ | CH₃ | 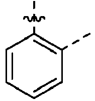 |
| 2 | CH₃ | CH₃ | H | H | CH₃ | CH₃ | 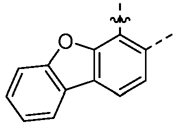 |
| 3 | CH₃ | CH₃ | H | H | CH₃ | CH₃ | 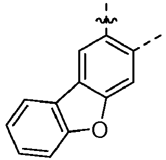 |
| 4 | CH₃ | CH₃ | H | H | CH₃ | CH₃ | 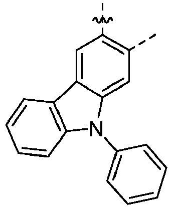 |
| 5 | CH₃ | CH₃ | H | H | CH₃ | CH₃ | 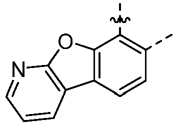 |
| 6 | CH₃ | CH₃ | H | H | CH₃ | CH₃ | 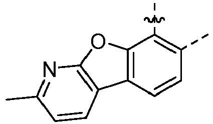 |
| 7 | CH₃ | CH₃ | H | H | CH₃ | CH₃ | 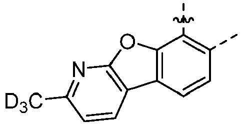 |
| 8 | CH₃ | CH₃ | H | H | CH₃ | CH₃ | 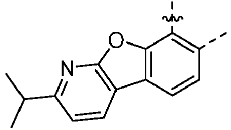 |
| 9 | CH₃ | CH₃ | H | H | CH₃ | CH₃ | 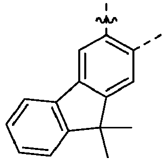 |
| 10 | CH₃ | CH₃ | H | H | CH₃ | CH₂CH₃ | 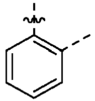 |
| 11 | CH₃ | CH₃ | H | H | CH₃ | CH₂CH₃ | 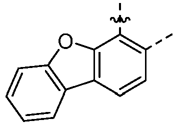 |
| 12 | CH₃ | CH₃ | H | H | CH₃ | CH₂CH₃ | 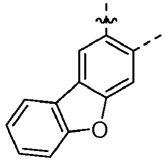 |
| 13 | CH₃ | CH₃ | H | H | CH₃ | CH₂CH₃ | 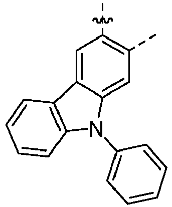 |
| 14 | CH₃ | CH₃ | H | H | CH₃ | CH₂CH₃ | 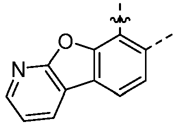 |
| 15 | CH₃ | CH₃ | H | H | CH₃ | CH₂CH₃ | 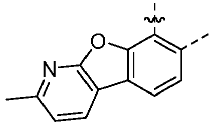 |
| 16 | CH₃ | CH₃ | H | H | CH₃ | CH₂CH₃ | 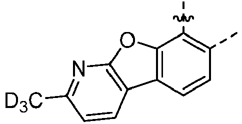 |
| 17 | CH₃ | CH₃ | H | H | CH₃ | CH₂CH₃ | 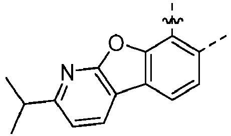 |
| 18 | CH₃ | CH₃ | H | H | CH₃ | CH₂CH₃ | 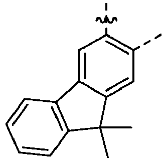 |
| 19 | CH₃ | CH₃ | H | H | CH₃ | CH(CH₃)₂ | 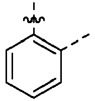 |
| 20 | CH₃ | CH₃ | H | H | CH₃ | CH(CH₃)₂ | 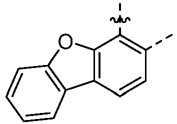 |
| 21 | CH₃ | CH₃ | H | H | CH₃ | CH(CH₃)₂ | 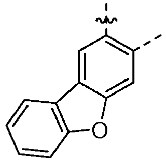 |
| 22 | CH₃ | CH₃ | H | H | CH₃ | CH(CH₃)₂ | 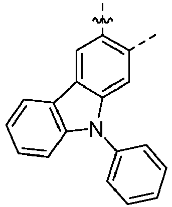 |
| 23 | CH₃ | CH₃ | H | H | CH₃ | CH(CH₃)₂ | 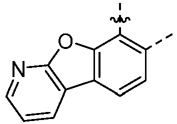 |
| 24 | CH₃ | CH₃ | H | H | CH₃ | CH(CH₃)₂ | 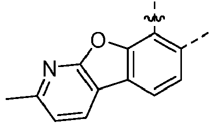 |
| 25 | CH₃ | CH₃ | H | H | CH₃ | CH(CH₃)₂ | 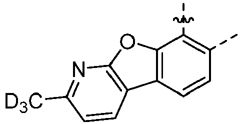 |
| 26 | CH₃ | CH₃ | H | H | CH₃ | CH(CH₃)₂ | 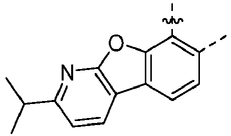 |
| 27 | CH₃ | CH₃ | H | H | CH₃ | CH(CH₃)₂ | 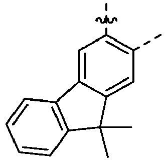 |
| 28 | CH₃ | CH₃ | H | H | CH₂CH₃ | CH₂CH₃ | 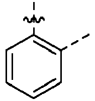 |
| 29 | CH₃ | CH₃ | H | H | CH₂CH₃ | CH₂CH₃ | 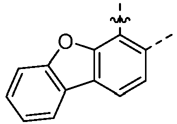 |
| 30 | CH₃ | CH₃ | H | H | CH₂CH₃ | CH₂CH₃ | 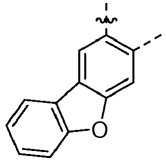 |
| 31 | CH₃ | CH₃ | H | H | CH₂CH₃ | CH₂CH₃ | 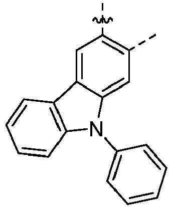 |
| 32 | CH₃ | CH₃ | H | H | CH₂CH₃ | CH₂CH₃ | 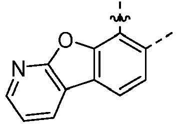 |
| 33 | CH₃ | CH₃ | H | H | CH₂CH₃ | CH₂CH₃ | 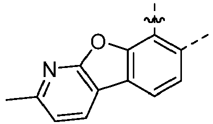 |
| 34 | CH₃ | CH₃ | H | H | CH₂CH₃ | CH₂CH₃ | 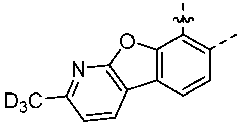 |
| 35 | CH₃ | CH₃ | H | H | CH₂CH₃ | CH₂CH₃ | 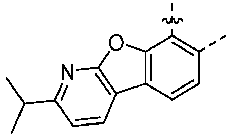 |
| 36 | CH₃ | CH₃ | H | H | CH₂CH₃ | CH₂CH₃ | 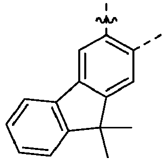 |
| 37 | CH₂CH₃ | CH₃ | H | H | CH₃ | CH₃ | 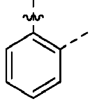 |
| 38 | CH₂CH₃ | CH₃ | H | H | CH₃ | CH₃ | 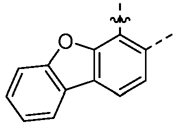 |
| 39 | CH₂CH₃ | CH₃ | H | H | CH₃ | CH₃ | 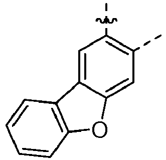 |
| 40 | CH₂CH₃ | CH₃ | H | H | CH₃ | CH₃ | 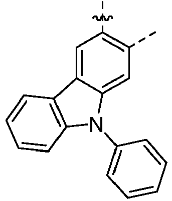 |
| 41 | CH₂CH₃ | CH₃ | H | H | CH₃ | CH₃ | 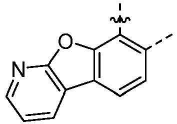 |
| 42 | CH₂CH₃ | CH₃ | H | H | CH₃ | CH₃ | 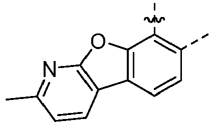 |
| 43 | CH₂CH₃ | CH₃ | H | H | CH₃ | CH₃ | 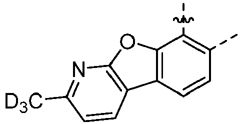 |
| 44 | CH₂CH₃ | CH₃ | H | H | CH₃ | CH₃ | 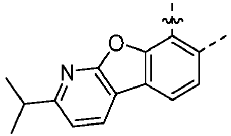 |
| 45 | CH₂CH₃ | CH₃ | H | H | CH₃ | CH₃ | 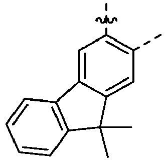 |
| 46 | CH(CH₃)₂ | CH₃ | H | H | CH₃ | CH₃ | 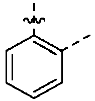 |
| 47 | CH(CH₃)₂ | CH₃ | H | H | CH₃ | CH₃ | 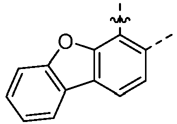 |
| 48 | CH(CH₃)₂ | CH₃ | H | H | CH₃ | CH₃ | 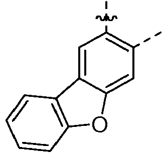 |
| 49 | CH(CH₃)₂ | CH₃ | H | H | CH₃ | CH₃ | 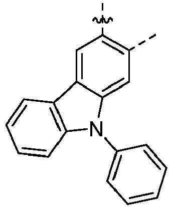 |
| 50 | CH(CH₃)₂ | CH₃ | H | H | CH₃ | CH₃ | 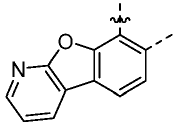 |
| 51 | CH(CH₃)₂ | CH₃ | H | H | CH₃ | CH₃ | 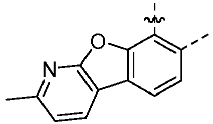 |
| 52 | CH(CH₃)₂ | CH₃ | H | H | CH₃ | CH₃ | 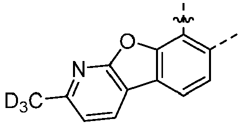 |
| 53 | CH(CH₃)₂ | CH₃ | H | H | CH₃ | CH₃ | 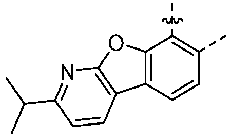 |
| 54 | CH(CH₃)₂ | CH₃ | H | H | CH₃ | CH₃ | 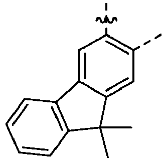 |
| 55 | CH₂CH₃ | CH₂CH₃ | H | H | CH₃ | CH₃ | 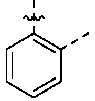 |
| 56 | CH₂CH₃ | CH₂CH₃ | H | H | CH₃ | CH₃ | 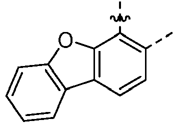 |
| 57 | CH₂CH₃ | CH₂CH₃ | H | H | CH₃ | CH₃ | 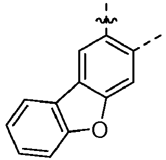 |
| 58 | CH₂CH₃ | CH₂CH₃ | H | H | CH₃ | CH₃ | 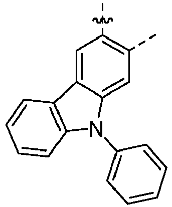 |
| 59 | CH₂CH₃ | CH₂CH₃ | H | H | CH₃ | CH₃ | 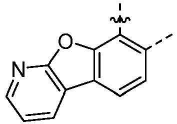 |
| 60 | CH₂CH₃ | CH₂CH₃ | H | H | CH₃ | CH₃ | 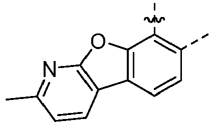 |
| 61 | CH₂CH₃ | CH₂CH₃ | H | H | CH₃ | CH₃ | 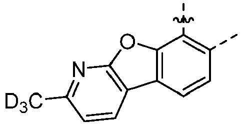 |
| 62 | CH₂CH₃ | CH₂CH₃ | H | H | CH₃ | CH₃ | 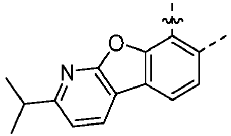 |
| 63 | CH₂CH₃ | CH₂CH₃ | H | H | CH₃ | CH₃ | 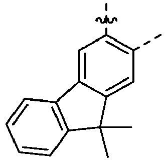 |
| 64 | CH₃ | CH₃ | H | H | 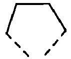 | | 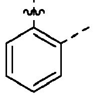 |
| 65 | CH₃ | CH₃ | H | H | 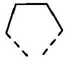 | | 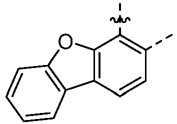 |
| 66 | CH₃ | CH₃ | H | H | 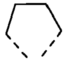 | | 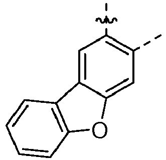 |
| 67 | CH₃ | CH₃ | H | H | 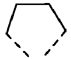 | | 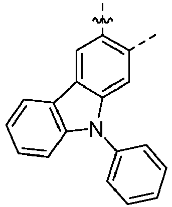 |
| 68 | CH₃ | CH₃ | H | H | 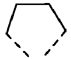 | | 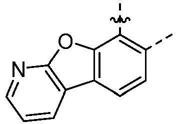 |
| 69 | CH₃ | CH₃ | H | H | 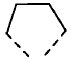 | | 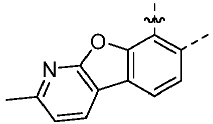 |
| 70 | CH₃ | CH₃ | H | H | 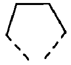 | | 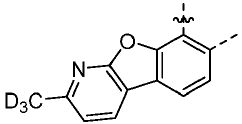 |
| 71 | CH₃ | CH₃ | H | H | 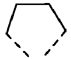 | | 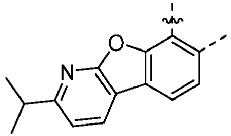 |
| 72 | CH₃ | CH₃ | H | H | 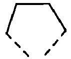 | | 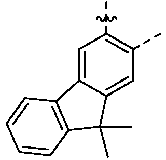 |
| 73 | CH₃ | CH₃ | H | H | 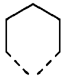 | | 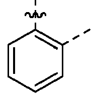 |
| 74 | CH₃ | CH₃ | H | H | 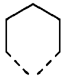 | | 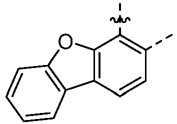 |
| 75 | CH₃ | CH₃ | H | H | 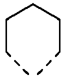 | | 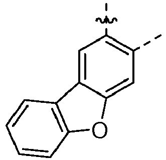 |
| 76 | CH₃ | CH₃ | H | H | 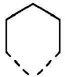 | | 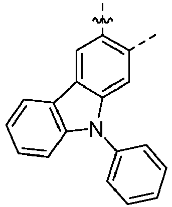 |
| 77 | CH₃ | CH₃ | H | H | 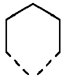 | | 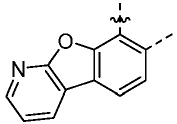 |
| 78 | CH₃ | CH₃ | H | H | 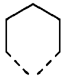 | | 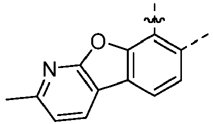 |
| 79 | CH₃ | CH₃ | H | H | 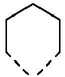 | | 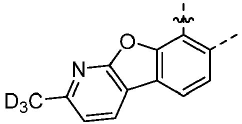 |
| 80 | CH₃ | CH₃ | H | H | 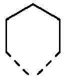 | | 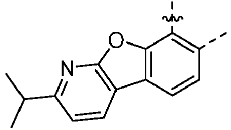 |
| 81 | CH₃ | CH₃ | H | H | 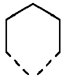 | | 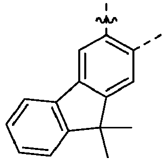 |
| 82 | CH₃ | CH₃ | H | H | 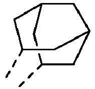 | | 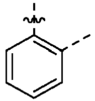 |
| 83 | CH₃ | CH₃ | H | H | 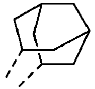 | | 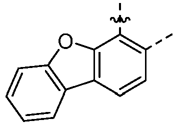 |
| 84 | CH₃ | CH₃ | H | H | 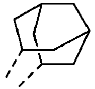 | | 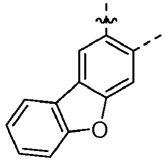 |
| 85 | CH₃ | CH₃ | H | H | 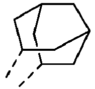 | | 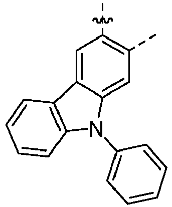 |
| 86 | CH₃ | CH₃ | H | H | 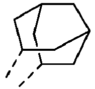 | | 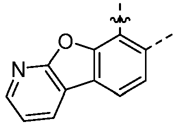 |
| 87 | CH₃ | CH₃ | H | H | 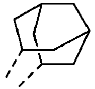 | | 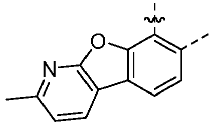 |
| 88 | CH₃ | CH₃ | H | H | 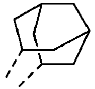 | | 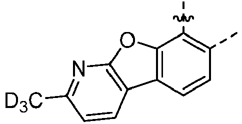 |
| 89 | CH₃ | CH₃ | H | H | 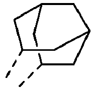 | | 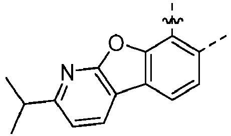 |
| 90 | CH₃ | CH₃ | H | H | 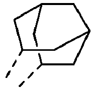 | | 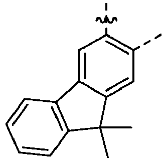 |
| 91 | 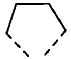 | | H | H | CH₃ | CH₃ | 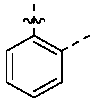 |
| 92 | 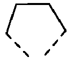 | | H | H | CH₃ | CH₃ | 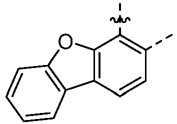 |
| 93 | 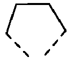 | | H | H | CH₃ | CH₃ | 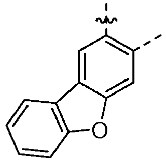 |
| 94 | 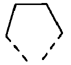 | | H | H | CH₃ | CH₃ | 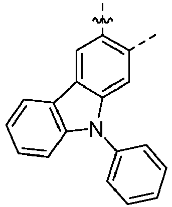 |
| 95 | 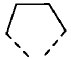 | | H | H | CH₃ | CH₃ | 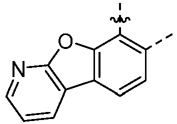 |
| 96 | 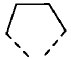 | | H | H | CH₃ | CH₃ | 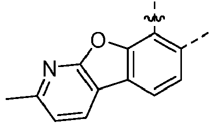 |
| 97 | 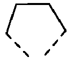 | | H | H | CH₃ | CH₃ | 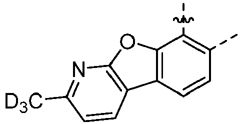 |
| 98 | 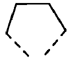 | | H | H | CH₃ | CH₃ | 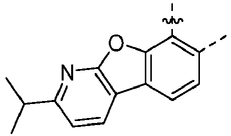 |
| 99 | 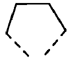 | | H | H | CH₃ | CH₃ | 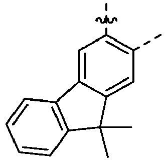 |
| 100 | 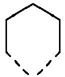 | | H | H | CH₃ | CH₃ | 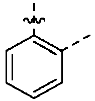 |
| 101 | 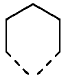 | | H | H | CH₃ | CH₃ | 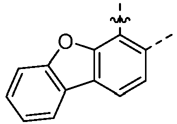 |
| 102 | 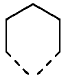 | | H | H | CH₃ | CH₃ | 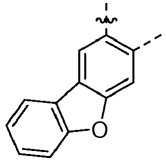 |
| 103 | 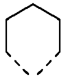 | | H | H | CH₃ | CH₃ | 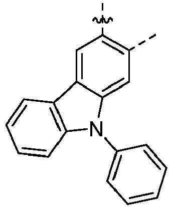 |
| 104 | 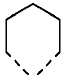 | | H | H | CH₃ | CH₃ | 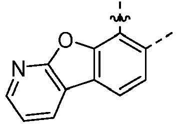 |
| 105 | 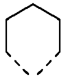 | | H | H | CH₃ | CH₃ | 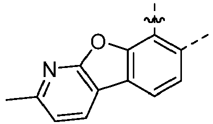 |
| 106 | 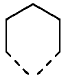 | | H | H | CH₃ | CH₃ | 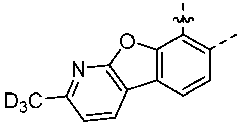 |
| 107 | 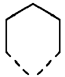 | | H | H | CH₃ | CH₃ | 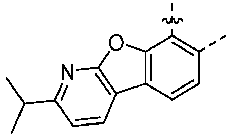 |
| 108 | 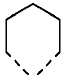 | | H | H | CH₃ | CH₃ | 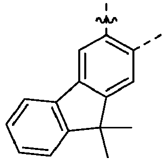 |
| 109 | 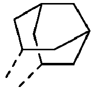 | | H | H | CH₃ | CH₃ | 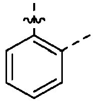 |
| 110 | 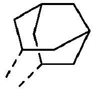 | | H | H | CH₃ | CH₃ | 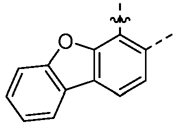 |
| 111 | 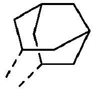 | | H | H | CH₃ | CH₃ | 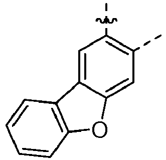 |
| 112 | 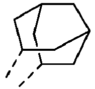 | | H | H | CH₃ | CH₃ | 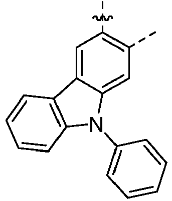 |
| 113 | 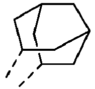 | | H | H | CH₃ | CH₃ | 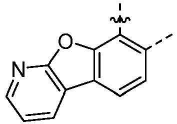 |
| 114 | 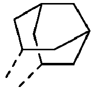 | | H | H | CH₃ | CH₃ | 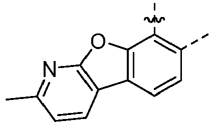 |
| 115 | 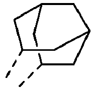 | | H | H | CH₃ | CH₃ | 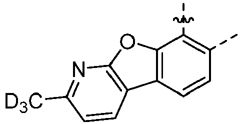 |
| 116 | 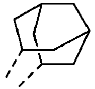 | | H | H | CH₃ | CH₃ | 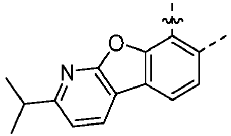 |
| 117 | 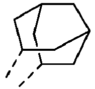 | | H | H | CH₃ | CH₃ | 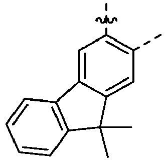 |
| 118 | 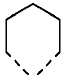 | | H | H | 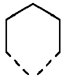 | | 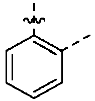 |
| 119 | 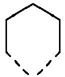 | | H | H | 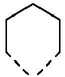 | | 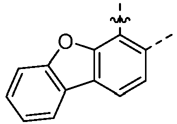 |
| 120 | 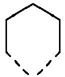 | | H | H | 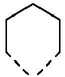 | | 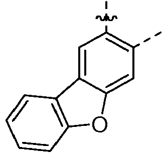 |
| 121 | 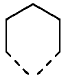 | | H | H | 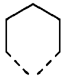 | | 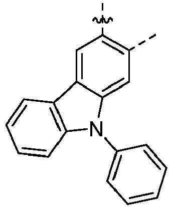 |
| 122 | 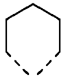 | | H | H | 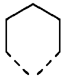 | | 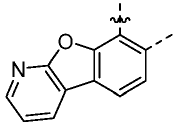 |
| 123 | 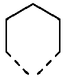 | | H | H | 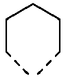 | | 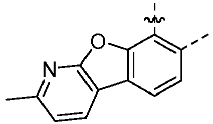 |
| 124 | 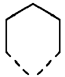 | | H | H | 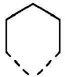 | | 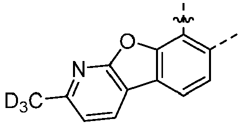 |
| 125 | 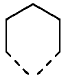 | | H | H | 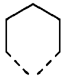 | | 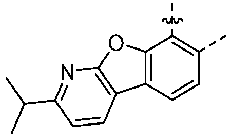 |
| 126 | 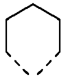 | | H | H | 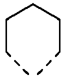 | | 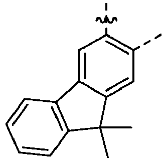 |
| 127 | CD₃ | CD₃ | H | H | CD₃ | CD₃ | 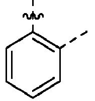 |
| 128 | CD₃ | CD₃ | H | H | CD₃ | CD₃ | 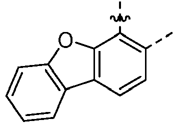 |
| 129 | CD₃ | CD₃ | H | H | CD₃ | CD₃ | 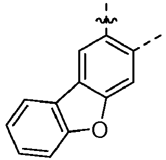 |
| 130 | CD₃ | CD₃ | H | H | CD₃ | CD₃ | 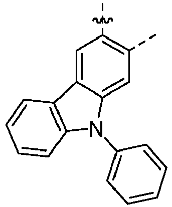 |
| 131 | CD₃ | CD₃ | H | H | CD₃ | CD₃ | 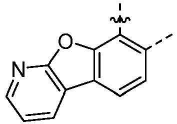 |
| 132 | CD₃ | CD₃ | H | H | CD₃ | CD₃ | 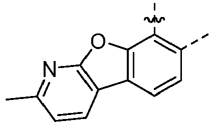 |
| 133 | CD₃ | CD₃ | H | H | CD₃ | CD₃ | 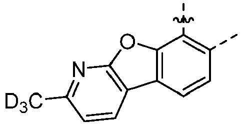 |
| 134 | CD₃ | CD₃ | H | H | CD₃ | CD₃ | 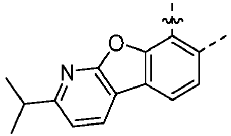 |
| 135 | CD₃ | CD₃ | H | H | CD₃ | CD₃ | 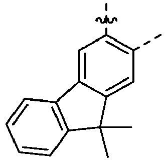 |
| 136 | CD₃ | CD₃ | D | D | CD₃ | CD₃ | 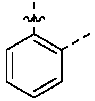 |
| 137 | CD₃ | CD₃ | D | D | CD₃ | CD₃ | 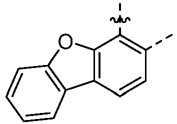 |
| 138 | CD₃ | CD₃ | D | D | CD₃ | CD₃ | 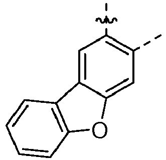 |
| 139 | CD₃ | CD₃ | D | D | CD₃ | CD₃ | 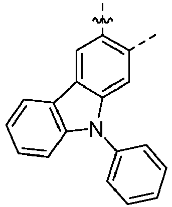 |
| 140 | CD₃ | CD₃ | D | D | CD₃ | CD₃ | 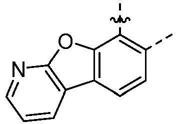 |
| 141 | CD₃ | CD₃ | D | D | CD₃ | CD₃ | 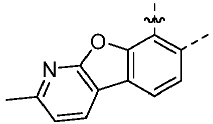 |
| 142 | CD₃ | CD₃ | D | D | CD₃ | CD₃ | 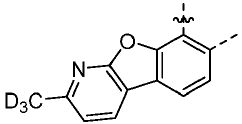 |
| 143 | CD₃ | CD₃ | D | D | CD₃ | CD₃ | 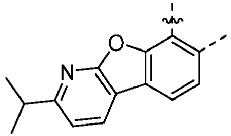 |
| 144 | CD₃ | CD₃ | D | D | CD₃ | CD₃ | 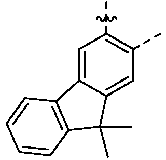 |
| 145 | CD₃ | CD₃ | D | D | CD₃ | CD(CD₃)₂ | 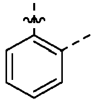 |
| 146 | CD₃ | CD₃ | D | D | CD₃ | CD(CD₃)₂ | 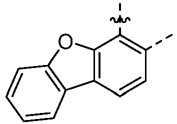 |
| 147 | CD₃ | CD₃ | D | D | CD₃ | CD(CD₃)₂ | 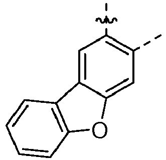 |
| 148 | CD₃ | CD₃ | D | D | CD₃ | CD(CD₃)₂ | 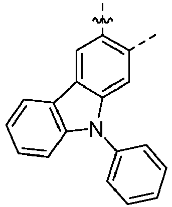 |
| 149 | CD₃ | CD₃ | D | D | CD₃ | CD(CD₃)₂ | 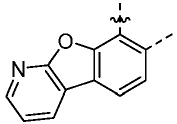 |
| 150 | CD₃ | CD₃ | D | D | CD₃ | CD(CD₃)₂ | 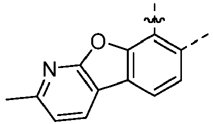 |
| 151 | CD₃ | CD₃ | D | D | CD₃ | CD(CD₃)₂ | 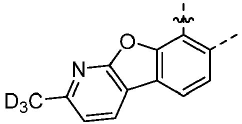 |
| 152 | CD₃ | CD₃ | D | D | CD₃ | CD(CD₃)₂ | 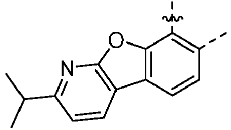 |
| 153 | CD₃ | CD₃ | D | D | CD₃ | CD(CD₃)₂ | 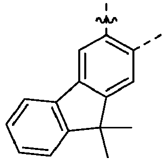 |
| 154 | CH₃ | CH₃ | H | H | CH₃ | CH₂CH₂CF₃ | 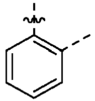 |
| 155 | CH₃ | CH₃ | H | H | CH₃ | CH₂CH₂CF₃ | 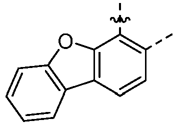 |
| 156 | CH₃ | CH₃ | H | H | CH₃ | CH₂CH₂CF₃ | 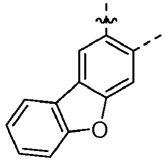 |
| 157 | CH₃ | CH₃ | H | H | CH₃ | CH₂CH₂CF₃ | 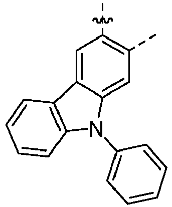 |
| 158 | CH₃ | CH₃ | H | H | CH₃ | CH₂CH₂CF₃ | 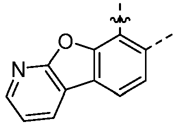 |
| 159 | CH₃ | CH₃ | H | H | CH₃ | CH₂CH₂CF₃ | 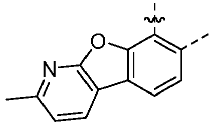 |
| 160 | CH₃ | CH₃ | H | H | CH₃ | CH₂CH₂CF₃ | 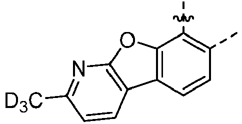 |
| 161 | CH₃ | CH₃ | H | H | CH₃ | CH₂CH₂CF₃ | 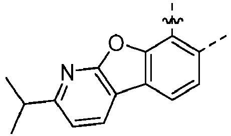 |
| 162 | CH₃ | CH₃ | H | H | CH₃ | CH₂CH₂CF₃ | 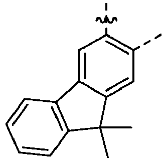 |
| 163 | CH₂CH₂CF₃ | CH₃ | H | H | CH₃ | CH₃ | 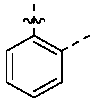 |
| 164 | CH₂CH₂CF₃ | CH₃ | H | H | CH₃ | CH₃ | 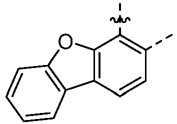 |
| 165 | CH₂CH₂CF₃ | CH₃ | H | H | CH₃ | CH₃ | 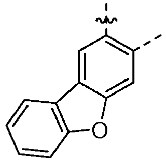 |
| 166 | CH₂CH₂CF₃ | CH₃ | H | H | CH₃ | CH₃ | 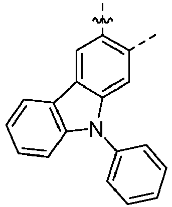 |
| 167 | CH₂CH₂CF₃ | CH₃ | H | H | CH₃ | CH₃ | 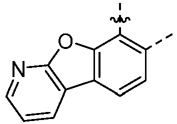 |
| 168 | CH₂CH₂CF₃ | CH₃ | H | H | CH₃ | CH₃ | 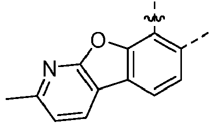 |
| 169 | CH₂CH₂CF₃ | CH₃ | H | H | CH₃ | CH₃ | 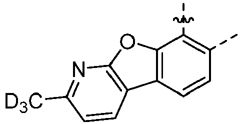 |
| 170 | CH₂CH₂CF₃ | CH₃ | H | H | CH₃ | CH₃ | 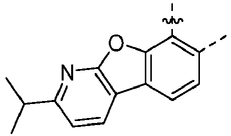 |
| 171 | CH₂CH₂CF₃ | CH₃ | H | H | CH₃ | CH₃ | 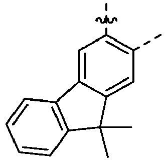 |
| 172 | CH₃ | CH₃ | H | H | CH₃ | CF₃ | 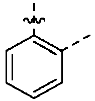 |
| 173 | CH₃ | CH₃ | H | H | CH₃ | CF₃ | 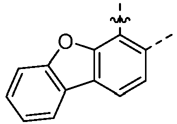 |
| 174 | CH₃ | CH₃ | H | H | CH₃ | CF₃ | 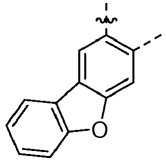 |
| 175 | CH₃ | CH₃ | H | H | CH₃ | CF₃ | 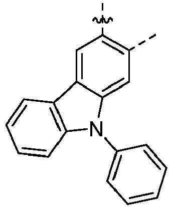 |
| 176 | CH₃ | CH₃ | H | H | CH₃ | CF₃ | 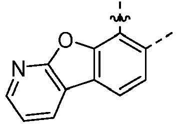 |
| 177 | CH₃ | CH₃ | H | H | CH₃ | CF₃ | 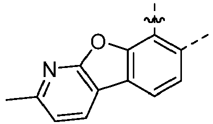 |
| 178 | CH₃ | CH₃ | H | H | CH₃ | CF₃ | 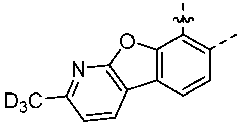 |
| 179 | CH₃ | CH₃ | H | H | CH₃ | CF₃ | 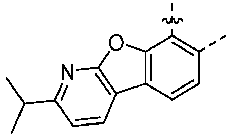 |
| 180 | CH₃ | CH₃ | H | H | CH₃ | CF₃ | 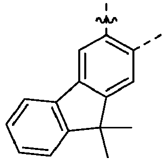 |
| 181 | CH₃ | CH₃ | H | H | CF₃ | CF₃ | 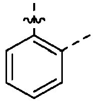 |
| 182 | CH₃ | CH₃ | H | H | CF₃ | CF₃ | 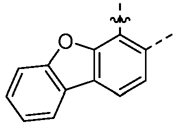 |
| 183 | CH₃ | CH₃ | H | H | CF₃ | CF₃ | 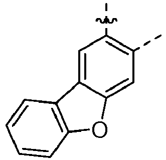 |
| 184 | CH₃ | CH₃ | H | H | CF₃ | CF₃ | 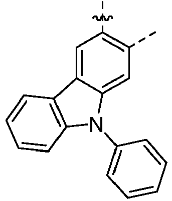 |
| 185 | CH₃ | CH₃ | H | H | CF₃ | CF₃ | 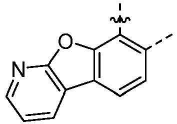 |
| 186 | CH₃ | CH₃ | H | H | CF₃ | CF₃ | 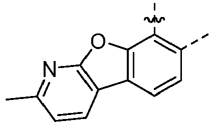 |
| 187 | CH₃ | CH₃ | H | H | CF₃ | CF₃ | 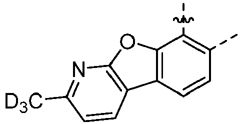 |
| 188 | CH₃ | CH₃ | H | H | CF₃ | CF₃ | 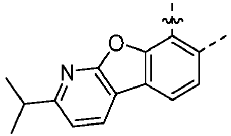 |
| 189 | CH₃ | CH₃ | H | H | CF₃ | CF₃ | 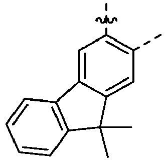 |
| 190 | CF₃ | CF₃ | H | H | CH₃ | CH₃ | 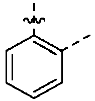 |
| 191 | CF₃ | CF₃ | H | H | CH₃ | CH₃ | 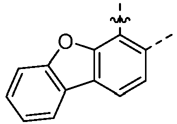 |
| 192 | CF₃ | CF₃ | H | H | CH₃ | CH₃ | 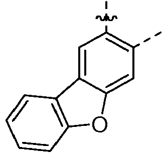 |
| 193 | CF₃ | CF₃ | H | H | CH₃ | CH₃ | 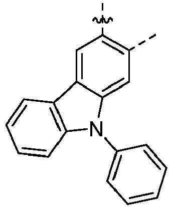 |
| 194 | CF₃ | CF₃ | H | H | CH₃ | CH₃ | 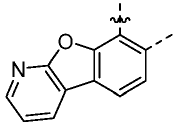 |
| 195 | CF₃ | CF₃ | H | H | CH₃ | CH₃ | 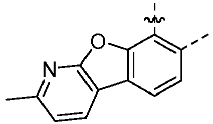 |
| 196 | CF₃ | CF₃ | H | H | CH₃ | CH₃ | 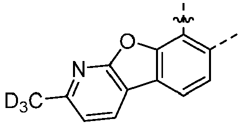 |
| 197 | CF₃ | CF₃ | H | H | CH₃ | CH₃ | 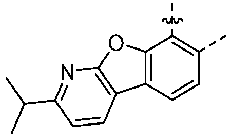 |
| 198 | CF₃ | CF₃ | H | H | CH₃ | CH₃ | 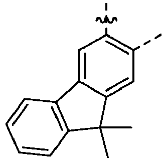 |

, and for *i* = 199 to 534, L_{A*i*} (i.e., L_{A199} to L_{A534}) has the structure 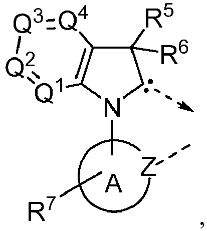 wherein substituents Q¹, Q², Q³, Q⁴, R⁵, R⁶, and Ring A are as defined in Table 2 below:

**Table 2**

| *i* | Q¹ | Q² | Q³ | Q⁴ | R⁵ | R⁶ | Ring A |
|---|---|---|---|---|---|---|---|
| 199 | CH | CH | CH | CH | CH₃ | CH₃ | 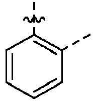 |
| 200 | CH | CH | CH | CH | CH₃ | CH₃ | 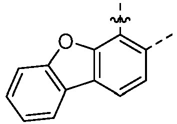 |
| 201 | CH | CH | CH | CH | CH₃ | CH₃ | 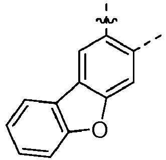 |
| 202 | CH | CH | CH | CH | CH₃ | CH₃ | 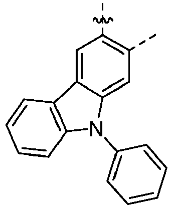 |
| 203 | CH | CH | CH | CH | CH₃ | CH₃ | 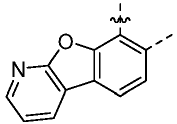 |
| 204 | CH | CH | CH | CH | CH₃ | CH₃ | 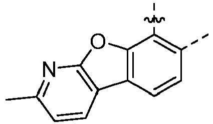 |
| 205 | CH | CH | CH | CH | CH₃ | CH₃ | 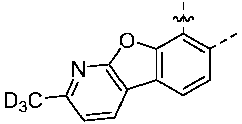 |
| 206 | CH | CH | CH | CH | CH₃ | CH₃ | 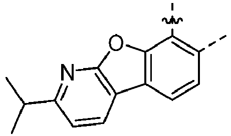 |
| 207 | CH | CH | CH | CH | CH₃ | CH₃ | 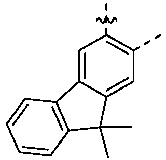 |
| 208 | CH | CH | CH | CH | CH₃ | CH₂CH₃ | 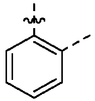 |
| 209 | CH | CH | CH | CH | CH₃ | CH₂CH₃ | 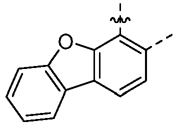 |
| 210 | CH | CH | CH | CH | CH₃ | CH₂CH₃ | 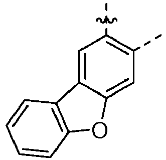 |
| 211 | CH | CH | CH | CH | CH₃ | CH₂CH₃ | 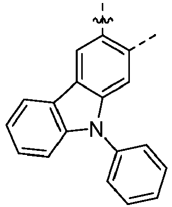 |
| 212 | CH | CH | CH | CH | CH₃ | CH₂CH₃ | 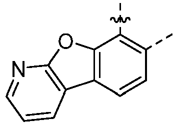 |
| 213 | CH | CH | CH | CH | CH₃ | CH₂CH₃ | 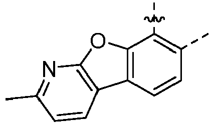 |
| 214 | CH | CH | CH | CH | CH₃ | CH₂CH₃ | 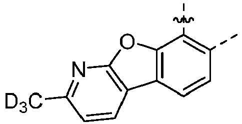 |
| 215 | CH | CH | CH | CH | CH₃ | CH₂CH₃ | 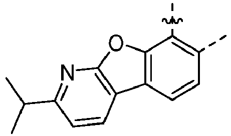 |
| 216 | CH | CH | CH | CH | CH₃ | CH₂CH₃ | 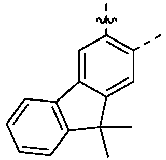 |
| 217 | CH | CH | CH | CH | CH₃ | CH(CH₃)₂ | 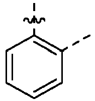 |
| 218 | CH | CH | CH | CH | CH₃ | CH(CH₃)₂ | 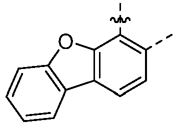 |
| 219 | CH | CH | CH | CH | CH₃ | CH(CH₃)₂ | 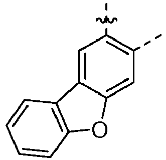 |
| 220 | CH | CH | CH | CH | CH₃ | CH(CH₃)₂ | 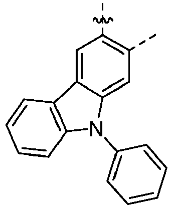 |
| 221 | CH | CH | CH | CH | CH₃ | CH(CH₃)₂ | 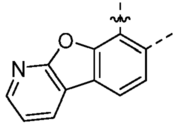 |
| 222 | CH | CH | CH | CH | CH₃ | CH(CH₃)₂ | 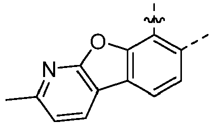 |
| 223 | CH | CH | CH | CH | CH₃ | CH(CH₃)₂ | 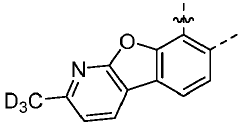 |
| 224 | CH | CH | CH | CH | CH₃ | CH(CH₃)₂ | 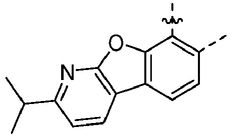 |
| 225 | CH | CH | CH | CH | CH₃ | CH(CH₃)₂ | 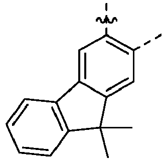 |
| 226 | CH | CH | CH | CH | 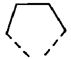 | | 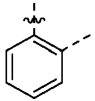 |
| 227 | CH | CH | CH | CH | 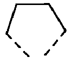 | | 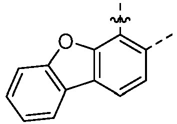 |
| 228 | CH | CH | CH | CH | 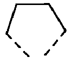 | | 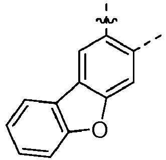 |
| 229 | CH | CH | CH | CH | 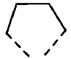 | | 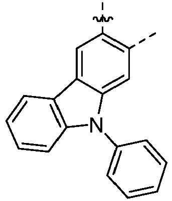 |
| 230 | CH | CH | CH | CH | 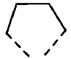 | | 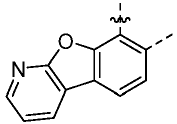 |
| 231 | CH | CH | CH | CH | 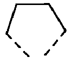 | | 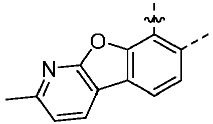 |
| 232 | CH | CH | CH | CH | 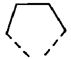 | | 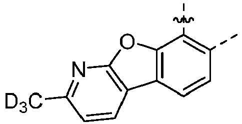 |
| 233 | CH | CH | CH | CH | 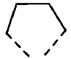 | | 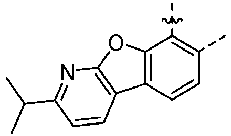 |
| 234 | CH | CH | CH | CH | 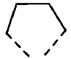 | | 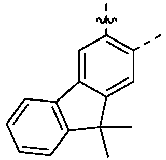 |
| 235 | CH | CH | CH | CH | 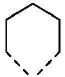 | | 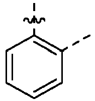 |
| 236 | CH | CH | CH | CH | 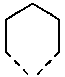 | | 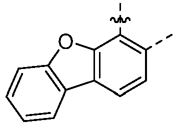 |
| 237 | CH | CH | CH | CH | 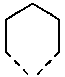 | | 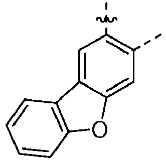 |
| 238 | CH | CH | CH | CH | 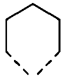 | | 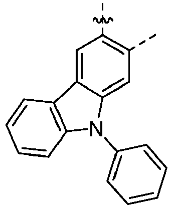 |
| 239 | CH | CH | CH | CH | 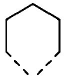 | | 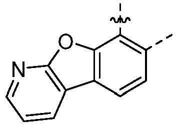 |
| 240 | CH | CH | CH | CH | 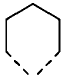 | | 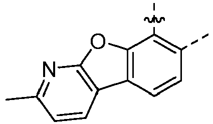 |
| 241 | CH | CH | CH | CH | 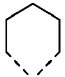 | | 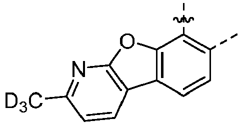 |
| 242 | CH | CH | CH | CH | 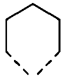 | | 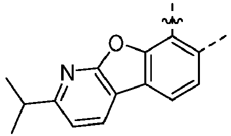 |
| 243 | CH | CH | CH | CH | 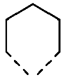 | | 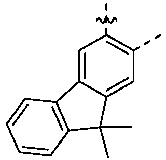 |
| 244 | CH | CH | CH | CH | 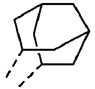 | | 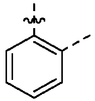 |
| 245 | CH | CH | CH | CH | 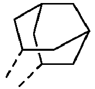 | | 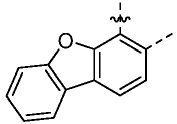 |
| 246 | CH | CH | CH | CH | 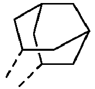 | | 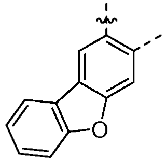 |
| 247 | CH | CH | CH | CH | 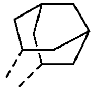 | | 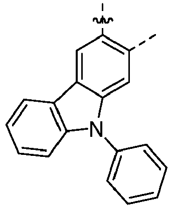 |
| 248 | CH | CH | CH | CH | 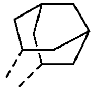 | | 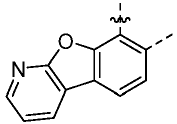 |
| 249 | CH | CH | CH | CH | 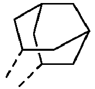 | | 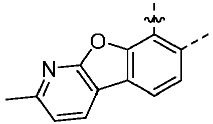 |
| 250 | CH | CH | CH | CH | 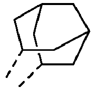 | | 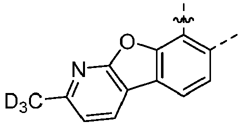 |
| 251 | CH | CH | CH | CH | 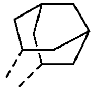 | | 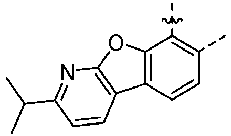 |
| 252 | CH | CH | CH | CH | 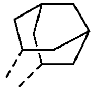 | | 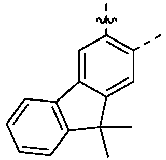 |
| 253 | N | CH | CH | CH | CH₃ | CH₃ | 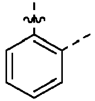 |
| 254 | N | CH | CH | CH | CH₃ | CH₃ | 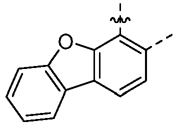 |
| 255 | N | CH | CH | CH | CH₃ | CH₃ | 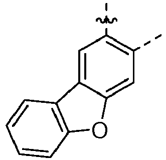 |
| 256 | N | CH | CH | CH | CH₃ | CH₃ | 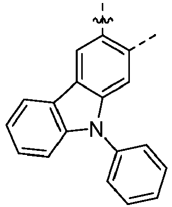 |
| 257 | N | CH | CH | CH | CH₃ | CH₃ | 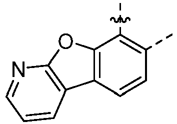 |
| 258 | N | CH | CH | CH | CH₃ | CH₃ | 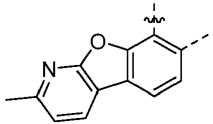 |
| 259 | N | CH | CH | CH | CH₃ | CH₃ | 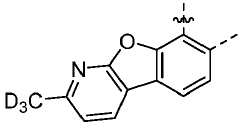 |
| 260 | N | CH | CH | CH | CH₃ | CH₃ | 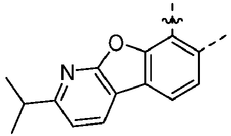 |
| 261 | N | CH | CH | CH | CH₃ | CH₃ | 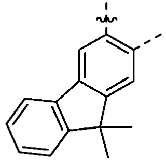 |
| 262 | N | CH | CH | CH | CH₃ | CH₂CH₃ | 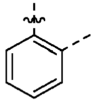 |
| 263 | N | CH | CH | CH | CH₃ | CH₂CH₃ | 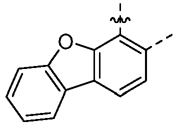 |
| 264 | N | CH | CH | CH | CH₃ | CH₂CH₃ | 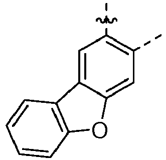 |
| 265 | N | CH | CH | CH | CH₃ | CH₂CH₃ | 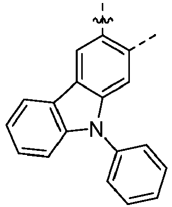 |
| 266 | N | CH | CH | CH | CH₃ | CH₂CH₃ | 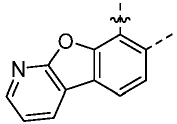 |
| 267 | N | CH | CH | CH | CH₃ | CH₂CH₃ | 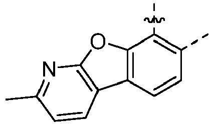 |
| 268 | N | CH | CH | CH | CH₃ | CH₂CH₃ | 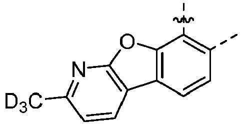 |
| 269 | N | CH | CH | CH | CH₃ | CH₂CH₃ | 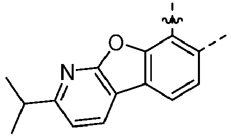 |
| 270 | N | CH | CH | CH | CH₃ | CH₂CH₃ | 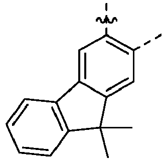 |
| 271 | N | CH | CH | CH | CH₃ | CH(CH₃)₂ | 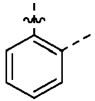 |
| 272 | N | CH | CH | CH | CH₃ | CH(CH₃)₂ | 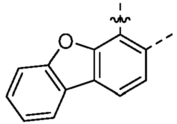 |
| 273 | N | CH | CH | CH | CH₃ | CH(CH₃)₂ | 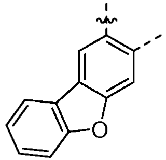 |
| 274 | N | CH | CH | CH | CH₃ | CH(CH₃)₂ | 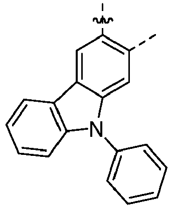 |
| 275 | N | CH | CH | CH | CH₃ | CH(CH₃)₂ | 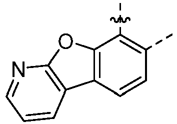 |
| 276 | N | CH | CH | CH | CH₃ | CH(CH₃)₂ | 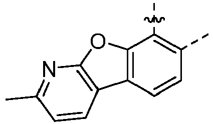 |
| 277 | N | CH | CH | CH | CH₃ | CH(CH₃)₂ | 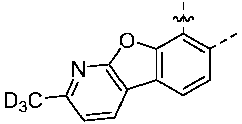 |
| 278 | N | CH | CH | CH | CH₃ | CH(CH₃)₂ | 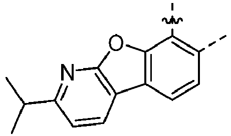 |
| 279 | N | CH | CH | CH | CH₃ | CH(CH₃)₂ | 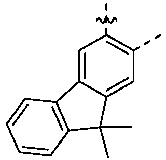 |
| 280 | N | CH | CH | CH | 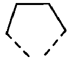 | | 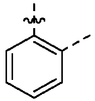 |
| 281 | N | CH | CH | CH | 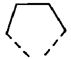 | | 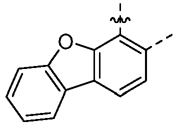 |
| 282 | N | CH | CH | CH | 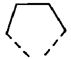 | | 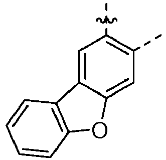 |
| 283 | N | CH | CH | CH | 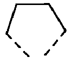 | | 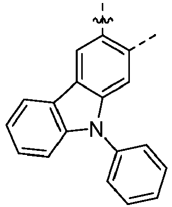 |
| 284 | N | CH | CH | CH | 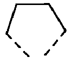 | | 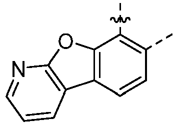 |
| 285 | N | CH | CH | CH | 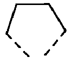 | | 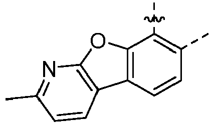 |
| 286 | N | CH | CH | CH | 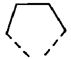 | | 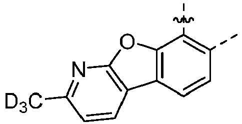 |
| 287 | N | CH | CH | CH | 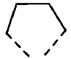 | | 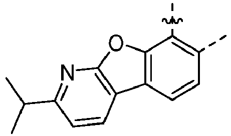 |
| 288 | N | CH | CH | CH | 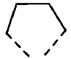 | | 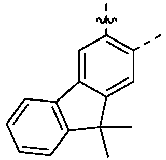 |
| 289 | N | CH | CH | CH | 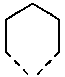 | | 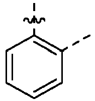 |
| 290 | N | CH | CH | CH | 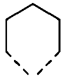 | | 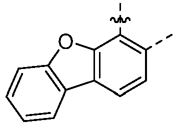 |
| 291 | N | CH | CH | CH | 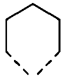 | | 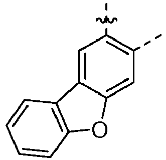 |
| 292 | N | CH | CH | CH | 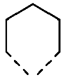 | | 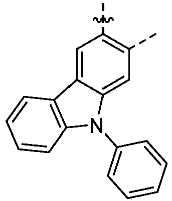 |
| 293 | N | CH | CH | CH | 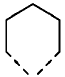 | | 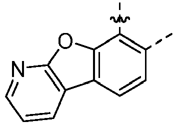 |
| 294 | N | CH | CH | CH | 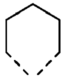 | | 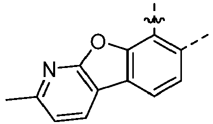 |
| 295 | N | CH | CH | CH | 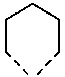 | | 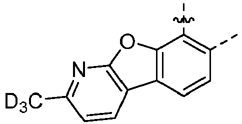 |
| 296 | N | CH | CH | CH | 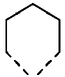 | | 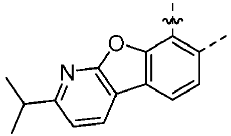 |
| 297 | N | CH | CH | CH | 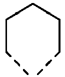 | | 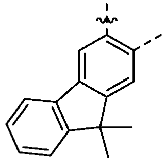 |
| 298 | N | CH | CH | CH | 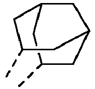 | | 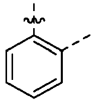 |
| 299 | N | CH | CH | CH | 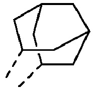 | | 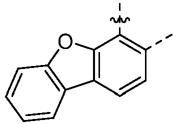 |
| 300 | N | CH | CH | CH | 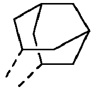 | | 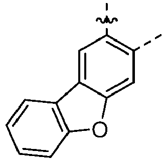 |
| 301 | N | CH | CH | CH | 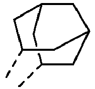 | | 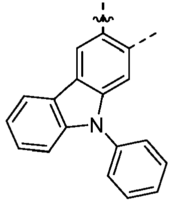 |
| 302 | N | CH | CH | CH | 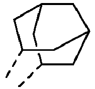 | | 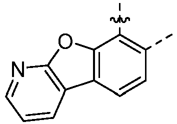 |
| 303 | N | CH | CH | CH | 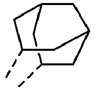 | | 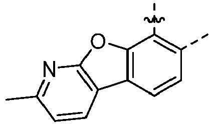 |
| 304 | N | CH | CH | CH | 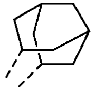 | | 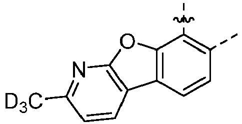 |
| 305 | N | CH | CH | CH | 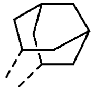 | | 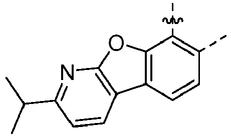 |
| 306 | N | CH | CH | CH | 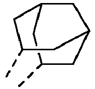 | | 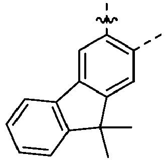 |
| 307 | CH | N | CH | CH | CH₃ | CH₃ | 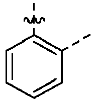 |
| 308 | CH | N | CH | CH | CH₃ | CH₃ | 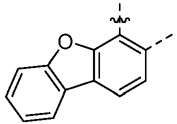 |
| 309 | CH | N | CH | CH | CH₃ | CH₃ | 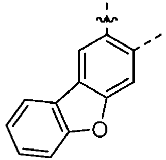 |
| 310 | CH | N | CH | CH | CH₃ | CH₃ | 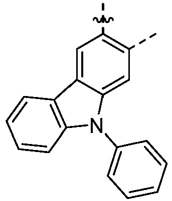 |
| 311 | CH | N | CH | CH | CH₃ | CH₃ | 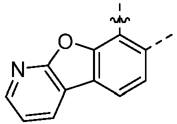 |
| 312 | CH | N | CH | CH | CH₃ | CH₃ | 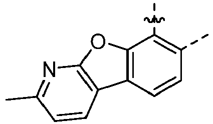 |
| 313 | CH | N | CH | CH | CH₃ | CH₃ | 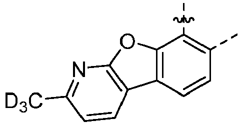 |
| 314 | CH | N | CH | CH | CH₃ | CH₃ | 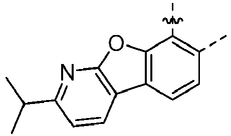 |
| 315 | CH | N | CH | CH | CH₃ | CH₃ | 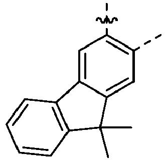 |
| 316 | CH | N | CH | CH | CH₃ | CH₂CH₃ | 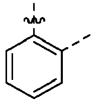 |
| 317 | CH | N | CH | CH | CH₃ | CH₂CH₃ | 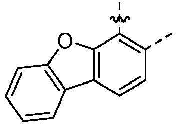 |
| 318 | CH | N | CH | CH | CH₃ | CH₂CH₃ | 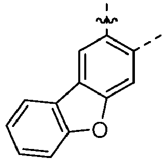 |
| 319 | CH | N | CH | CH | CH₃ | CH₂CH₃ | 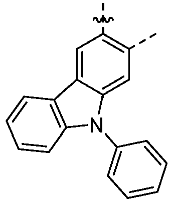 |
| 320 | CH | N | CH | CH | CH₃ | CH₂CH₃ | 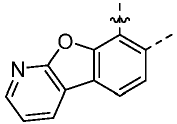 |
| 321 | CH | N | CH | CH | CH₃ | CH₂CH₃ | 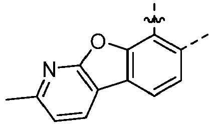 |
| 322 | CH | N | CH | CH | CH₃ | CH₂CH₃ | 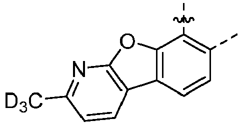 |
| 323 | CH | N | CH | CH | CH₃ | CH₂CH₃ | 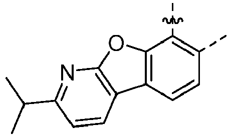 |
| 324 | CH | N | CH | CH | CH₃ | CH₂CH₃ | 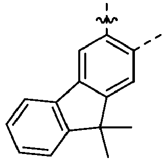 |
| 325 | CH | N | CH | CH | CH₃ | CH(CH₃)₂ | 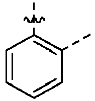 |
| 326 | CH | N | CH | CH | CH₃ | CH(CH₃)₂ | 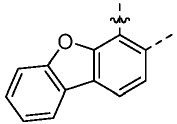 |
| 327 | CH | N | CH | CH | CH₃ | CH(CH₃)₂ | 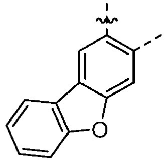 |
| 328 | CH | N | CH | CH | CH₃ | CH(CH₃)₂ | 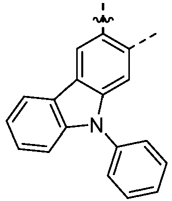 |
| 329 | CH | N | CH | CH | CH₃ | CH(CH₃)₂ | 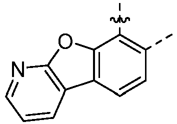 |
| 330 | CH | N | CH | CH | CH₃ | CH(CH₃)₂ | 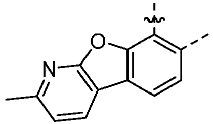 |
| 331 | CH | N | CH | CH | CH₃ | CH(CH₃)₂ | 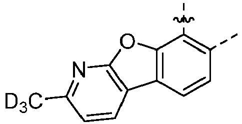 |
| 332 | CH | N | CH | CH | CH₃ | CH(CH₃)₂ | 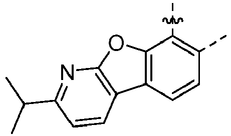 |
| 333 | CH | N | CH | CH | CH₃ | CH(CH₃)₂ | 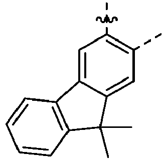 |
| 334 | CH | N | CH | CH | 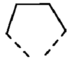 | | 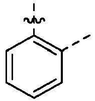 |
| 335 | CH | N | CH | CH | 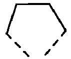 | | 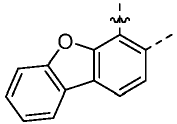 |
| 336 | CH | N | CH | CH | 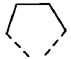 | | 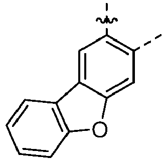 |
| 337 | CH | N | CH | CH | 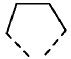 | | 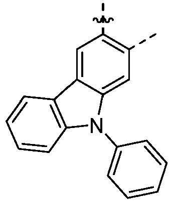 |
| 338 | CH | N | CH | CH | 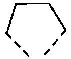 | | 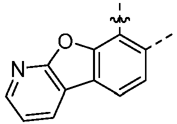 |
| 339 | CH | N | CH | CH | 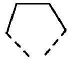 | | 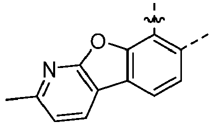 |
| 340 | CH | N | CH | CH | 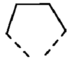 | | 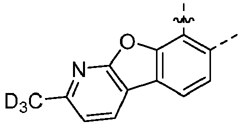 |
| 341 | CH | N | CH | CH | 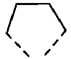 | | 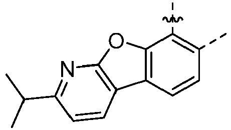 |
| 342 | CH | N | CH | CH | 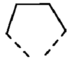 | | 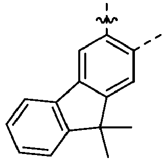 |
| 343 | CH | N | CH | CH | 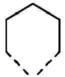 | | 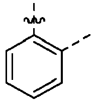 |
| 344 | CH | N | CH | CH | 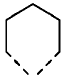 | | 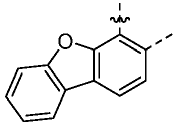 |
| 345 | CH | N | CH | CH | 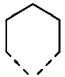 | | 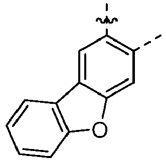 |
| 346 | CH | N | CH | CH | 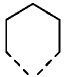 | | 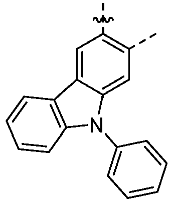 |
| 347 | CH | N | CH | CH | 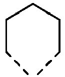 | | 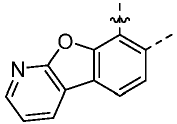 |
| 348 | CH | N | CH | CH | 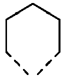 | | 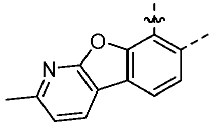 |
| 349 | CH | N | CH | CH | 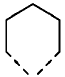 | | 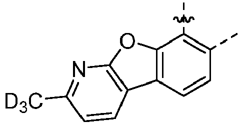 |
| 350 | CH | N | CH | CH | 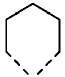 | | 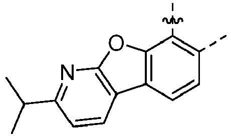 |
| 351 | CH | N | CH | CH | 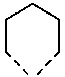 | | 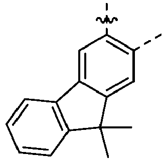 |
| 352 | CH | N | CH | CH | 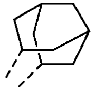 | | 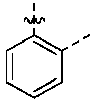 |
| 353 | CH | N | CH | CH | 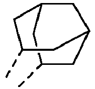 | | 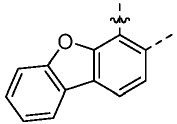 |
| 354 | CH | N | CH | CH | 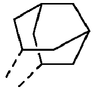 | | 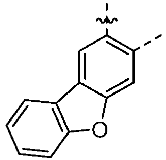 |
| 355 | CH | N | CH | CH | 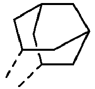 | | 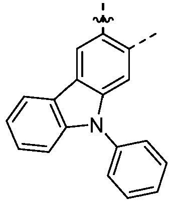 |
| 356 | CH | N | CH | CH | 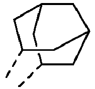 | | 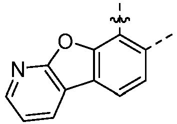 |
| 357 | CH | N | CH | CH | 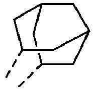 | | 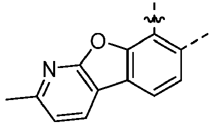 |
| 358 | CH | N | CH | CH | 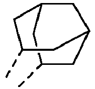 | | 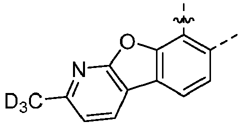 |
| 359 | CH | N | CH | CH | 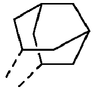 | | 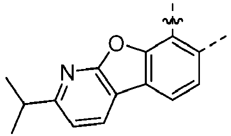 |
| 360 | CH | N | CH | CH | 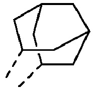 | | 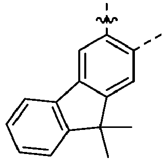 |
| 361 | N | CH | N | CH | CH₃ | CH₃ | 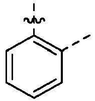 |
| 362 | N | CH | N | CH | CH₃ | CH₃ | 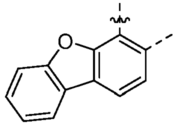 |
| 363 | N | CH | N | CH | CH₃ | CH₃ | 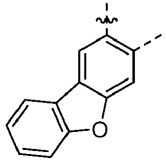 |
| 364 | N | CH | N | CH | CH₃ | CH₃ | 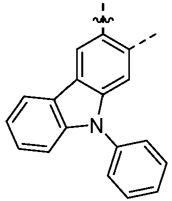 |
| 365 | N | CH | N | CH | CH₃ | CH₃ | 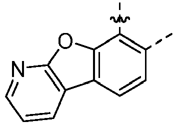 |
| 366 | N | CH | N | CH | CH₃ | CH₃ | 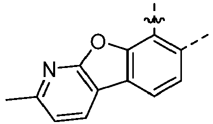 |
| 367 | N | CH | N | CH | CH₃ | CH₃ | 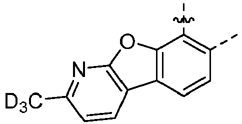 |
| 368 | N | CH | N | CH | CH₃ | CH₃ | 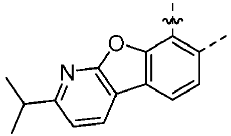 |
| 369 | N | CH | N | CH | CH₃ | CH₃ | 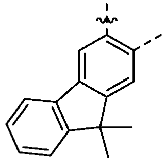 |
| 370 | N | CH | N | CH | CH₃ | CH₂CH₃ | 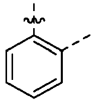 |
| 371 | N | CH | N | CH | CH₃ | CH₂CH₃ | 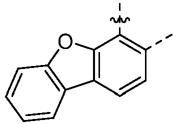 |
| 372 | N | CH | N | CH | CH₃ | CH₂CH₃ | 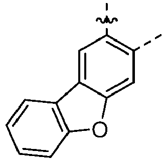 |
| 373 | N | CH | N | CH | CH₃ | CH₂CH₃ | 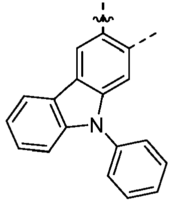 |
| 374 | N | CH | N | CH | CH₃ | CH₂CH₃ | 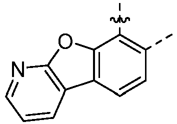 |
| 375 | N | CH | N | CH | CH₃ | CH₂CH₃ | 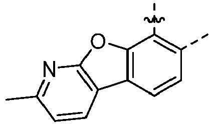 |
| 376 | N | CH | N | CH | CH₃ | CH₂CH₃ | 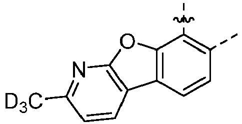 |
| 377 | N | CH | N | CH | CH₃ | CH₂CH₃ | 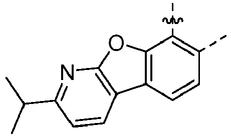 |
| 378 | N | CH | N | CH | CH₃ | CH₂CH₃ | 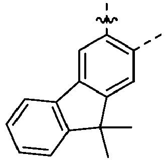 |
| 379 | N | CH | N | CH | CH₃ | CH(CH₃)₂ | 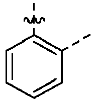 |
| 380 | N | CH | N | CH | CH₃ | CH(CH₃)₂ | 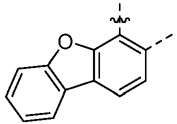 |
| 381 | N | CH | N | CH | CH₃ | CH(CH₃)₂ | 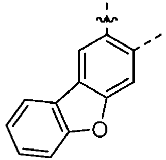 |
| 382 | N | CH | N | CH | CH₃ | CH(CH₃)₂ | 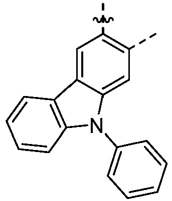 |
| 383 | N | CH | N | CH | CH₃ | CH(CH₃)₂ | 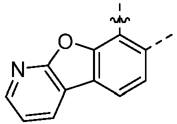 |
| 384 | N | CH | N | CH | CH₃ | CH(CH₃)₂ | 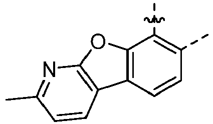 |
| 385 | N | CH | N | CH | CH₃ | CH(CH₃)₂ | 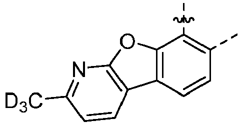 |
| 386 | N | CH | N | CH | CH₃ | CH(CH₃)₂ | 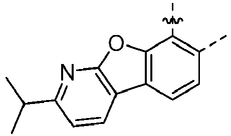 |
| 387 | N | CH | N | CH | CH₃ | CH(CH₃)₂ | 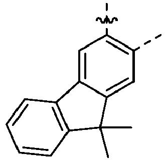 |
| 388 | CH | CH | N | CH | 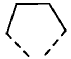 | | 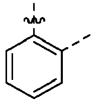 |
| 389 | CH | CH | N | CH | 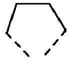 | | 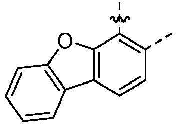 |
| 390 | CH | CH | N | CH | 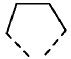 | | 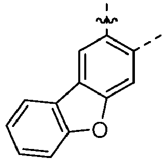 |
| 391 | CH | CH | N | CH | 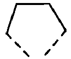 | | 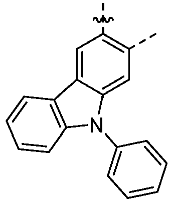 |
| 392 | CH | CH | N | CH | 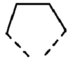 | | 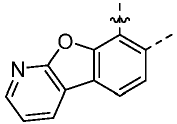 |
| 393 | CH | CH | N | CH | 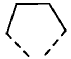 | | 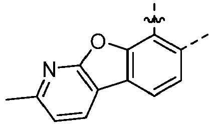 |
| 394 | CH | CH | N | CH | 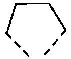 | | 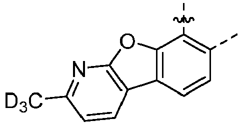 |
| 395 | CH | CH | N | CH | 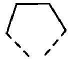 | | 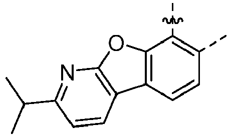 |
| 396 | CH | CH | N | CH | 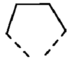 | | 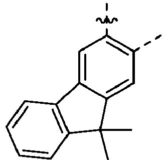 |
| 397 | CH | CH | N | CH | 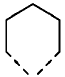 | | 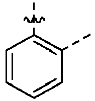 |
| 398 | CH | CH | N | CH | 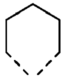 | | 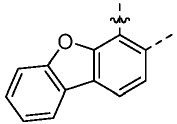 |
| 399 | CH | CH | N | CH | 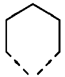 | | 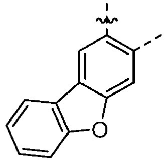 |
| 400 | CH | CH | N | CH | 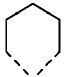 | | 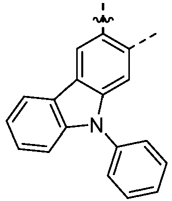 |
| 401 | CH | CH | N | CH | 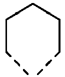 | | 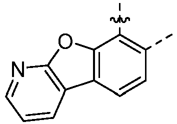 |
| 402 | CH | CH | N | CH | 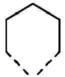 | | 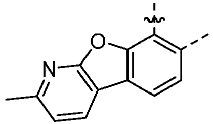 |
| 403 | CH | CH | N | CH | 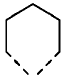 | | 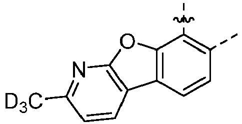 |
| 404 | CH | CH | N | CH | 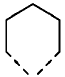 | | 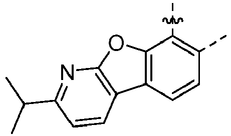 |
| 405 | CH | CH | N | CH | 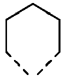 | | 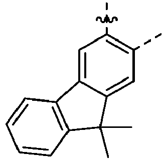 |
| 406 | CH | CH | N | CH | 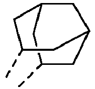 | | 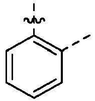 |
| 407 | CH | CH | N | CH | 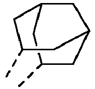 | | 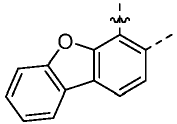 |
| 408 | CH | CH | N | CH | 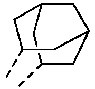 | | 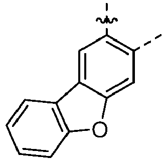 |
| 409 | CH | CH | N | CH | 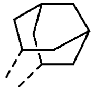 | | 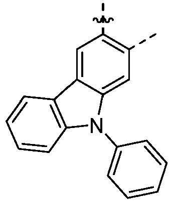 |
| 410 | CH | CH | N | CH | 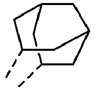 | | 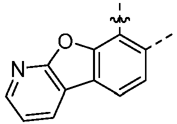 |
| 411 | CH | CH | N | CH | 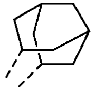 | | 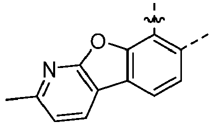 |
| 412 | CH | CH | N | CH | 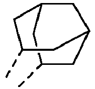 | | 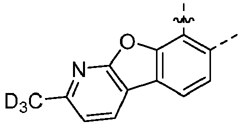 |
| 413 | CH | CH | N | CH | 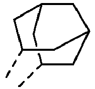 | | 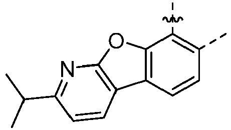 |
| 414 | CH | CH | N | CH | 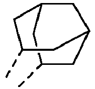 | | 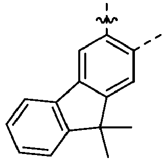 |
| 415 | CH | CH | CH | N | CH₃ | CH₃ | 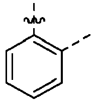 |
| 416 | CH | CH | CH | N | CH₃ | CH₃ | 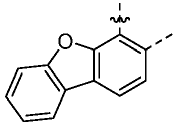 |
| 417 | CH | CH | CH | N | CH₃ | CH₃ | 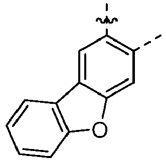 |
| 418 | CH | CH | CH | N | CH₃ | CH₃ | 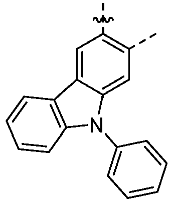 |
| 419 | CH | CH | CH | N | CH₃ | CH₃ | 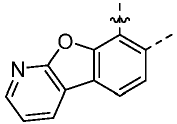 |
| 420 | CH | CH | CH | N | CH₃ | CH₃ | 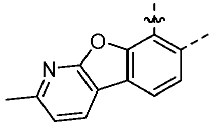 |
| 421 | CH | CH | CH | N | CH₃ | CH₃ | 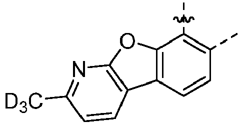 |
| 422 | CH | CH | CH | N | CH₃ | CH₃ | 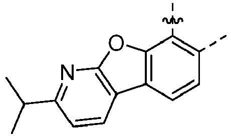 |
| 423 | CH | CH | CH | N | CH₃ | CH₃ | 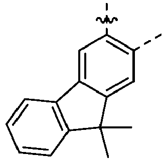 |
| 424 | CH | CH | CH | N | CH₃ | CH₂CH₃ | 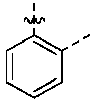 |
| 425 | CH | CH | CH | N | CH₃ | CH₂CH₃ | 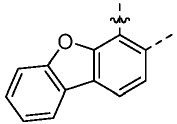 |
| 426 | CH | CH | CH | N | CH₃ | CH₂CH₃ | 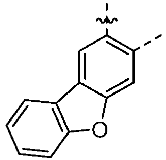 |
| 427 | CH | CH | CH | N | CH₃ | CH₂CH₃ | 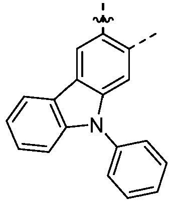 |
| 428 | CH | CH | CH | N | CH₃ | CH₂CH₃ | 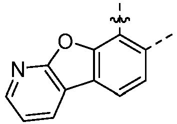 |
| 429 | CH | CH | CH | N | CH₃ | CH₂CH₃ | 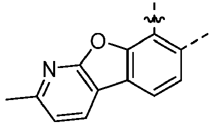 |
| 430 | CH | CH | CH | N | CH₃ | CH₂CH₃ | 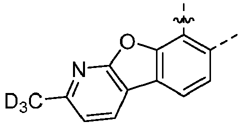 |
| 431 | CH | CH | CH | N | CH₃ | CH₂CH₃ | 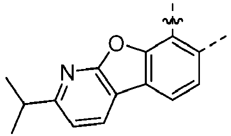 |
| 432 | CH | CH | CH | N | CH₃ | CH₂CH₃ | 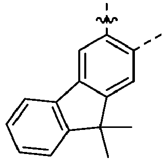 |
| 433 | CH | CH | CH | N | CH₃ | CH(CH₃)₂ | 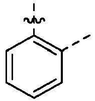 |
| 434 | CH | CH | CH | N | CH₃ | CH(CH₃)₂ | 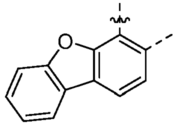 |
| 435 | CH | CH | CH | N | CH₃ | CH(CH₃)₂ | 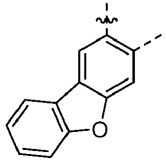 |
| 436 | CH | CH | CH | N | CH₃ | CH(CH₃)₂ | 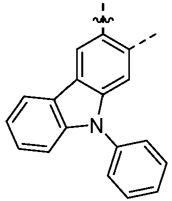 |
| 437 | CH | CH | CH | N | CH₃ | CH(CH₃)₂ | 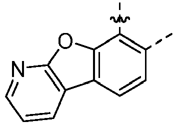 |
| 438 | CH | CH | CH | N | CH₃ | CH(CH₃)₂ | 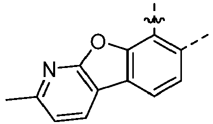 |
| 439 | CH | CH | CH | N | CH₃ | CH(CH₃)₂ | 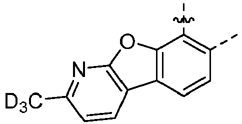 |
| 440 | CH | CH | CH | N | CH₃ | CH(CH₃)₂ | 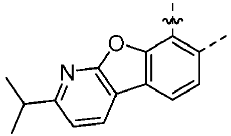 |
| 441 | CH | CH | CH | N | CH₃ | CH(CH₃)₂ | 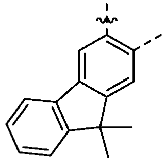 |
| 442 | CH | CH | CH | N | 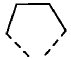 | | 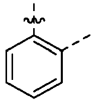 |
| 443 | CH | CH | CH | N | 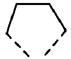 | | 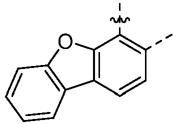 |
| 444 | CH | CH | CH | N | 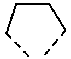 | | 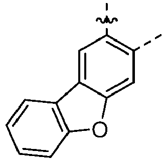 |
| 445 | CH | CH | CH | N | 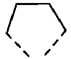 | | 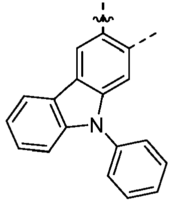 |
| 446 | CH | CH | CH | N | 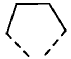 | | 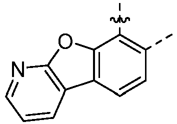 |
| 447 | CH | CH | CH | N | 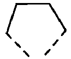 | | 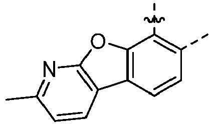 |
| 448 | CH | CH | CH | N | 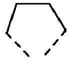 | | 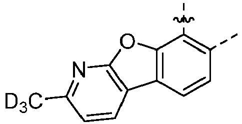 |
| 449 | CH | CH | CH | N | 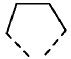 | | 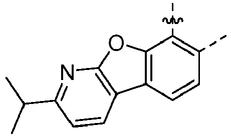 |
| 450 | CH | CH | CH | N | 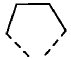 | | 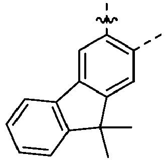 |
| 451 | CH | CH | CH | N | 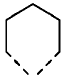 | | 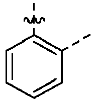 |
| 452 | CH | CH | CH | N | 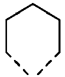 | | 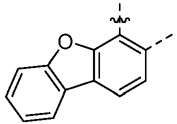 |
| 453 | CH | CH | CH | N | 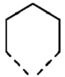 | | 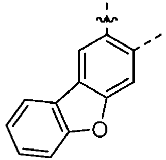 |
| 454 | CH | CH | CH | N | 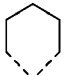 | | 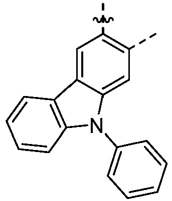 |
| 455 | CH | CH | CH | N | 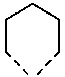 | | 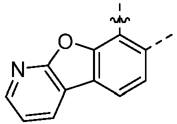 |
| 456 | CH | CH | CH | N | 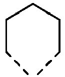 | | 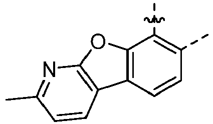 |
| 457 | CH | CH | CH | N | 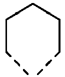 | | 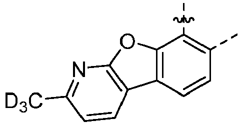 |
| 458 | CH | CH | CH | N | 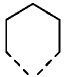 | | 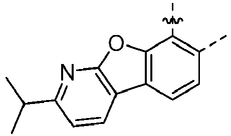 |
| 459 | CH | CH | CH | N | 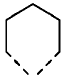 | | 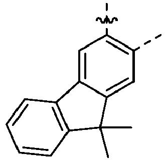 |
| 460 | CH | CH | CH | N | 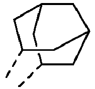 | | 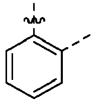 |
| 461 | CH | CH | CH | N | 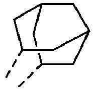 | | 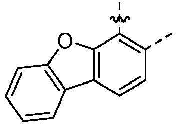 |
| 462 | CH | CH | CH | N | 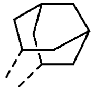 | | 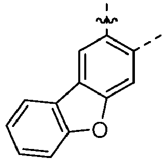 |
| 463 | CH | CH | CH | N | 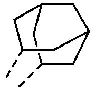 | | 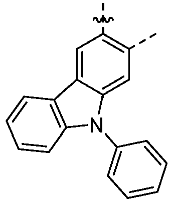 |
| 464 | CH | CH | CH | N | 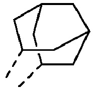 | | 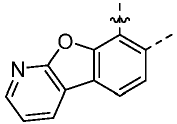 |
| 465 | CH | CH | CH | N | 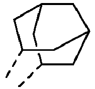 | | 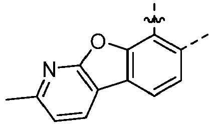 |
| 466 | CH | CH | CH | N | 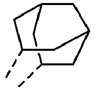 | | 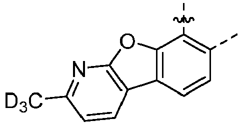 |
| 467 | CH | CH | CH | N | 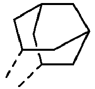 | | 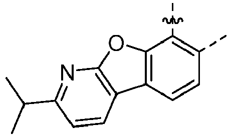 |
| 468 | CH | CH | CH | N | 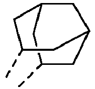 | | 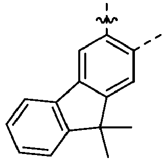 |
| 469 | N | CH | CH | N | CH₃ | CH₃ | 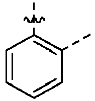 |
| 470 | N | CH | CH | N | CH₃ | CH₃ | 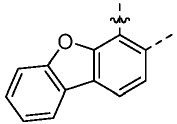 |
| 471 | N | CH | CH | N | CH₃ | CH₃ | 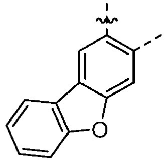 |
| 472 | N | CH | CH | N | CH₃ | CH₃ | 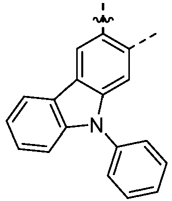 |
| 473 | N | CH | CH | N | CH₃ | CH₃ | 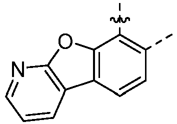 |
| 474 | N | CH | CH | N | CH₃ | CH₃ | 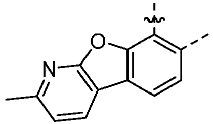 |
| 475 | N | CH | CH | N | CH₃ | CH₃ | 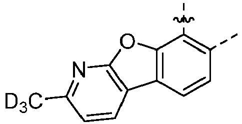 |
| 476 | N | CH | CH | N | CH₃ | CH₃ | 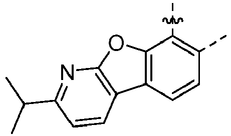 |
| 477 | N | CH | CH | N | CH₃ | CH₃ | 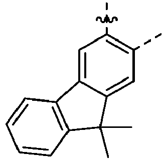 |
| 478 | N | CH | CH | N | CH₃ | CH₂CH₃ | 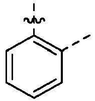 |
| 479 | N | CH | CH | N | CH₃ | CH₂CH₃ | 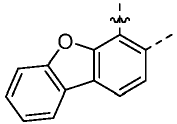 |
| 480 | N | CH | CH | N | CH₃ | CH₂CH₃ | 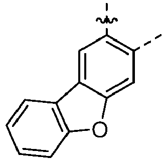 |
| 481 | N | CH | CH | N | CH₃ | CH₂CH₃ | 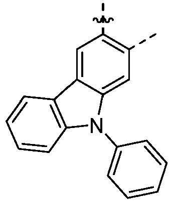 |
| 482 | N | CH | CH | N | CH₃ | CH₂CH₃ | 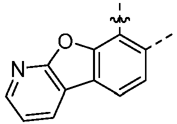 |
| 483 | N | CH | CH | N | CH₃ | CH₂CH₃ | 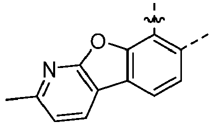 |
| 484 | N | CH | CH | N | CH₃ | CH₂CH₃ | 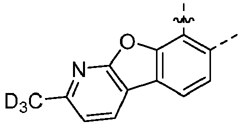 |
| 485 | N | CH | CH | N | CH₃ | CH₂CH₃ | 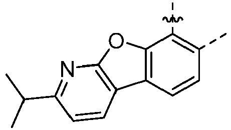 |
| 486 | N | CH | CH | N | CH₃ | CH₂CH₃ | 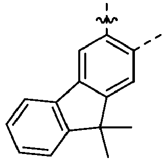 |
| 487 | N | CH | CH | N | CH₃ | CH(CH₃)₂ | 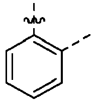 |
| 488 | N | CH | CH | N | CH₃ | CH(CH₃)₂ | 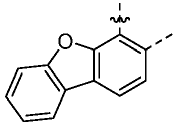 |
| 489 | N | CH | CH | N | CH₃ | CH(CH₃)₂ | 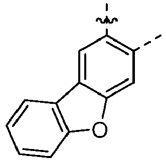 |
| 490 | N | CH | CH | N | CH₃ | CH(CH₃)₂ | 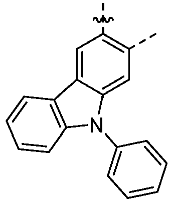 |
| 491 | N | CH | CH | N | CH₃ | CH(CH₃)₂ | 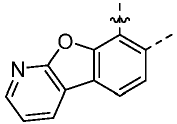 |
| 492 | N | CH | CH | N | CH₃ | CH(CH₃)₂ | 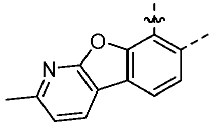 |
| 493 | N | CH | CH | N | CH₃ | CH(CH₃)₂ | 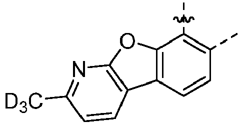 |
| 494 | N | CH | CH | N | CH₃ | CH(CH₃)₂ | 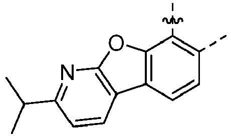 |
| 495 | N | CH | CH | N | CH₃ | CH(CH₃)₂ | 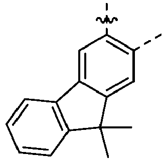 |
| 496 | N | CH | CH | N | 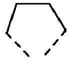 | | 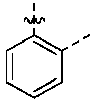 |
| 497 | N | CH | CH | N | 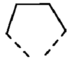 | | 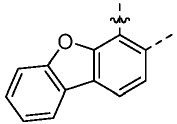 |
| 498 | N | CH | CH | N | 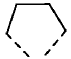 | | 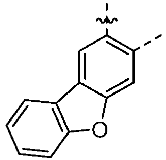 |
| 499 | N | CH | CH | N | 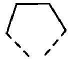 | | 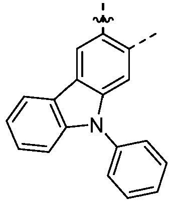 |
| 500 | N | CH | CH | N | 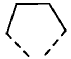 | | 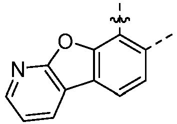 |
| 501 | N | CH | CH | N | 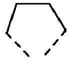 | | 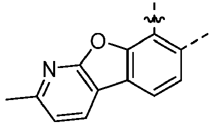 |
| 502 | N | CH | CH | N | 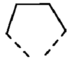 | | 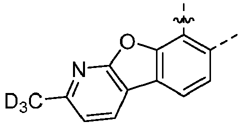 |
| 503 | N | CH | CH | N | 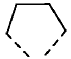 | | 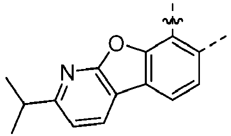 |
| 504 | N | CH | CH | N | 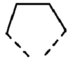 | | 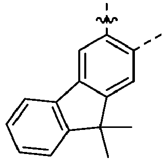 |
| 505 | N | CH | CH | N | 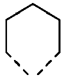 | | 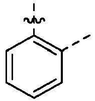 |
| 506 | N | CH | CH | N | 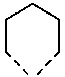 | | 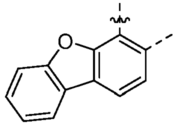 |
| 507 | N | CH | CH | N | 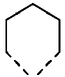 | | 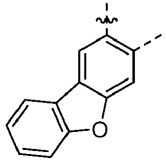 |
| 508 | N | CH | CH | N | 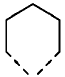 | | 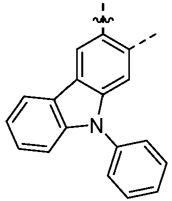 |
| 509 | N | CH | CH | N | 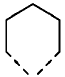 | | 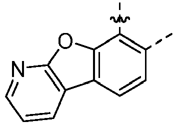 |
| 510 | N | CH | CH | N | 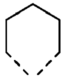 | | 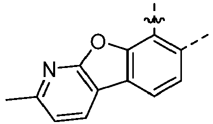 |
| 511 | N | CH | CH | N | 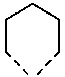 | | 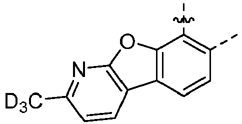 |
| 512 | N | CH | CH | N | 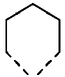 | | 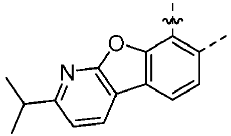 |
| 513 | N | CH | CH | N | 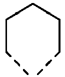 | | 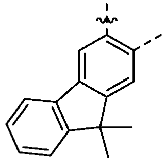 |
| 514 | N | CH | CH | N | 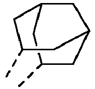 | | 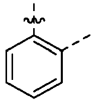 |
| 515 | N | CH | CH | N | 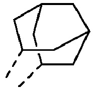 | | 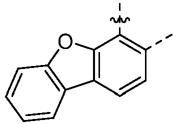 |
| 516 | N | CH | CH | N | 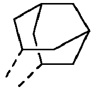 | | 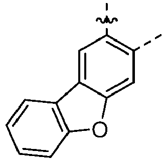 |
| 517 | N | CH | CH | N | 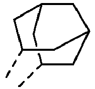 | | 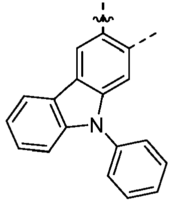 |
| 518 | N | CH | CH | N | 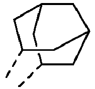 | | 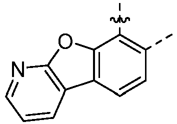 |
| 519 | N | CH | CH | N | 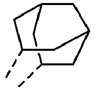 | | 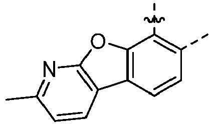 |
| 520 | N | CH | CH | N | 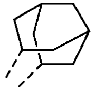 | | 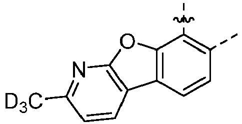 |
| 521 | N | CH | CH | N | 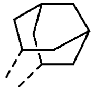 | | 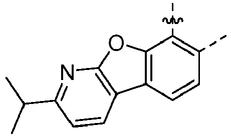 |
| 522 | N | CH | CH | N | 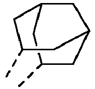 | | 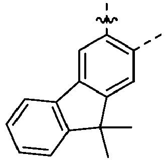 |
| 523 | CH | CH | CH | CH | CD₃ | CD₃ | 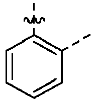 |
| 524 | CH | CH | CH | CH | CD₃ | CD₃ | 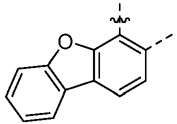 |
| 525 | N | CH | CH | CH | CD₃ | CD₃ | 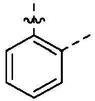 |
| 526 | N | CH | CH | CH | CD₃ | CD₃ | 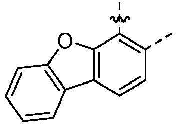 |
| 527 | CH | N | CH | CH | CD₃ | CD₃ | 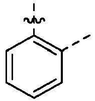 |
| 528 | CH | N | CH | CH | CD₃ | CD₃ | 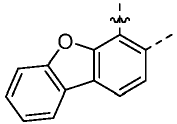 |
| 529 | CH | CH | N | CH | CD₃ | CD₃ | 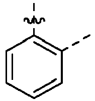 |
| 530 | CH | CH | N | CH | CD₃ | CD₃ | 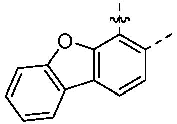 |
| 531 | CH | CH | CH | N | CD₃ | CD₃ | 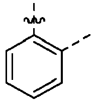 |
| 532 | CH | CH | CH | N | CD₃ | CD₃ | 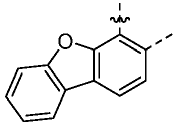 |
| 533 | N | CH | CH | N | CD₃ | CD₃ | 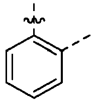 |
| 534 | N | CH | CH | N | CD₃ | CD₃ | 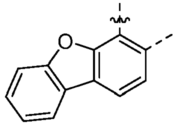 |

In some embodiments of the compound comprising a carbene ligand L_{A} of Formula I, the ligand L_{A} is selected from the group consisting of:

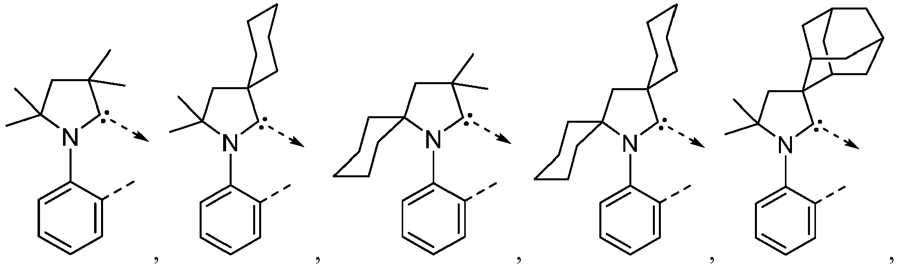

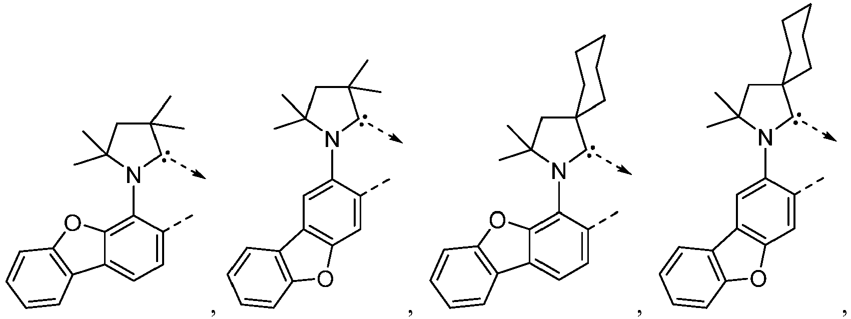

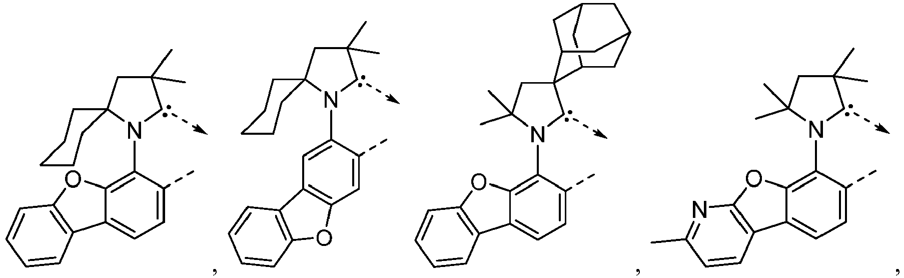

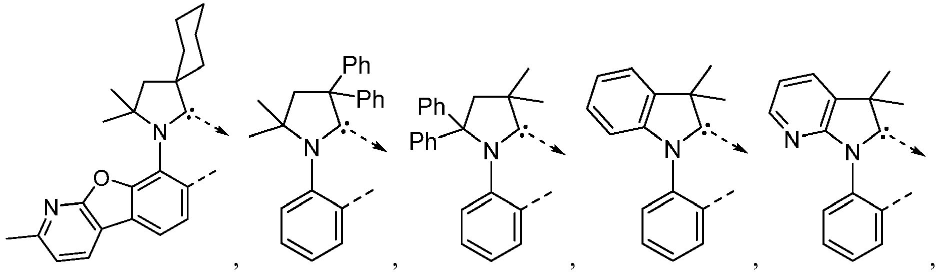

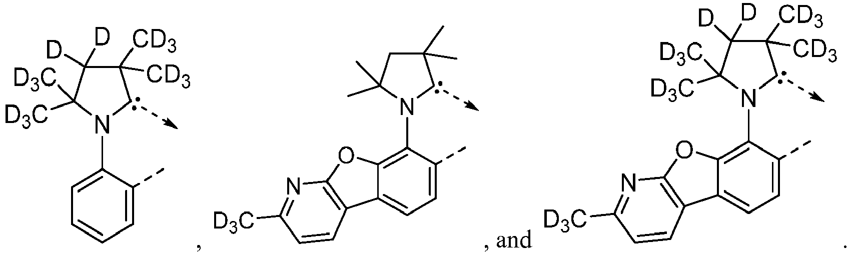

In some embodiments of the compound comprising a carbene ligand L_{A} of Formula I, the compound has a formula M(L_{A})ₙ(L_{B})ₘ₋ₙ;
wherein M is Ir or Pt;
wherein L_{B} is a bidentate ligand;
wherein, when M is Ir, m is 3, and n is 1, 2, or 3; and
wherein, when M is Pt, m is 2, and n is 1, or 2.
In some other embodiments of the compound, the compound has a formula of Ir(L_{A})₃.

In embodiments where the compound has a formula M(L_{A})ₙ(L_{B})ₘ₋ₙ as defined above, the compound has a formula of Ir(L_{A})(L_{B})₂; and L_{B} is different from L_{A}.

In embodiments where the compound has a formula M(L_{A})ₙ(L_{B})ₘ₋ₙ as defined above, the compound has a formula of Ir(L_{A})₂(L_{B}); and L_{B} is different from L_{A}.

In some embodiments where the compound comprises a carbene ligand L_{A} having the structure of Formula I defined above, the ligand L_{A} is L_{Ai} selected from the group consisting of L_{A1} to L_{A534}, wherein the substituents R¹, R², R³, R⁴, R⁵, R⁶, and Ring A in L_{A*i*} for *i* = 1 to 198 are defined in Table 1; and substitutents Q¹, Q², Q³, Q⁴, R⁵, R⁶, and Ring A in L_{A*i*} for *i* = 199 to 534 are defined in Table 2, the compound has a formula of Ir(L_{A})(L_{B})₂ or Ir(L_{A})₂(L_{B});
wherein L_{B} is different from L_{A}; and
wherein L_{A} and L_{B} are independently selected from the group consisting of L_{A1} to L_{A534}.

In some embodiments where the compound has a formula M(L_{A})ₙ(L_{B})ₘ₋ₙ defined above, the compound has a formula of Pt(L_{A})(L_{B}) and wherein L_{A} and L_{B} can be same or different. In some embodiments, L_{A} and L_{B} are connected to form a tetradentate ligand. In some embodiments, L_{A} and L_{B} are connected at two places to form a marcrocyclic tetradentate ligand.

In some embodiments of the compound having the formula M(L_{A})ₙ(L_{B})ₘ₋ₙ defined above, L_{B} is selected from the group consisting of: 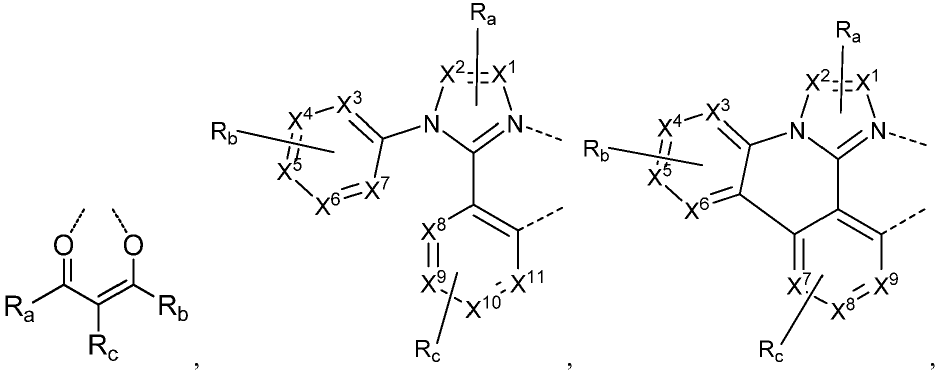 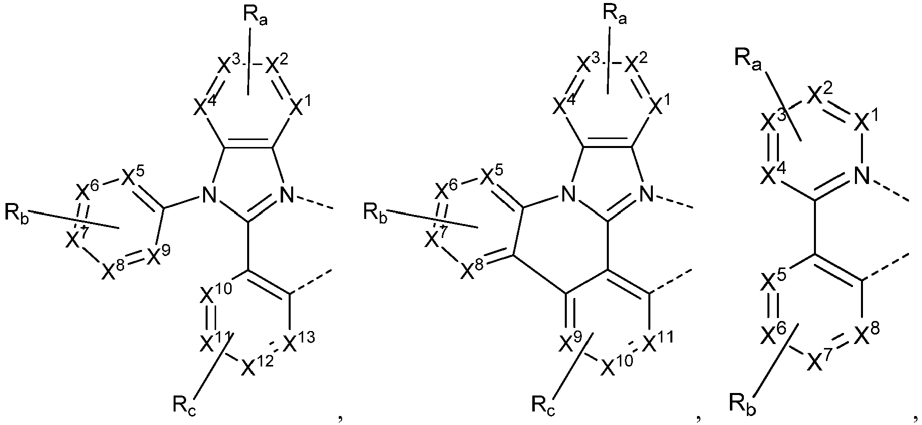 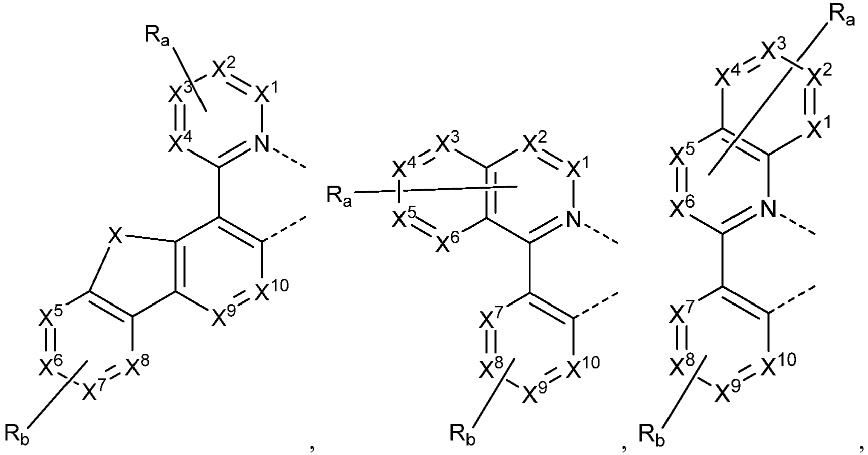 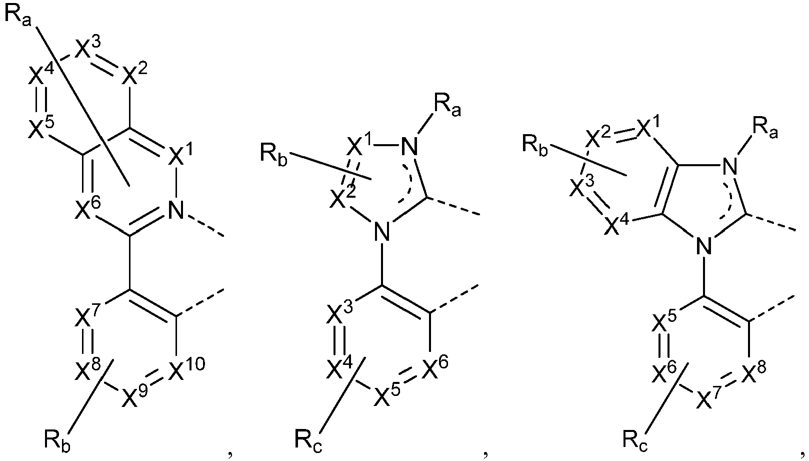 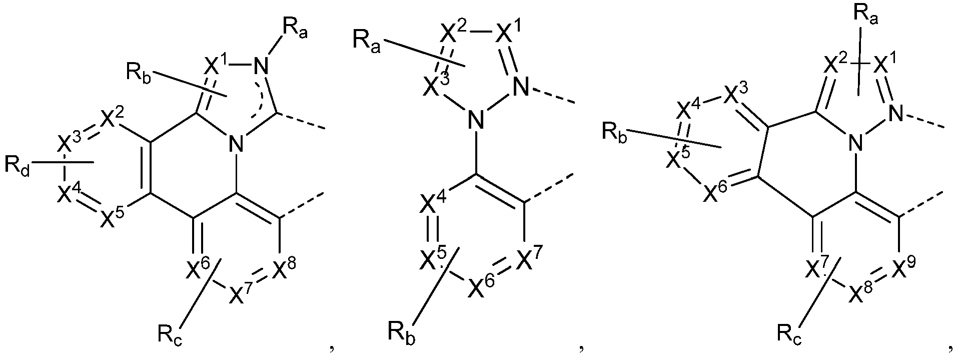 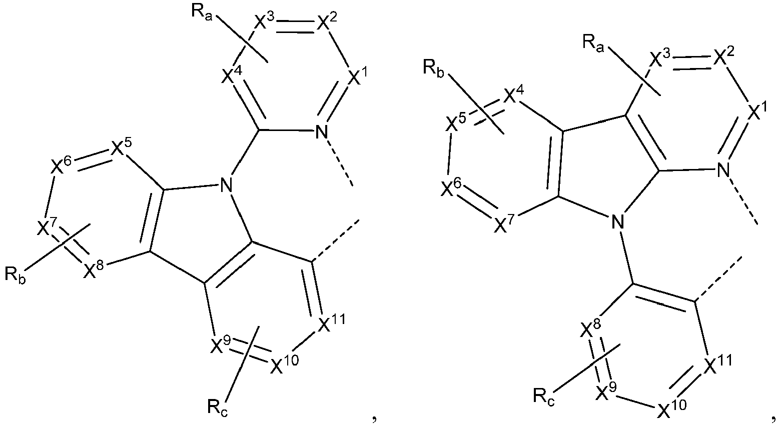 and 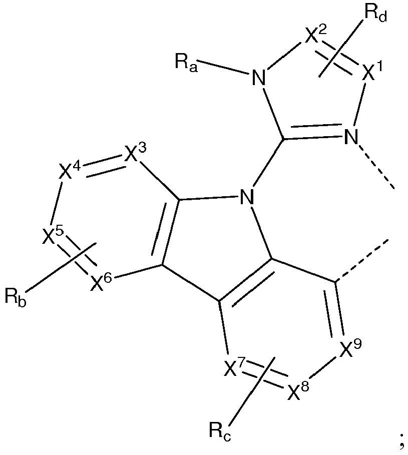
wherein each X¹ to X¹³ are independently selected from the group consisting of carbon and nitrogen;
wherein X is selected from the group consisting of BR', NR', PR', O, S, Se, C=O, S=O, SO₂, CR'R", SiR'R", and GeR'R";
wherein R' and R" are optionally fused or joined to form a ring;
wherein each Rₐ, R_{b}, R_{c}, and R_{d} may represent from mono substitution to the possible maximum number of substitution, or no substitution;
wherein R', R", Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any two adjacent substitutents of Rₐ, R_{b}, R_{c}, and R_{d} are optionally fused or joined to form a ring or form a multidentate ligand.

In some embodiments, L_{B} is selected from the group consisting of:

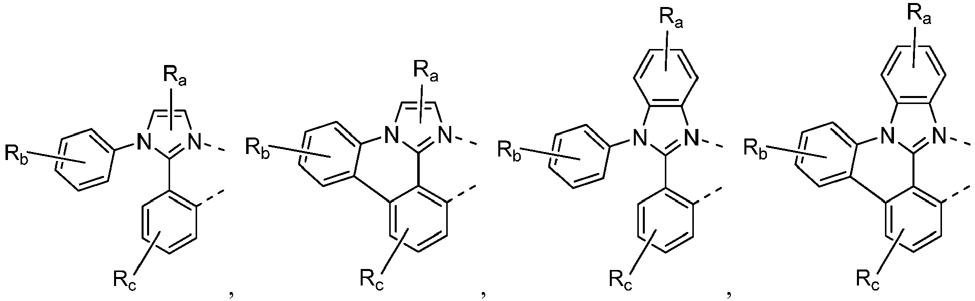

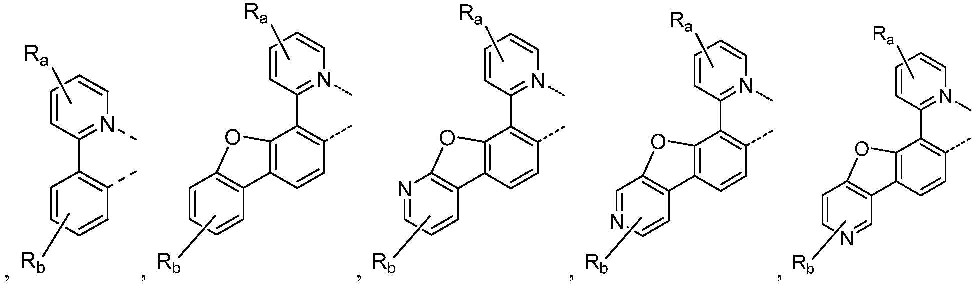

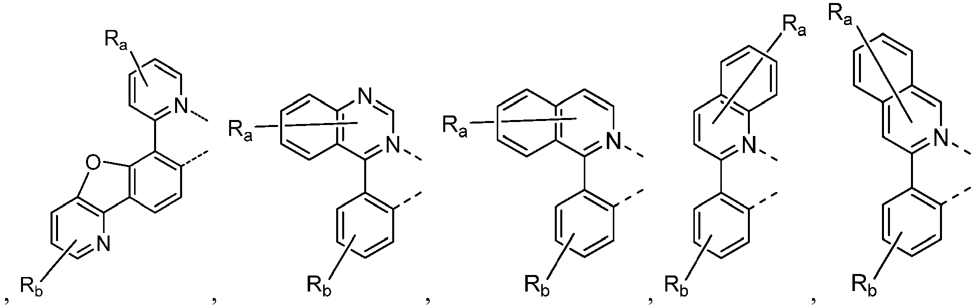

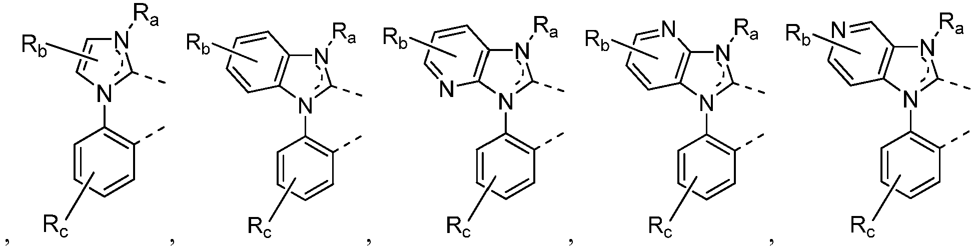

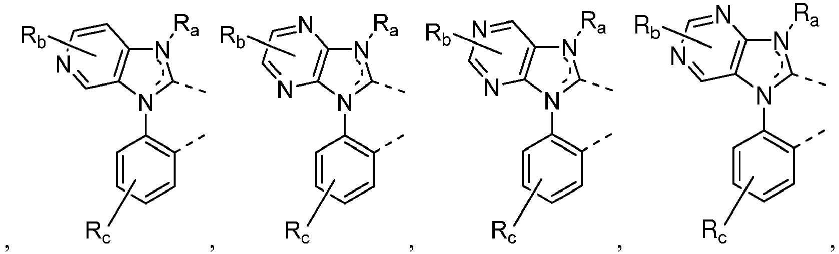

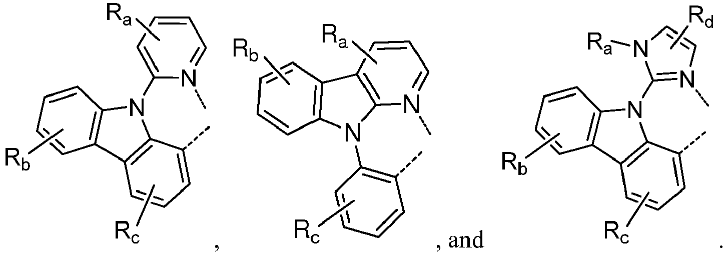

In some embodiments of the compound having the formula M(L_{A})ₙ(L_{B})ₘ₋ₙ defined above, L_{B} is another carbene ligand.

In some embodiments of the compound having the formula M(L_{A})ₙ(L_{B})ₘ₋ₙ defined above. L_{B} is selected from the group consisting of:

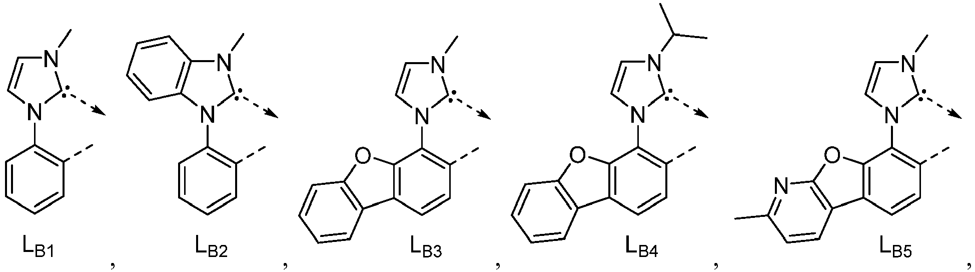

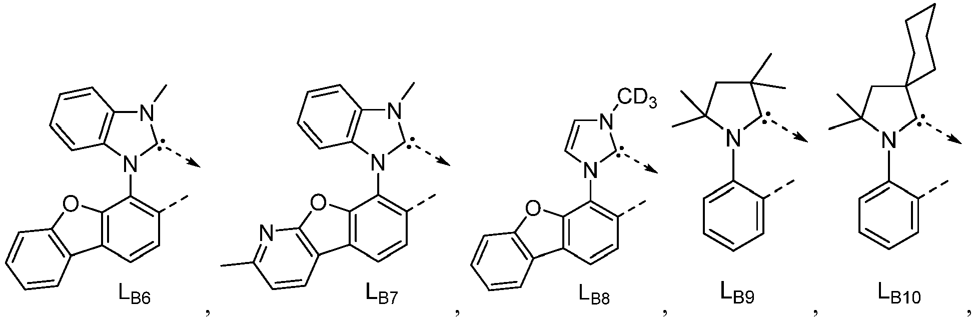

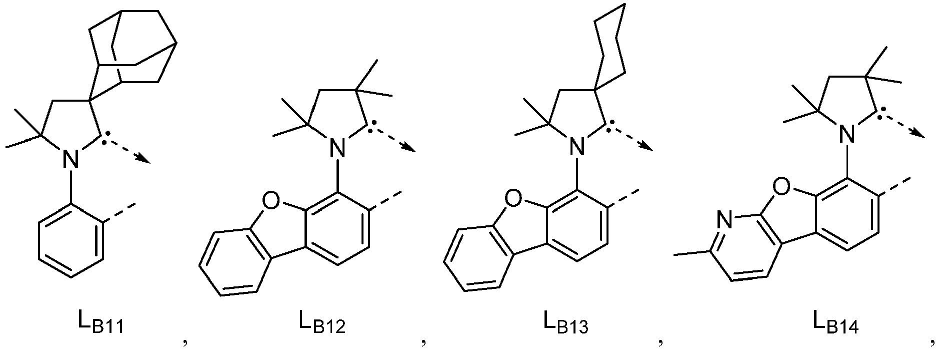

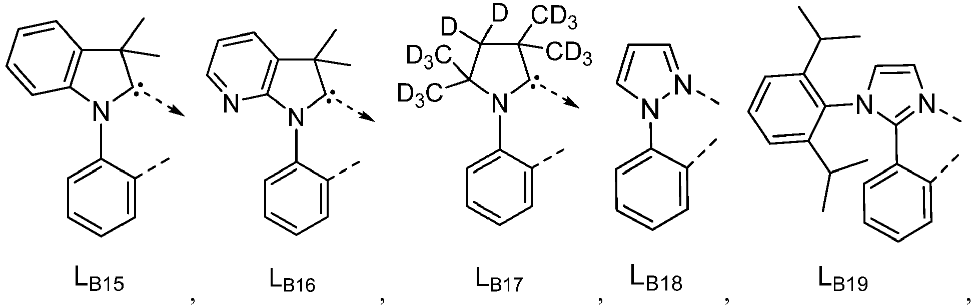

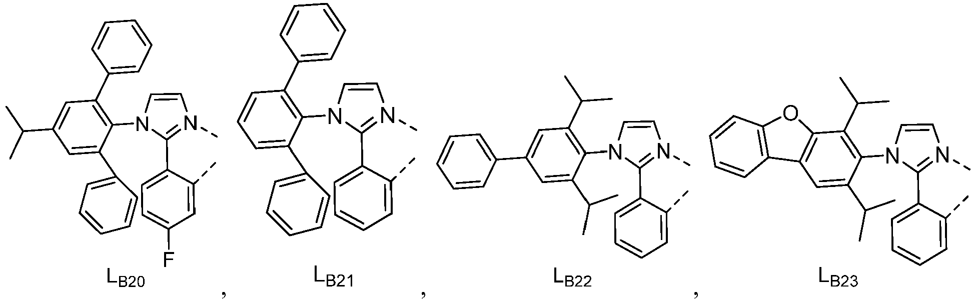

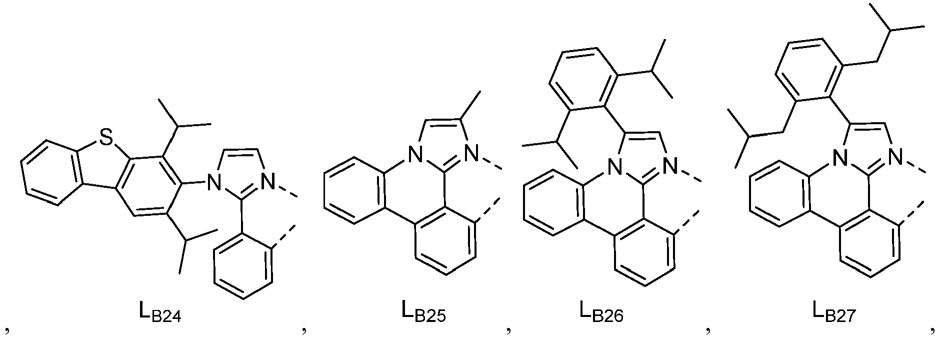

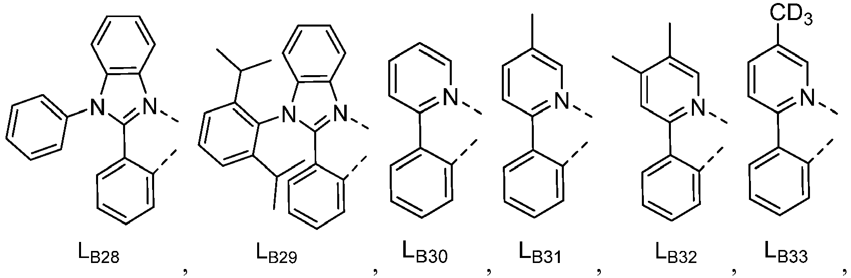

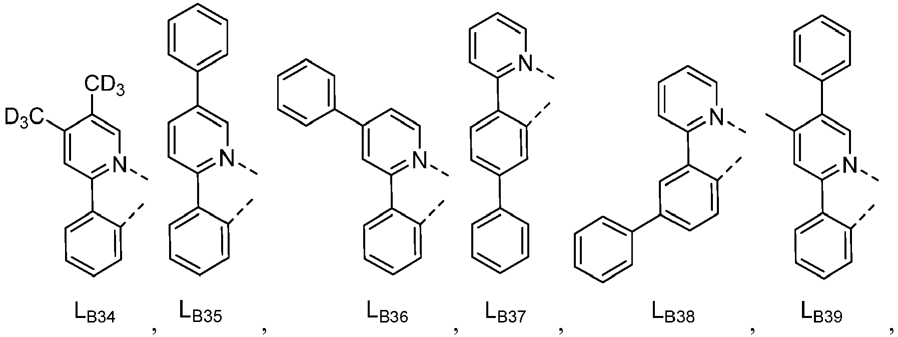

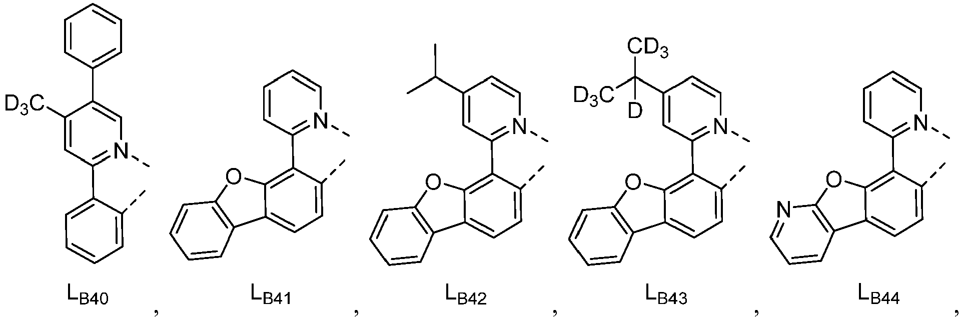

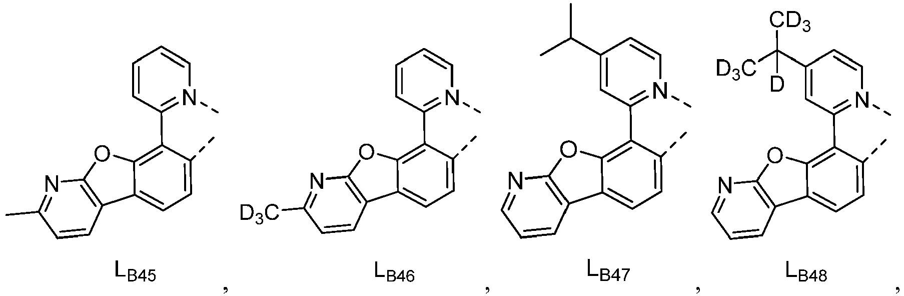

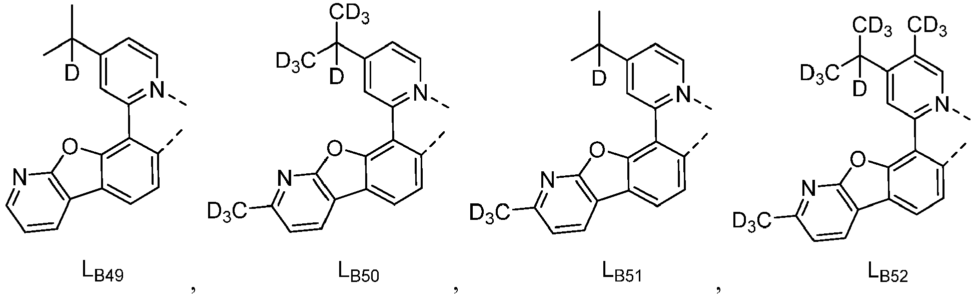

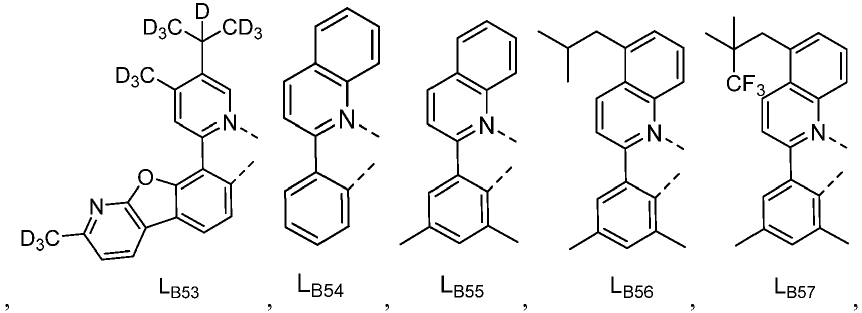

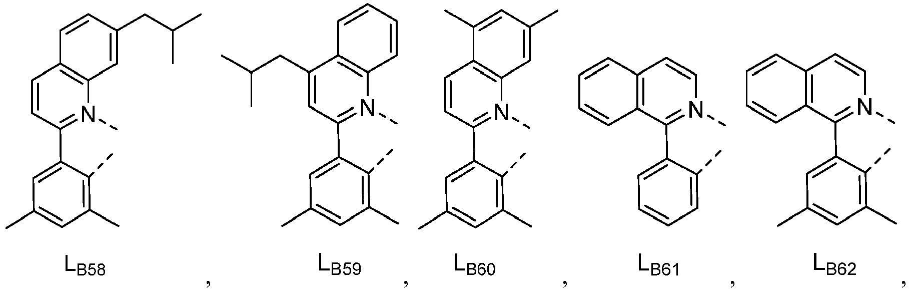

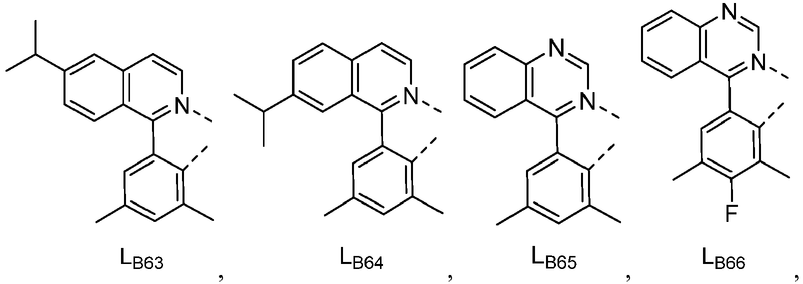

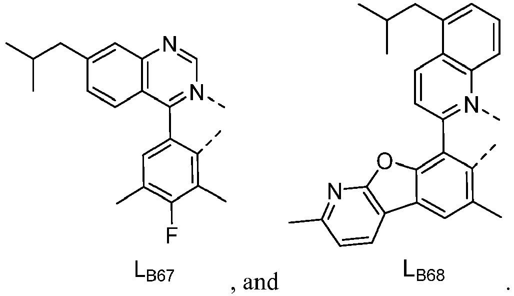

In some embodiments where the compound comprises a carbene ligand L_{A} having the structure of Formula I defined above, the ligand L_{A} is L_{Ai} selected from the group consisting of L_{A1} to L_{A534}, wherein the substituents R¹, R², R³, R⁴, R⁵, R⁶, and Ring A in L_{A*i*} for *i* = 1 to 198 are defined in Table 1; and substitutents Q¹, Q², Q³, Q⁴, R⁵, R⁶, and Ring A in L_{A*i*} for *i* = 199 to 534 are defined in Table 2,
the compound is selected from the group consisting of Compound A1 through Compound A534; wherein each Compound Ax has the formula Ir(L_{A*i*})₃; and *x* = *i* and *i* is an integer from 1 to 534.

In some embodiments where the compound comprises a carbene ligand L_{A} having the structure of Formula I defined above, the ligand L_{A} is L_{Ai} selected from the group consisting of L_{A1} to L_{A534}, wherein the substituents R¹, R², R³, R⁴, R⁵, R⁶, and Ring A in L_{A*i*} for *i* = 1 to 198 are defined in Table 1; and substitutents Q¹, Q², Q³, Q⁴, R⁵, R⁶, and Ring A in L_{A*i*} for *i* = 199 to 534 are defined in Table 2,
the compound is selected from the group consisting of Compound B1 through Compound B36,312 and Compound C1 through Compound C36,312;
wherein, for Compound B1 through Compound B36,312, each Compound B*y* has the formula Ir(L_{A*i*})(L_{B*j*})₂, wherein *y* = 534*j* + *i* - 533; *i* is an integer from 1 to 534, and *j* is an integer from 1 to 68;
wherein, for Compound C1 through Compound C36,312, each Compound C*z* has the formula Ir(L_{A*i*})₂(L_{B*j*}), wherein *z* = 534*j* + *i*-533; *i* is an integer from 1 to 534, and *j* is an integer from 1 to 68; and
wherein L_{B} is selected from the group consisting of:

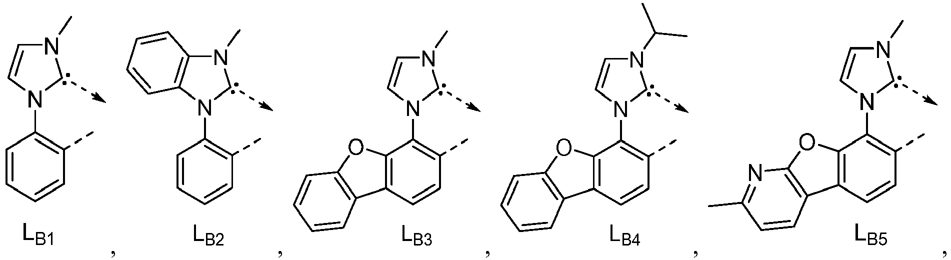

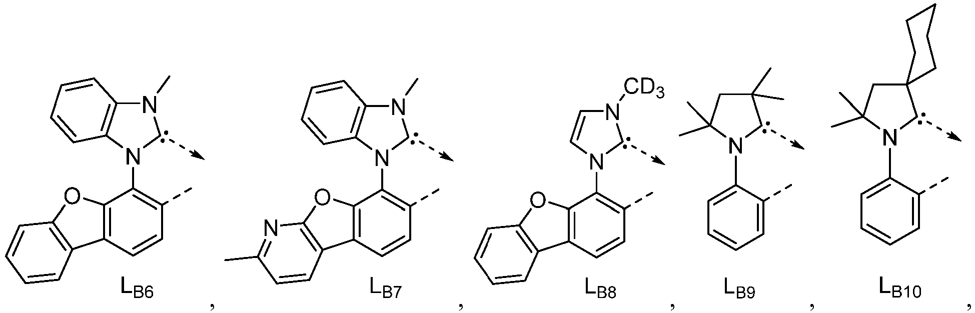

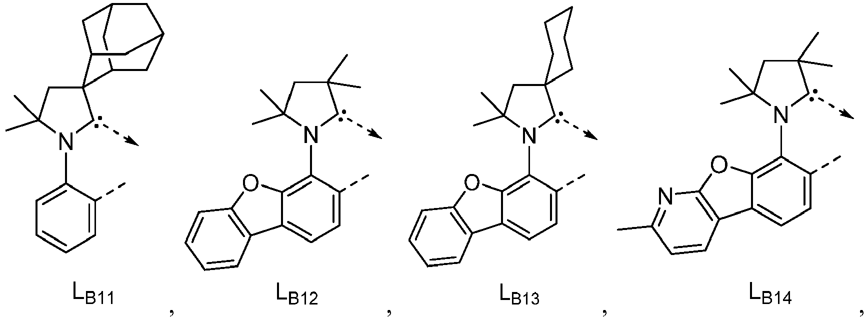

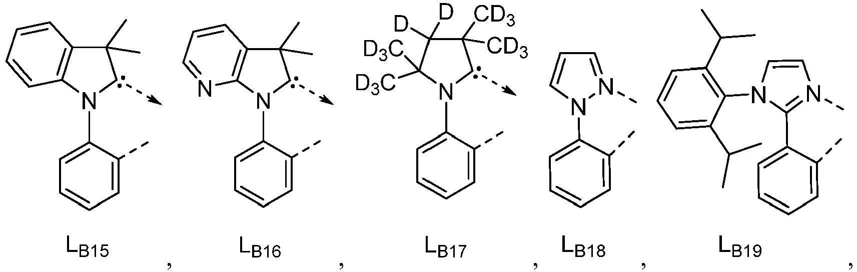

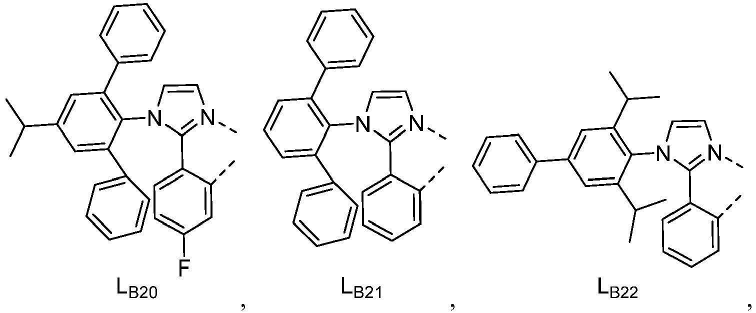

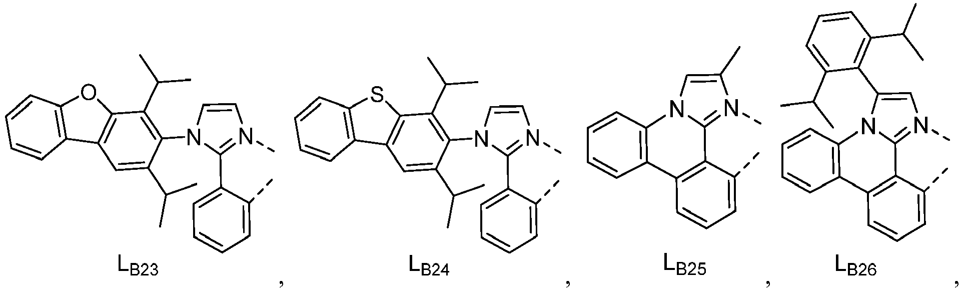

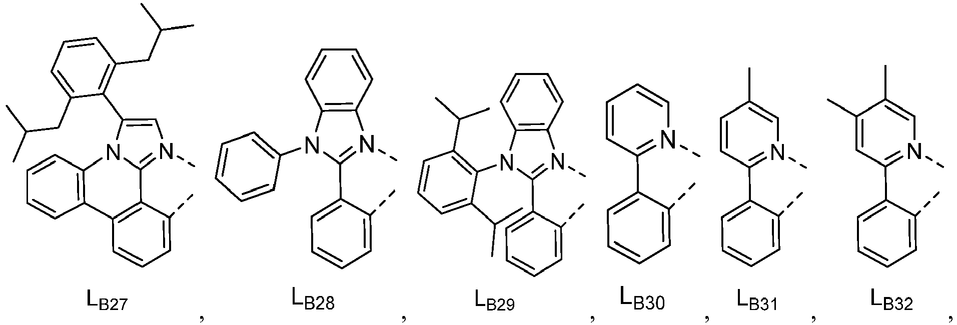

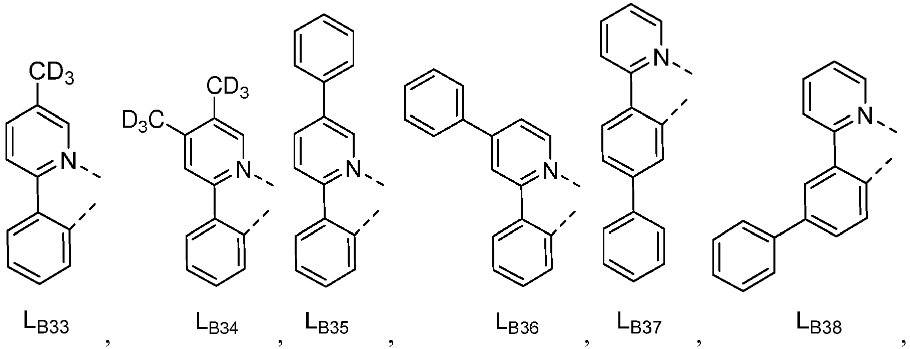

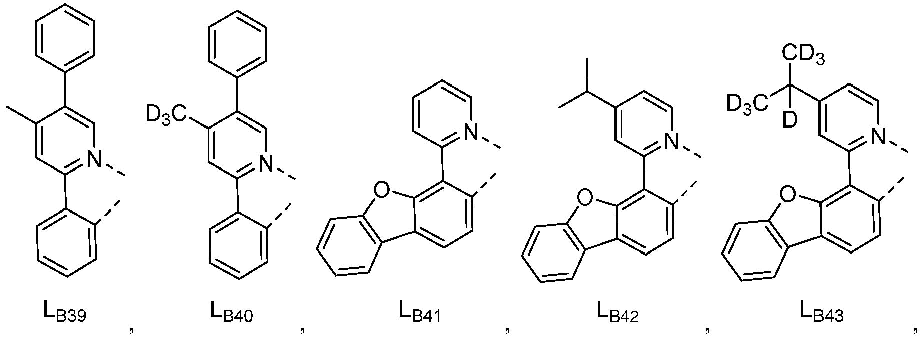

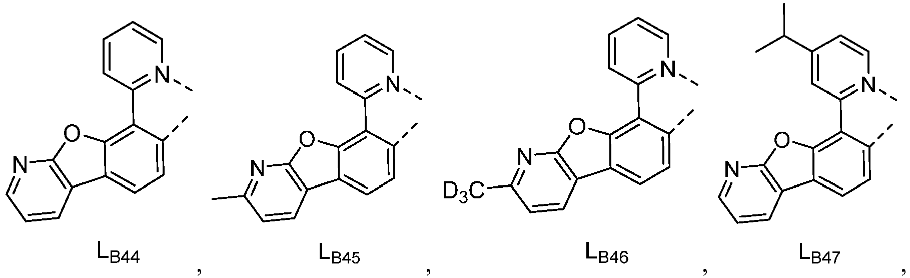

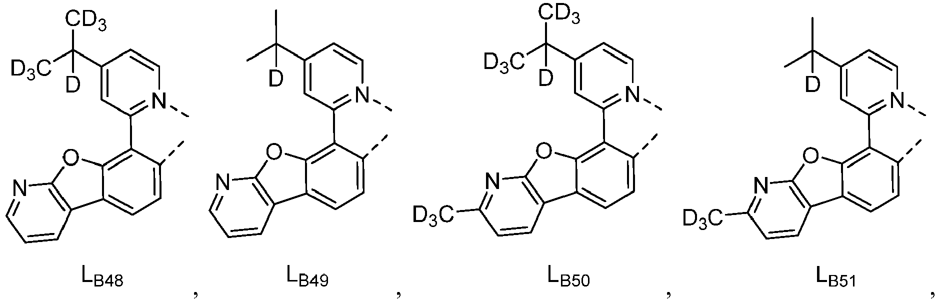

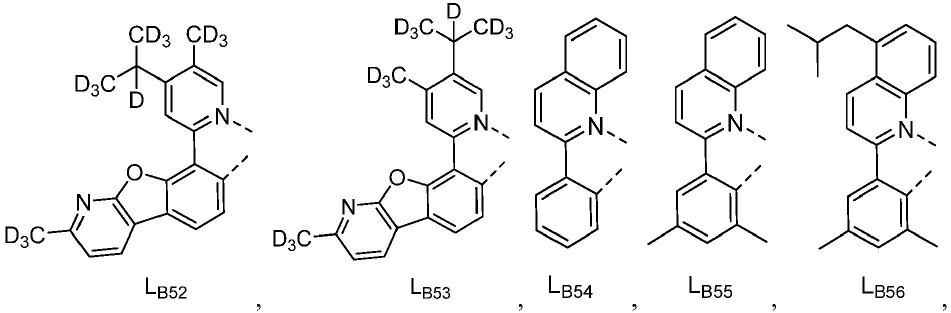

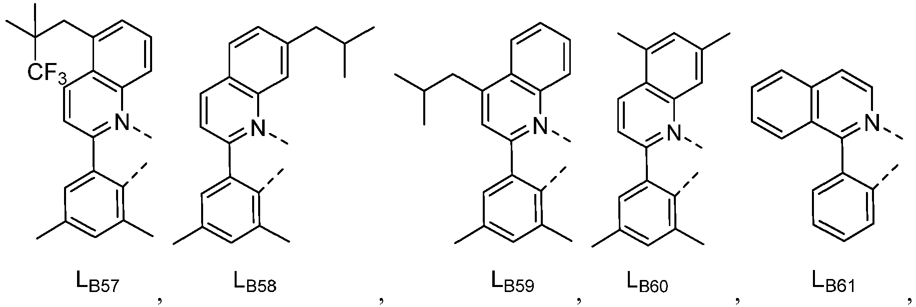

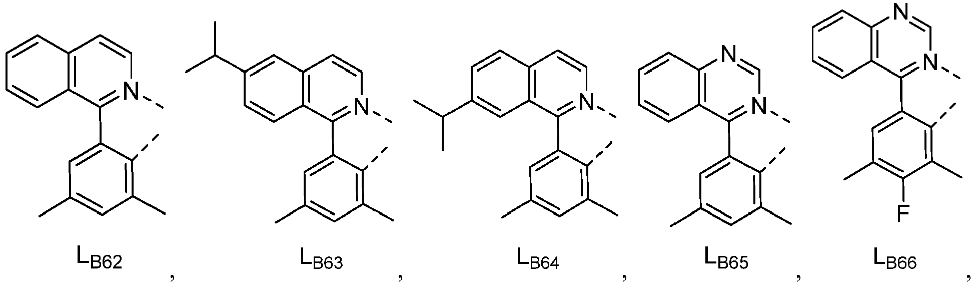

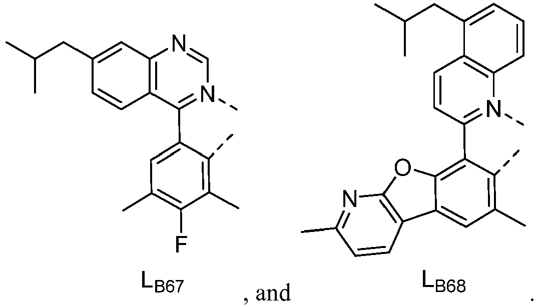

According to another aspect of the present disclosure, a first organic light emitting device is disclosed. The first organic light emitting device comprises: an anode; a cathode; and
an organic layer, disposed between the anode and the cathode, comprising a compound comprising a carbene ligand L_{A} of Formula I: 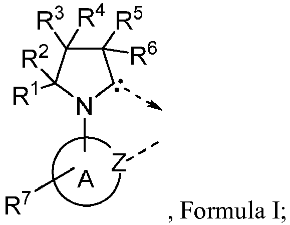
wherein ring A is a 5-membered or 6-membered carbocyclic or heterocyclic ring;
wherein Z is nitrogen or carbon;
wherein R⁷ represents from mono-substitution to the possible maximum number of substitution, or no substitution;
wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein any adjacent substituents of R¹, R², R³, R⁴, R⁵, R⁶, and R⁷ are optionally joined or fused into a ring;
wherein the ligand L_{A} is coordinated to a metal M through the carbene carbon and Z; and
wherein the ligand L_{A} is optionally linked with other ligands to comprise a tridentate, tetradentate, pentadentate or hexadentate ligand.

In some embodiments, the first organic light emitting device is incorporated into a device selected from the group consisting of a consumer product, an electronic component module, an organic light-emitting device, and a lighting panel.

In some embodiments of the first organic light emitting device, the organic layer is an emissive layer and the compound is an emissive dopant or a non-emissive dopant.

In some embodiments of the first organic light emitting device, the organic layer is a charge transporting layer and the compound is a charge transporting material in the organic layer.

In some embodiments of the first organic light emitting device, the organic layer is a blocking layer and the compound is a blocking material in the organic layer.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The first organic light emitting device disclosed herein can be incorporated into one or more of a consumer product, an electronic component module, an organic light-emitting device, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be a triphenylene containing benzo-fused thiophene or benzo-fused furan. Any substituent in the host can be an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C=C-CₙH₂ₙ₊₁, Ar₁, Ar₁-Ar₂, and CₙH₂ₙ-Ar₁, or the host has no substitution. In the preceding substituents n can range from 1 to 10; and Ar₁ and Ar₂ can be independently selected from the group consisting of benzene, biphenyl, naphthalene, triphenylene, carbazole, and heteroaromatic analogs thereof. The host can be an inorganic compound. For example a Zn containing inorganic material e.g. ZnS.

The host can be a compound comprising at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene. The host can include a metal complex.

The host can be, but is not limited to, a specific compound selected from the group consisting of: 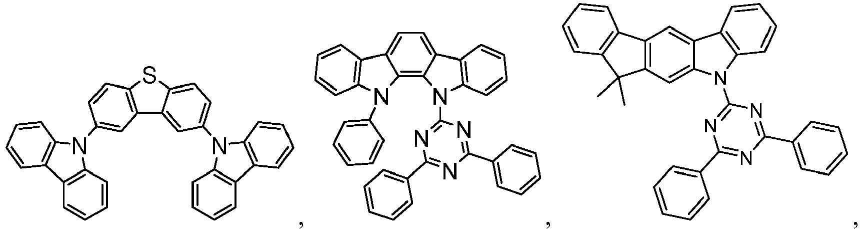 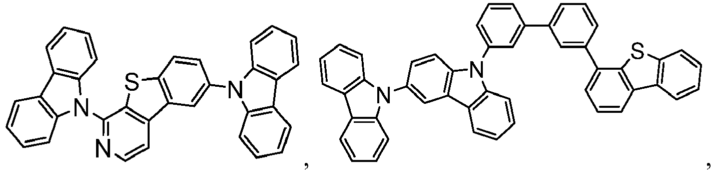 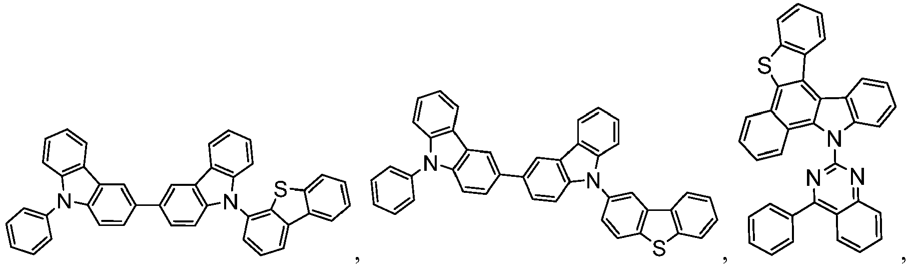 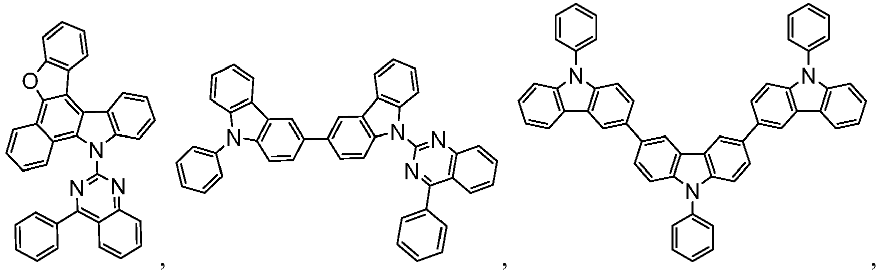 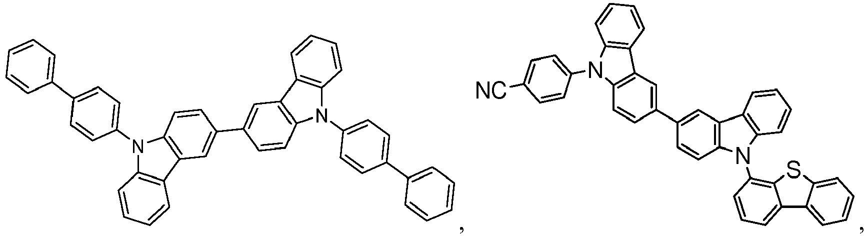 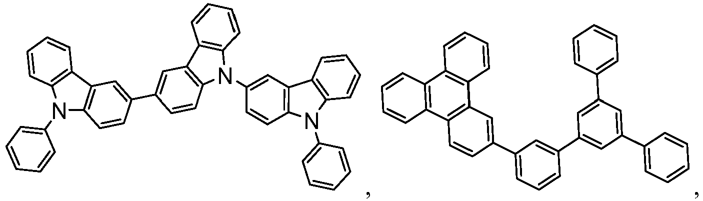 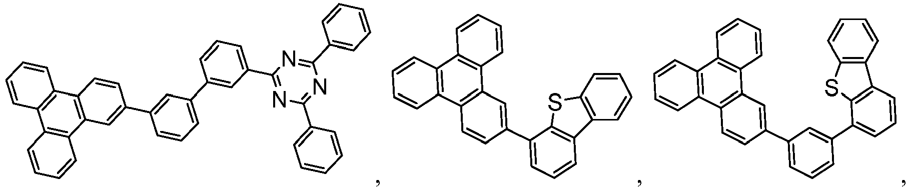 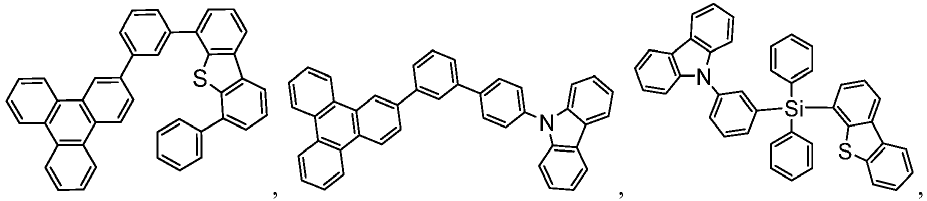 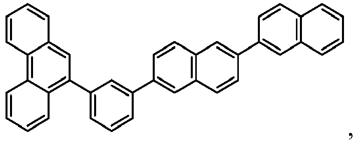 and combinations thereof. Additional information on possible hosts is provided below.

According to another aspect, a formulation comprising a compound comprising a carbene ligand L_{A} of Formula I defined above is also disclosed. The formulation can include one or more components selected from the group consisting of a solvent, a host, a hole injection material, hole transport material, and an electron transport layer material, disclosed herein.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer. Non-limiting examples of the conductivity dopants that may be used in an OLED in combination with materials disclosed herein are exemplified below together with references that disclose those materials:
EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804 and US2012146012. 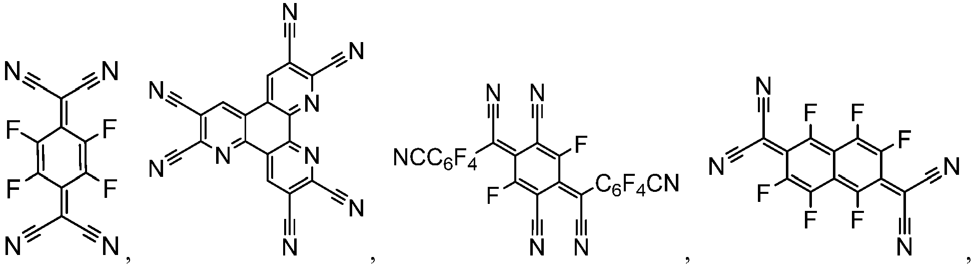 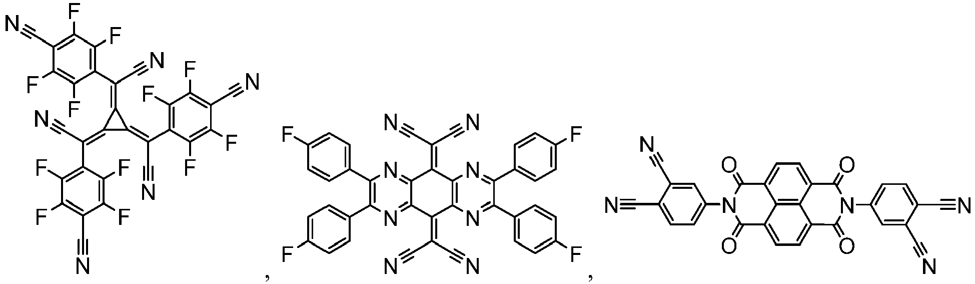 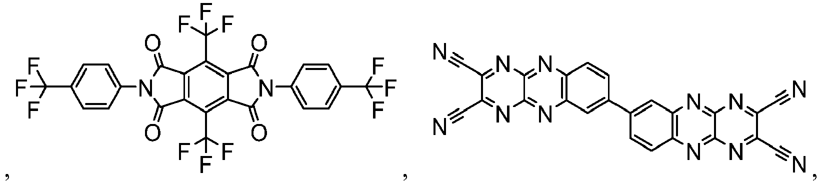 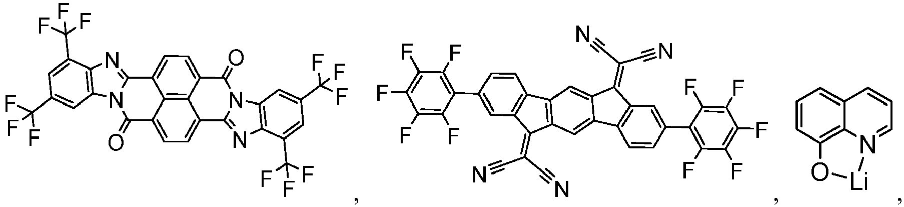 and

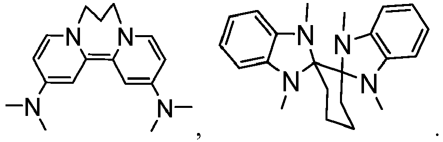

### HIL/HTL:

A hole injecting/transporting material to be used in the present invention is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

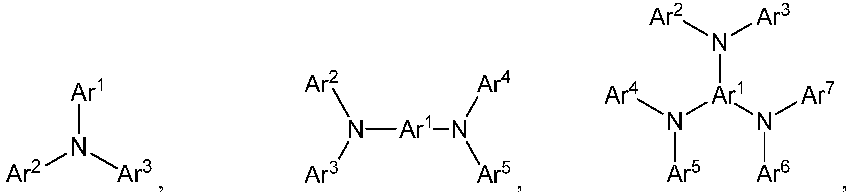

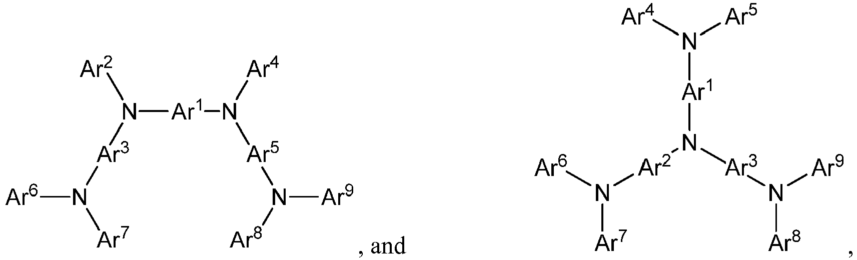

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 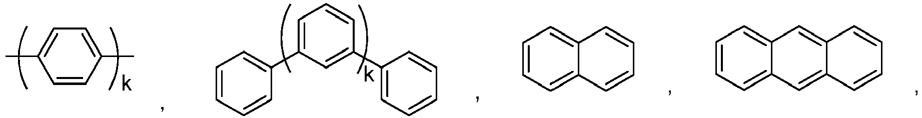 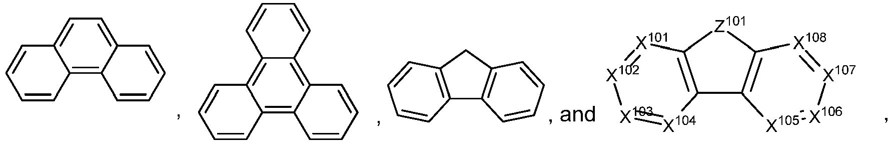 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 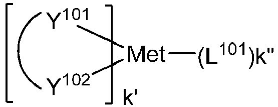 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials:
CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018. 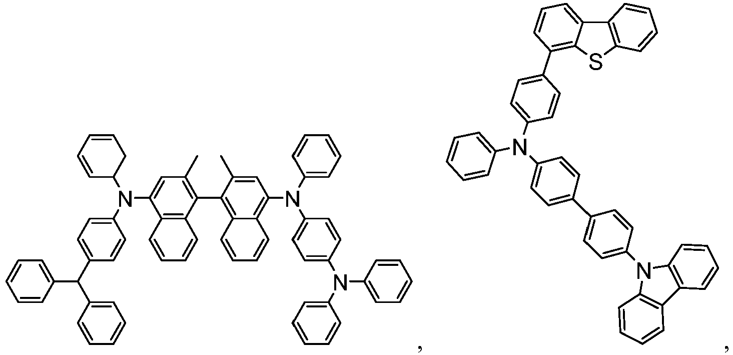 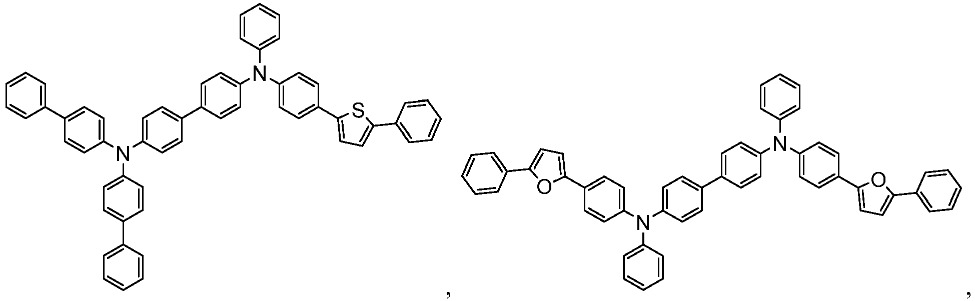 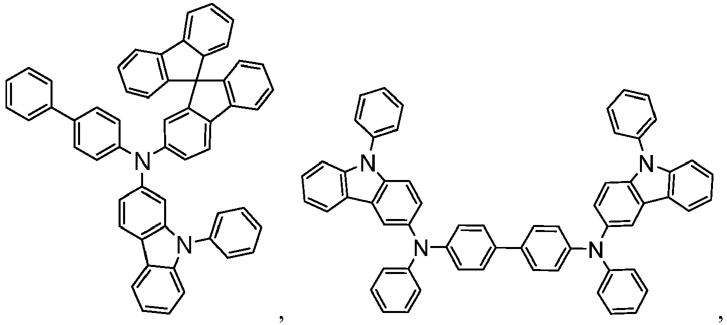 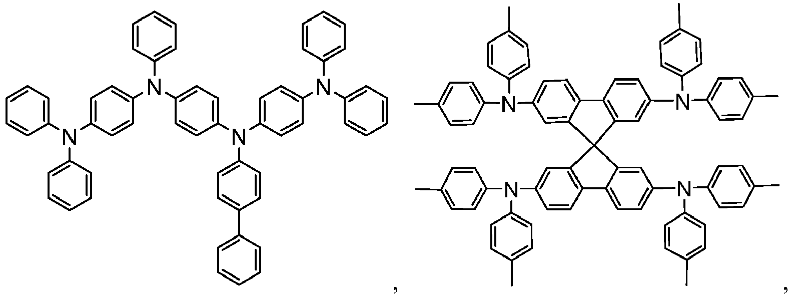 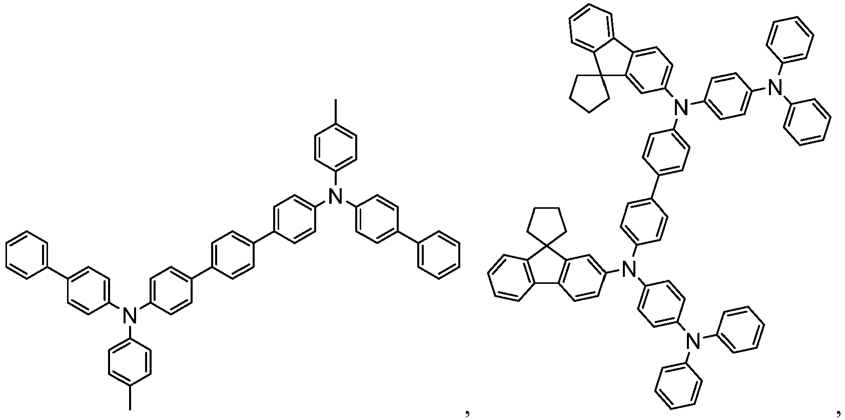 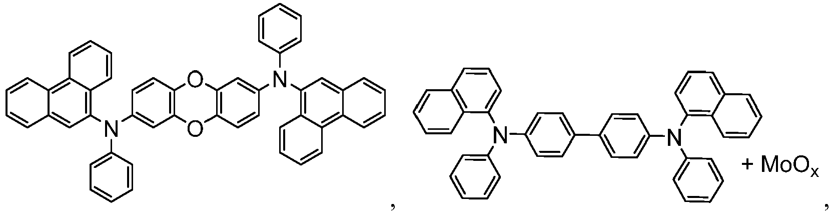 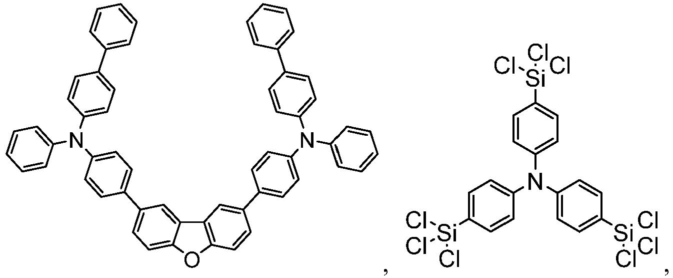 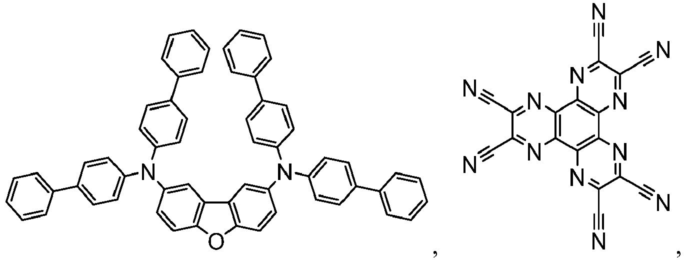 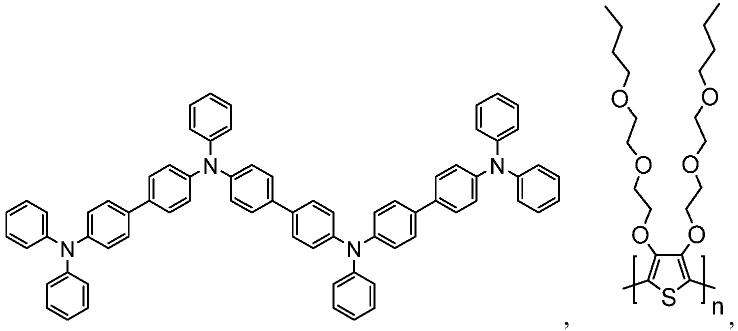 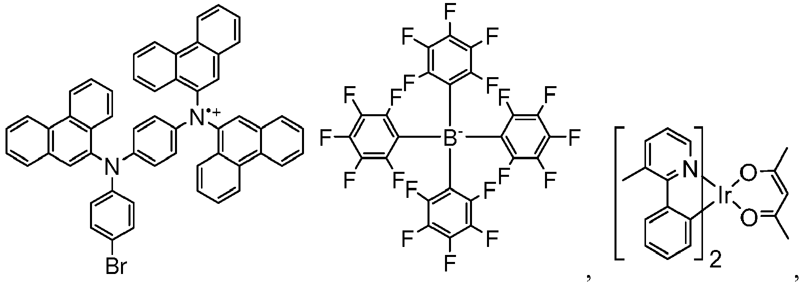 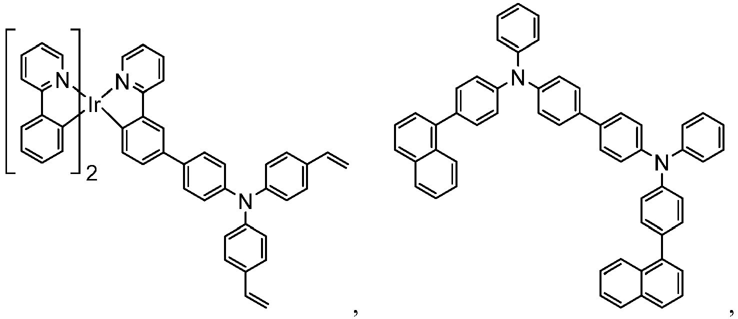 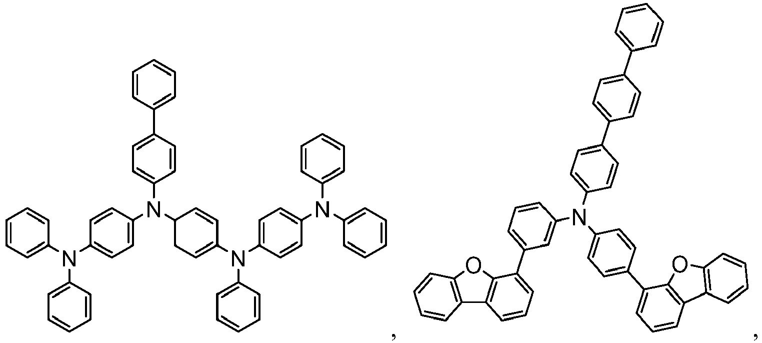 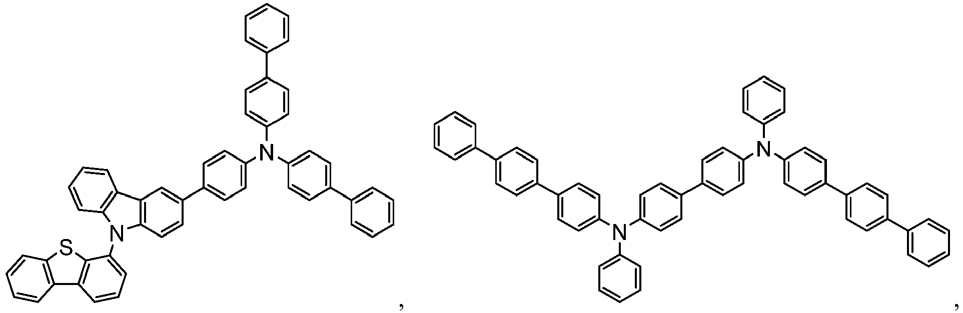 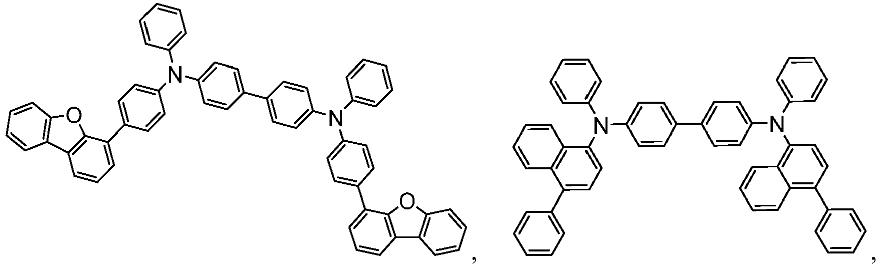 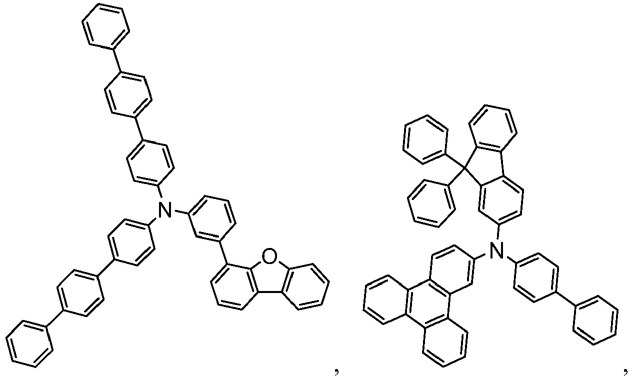 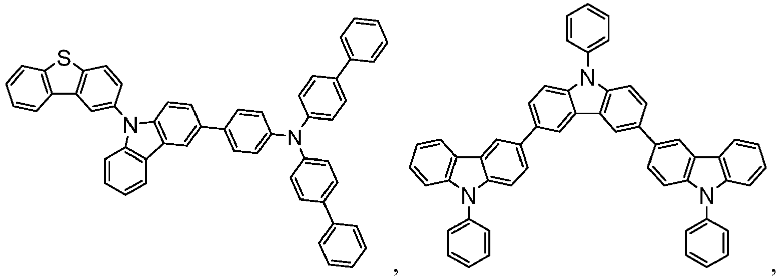 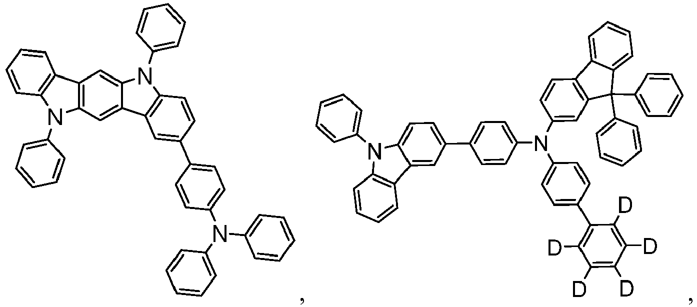 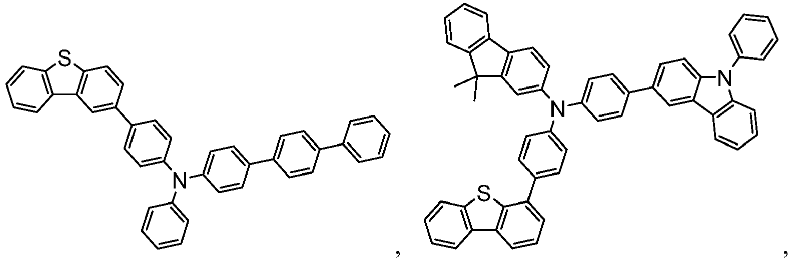 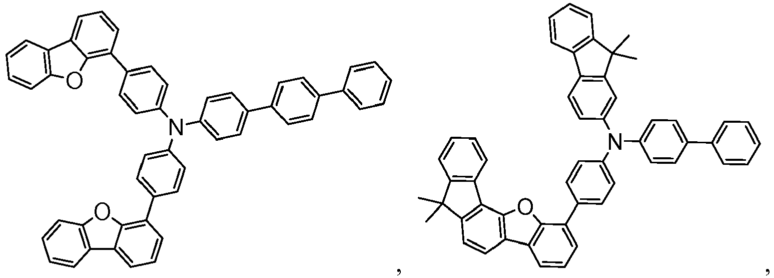 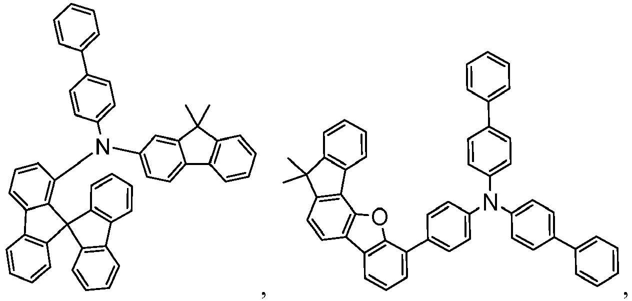 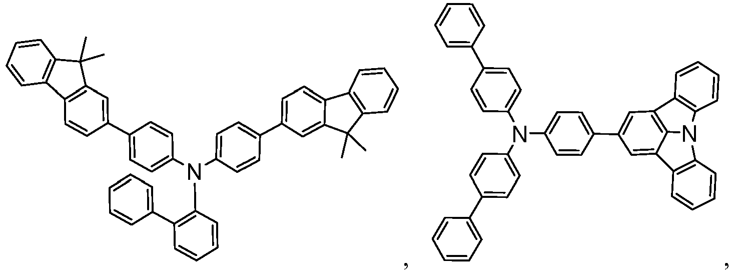 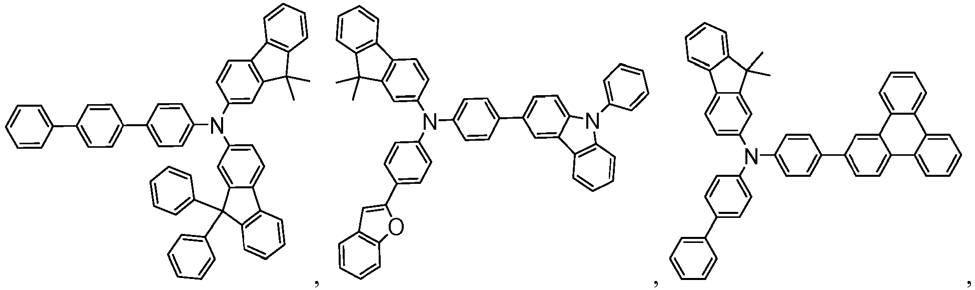 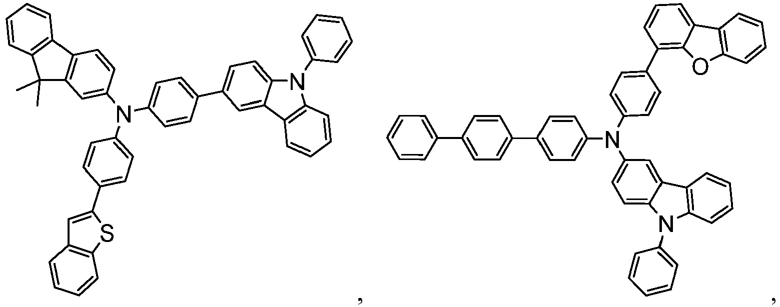 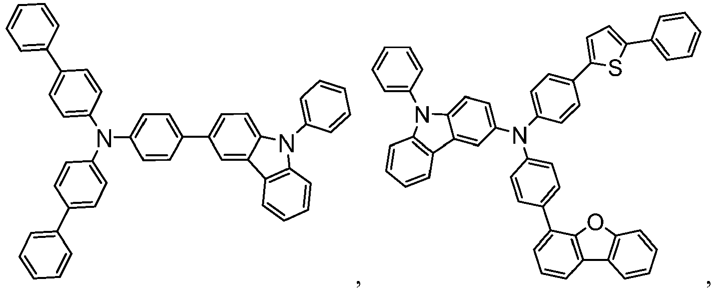 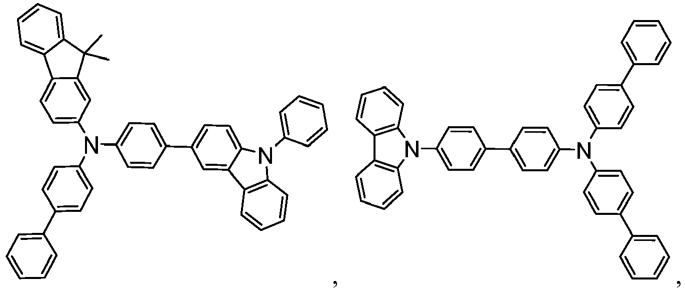 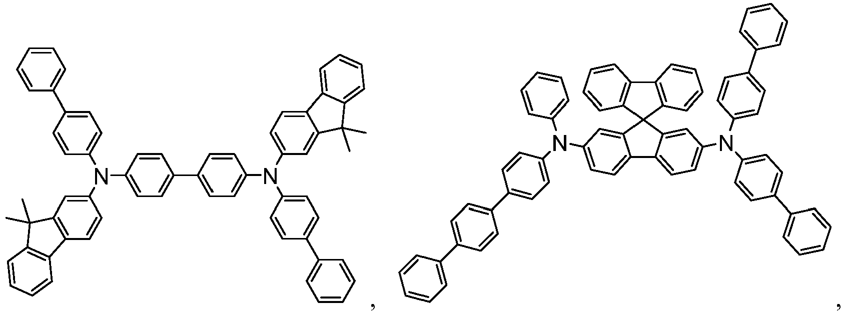 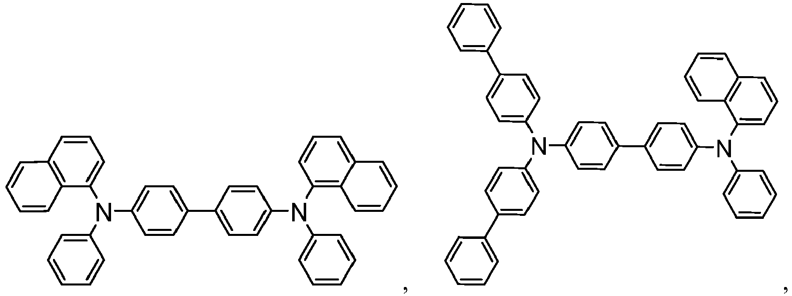 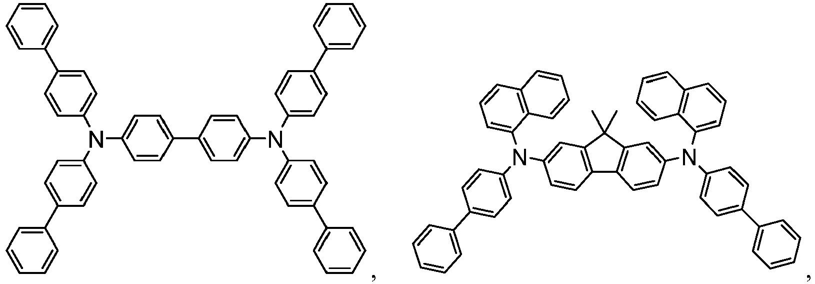 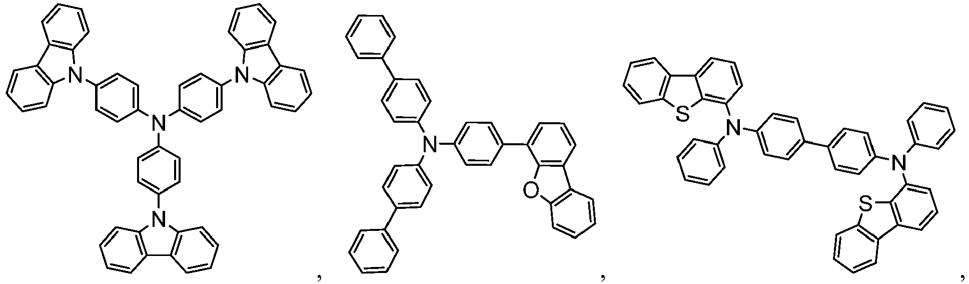 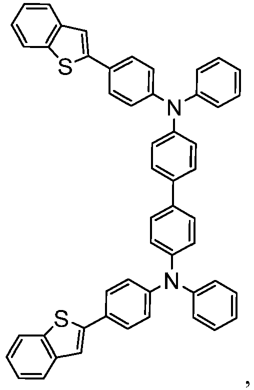 and

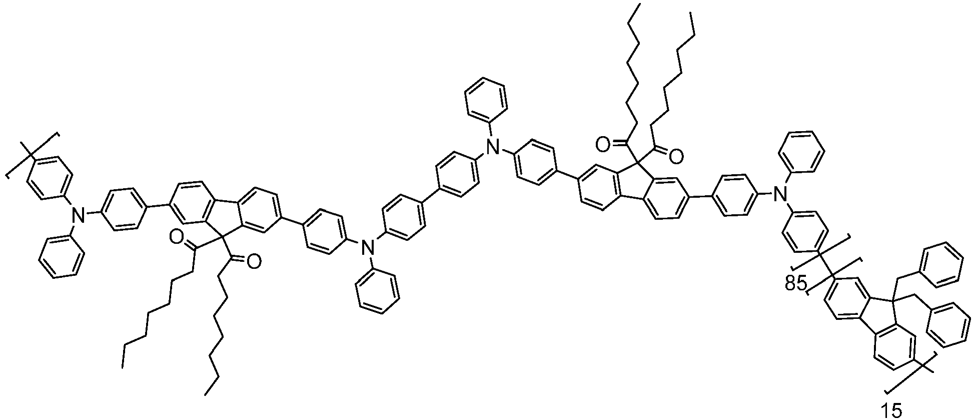

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. While the Table below categorizes host materials as preferred for devices that emit various colors, any host material may be used with any dopant so long as the triplet criteria is satisfied.

Examples of metal complexes used as host are preferred to have the following general formula: 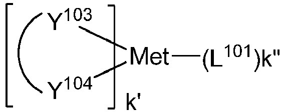 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 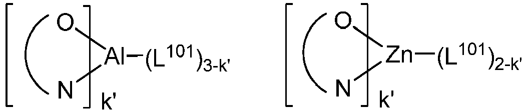 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

Examples of organic compounds used as host are selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, the host compound contains at least one of the following groups in the molecule: 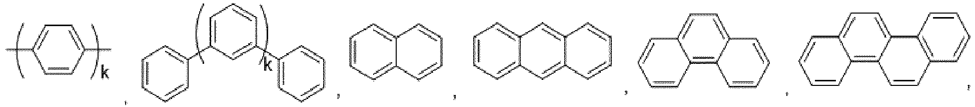 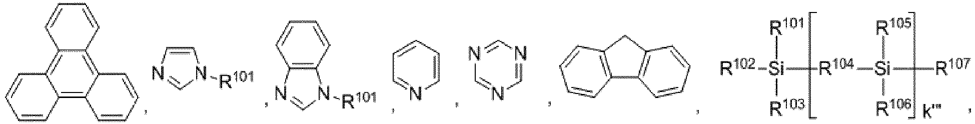 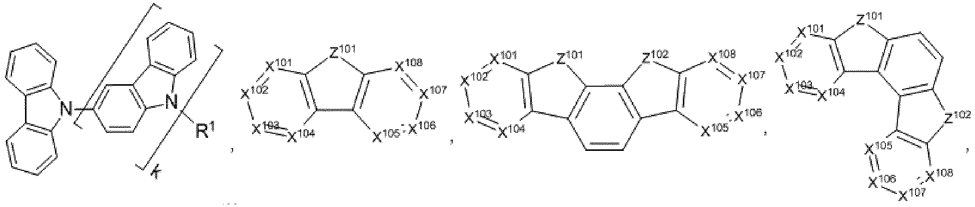 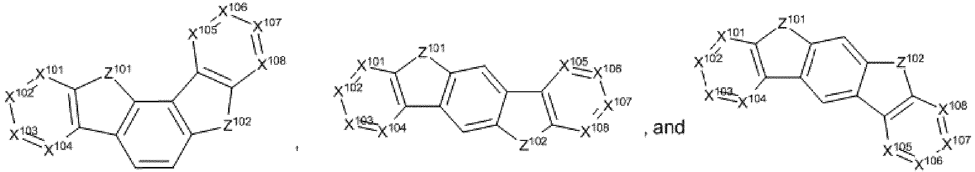 wherein each of R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20; k'" is an integer from 0 to 20. X¹⁰¹ to X¹⁰⁸ is selected from C (including CH) or N. Z¹⁰¹ and Z¹⁰² is selected from NR¹⁰¹, O, or S.
Non-limiting examples of the Host materials that may be used in an OLED in combination with materials disclosed herein are exemplified below together with references that disclose those materials:
EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472.

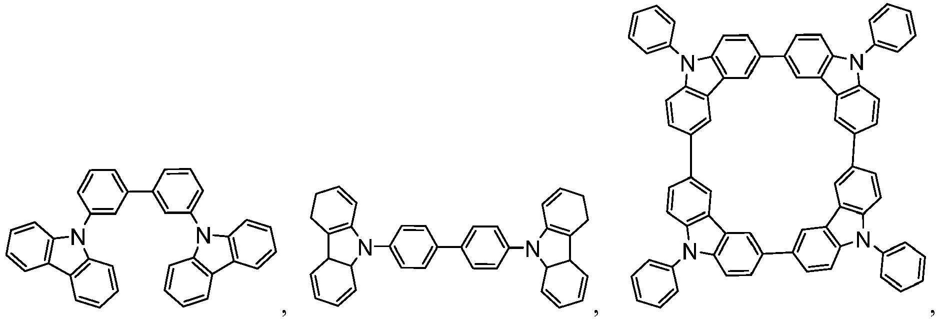

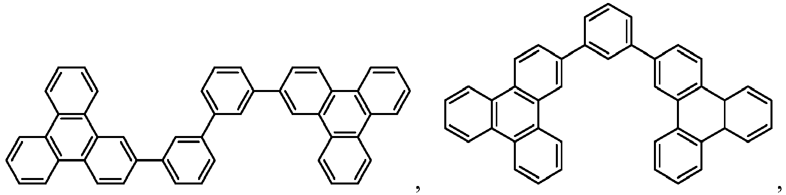

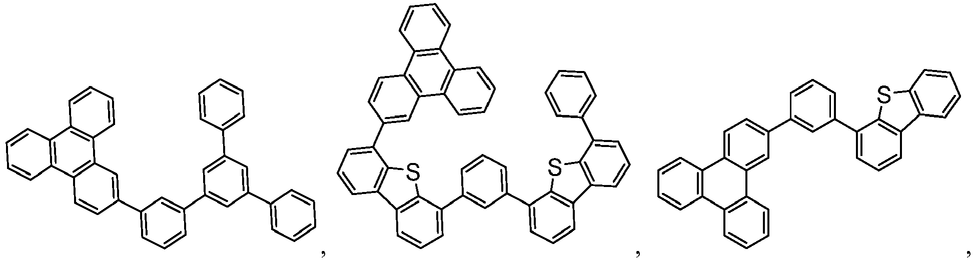

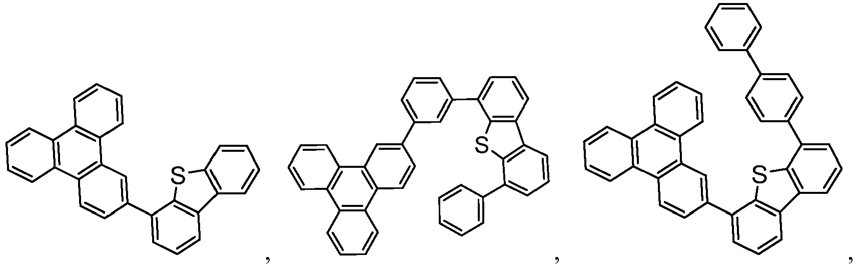

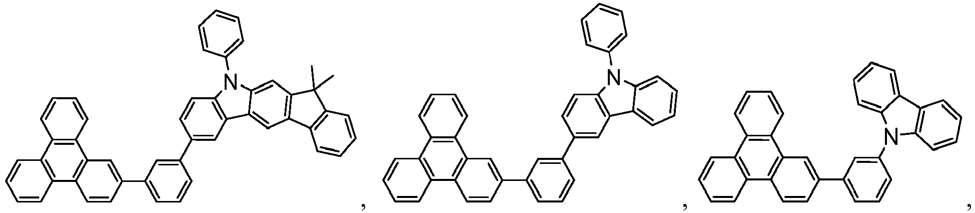

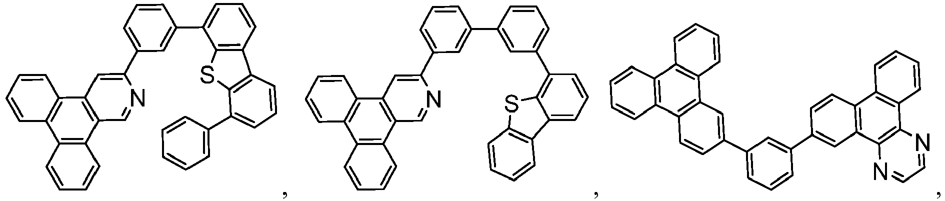

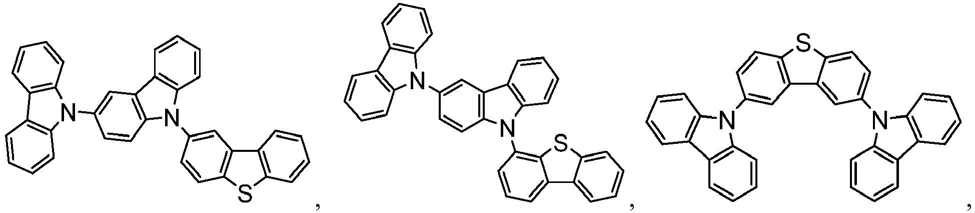

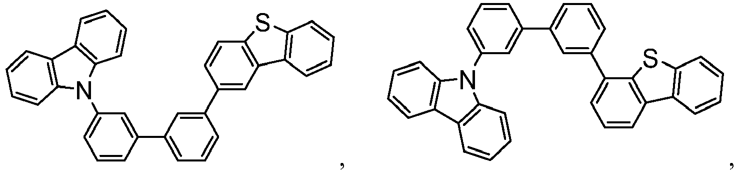

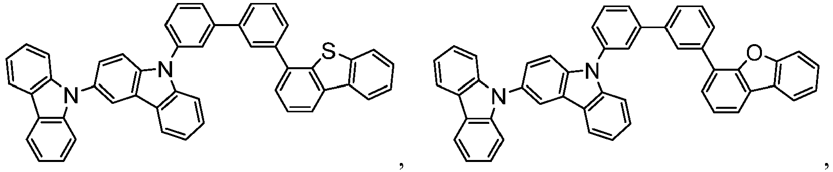

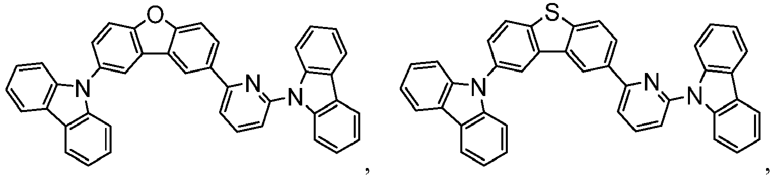

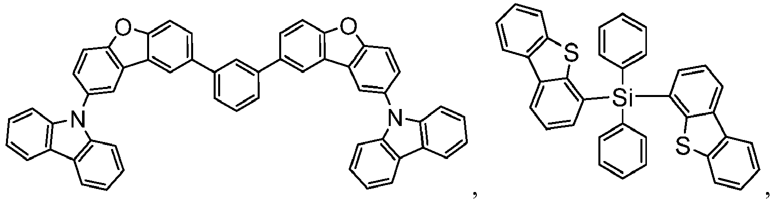

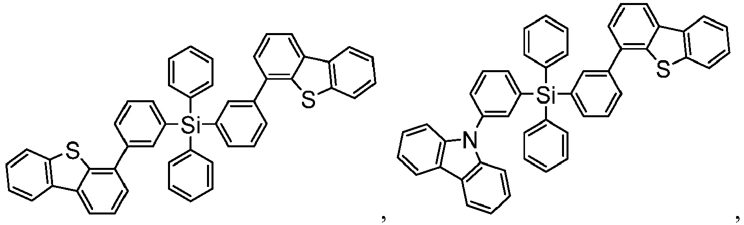

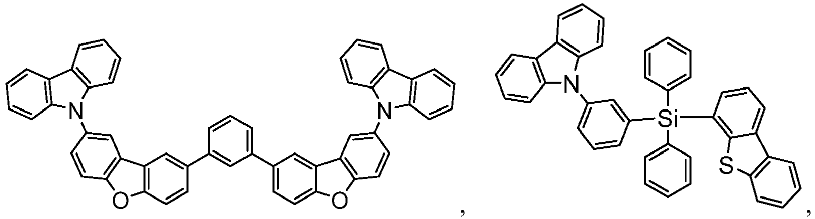

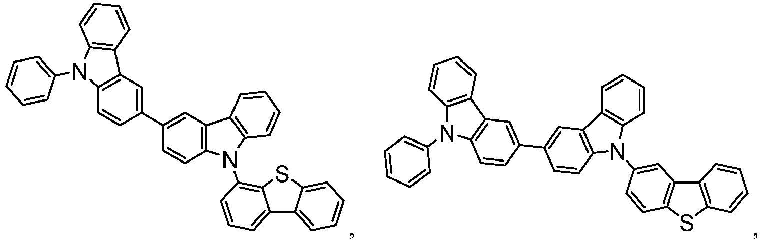

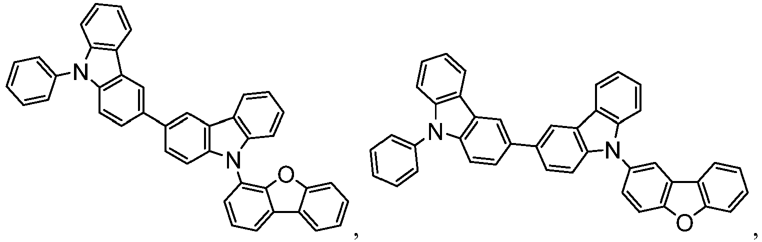

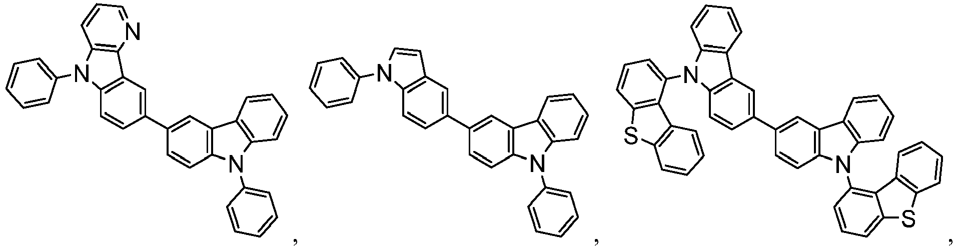

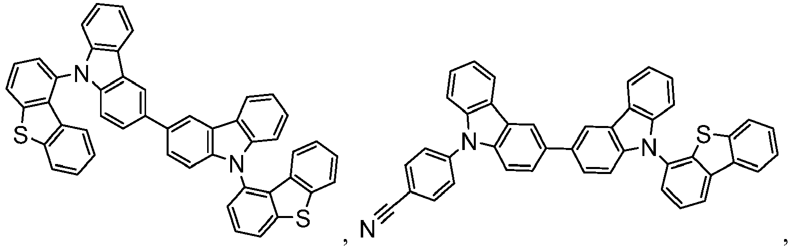

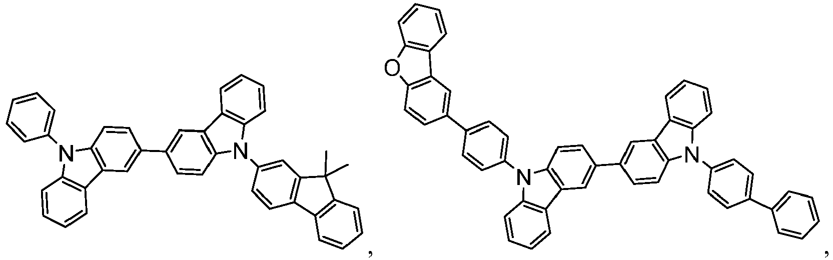

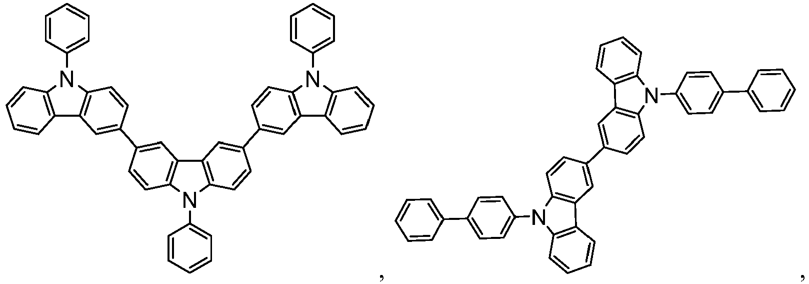

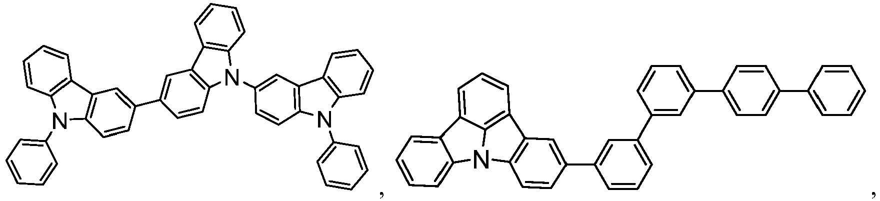

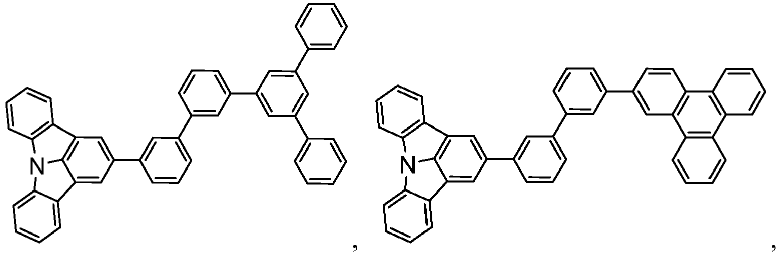

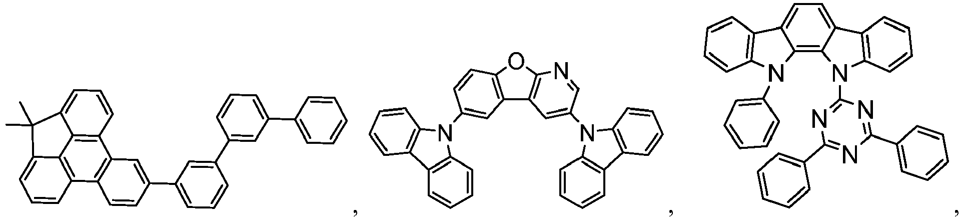

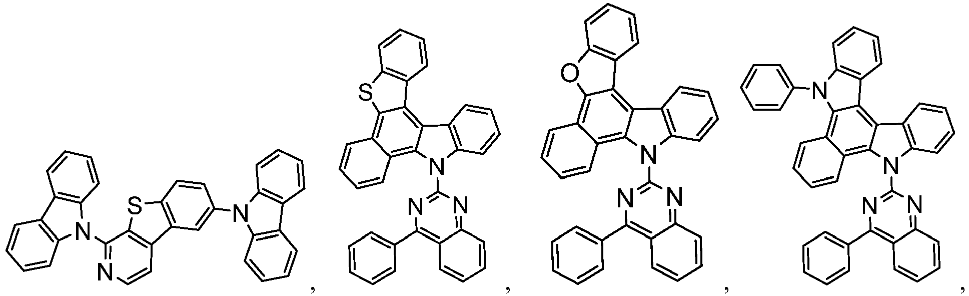

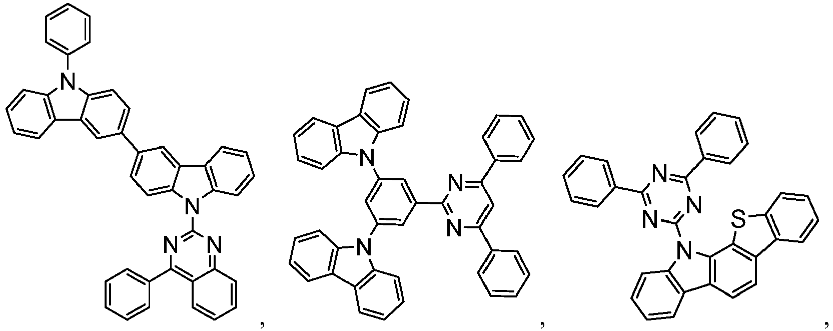

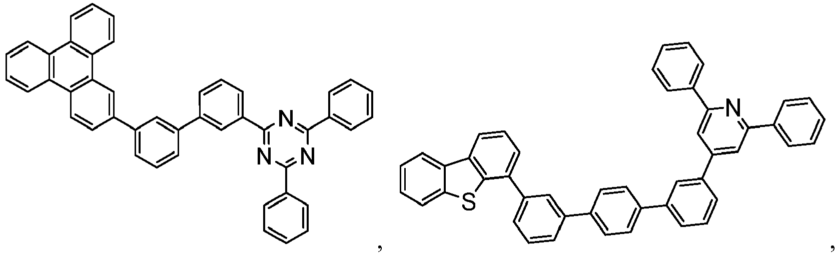

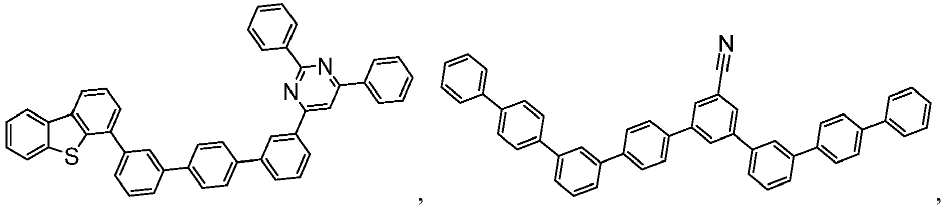

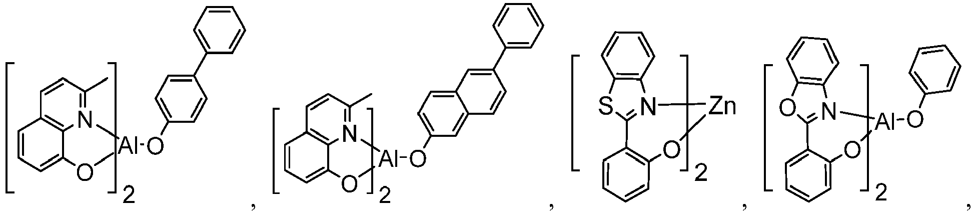

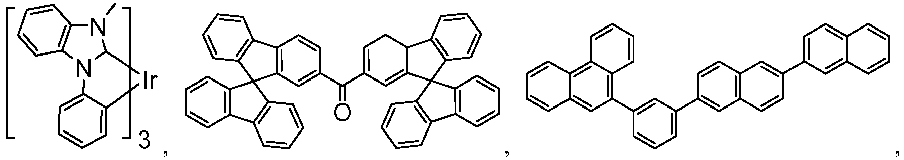

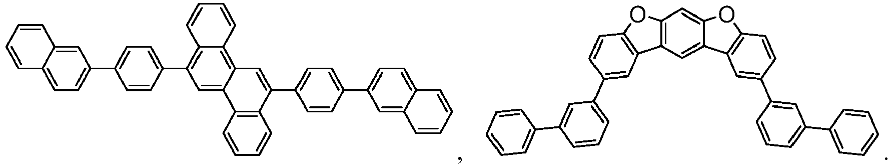

### Emitter:

An emitter example is not particularly limited, and any compound may be used as long as the compound is typically used as an emitter material. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

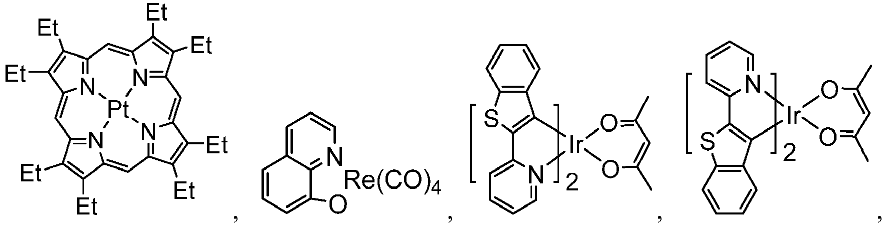

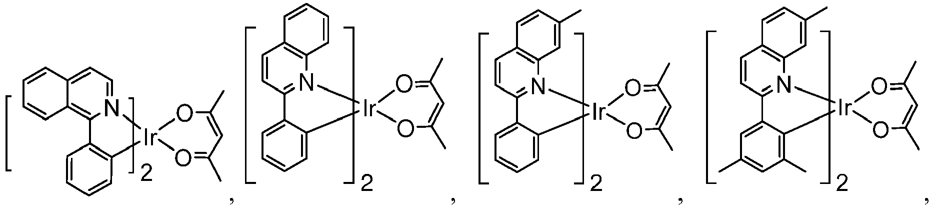

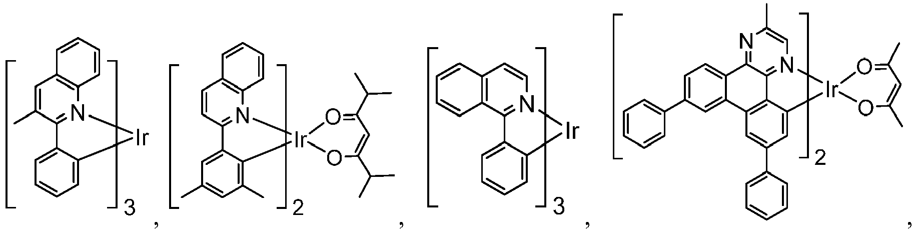

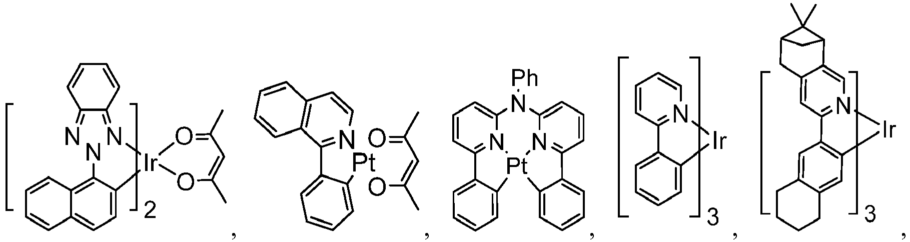

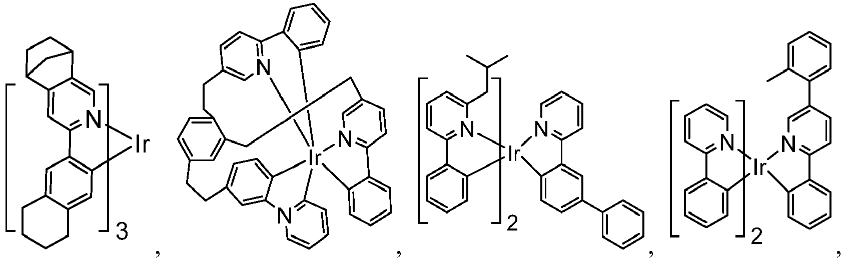

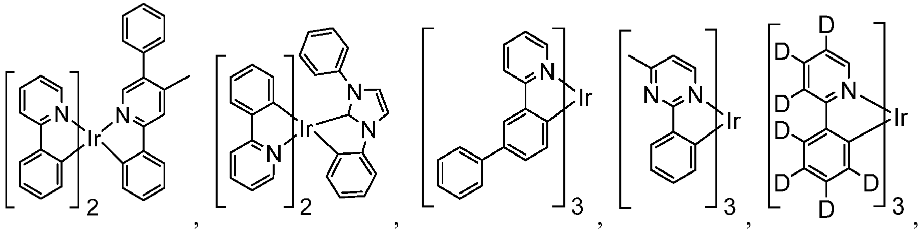

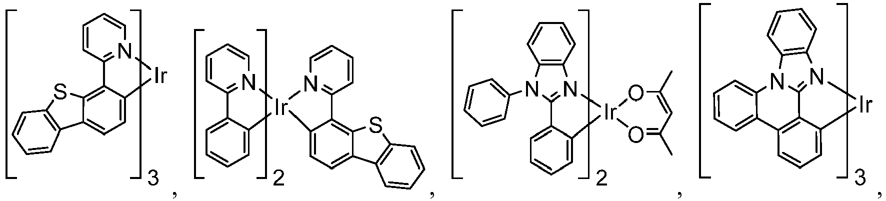

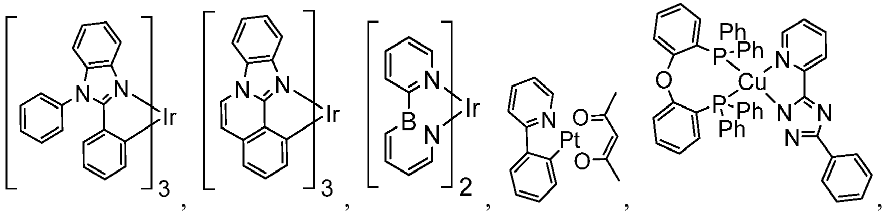

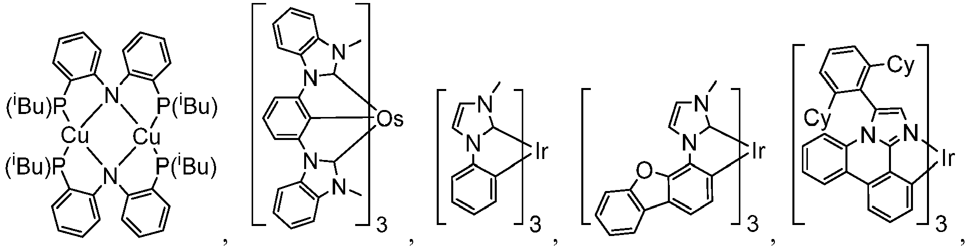

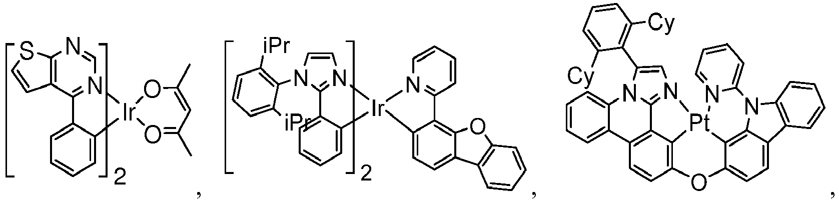

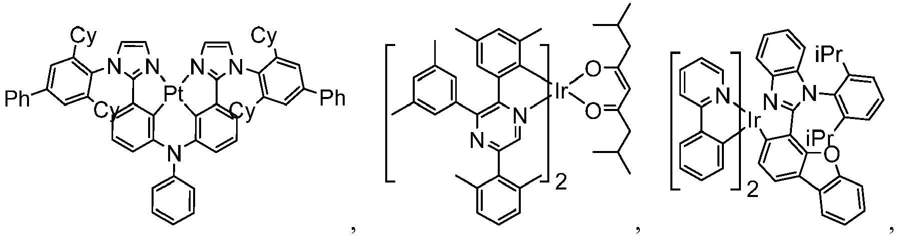

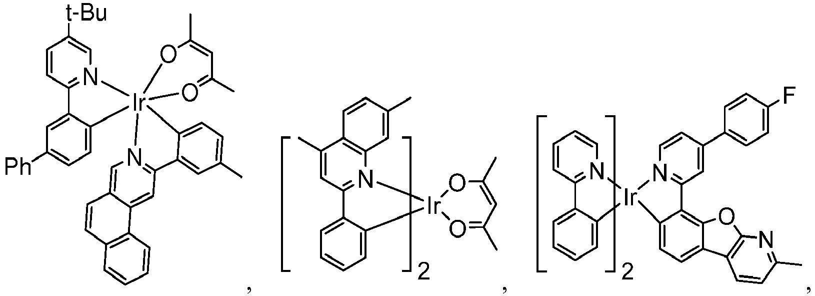

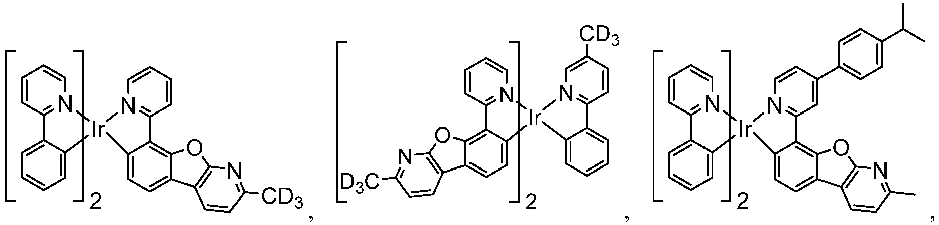

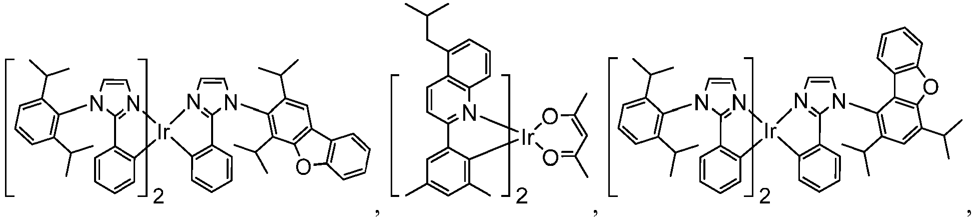

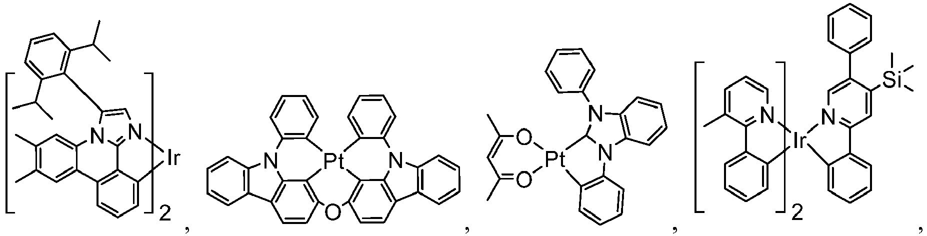

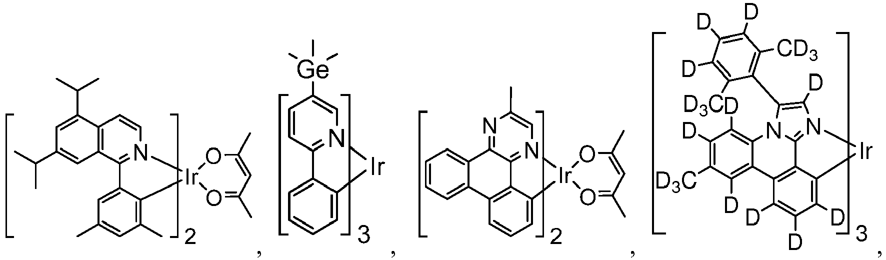

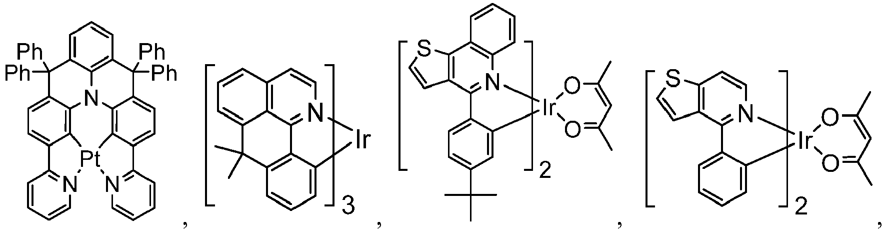

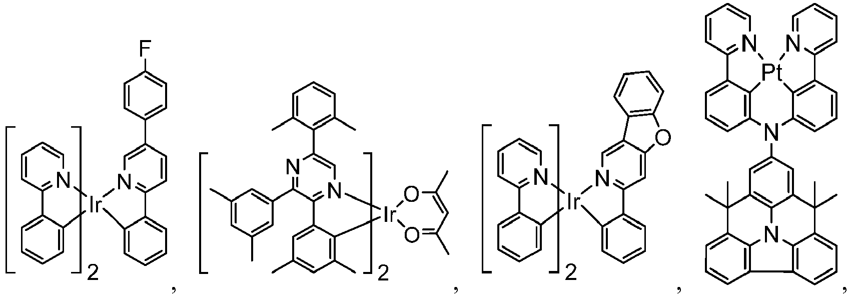

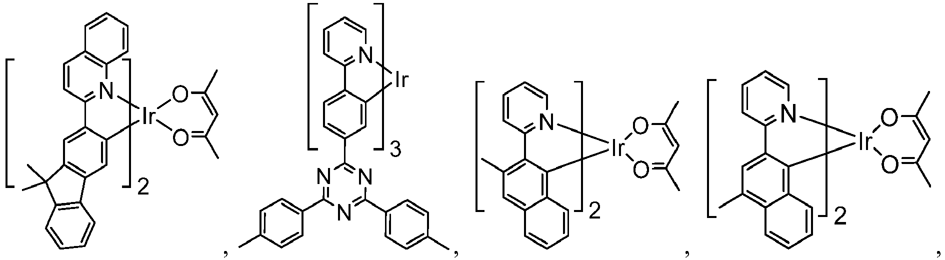

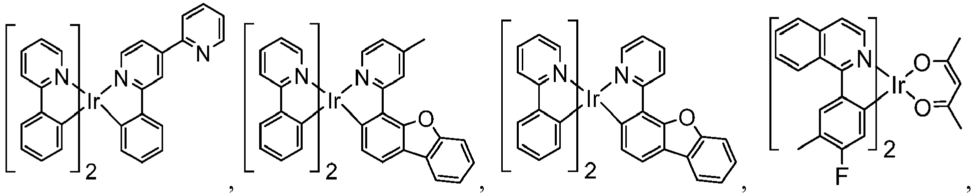

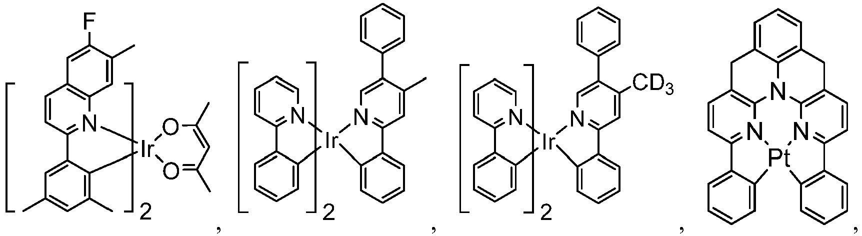

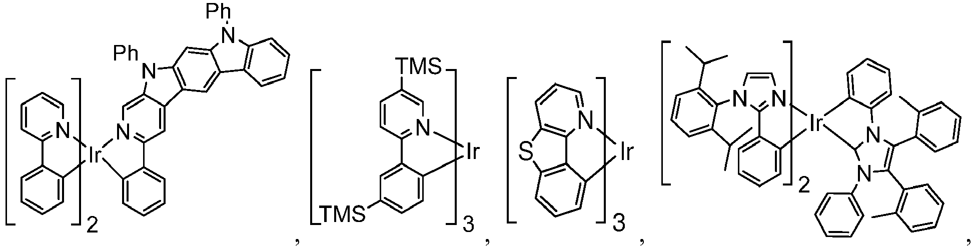

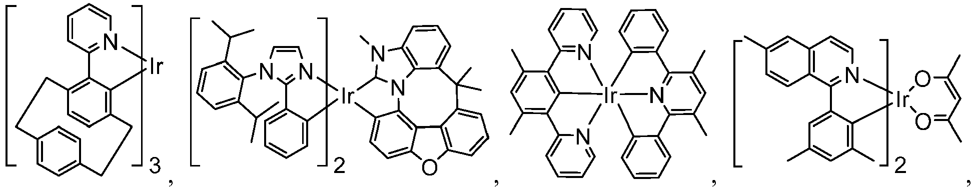

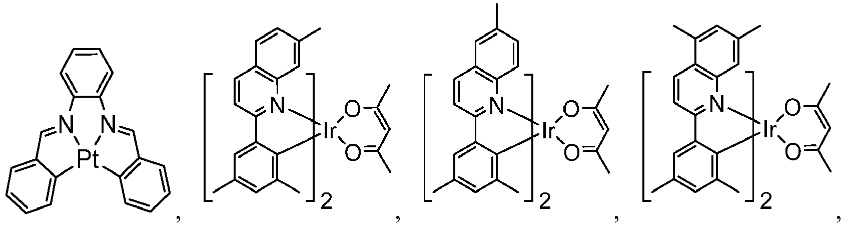

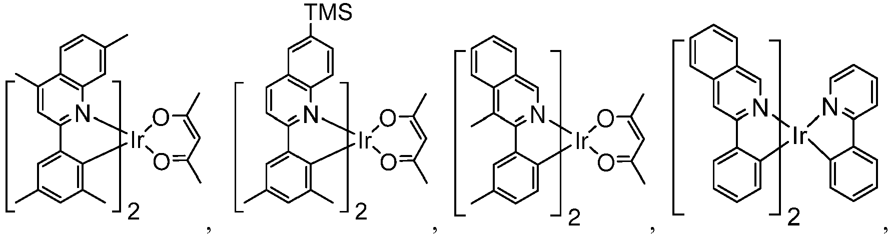

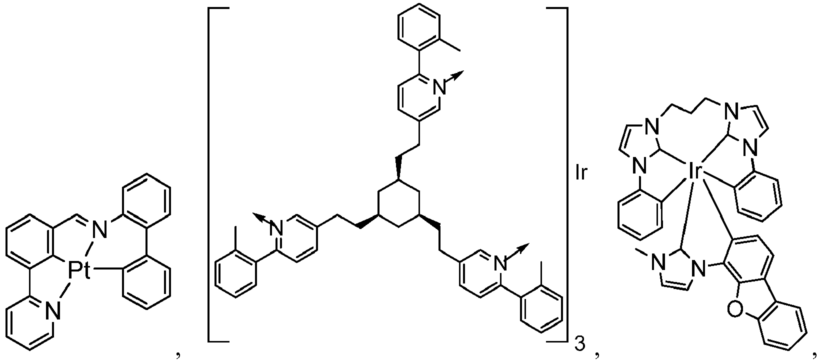

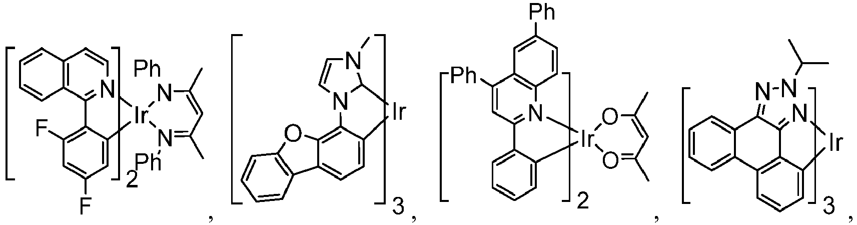

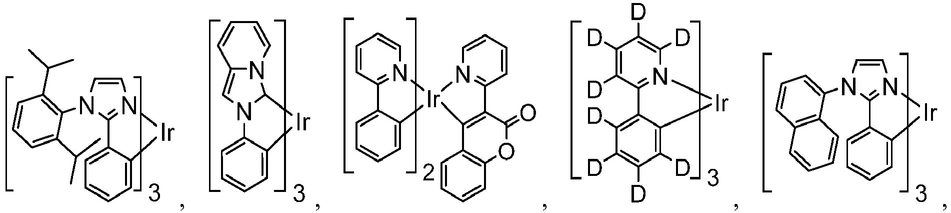

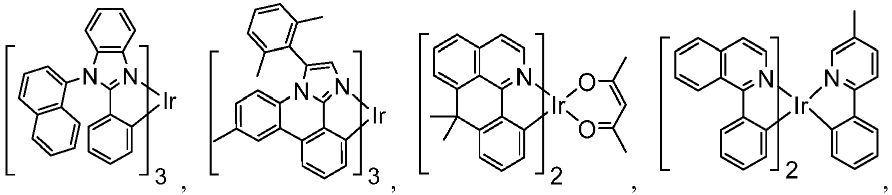

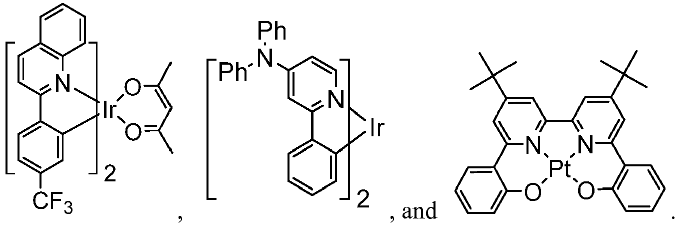

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 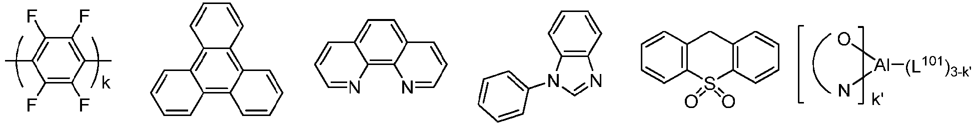 wherein k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 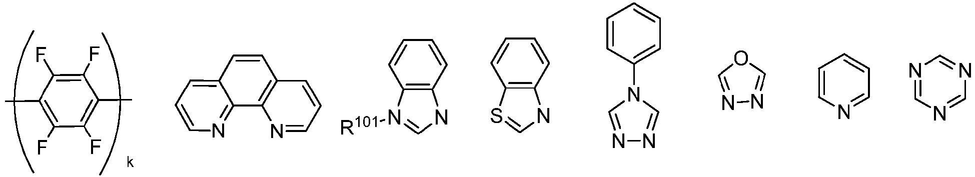 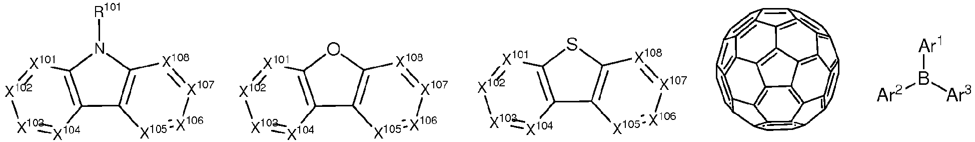 wherein R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 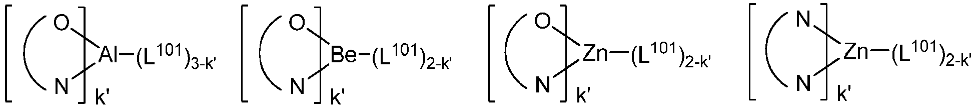 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535.

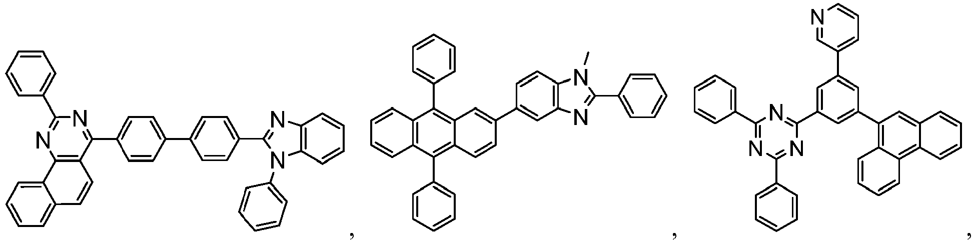

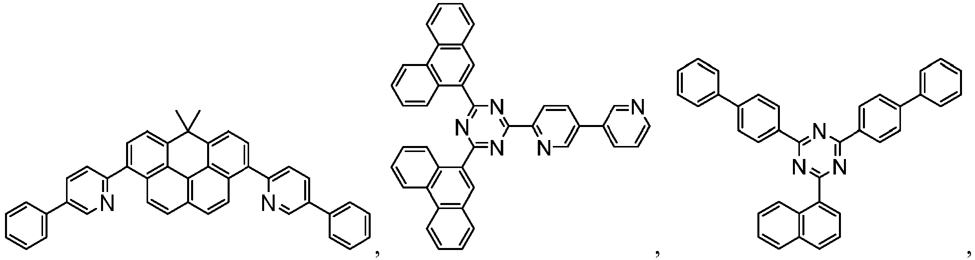

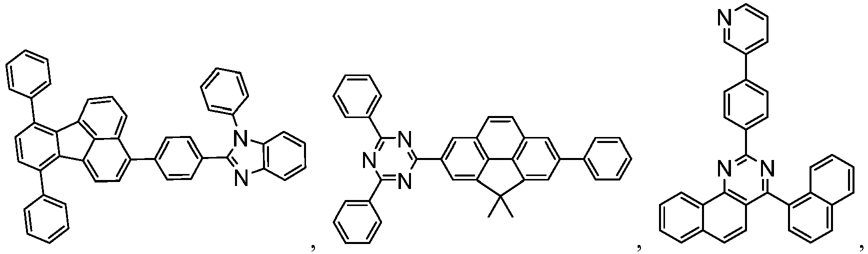

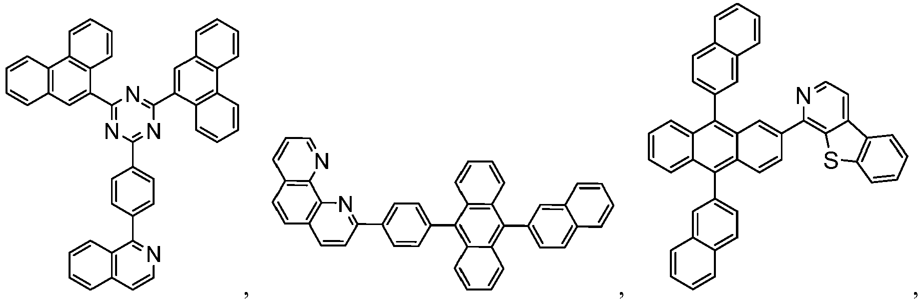

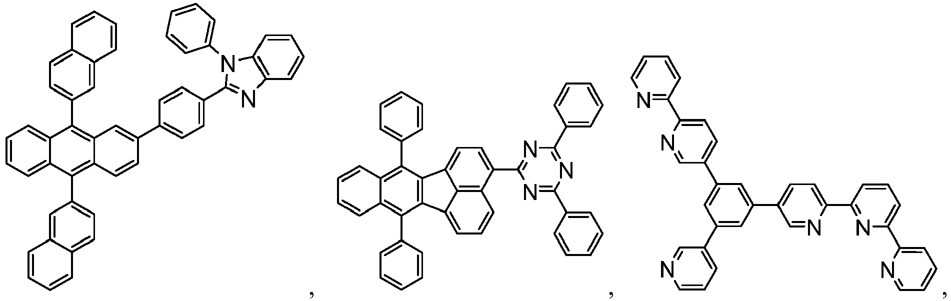

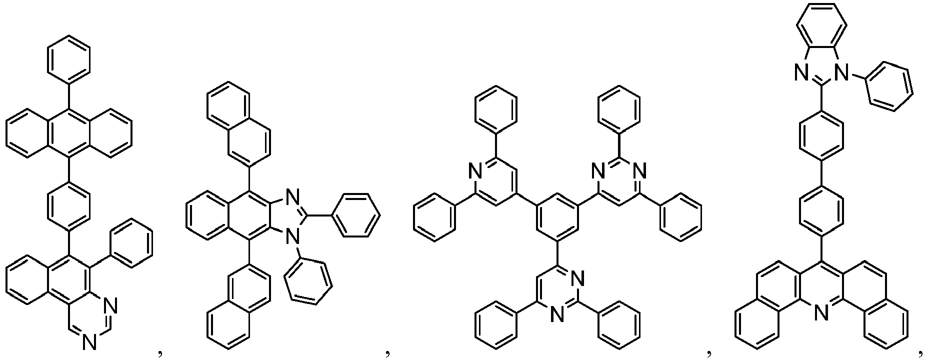

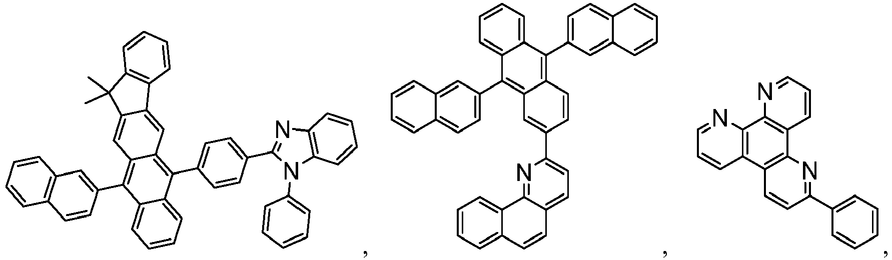

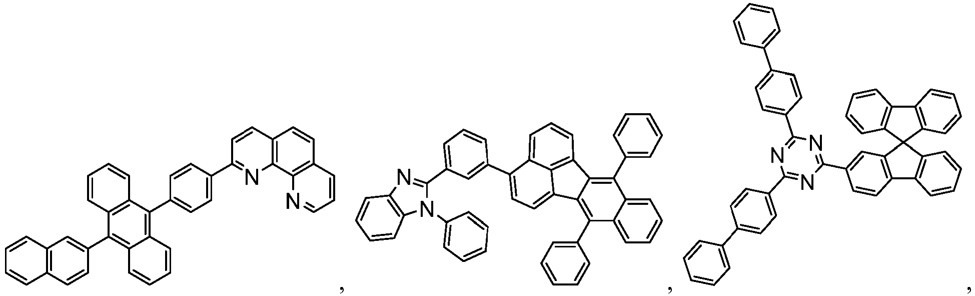

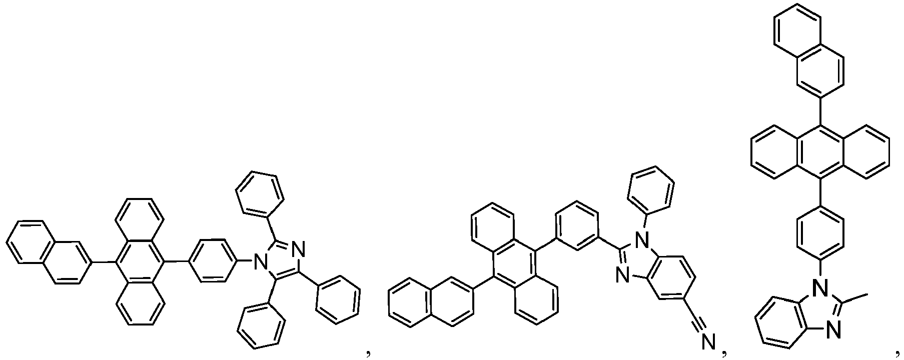

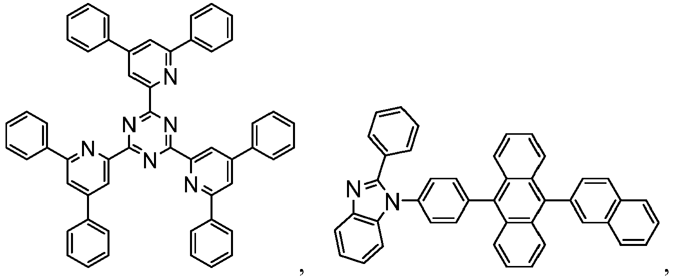

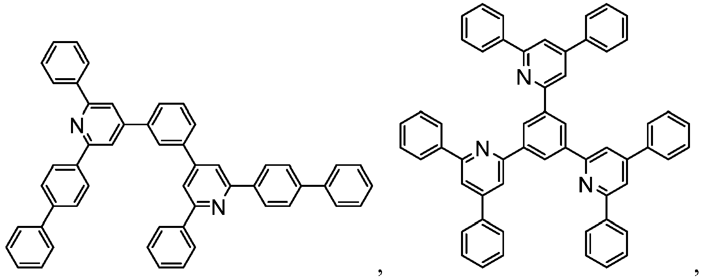

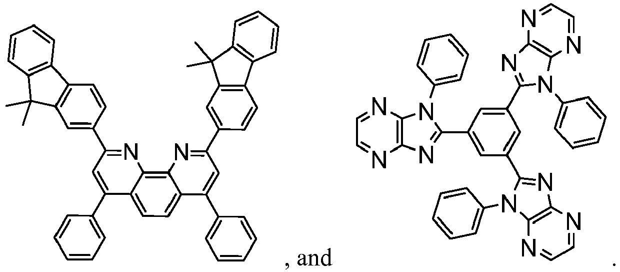

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

### EXPERIMENTAL

### Synthetic Examples

Synthetic scheme to make CAAC carbene ligand precurcor 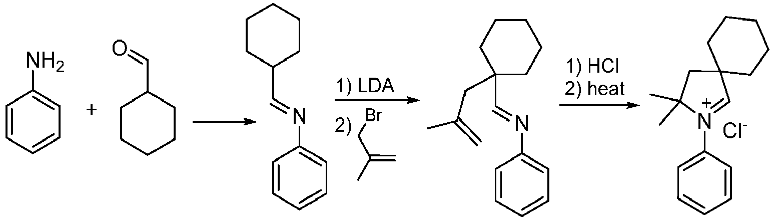 The scheme above shows the synthesis for the CAAC carbene ligand precursor. One of ordinary skill in the art can follow literature procedures to make the above compounds. Detailed procedures of similar compounds can be found from the following publications:
∘ Bertrand, G. et. al. Angew. Chem. Int. Ed. 2005, 44(35), 5705-5709.
∘ Bertrand, G. et. al. J. Org. Chem. 2007, 72, 3492-3499.
∘ Bertrand, G. et. al. Angew. Chem. Int. Ed. 2007, 46(16), 2899-2902.
Metal complexes can be made from the CAAC carbene precursor following literature procedures such as the methods disclosed in US7393599, US7491823, US20090096367, and WO2011051404.

### Calculation results

DFT calculations were performed for certain inventive example compounds and comparative compounds. The results are shown in Table 3 below. Geometry optimization calculations were performed within the Gaussian 09 software package using the B3LYP hybrid functional and CEP-31g effective core potential basis set.

**Table 3. Calculated HOMO, LUMO, and T1 of selected inventive compounds**

| Compound Structure | HOMO (eV) | LUMO (eV) | T1 (nm) |
|---|---|---|---|
| 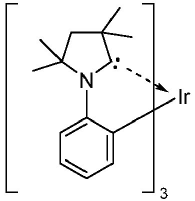 | -5.04 | -0.80 | 425 |
| 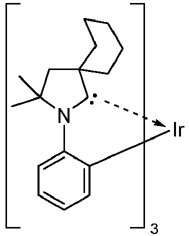 | -4.98 | -0.79 | 429 |
| 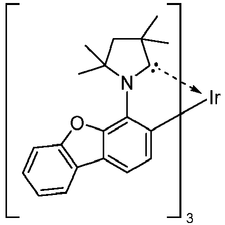 | -5.15 | -1.18 | 466 |
| 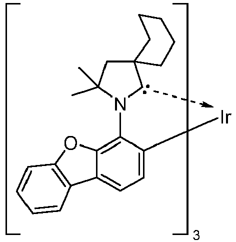 | -5.11 | -1.18 | 468 |
| 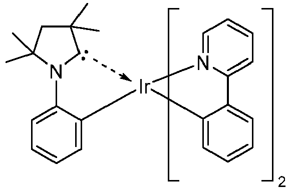 | -5.17 | -1.54 | 487 |
| 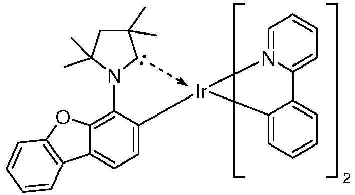 | -5.18 | -1.57 | 484 |
| 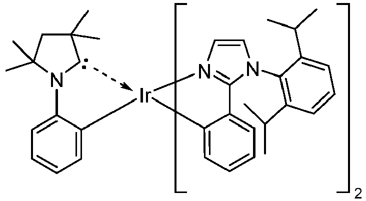 | -4.95 | -0.99 | 452 |
| 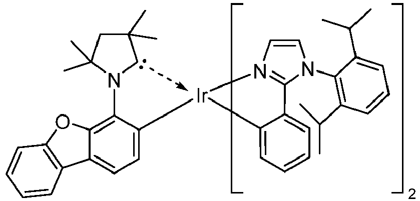 | -4.97 | -1.09 | 484 |
| 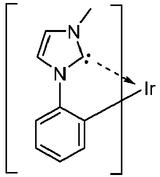 | -4.73 | -0.16 | 391 |
| Comparative Compound 1 | | | |
| 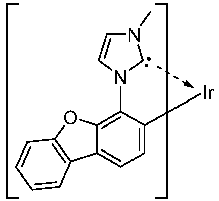 | -4.91 | -0.93 | 450 |
| Comparative Compound 2 | | | |

Table 3 showes the calculation results of the inventive compounds. The HOMO levels are between 4.95 eV to 5.18 eV. It is very suitable for traping holes in a PHOLED device. The triplet energies (T1) were also calculated. As can be seen, the homoleptic tris complexes of these CAAC ligands showed emission in the deep blue to blue range, which provides a novel family of blue phosphorescent compounds. When combined with other ligands such as phenylpyridine or phenylimidazole, the triplet energy can be tuned to emit blue to blue green color, Therefore, this new set of ligands provide very useful tools to achieve different emission colors. Compared to the comparative compounds, the inventive compounds have much deep LUMO, which means that the inventive compounds should be more stable toward electrons. As a result, the inventive compounds should provide more stability to the OLED device.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

Disclosed are:
1. A compound comprising a carbene ligand L_{A} of Formula I: 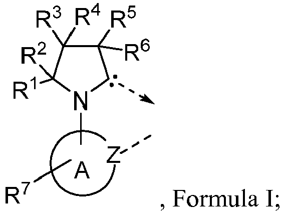 wherein ring A is a 5-membered or 6-membered carbocyclic or heterocyclic ring; wherein Z is nitrogen or carbon; wherein R⁷ represents from mono-substitution to the possible maximum number of substitution, or no substitution; wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; wherein any adjacent substituents of R¹, R², R³, R⁴, R⁵, R⁶, and R⁷ are optionally joined or fused into a ring or a double bond; wherein the ligand L_{A} is coordinated to a metal M through the carbene carbon and Z; and wherein the ligand L_{A} is optionally linked with other ligands to comprise a tridentate, tetradentate, pentadentate or hexadentate ligand.
2. The compound of aspect 1, wherein M is selected from the group consisting of Ir, Rh, Re, Ru, Os, Pt, Au, and Cu.
3. The compound of aspect 1, wherein M is Ir or Pt.
4. The compound of aspect 1, wherein the compound is homoleptic.
5. The compound of aspect 1, wherein the compound is heteroleptic.
6. The compound of aspect 1, wherein ring A is phenyl.
7. The compound of aspect 1, wherein R¹, R², R³, R⁴, R⁵, and R⁶ are independently selected from the group consisting of hydrogen, deuterium, alkyl, cycloalkyl, aryl, heteroaryl, and combinations thereof.
8. The compound of aspect 1, wherein R¹, R², R³, R⁴, R⁵, R⁶, and R⁷ are independently selected from the group consisting of hydrogen, deuterium, alkyl, cycloalkyl, and combinations thereof.
9. The compound of aspect 1, wherein any adjacent substituents of R¹, R², R³, R⁴, R⁵, R⁶, and R⁷ are optionally joined or fused into a non-aromatic ring.
10. The compound of aspect 1, wherein any adjacent substituents of R¹, R², R³, R⁴, R⁵, R⁶, and R⁷ are optionally joined or fused into an aromatic ring.
11. The compound of aspect 1, wherein R¹, R², R⁵, R⁶, and R⁷ are independently selected from the group consisting of alkyl, cycloalkyl, partially or fully deuterated variants thereof, and combinations thereof.
12. The compound of aspect 1, wherein R³, and R⁴ are hydrogen or deuterium.
13. The compound of aspect 1, wherein R¹, R², R³, R⁴, R⁵, R⁶, and R⁷ are independently selected from the group consisting of hydrogen, deuterium, methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, cyclohexyl, phenyl, 2,6-dimethylphenyl, 2,4,6-trimethylphenyl, 2,6-diisopropylphenyl, and combinations thereof.
14. The compound of aspect 1, wherein the ligand L_{A} has the structure: 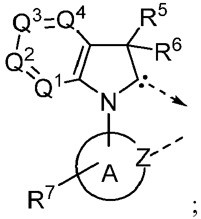 wherein Q¹, Q², Q³, and Q⁴ are each independently selected from the group consisting of N and CR; and wherein each R is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.
15. The compound of aspect 1, wherein the ligand L_{A} is L_{Ai} selected from the group consisting of L_{A1} to L_{A534}, wherein substituents R¹, R², R³, R⁴, R⁵, R⁶, and ring A in L_{A*i*} for *i* = 1 to 198 are as defined in Table 1 herein above and for *i* = 199 to 534 L_{A*i*} has the structure 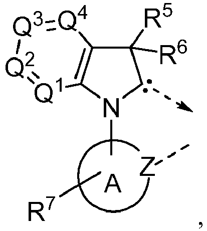 where substituents Q¹, Q², Q³, Q⁴, R⁵, R⁶, and ring A are as defined in Table 2 herein above.
16. The compound of aspect 1, wherein the ligand L_{A} is selected from the group consisting of: 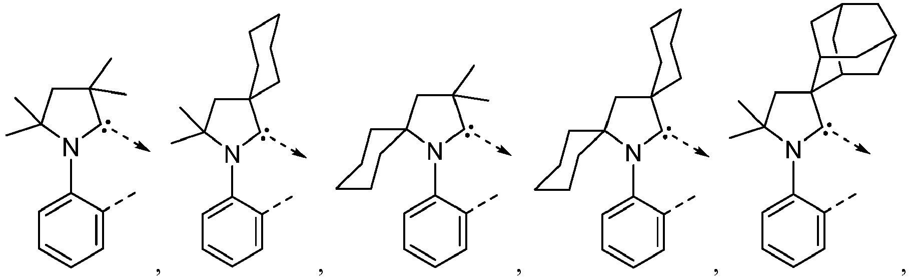 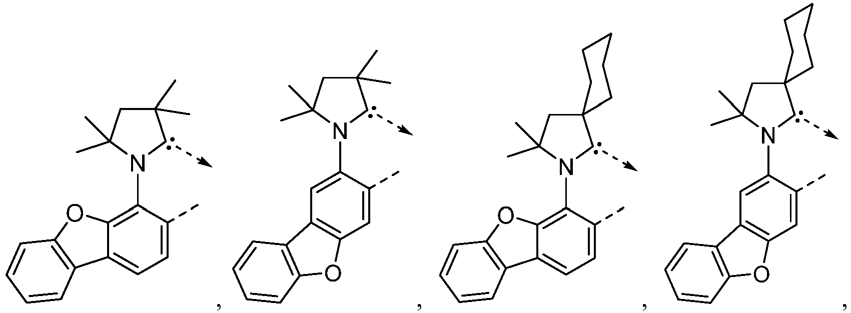 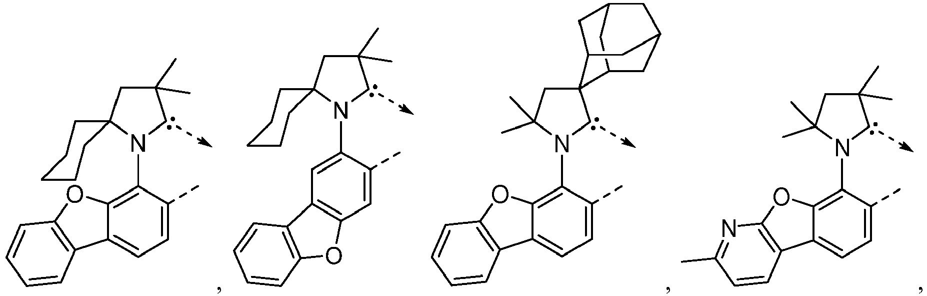 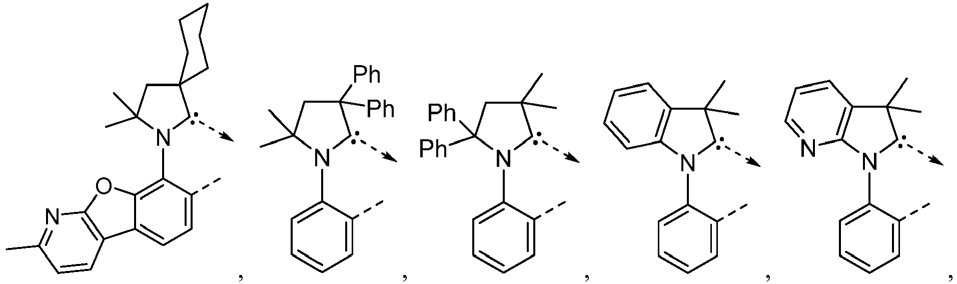 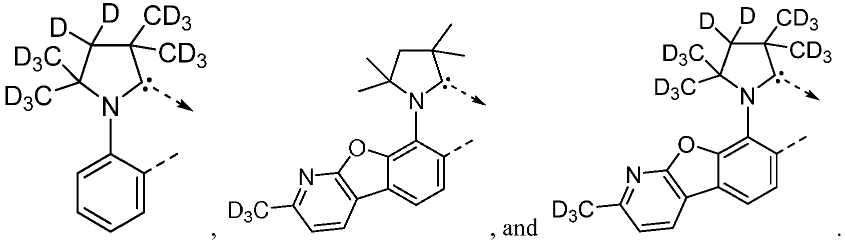
17. The compound of aspect 1, wherein the compound has a formula M(L_{A})ₙ(L_{B})ₘ₋ₙ; wherein M is Ir or Pt; wherein L_{B} is a bidentate ligand; wherein, when M is Ir, m is 3, and n is 1, 2, or 3; and wherein, when M is Pt, m is 2, and n is 1, or 2.
18. The compound of aspect 17, wherein the compound has a formula of Ir(L_{A})₃.
19. The compound of aspect 17, wherein the compound has a formula of Ir(L_{A})(L_{B})₂; and wherein L_{B} is different from L_{A}.
20. The compound of aspect 17, wherein the compound has a formula of Ir(L_{A})₂(L_{B}); and wherein L_{B} is different from L_{A}.
21. The compound of aspect 15, wherein the compound has a formula of Ir(L_{A})(L_{B})₂ or Ir(L_{A})₂(L_{B}); wherein L_{B} is different from L_{A}; and wherein L_{A} and L_{B} are independently selected from the group consisting of L_{A1} to L_{A534};.
22. The compound of aspect 17, wherein the compound has a formula of Pt(L_{A})(L_{B}); and wherein L_{A} and L_{B} can be same or different.
23. The compound of aspect 22, wherein L_{A} and L_{B} are connected to form a tetradentate ligand.
24. The compound of aspect 22, wherein L_{A} and L_{B} are connected at two places to form a marcrocyclic tetradentate ligand.
25. The compound of aspect 17, wherein L_{B} is selected from the group consisting of: 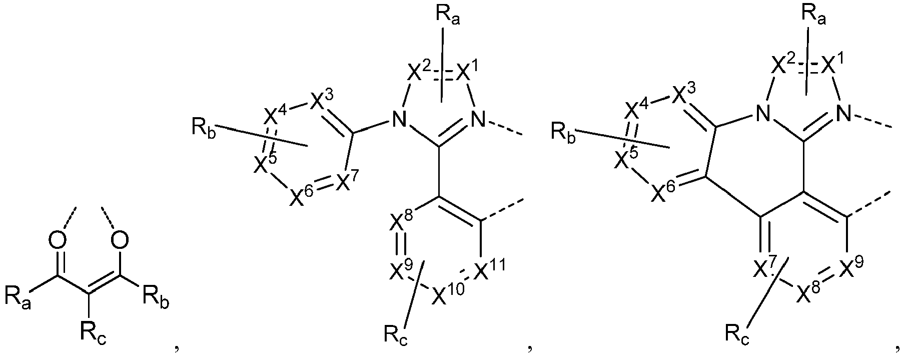 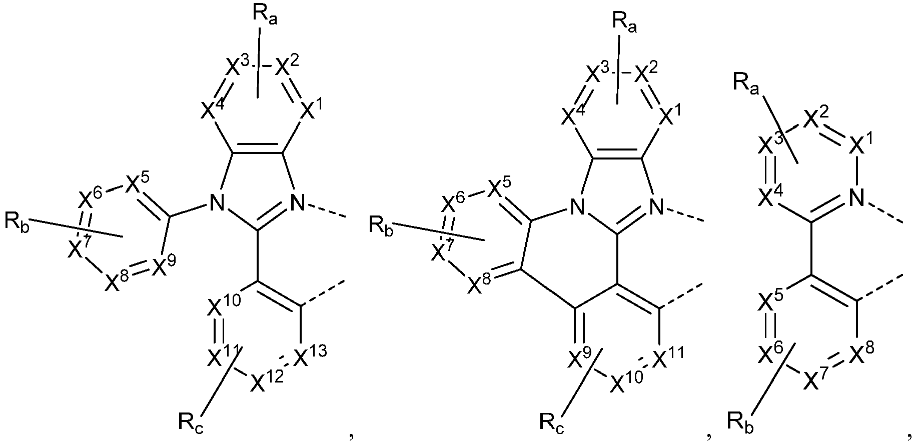 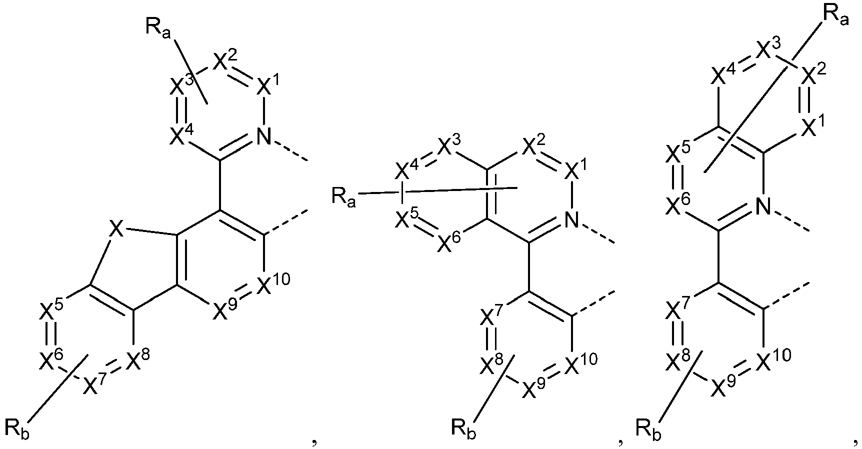 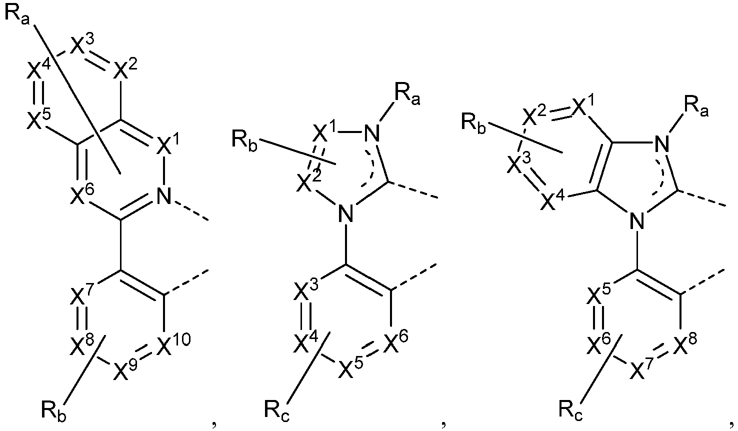 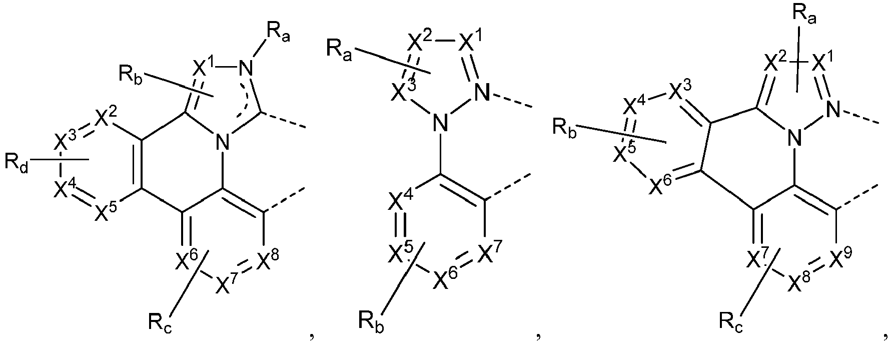 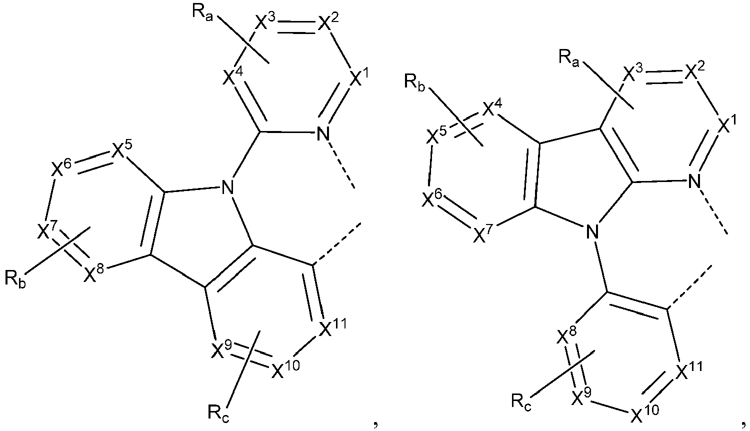 and 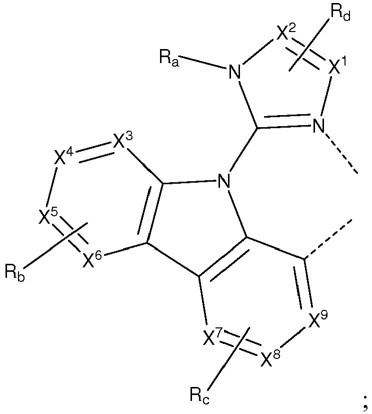 wherein each X¹ to X¹³ are independently selected from the group consisting of carbon and nitrogen; wherein X is selected from the group consisting of BR', NR', PR', O, S, Se, C=O, S=O, SO₂, CR'R", SiR'R", and GeR'R"; wherein R' and R" are optionally fused or joined to form a ring; wherein each Rₐ, R_{b}, R_{c}, and R_{d} may represent from mono substitution to the possible maximum number of substitution, or no substitution; wherein R', R", Rₐ, R_{b}, R_{c}, and R_{d} are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein any two adjacent substitutents of Rₐ, R_{b}, R_{c}, and R_{d} are optionally fused or joined to form a ring or form a multidentate ligand.
26. The compound of aspect 17, wherein L_{B} is another carbene ligand.
27. The compound of aspect 17, wherein L_{B} is selected from the group consisting of L₁ to L_{B68} as described herein above.
28. The compound of aspect 15, wherein the compound is selected from the group consisting of Compound A1 through Compound A534; wherein each Compound A*x* has the formula Ir(L_{A*i*})₃; and wherein *x* = *i; i* is an integer from 1 to 534.
29. The compound of aspect 15, wherein the compound is selected from the group consisting of Compound B1 through Compound B36,312 and Compound C1 through Compound C36,312; wherein, for Compound B1 through Compound B36,312, each Compound B*y* has the formula Ir(L_{A*i*})(L_{B*j*})₂, wherein *y* = 534*j* + *i* - 533 *i* is an integer from 1 to 534, and *j* is an integer from 1 to 68; wherein, for Compound C1 through Compound C36,312, each Compound Cz has the formula Ir(L_{A*i*})₂(L_{B*j*}), wherein *z* = 534*j* + *i*+533; *i* is an integer from 1 to 534, and *j* is an integer from 1 to 68; and wherein L_{B} is selected from the group consisting of L_{B1} to L_{B68} as described herein before.
30. A first organic light emitting device comprising: an anode; a cathode; and an organic layer, disposed between the anode and the cathode, comprising a compound comprising a carbene ligand L_{A} of Formula I: 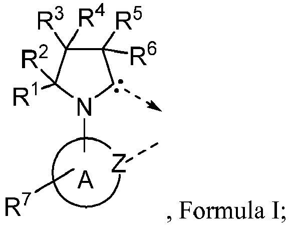 wherein ring A is a 5-membered or 6-membered carbocyclic or heterocyclic ring; wherein Z is nitrogen or carbon; wherein R⁷ represents from mono-substitution to the possible maximum number of substitution, or no substitution; wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; wherein any adjacent substituents of R¹, R², R³, R⁴, R⁵, R⁶, and R⁷ are optionally joined or fused into a ring or a double bond; wherein the ligand L_{A} is coordinated to a metal M through the carbene carbon and Z; and wherein the ligand L_{A} is optionally linked with other ligands to comprise a tridentate, tetradentate, pentadentate or hexadentate ligand.
31. The first organic light emitting device of aspect 30, wherein the first organic light emitting device is incorporated into a device selected from the group consisting of a consumer product, an electronic component module, an organic light-emitting device, and a lighting panel.
32. The first organic light emitting device of aspect 30, wherein the organic layer is an emissive layer and the compound is an emissive dopant or a non-emissive dopant.
33. The first organic light emitting device of aspect 30, wherein the organic layer is a charge transporting layer and the compound is a charge transporting material in the organic layer.
34. The first organic light emitting device of aspect 30, wherein the organic layer is a blocking layer and the compound is a blocking material in the organic layer.
35. The first organic light emitting device of aspect 30, wherein the organic layer further comprises a host, wherein the host comprises a triphenylene containing benzo-fused thiophene or benzo-fused furan; wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C=CCₙH₂ₙ₊₁, Ar₁, Ar₁-Ar₂, CₙH₂ₙ-Ar₁, or no substitution; wherein n is from 1 to 10; and wherein Ar₁ and Ar₂ are independently selected from the group consisting of benzene, biphenyl, naphthalene, triphenylene, carbazole, and heteroaromatic analogs thereof.
36. The first organic light emitting device of aspect 30, wherein the organic layer further comprises a host, wherein the host comprises at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene.
37. The first organic light emitting device of aspect 30, wherein the organic layer further comprises a host and the host is selected from the group consisting of: 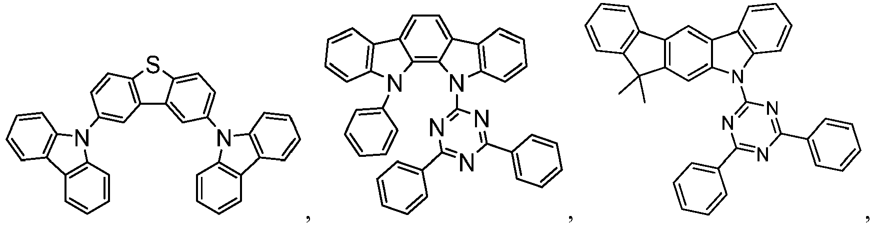 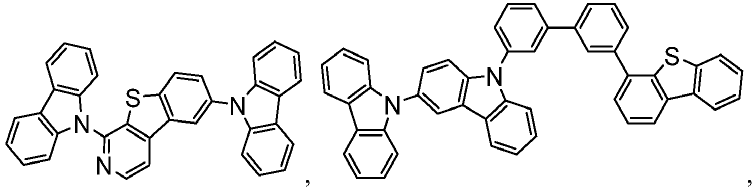 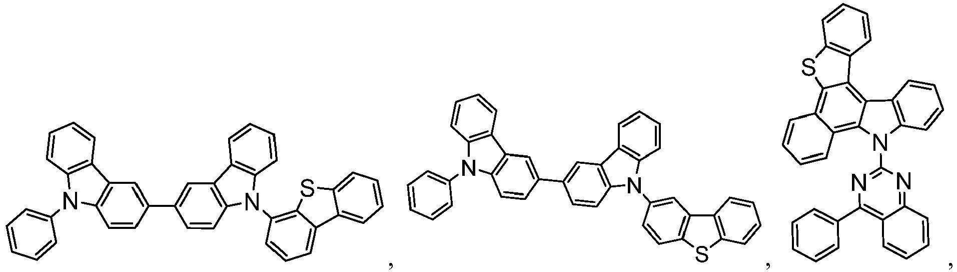 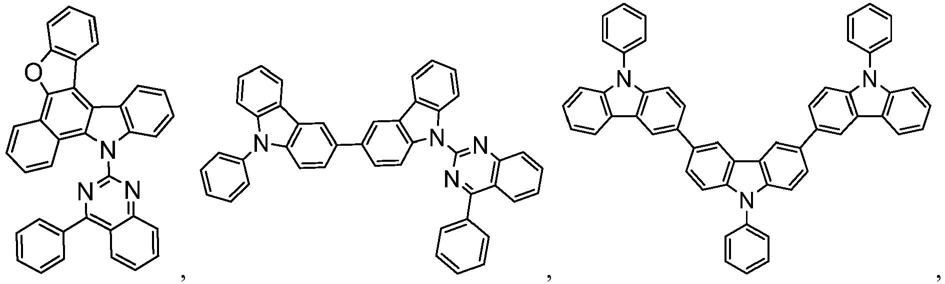 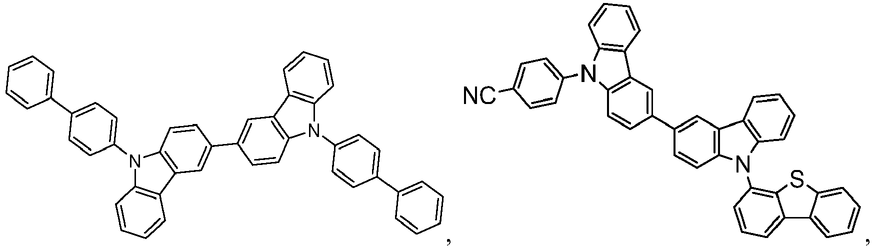 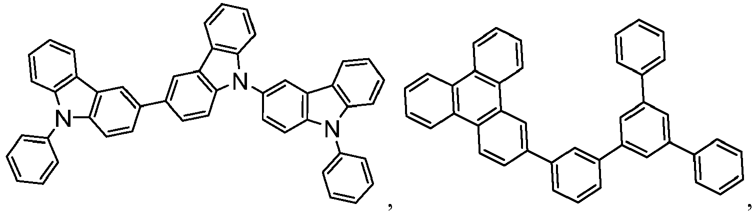 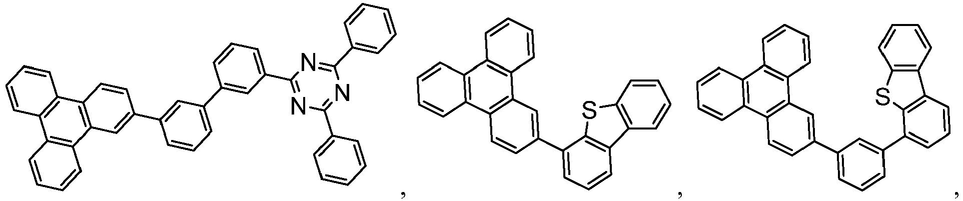 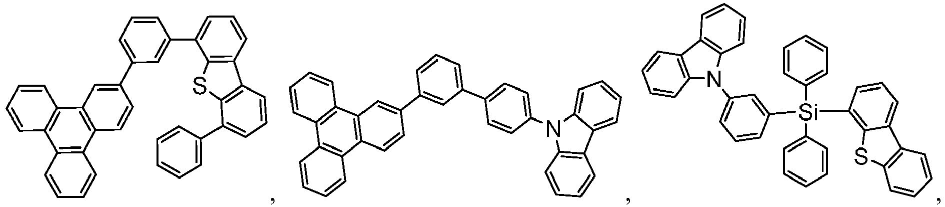 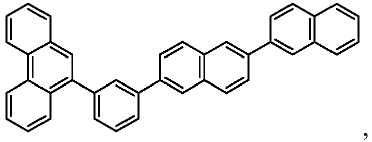 and combinations thereof.
38. The first organic light emitting device of aspect 30, wherein the organic layer further comprises a host and the host comprises a metal complex.
39. A formulation comprising a compound comprising a carbene ligand L_{A} of Formula I: 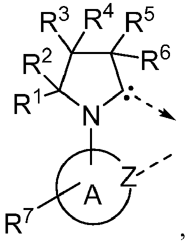 Formula I; wherein ring A is a 5-membered or 6-membered carbocyclic or heterocyclic ring; wherein Z is nitrogen or carbon; wherein R⁷ represents from mono-substitution to the possible maximum number of substitution, or no substitution; wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; wherein any adjacent substituents of R¹, R², R³, R⁴, R⁵, R⁶, and R⁷ are optionally joined or fused into a ring or a double bond; wherein the ligand L_{A} is coordinated to a metal M through the carbene carbon and Z; and wherein the ligand L_{A} is optionally linked with other ligands to comprise a tridentate, tetradentate, pentadentate or hexadentate ligand.

## Claims

1. A compound comprising a carbene ligand L_{A} of Formula I: 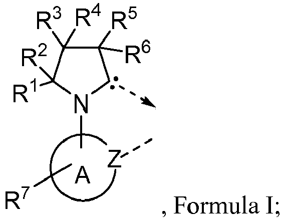
wherein ring A is a 5-membered or 6-membered carbocyclic or heterocyclic ring;
wherein Z is nitrogen or carbon;
wherein R⁷ represents from mono-substitution to the possible maximum number of substitution, or no substitution;
wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein any adjacent substituents of R¹, R², R³, R⁴, R⁵, R⁶, and R⁷ are optionally joined or fused into a ring or a double bond;
wherein the ligand L_{A} is coordinated to a metal M through the carbene carbon and Z; and
wherein the ligand L_{A} is optionally linked with other ligands to comprise a tridentate, tetradentate, pentadentate or hexadentate ligand. except 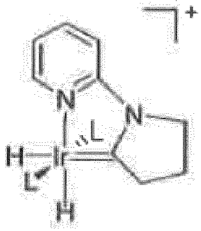 wherein L is PPh₃.

2. The compound of claim 1, wherein M is selected from the group consisting of Ir, Rh, Re, Ru, Os, Pt, Au, and Cu.

3. The compound of claim 1 or 2, wherein ring A is phenyl.

4. The compound of any one of claims 1 to 3, wherein R¹, R², R³, R⁴, R⁵, and R⁶ are independently selected from the group consisting of hydrogen, deuterium, alkyl, cycloalkyl, aryl, heteroaryl, and combinations thereof.

5. The compound of any one of claims 1 to 4, wherein any adjacent substituents of R¹, R², R³, R⁴, R⁵, R⁶, and R⁷ are optionally joined or fused into a non-aromatic ring.

6. The compound of any one of claims 1 to 4, wherein any adjacent substituents of R^{I}, R², R³, R⁴, R⁵, R⁶, and R⁷ are optionally joined or fused into an aromatic ring.

7. The compound of any one of claims 1 to 4, wherein R³, and R⁴ are hydrogen or deuterium.

8. The compound of Claim 1, wherein the ligand L_{A} has the structure: 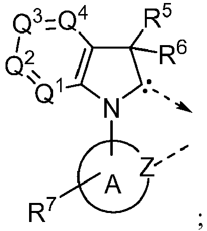
wherein Q¹, Q², Q³, and Q⁴ are each independently selected from the group consisting of N and CR; and
wherein each R is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

9. The compound of claim 1, wherein the ligand L_{A} is L_{Ai} selected from the group consisting of L_{A1} to L_{A534},
wherein substituents R¹, R², R³, R⁴, R⁵, R⁶, and ring A in L_{A*i*} for *i* = 1 to 198 are as defined in Table 1 below:
**Table 1**
| *i* | R¹ | R² | R³ | R⁴ | R⁵ | R⁶ | Ring A |
|---|---|---|---|---|---|---|---|
| 1 | CH₃ | CH₃ | H | H | CH₃ | CH₃ | 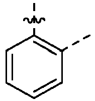 |
| 2 | CH₃ | CH₃ | H | H | CH₃ | CH₃ | 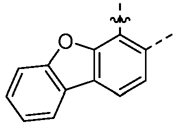 |
| 3 | CH₃ | CH₃ | H | H | CH₃ | CH₃ | 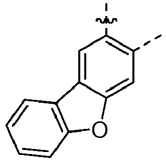 |
| 4 | CH₃ | CH₃ | H | H | CH₃ | CH₃ | 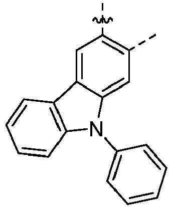 |
| 5 | CH₃ | CH₃ | H | H | CH₃ | CH₃ | 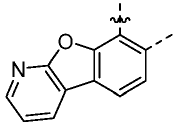 |
| 6 | CH₃ | CH₃ | H | H | CH₃ | CH₃ | 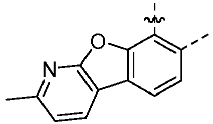 |
| 7 | CH₃ | CH₃ | H | H | CH₃ | CH₃ | 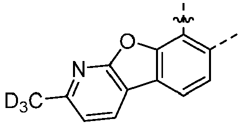 |
| 8 | CH₃ | CH₃ | H | H | CH₃ | CH₃ | 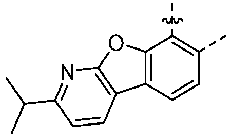 |
| 9 | CH₃ | CH₃ | H | H | CH₃ | CH₃ | 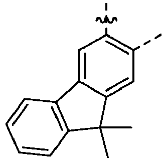 |
| 10 | CH₃ | CH₃ | H | H | CH₃ | CH₂CH₃ | 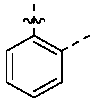 |
| 11 | CH₃ | CH₃ | H | H | CH₃ | CH₂CH₃ | 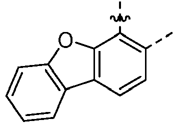 |
| 12 | CH₃ | CH₃ | H | H | CH₃ | CH₂CH₃ | 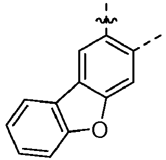 |
| 13 | CH₃ | CH₃ | H | H | CH₃ | CH₂CH₃ | 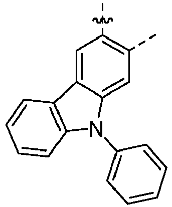 |
| 14 | CH₃ | CH₃ | H | H | CH₃ | CH₂CH₃ | 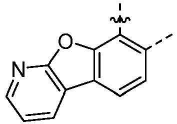 |
| 15 | CH₃ | CH₃ | H | H | CH₃ | CH₂CH₃ | 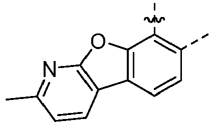 |
| 16 | CH₃ | CH₃ | H | H | CH₃ | CH₂CH₃ | 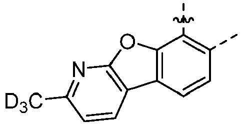 |
| 17 | CH₃ | CH₃ | H | H | CH₃ | CH₂CH₃ | 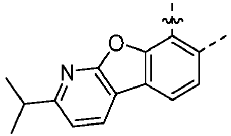 |
| 18 | CH₃ | CH₃ | H | H | CH₃ | CH₂CH₃ | 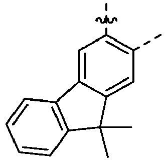 |
| 19 | CH₃ | CH₃ | H | H | CH₃ | CH(CH₃)₂ | 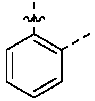 |
| 20 | CH₃ | CH₃ | H | H | CH₃ | CH(CH₃)₂ | 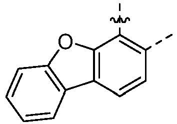 |
| 21 | CH₃ | CH₃ | H | H | CH₃ | CH(CH₃)₂ | 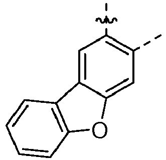 |
| 22 | CH₃ | CH₃ | H | H | CH₃ | CH(CH₃)₂ | 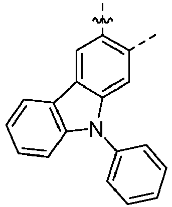 |
| 23 | CH₃ | CH₃ | H | H | CH₃ | CH(CH₃)₂ | 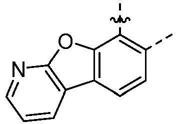 |
| 24 | CH₃ | CH₃ | H | H | CH₃ | CH(CH₃)₂ | 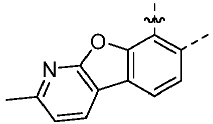 |
| 25 | CH₃ | CH₃ | H | H | CH₃ | CH(CH₃)₂ | 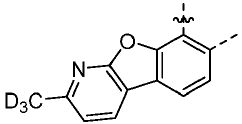 |
| 26 | CH₃ | CH₃ | H | H | CH₃ | CH(CH₃)₂ | 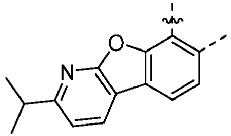 |
| 27 | CH₃ | CH₃ | H | H | CH₃ | CH(CH₃)₂ | 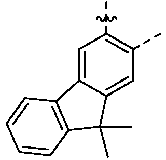 |
| 28 | CH₃ | CH₃ | H | H | CH₂CH₃ | CH₂CH₃ | 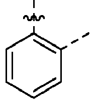 |
| 29 | CH₃ | CH₃ | H | H | CH₂CH₃ | CH₂CH₃ | 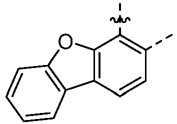 |
| 30 | CH₃ | CH₃ | H | H | CH₂CH₃ | CH₂CH₃ | 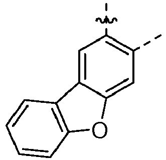 |
| 31 | CH₃ | CH₃ | H | H | CH₂CH₃ | CH₂CH₃ | 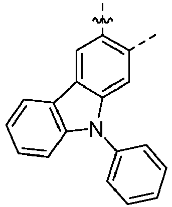 |
| 32 | CH₃ | CH₃ | H | H | CH₂CH₃ | CH₂CH₃ | 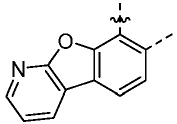 |
| 33 | CH₃ | CH₃ | H | H | CH₂CH₃ | CH₂CH₃ | 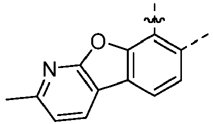 |
| 34 | CH₃ | CH₃ | H | H | CH₂CH₃ | CH₂CH₃ | 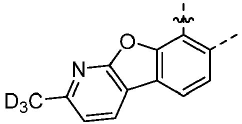 |
| 35 | CH₃ | CH₃ | H | H | CH₂CH₃ | CH₂CH₃ | 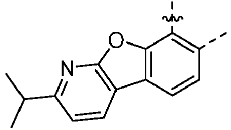 |
| 36 | CH₃ | CH₃ | H | H | CH₂CH₃ | CH₂CH₃ | 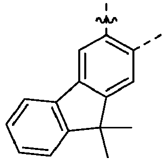 |
| 37 | CH₂CH₃ | CH₃ | H | H | CH₃ | CH₃ | 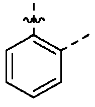 |
| 38 | CH₂CH₃ | CH₃ | H | H | CH₃ | CH₃ | 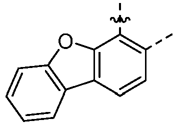 |
| 39 | CH₂CH₃ | CH₃ | H | H | CH₃ | CH₃ | 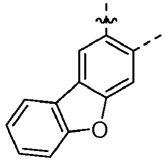 |
| 40 | CH₂CH₃ | CH₃ | H | H | CH₃ | CH₃ | 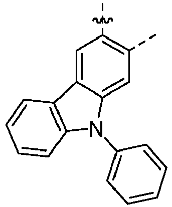 |
| 41 | CH₂CH₃ | CH₃ | H | H | CH₃ | CH₃ | 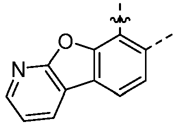 |
| 42 | CH₂CH₃ | CH₃ | H | H | CH₃ | CH₃ | 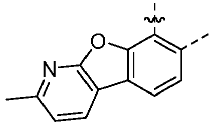 |
| 43 | CH₂CH₃ | CH₃ | H | H | CH₃ | CH₃ | 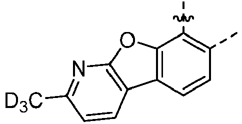 |
| 44 | CH₂CH₃ | CH₃ | H | H | CH₃ | CH₃ | 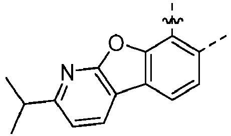 |
| 45 | CH₂CH₃ | CH₃ | H | H | CH₃ | CH₃ | 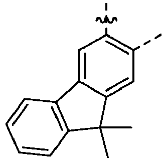 |
| 46 | CH(CH₃)₂ | CH₃ | H | H | CH₃ | CH₃ | 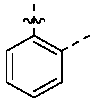 |
| 47 | CH(CH₃)₂ | CH₃ | H | H | CH₃ | CH₃ | 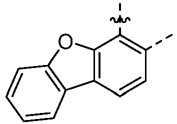 |
| 48 | CH(CH₃)₂ | CH₃ | H | H | CH₃ | CH₃ | 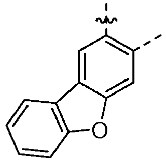 |
| +49 | CH(CH₃)₂ | CH₃ | H | H | CH₃ | CH₃ | 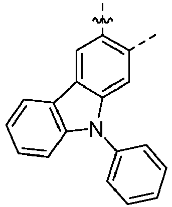 |
| 50 | CH(CH₃)₂ | CH₃ | H | H | CH₃ | CH₃ | 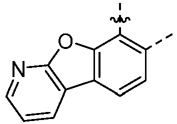 |
| 51 | CH(CH₃)₂ | CH₃ | H | H | CH₃ | CH₃ | 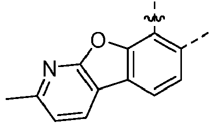 |
| 52 | CH(CH₃)₂ | CH₃ | H | H | CH₃ | CH₃ | 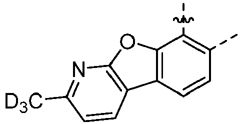 |
| 53 | CH(CH₃)₂ | CH₃ | H | H | CH₃ | CH₃ | 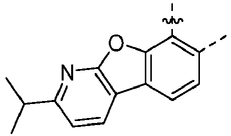 |
| 54 | CH(CH₃)₂ | CH₃ | H | H | CH₃ | CH₃ | 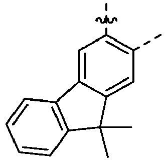 |
| 55 | CH₂CH₃ | CH₂CH₃ | H | H | CH₃ | CH₃ | 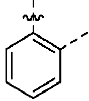 |
| 56 | CH₂CH₃ | CH₂CH₃ | H | H | CH₃ | CH₃ | 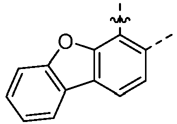 |
| 57 | CH₂CH₃ | CH₂CH₃ | H | H | CH₃ | CH₃ | 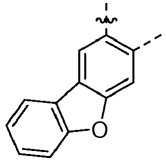 |
| 58 | CH₂CH₃ | CH₂CH₃ | H | H | CH₃ | CH₃ | 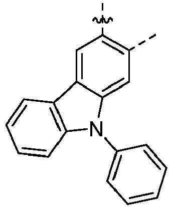 |
| 59 | CH₂CH₃ | CH₂CH₃ | H | H | CH₃ | CH₃ | 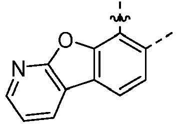 |
| 60 | CH₂CH₃ | CH₂CH₃ | H | H | CH₃ | CH₃ | 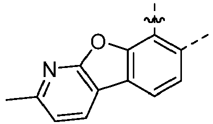 |
| 61 | CH₂CH₃ | CH₂CH₃ | H | H | CH₃ | CH₃ | 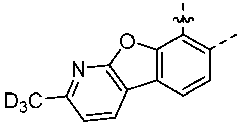 |
| 62 | CH₂CH₃ | CH₂CH₃ | H | H | CH₃ | CH₃ | 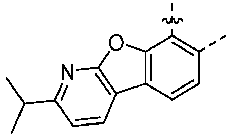 |
| 63 | CH₂CH₃ | CH₂CH₃ | H | H | CH₃ | CH₃ | 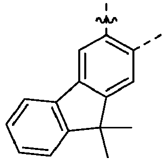 |
| 64 | CH₃ | CH₃ | H | H | 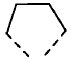 | | 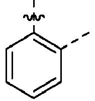 |
| 65 | CH₃ | CH₃ | H | H | 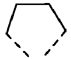 | | 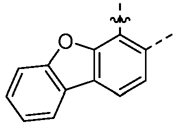 |
| 66 | CH₃ | CH₃ | H | H | 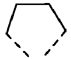 | | 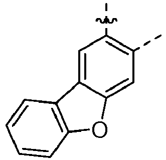 |
| 67 | CH₃ | CH₃ | H | H | 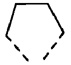 | | 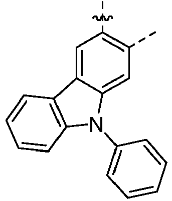 |
| 68 | CH₃ | CH₃ | H | H | 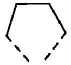 | | 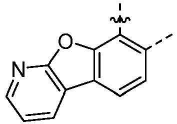 |
| 69 | CH₃ | CH₃ | H | H | 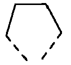 | | 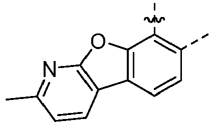 |
| 70 | CH₃ | CH₃ | H | H | 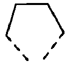 | | 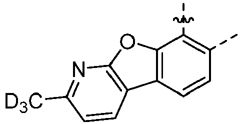 |
| 71 | CH₃ | CH₃ | H | H | 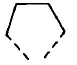 | | 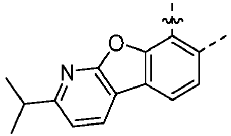 |
| 72 | CH₃ | CH₃ | H | H | 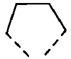 | | 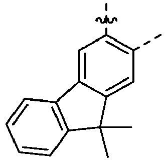 |
| 73 | CH₃ | CH₃ | H | H | 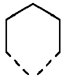 | | 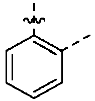 |
| 74 | CH₃ | CH₃ | H | H | 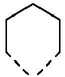 | | 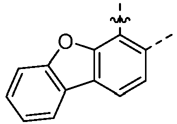 |
| 75 | CH₃ | CH₃ | H | H | 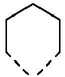 | | 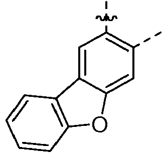 |
| 76 | CH₃ | CH₃ | H | H | 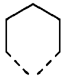 | | 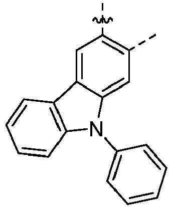 |
| 77 | CH₃ | CH₃ | H | H | 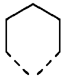 | | 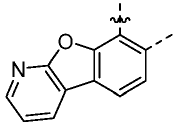 |
| 78 | CH₃ | CH₃ | H | H | 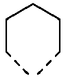 | | 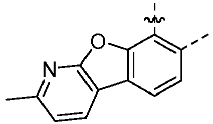 |
| 79 | CH₃ | CH₃ | H | H | 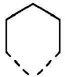 | | 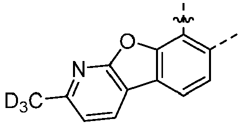 |
| 80 | CH₃ | CH₃ | H | H | 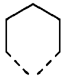 | | 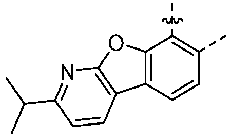 |
| 81 | CH₃ | CH₃ | H | H | 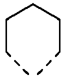 | | 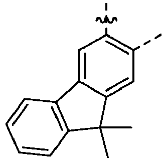 |
| 82 | CH₃ | CH₃ | H | H | 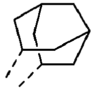 | | 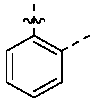 |
| 83 | CH₃ | CH₃ | H | H | 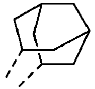 | | 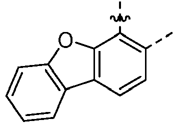 |
| 84 | CH₃ | CH₃ | H | H | 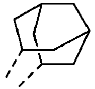 | | 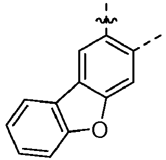 |
| 85 | CH₃ | CH₃ | H | H | 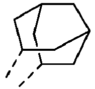 | | 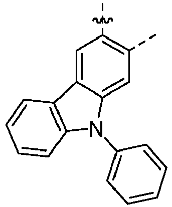 |
| 86 | CH₃ | CH₃ | H | H | 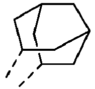 | | 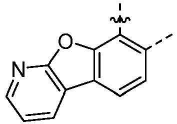 |
| 87 | CH₃ | CH₃ | H | H | 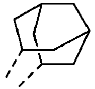 | | 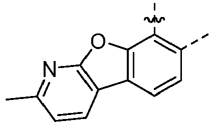 |
| 88 | CH₃ | CH₃ | H | H | 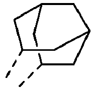 | | 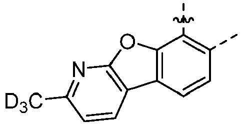 |
| 89 | CH₃ | CH₃ | H | H | 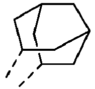 | | 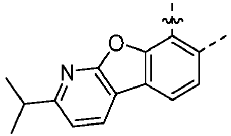 |
| 90 | CH₃ | CH₃ | H | H | 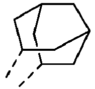 | | 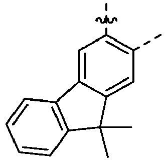 |
| 91 | 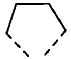 | | H | H | CH₃ | CH₃ | 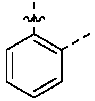 |
| 92 | 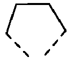 | | H | H | CH₃ | CH₃ | 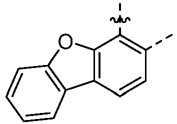 |
| 93 | 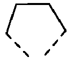 | | H | H | CH₃ | CH₃ | 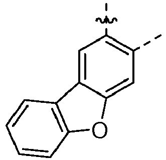 |
| 94 | 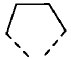 | | H | H | CH₃ | CH₃ | 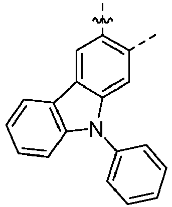 |
| 95 | 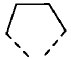 | | H | H | CH₃ | CH₃ | 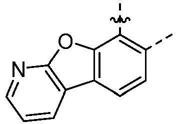 |
| 96 | 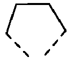 | | H | H | CH₃ | CH₃ | 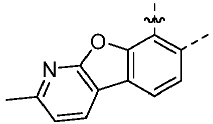 |
| 97 | 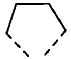 | | H | H | CH₃ | CH₃ | 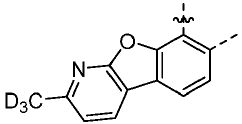 |
| 98 | 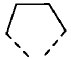 | | H | H | CH₃ | CH₃ | 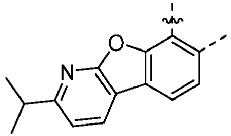 |
| 99 | 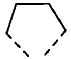 | | H | H | CH₃ | CH₃ | 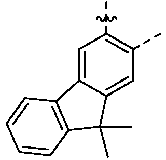 |
| 100 | 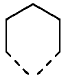 | | H | H | CH₃ | CH₃ | 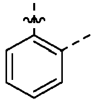 |
| 101 | 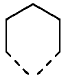 | | H | H | CH₃ | CH₃ | 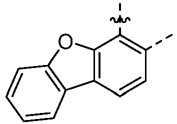 |
| 102 | 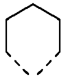 | | H | H | CH₃ | CH₃ | 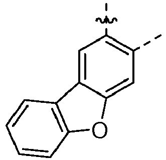 |
| 103 | 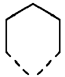 | | H | H | CH₃ | CH₃ | 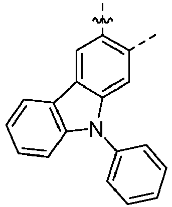 |
| 104 | 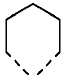 | | H | H | CH₃ | CH₃ | 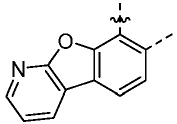 |
| 105 | 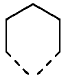 | | H | H | CH₃ | CH₃ | 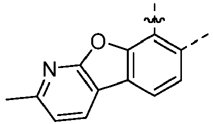 |
| 106 | 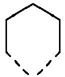 | | H | H | CH₃ | CH₃ | 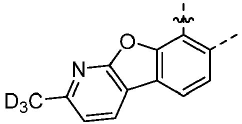 |
| 107 | 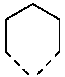 | | H | H | CH₃ | CH₃ | 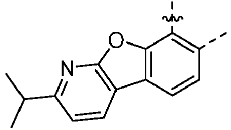 |
| 108 | 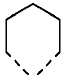 | | H | H | CH₃ | CH₃ | 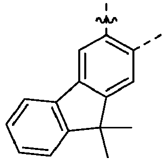 |
| 109 | 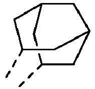 | | H | H | CH₃ | CH₃ | 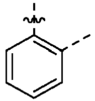 |
| 110 | 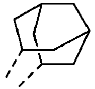 | | H | H | CH₃ | CH₃ | 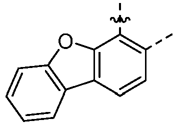 |
| 111 | 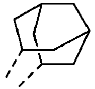 | | H | H | CH₃ | CH₃ | 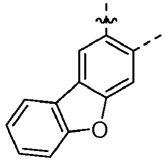 |
| 112 | 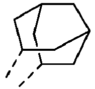 | | H | H | CH₃ | CH₃ | 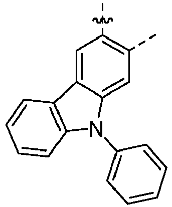 |
| 113 | 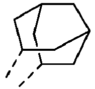 | | H | H | CH₃ | CH₃ | 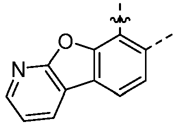 |
| 114 | 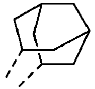 | | H | H | CH₃ | CH₃ | 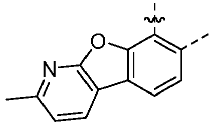 |
| 115 | 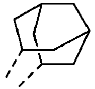 | | H | H | CH₃ | CH₃ | 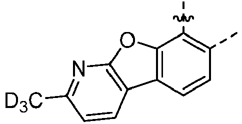 |
| 116 | 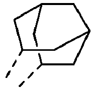 | | H | H | CH₃ | CH₃ | 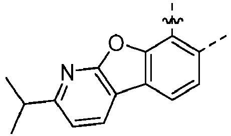 |
| 117 | 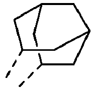 | | H | H | CH₃ | CH₃ | 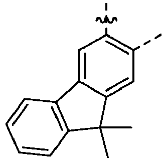 |
| 118 | 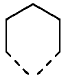 | | H | H | 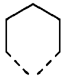 | | 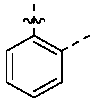 |
| 119 | 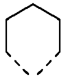 | | H | H | 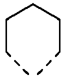 | | 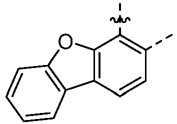 |
| 120 | 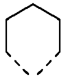 | | H | H | 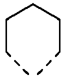 | | 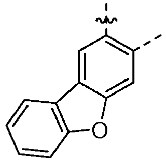 |
| 121 | 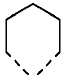 | | H | H | 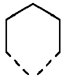 | | 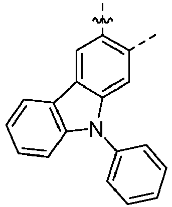 |
| 122 | 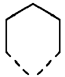 | | H | H | 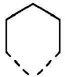 | | 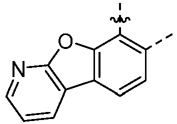 |
| 123 | 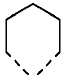 | | H | H | 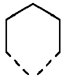 | | 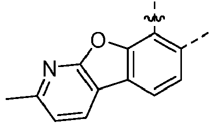 |
| 124 | 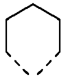 | | H | H | 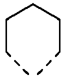 | | 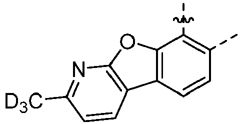 |
| 125 | 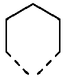 | | H | H | 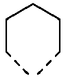 | | 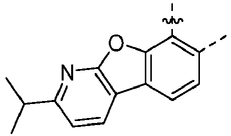 |
| 126 | 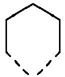 | | H | H | 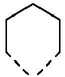 | | 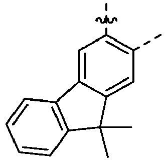 |
| 127 | CD₃ | CD₃ | H | H | CD₃ | CD₃ | 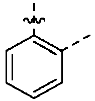 |
| 128 | CD₃ | CD₃ | H | H | CD₃ | CD₃ | 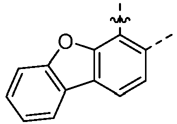 |
| 129 | CD₃ | CD₃ | H | H | CD₃ | CD₃ | 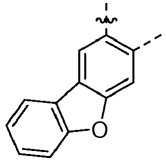 |
| 130 | CD₃ | CD₃ | H | H | CD₃ | CD₃ | 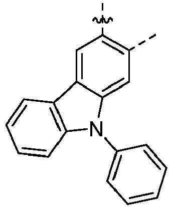 |
| 131 | CD₃ | CD₃ | H | H | CD₃ | CD₃ | 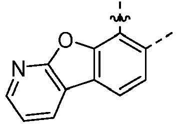 |
| 132 | CD₃ | CD₃ | H | H | CD₃ | CD₃ | 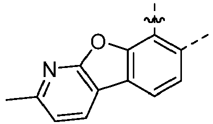 |
| 133 | CD₃ | CD₃ | H | H | CD₃ | CD₃ | 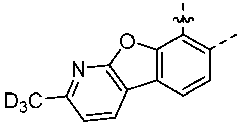 |
| 134 | CD₃ | CD₃ | H | H | CD₃ | CD₃ | 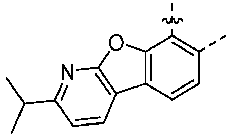 |
| 135 | CD₃ | CD₃ | H | H | CD₃ | CD₃ | 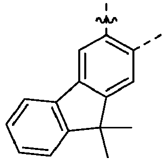 |
| 136 | CD₃ | CD₃ | D | D | CD₃ | CD₃ | 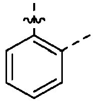 |
| 137 | CD₃ | CD₃ | D | D | CD₃ | CD₃ | 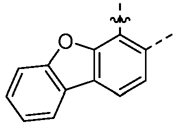 |
| 138 | CD₃ | CD₃ | D | D | CD₃ | CD₃ | 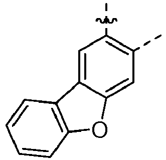 |
| 139 | CD₃ | CD₃ | D | D | CD₃ | CD₃ | 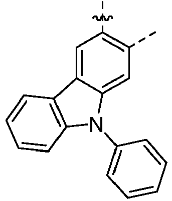 |
| 140 | CD₃ | CD₃ | D | D | CD₃ | CD₃ | 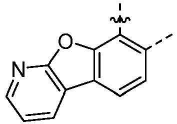 |
| 141 | CD₃ | CD₃ | D | D | CD₃ | CD₃ | 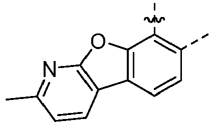 |
| 142 | CD₃ | CD₃ | D | D | CD₃ | CD₃ | 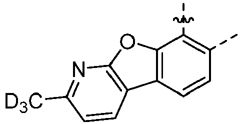 |
| 143 | CD₃ | CD₃ | D | D | CD₃ | CD₃ | 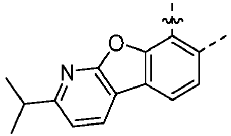 |
| 144 | CD₃ | CD₃ | D | D | CD₃ | CD₃ | 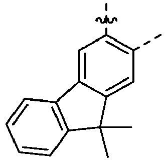 |
| 145 | CD₃ | CD₃ | D | D | CD₃ | CD(CD₃)₂ | 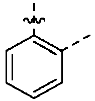 |
| 146 | CD₃ | CD₃ | D | D | CD₃ | CD(CD₃)₂ | 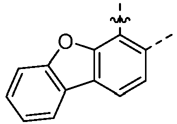 |
| 147 | CD₃ | CD₃ | D | D | CD₃ | CD(CD₃)₂ | 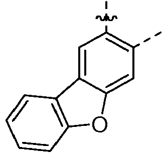 |
| 148 | CD₃ | CD₃ | D | D | CD₃ | CD(CD₃)₂ | 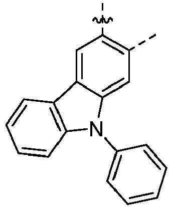 |
| 149 | CD₃ | CD₃ | D | D | CD₃ | CD(CD₃)₂ | 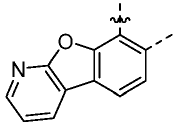 |
| 150 | CD₃ | CD₃ | D | D | CD₃ | CD(CD₃)₂ | 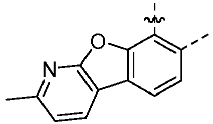 |
| 151 | CD₃ | CD₃ | D | D | CD₃ | CD(CD₃)₂ | 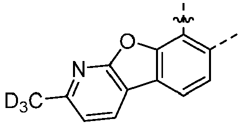 |
| 152 | CD₃ | CD₃ | D | D | CD₃ | CD(CD₃)₂ | 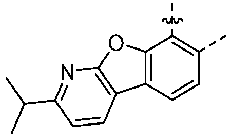 |
| 153 | CD₃ | CD₃ | D | D | CD₃ | CD(CD₃)₂ | 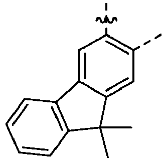 |
| 154 | CH₃ | CH₃ | H | H | CH₃ | CH₂CH₂CF₃ | 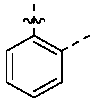 |
| 155 | CH₃ | CH₃ | H | H | CH₃ | CH₂CH₂CF₃ | 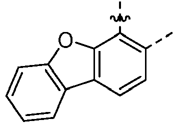 |
| 156 | CH₃ | CH₃ | H | H | CH₃ | CH₂CH₂CF₃ | 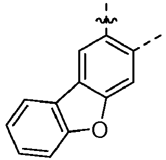 |
| 157 | CH₃ | CH₃ | H | H | CH₃ | CH₂CH₂CF₃ | 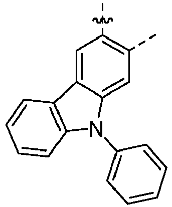 |
| 158 | CH₃ | CH₃ | H | H | CH₃ | CH₂CH₂CF₃ | 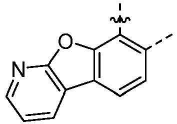 |
| 159 | CH₃ | CH₃ | H | H | CH₃ | CH₂CH₂CF₃ | 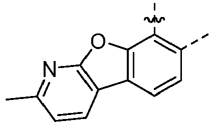 |
| 160 | CH₃ | CH₃ | H | H | CH₃ | CH₂CH₂CF₃ | 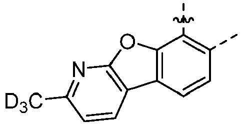 |
| 161 | CH₃ | CH₃ | H | H | CH₃ | CH₂CH₂CF₃ | 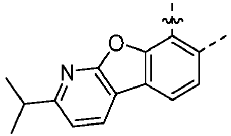 |
| 162 | CH₃ | CH₃ | H | H | CH₃ | CH₂CH₂CF₃ | 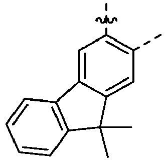 |
| 163 | CH₂CH₂CF₃ | CH₃ | H | H | CH₃ | CH₃ | 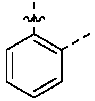 |
| 164 | CH₂CH₂CF₃ | CH₃ | H | H | CH₃ | CH₃ | 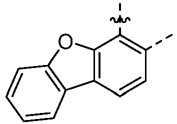 |
| 165 | CH₂CH₂CF₃ | CH₃ | H | H | CH₃ | CH₃ | 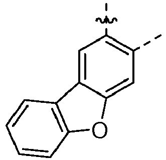 |
| 166 | CH₂CH₂CF₃ | CH₃ | H | H | CH₃ | CH₃ | 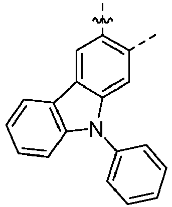 |
| 167 | CH₂CH₂CF₃ | CH₃ | H | H | CH₃ | CH₃ | 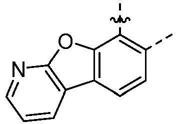 |
| 168 | CH₂CH₂CF₃ | CH₃ | H | H | CH₃ | CH₃ | 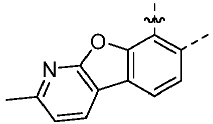 |
| 169 | CH₂CH₂CF₃ | CH₃ | H | H | CH₃ | CH₃ | 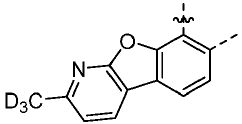 |
| 170 | CH₂CH₂CF₃ | CH₃ | H | H | CH₃ | CH₃ | 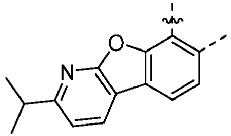 |
| 171 | CH₂CH₂CF₃ | CH₃ | H | H | CH₃ | CH₃ | 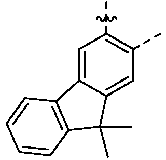 |
| 172 | CH₃ | CH₃ | H | H | CH₃ | CF₃ | 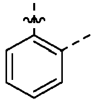 |
| 173 | CH₃ | CH₃ | H | H | CH₃ | CF₃ | 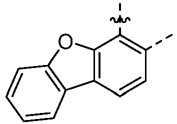 |
| 174 | CH₃ | CH₃ | H | H | CH₃ | CF₃ | 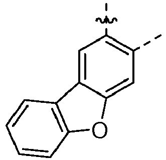 |
| 175 | CH₃ | CH₃ | H | H | CH₃ | CF₃ | 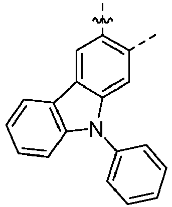 |
| 176 | CH₃ | CH₃ | H | H | CH₃ | CF₃ | 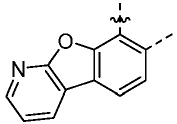 |
| 177 | CH₃ | CH₃ | H | H | CH₃ | CF₃ | 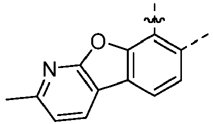 |
| 178 | CH₃ | CH₃ | H | H | CH₃ | CF₃ | 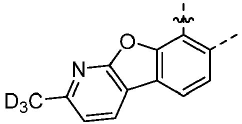 |
| 179 | CH₃ | CH₃ | H | H | CH₃ | CF₃ | 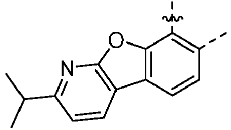 |
| 180 | CH₃ | CH₃ | H | H | CH₃ | CF₃ | 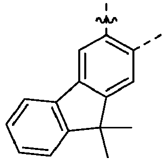 |
| 181 | CH₃ | CH₃ | H | H | CF₃ | CF₃ | 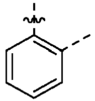 |
| 182 | CH₃ | CH₃ | H | H | CF₃ | CF₃ | 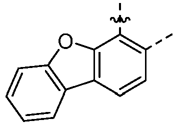 |
| 183 | CH₃ | CH₃ | H | H | CF₃ | CF₃ | 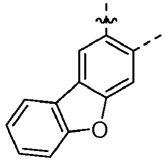 |
| 184 | CH₃ | CH₃ | H | H | CF₃ | CF₃ | 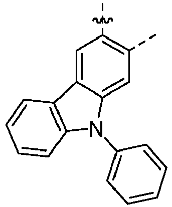 |
| 185 | CH₃ | CH₃ | H | H | CF₃ | CF₃ | 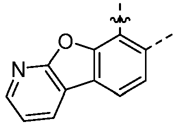 |
| 186 | CH₃ | CH₃ | H | H | CF₃ | CF₃ | 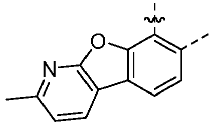 |
| 187 | CH₃ | CH₃ | H | H | CF₃ | CF₃ | 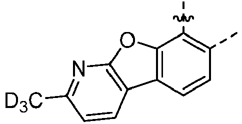 |
| 188 | CH₃ | CH₃ | H | H | CF₃ | CF₃ | 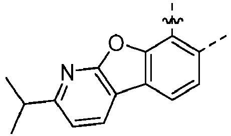 |
| 189 | CH₃ | CH₃ | H | H | CF₃ | CF₃ | 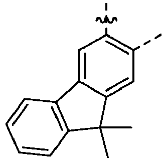 |
| 190 | CF₃ | CF₃ | H | H | CH₃ | CH₃ | 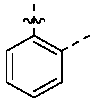 |
| 191 | CF₃ | CF₃ | H | H | CH₃ | CH₃ | 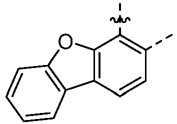 |
| 192 | CF₃ | CF₃ | H | H | CH₃ | CH₃ | 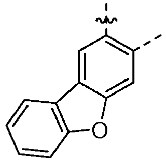 |
| 193 | CF₃ | CF₃ | H | H | CH₃ | CH₃ | 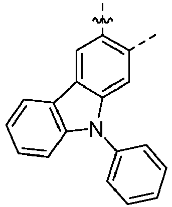 |
| 194 | CF₃ | CF₃ | H | H | CH₃ | CH₃ | 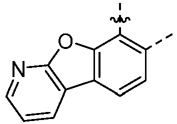 |
| 195 | CF₃ | CF₃ | H | H | CH₃ | CH₃ | 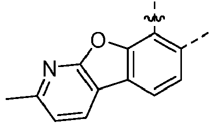 |
| 196 | CF₃ | CF₃ | H | H | CH₃ | CH₃ | 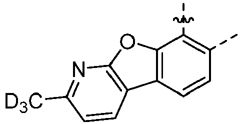 |
| 197 | CF₃ | CF₃ | H | H | CH₃ | CH₃ | 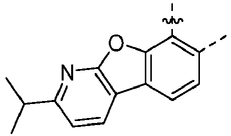 |
| 198 | CF₃ | CF₃ | H | H | CH₃ | CH₃ | 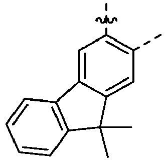 |
, and for *i* = 199 to 534 L_{A*i*} has the structure 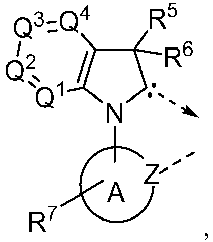 where substituents Q¹, Q², Q³, Q⁴, R⁵, R⁶, and ring A are as defined in Table 2 below:
**Table 2**
| *i* | Q¹ | Q² | Q³ | Q⁴ | R⁵ | R⁶ | Ring A |
|---|---|---|---|---|---|---|---|
| 199 | CH | CH | CH | CH | CH₃ | CH₃ | 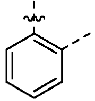 |
| 200 | CH | CH | CH | CH | CH₃ | CH₃ | 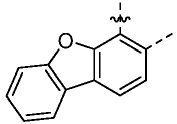 |
| 201 | CH | CH | CH | CH | CH₃ | CH₃ | 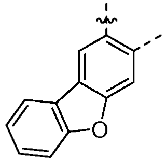 |
| 202 | CH | CH | CH | CH | CH₃ | CH₃ | 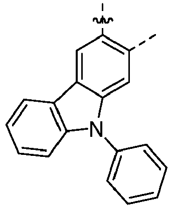 |
| 203 | CH | CH | CH | CH | CH₃ | CH₃ | 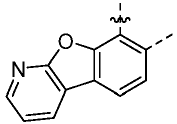 |
| 204 | CH | CH | CH | CH | CH₃ | CH₃ | 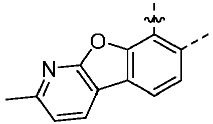 |
| 205 | CH | CH | CH | CH | CH₃ | CH₃ | 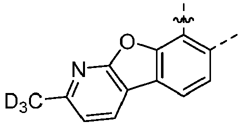 |
| 206 | CH | CH | CH | CH | CH₃ | CH₃ | 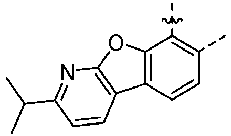 |
| 207 | CH | CH | CH | CH | CH₃ | CH₃ | 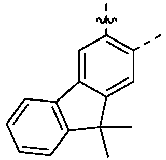 |
| 208 | CH | CH | CH | CH | CH₃ | CH₂CH₃ | 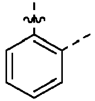 |
| 209 | CH | CH | CH | CH | CH₃ | CH₂CH₃ | 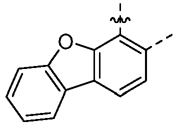 |
| 210 | CH | CH | CH | CH | CH₃ | CH₂CH₃ | 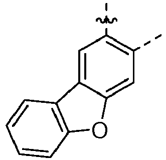 |
| 211 | CH | CH | CH | CH | CH₃ | CH₂CH₃ | 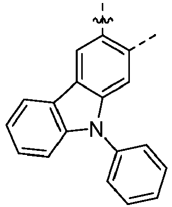 |
| 212 | CH | CH | CH | CH | CH₃ | CH₂CH₃ | 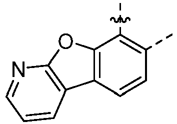 |
| 213 | CH | CH | CH | CH | CH₃ | CH₂CH₃ | 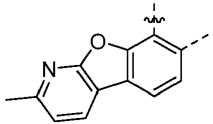 |
| 214 | CH | CH | CH | CH | CH₃ | CH₂CH₃ | 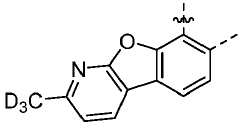 |
| 215 | CH | CH | CH | CH | CH₃ | CH₂CH₃ | 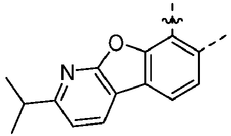 |
| 216 | CH | CH | CH | CH | CH₃ | CH₂CH₃ | 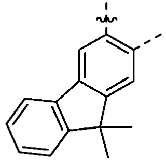 |
| 217 | CH | CH | CH | CH | CH₃ | CH(CH₃)₂ | 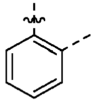 |
| 218 | CH | CH | CH | CH | CH₃ | CH(CH₃)₂ | 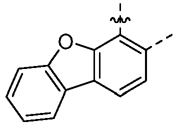 |
| 219 | CH | CH | CH | CH | CH₃ | CH(CH₃)₂ | 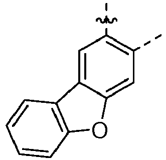 |
| 220 | CH | CH | CH | CH | CH₃ | CH(CH₃)₂ | 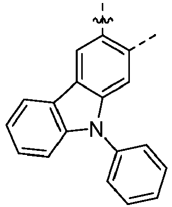 |
| 221 | CH | CH | CH | CH | CH₃ | CH(CH₃)₂ | 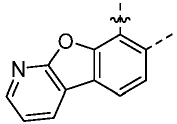 |
| 222 | CH | CH | CH | CH | CH₃ | CH(CH₃)₂ | 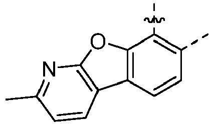 |
| 223 | CH | CH | CH | CH | CH₃ | CH(CH₃)₂ | 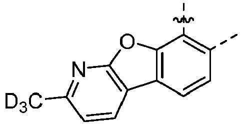 |
| 224 | CH | CH | CH | CH | CH₃ | CH(CH₃)₂ | 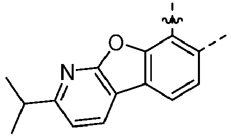 |
| 225 | CH | CH | CH | CH | CH₃ | CH(CH₃)₂ | 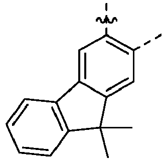 |
| 226 | CH | CH | CH | CH | 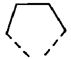 | | 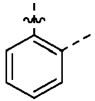 |
| 227 | CH | CH | CH | CH | 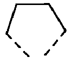 | | 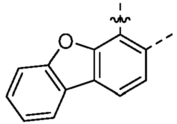 |
| 228 | CH | CH | CH | CH | 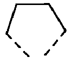 | | 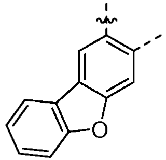 |
| 229 | CH | CH | CH | CH | 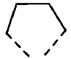 | | 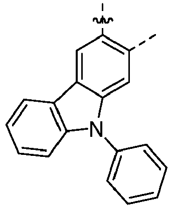 |
| 230 | CH | CH | CH | CH | 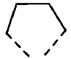 | | 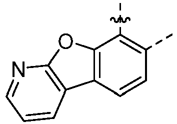 |
| 231 | CH | CH | CH | CH | 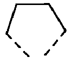 | | 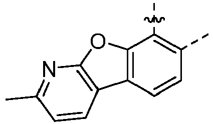 |
| 232 | CH | CH | CH | CH | 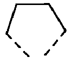 | | 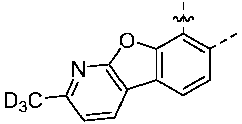 |
| 233 | CH | CH | CH | CH | 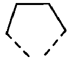 | | 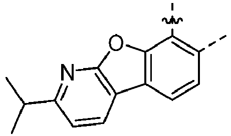 |
| 234 | CH | CH | CH | CH | 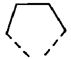 | | 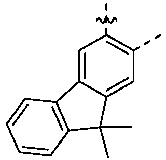 |
| 235 | CH | CH | CH | CH | 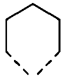 | | 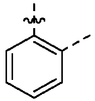 |
| 236 | CH | CH | CH | CH | 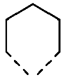 | | 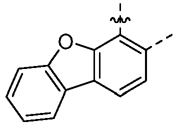 |
| 237 | CH | CH | CH | CH | 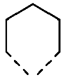 | | 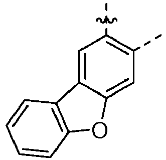 |
| 238 | CH | CH | CH | CH | 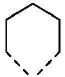 | | 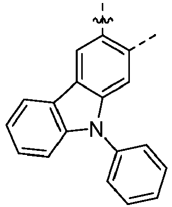 |
| 239 | CH | CH | CH | CH | 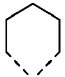 | | 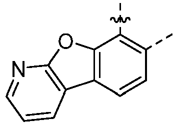 |
| 240 | CH | CH | CH | CH | 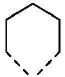 | | 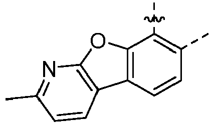 |
| 241 | CH | CH | CH | CH | 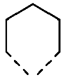 | | 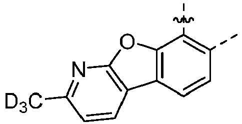 |
| 242 | CH | CH | CH | CH | 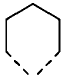 | | 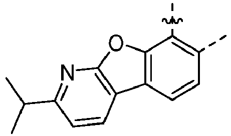 |
| 243 | CH | CH | CH | CH | 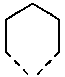 | | 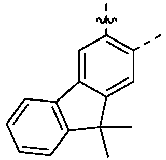 |
| 244 | CH | CH | CH | CH | 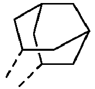 | | 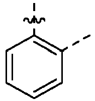 |
| 245 | CH | CH | CH | CH | 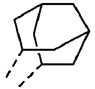 | | 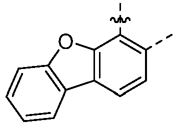 |
| 246 | CH | CH | CH | CH | 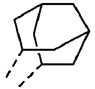 | | 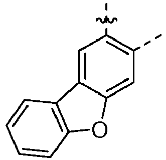 |
| 247 | CH | CH | CH | CH | 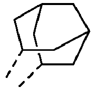 | | 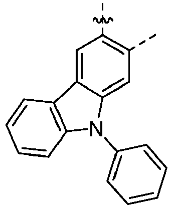 |
| 248 | CH | CH | CH | CH | 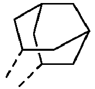 | | 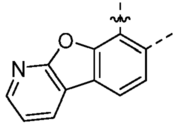 |
| 249 | CH | CH | CH | CH | 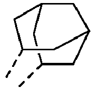 | | 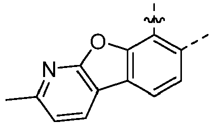 |
| 250 | CH | CH | CH | CH | 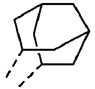 | | 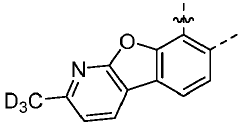 |
| 251 | CH | CH | CH | CH | 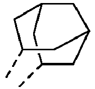 | | 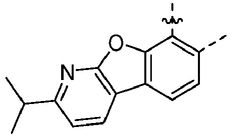 |
| 252 | CH | CH | CH | CH | 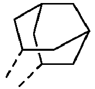 | | 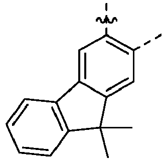 |
| 253 | N | CH | CH | CH | CH₃ | CH₃ | 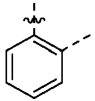 |
| 254 | N | CH | CH | CH | CH₃ | CH₃ | 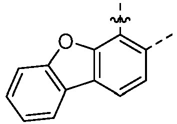 |
| 255 | N | CH | CH | CH | CH₃ | CH₃ | 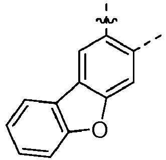 |
| 256 | N | CH | CH | CH | CH₃ | CH₃ | 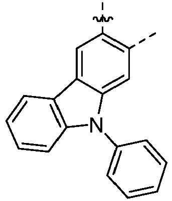 |
| 257 | N | CH | CH | CH | CH₃ | CH₃ | 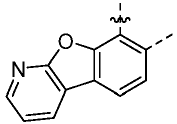 |
| 258 | N | CH | CH | CH | CH₃ | CH₃ | 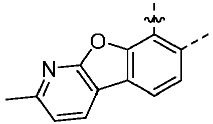 |
| 259 | N | CH | CH | CH | CH₃ | CH₃ | 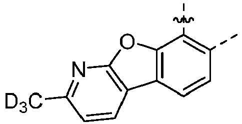 |
| 260 | N | CH | CH | CH | CH₃ | CH₃ | 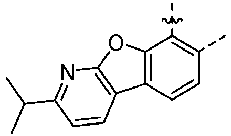 |
| 261 | N | CH | CH | CH | CH₃ | CH₃ | 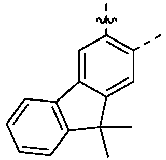 |
| 262 | N | CH | CH | CH | CH₃ | CH₂CH₃ | 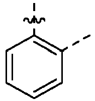 |
| 263 | N | CH | CH | CH | CH₃ | CH₂CH₃ | 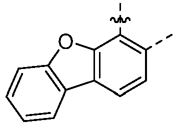 |
| 264 | N | CH | CH | CH | CH₃ | CH₂CH₃ | 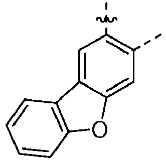 |
| 265 | N | CH | CH | CH | CH₃ | CH₂CH₃ | 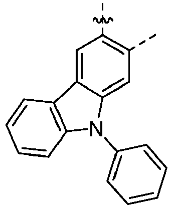 |
| 266 | N | CH | CH | CH | CH₃ | CH₂CH₃ | 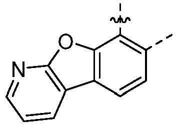 |
| 267 | N | CH | CH | CH | CH₃ | CH₂CH₃ | 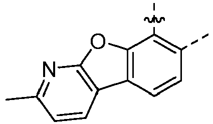 |
| 268 | N | CH | CH | CH | CH₃ | CH₂CH₃ | 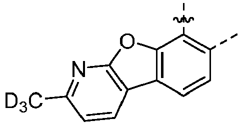 |
| 269 | N | CH | CH | CH | CH₃ | CH₂CH₃ | 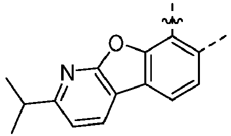 |
| 270 | N | CH | CH | CH | CH₃ | CH₂CH₃ | 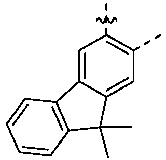 |
| 271 | N | CH | CH | CH | CH₃ | CH(CH₃)₂ | 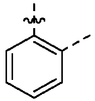 |
| 272 | N | CH | CH | CH | CH₃ | CH(CH₃)₂ | 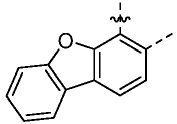 |
| 273 | N | CH | CH | CH | CH₃ | CH(CH₃)₂ | 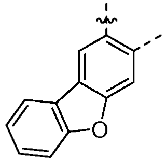 |
| 274 | N | CH | CH | CH | CH₃ | CH(CH₃)₂ | 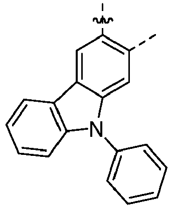 |
| 275 | N | CH | CH | CH | CH₃ | CH(CH₃)₂ | 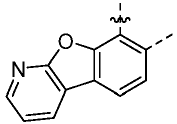 |
| 276 | N | CH | CH | CH | CH₃ | CH(CH₃)₂ | 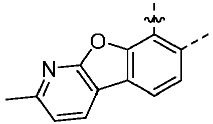 |
| 277 | N | CH | CH | CH | CH₃ | CH(CH₃)₂ | 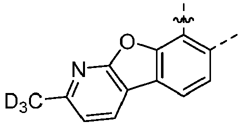 |
| 278 | N | CH | CH | CH | CH₃ | CH(CH₃)₂ | 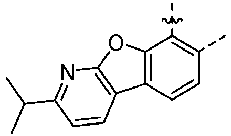 |
| 279 | N | CH | CH | CH | CH₃ | CH(CH₃)₂ | 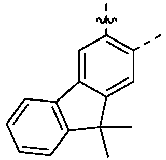 |
| 280 | N | CH | CH | CH | 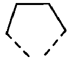 | | 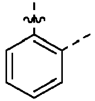 |
| 281 | N | CH | CH | CH | 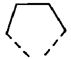 | | 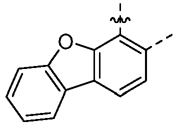 |
| 282 | N | CH | CH | CH | 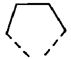 | | 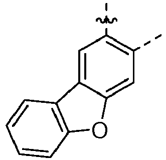 |
| 283 | N | CH | CH | CH | 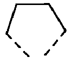 | | 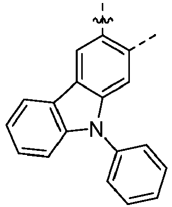 |
| 284 | N | CH | CH | CH | 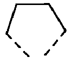 | | 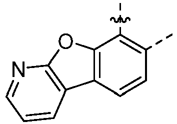 |
| 285 | N | CH | CH | CH | 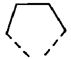 | | 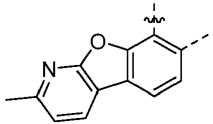 |
| 286 | N | CH | CH | CH | 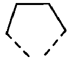 | | 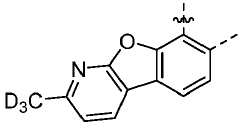 |
| 287 | N | CH | CH | CH | 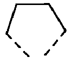 | | 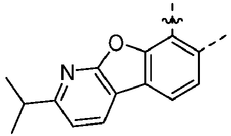 |
| 288 | N | CH | CH | CH | 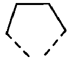 | | 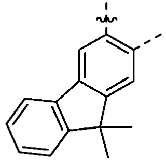 |
| 289 | N | CH | CH | CH | 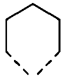 | | 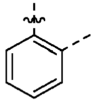 |
| 290 | N | CH | CH | CH | 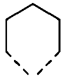 | | 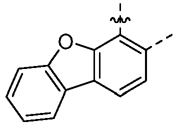 |
| 291 | N | CH | CH | CH | 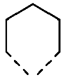 | | 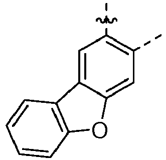 |
| 292 | N | CH | CH | CH | 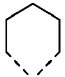 | | 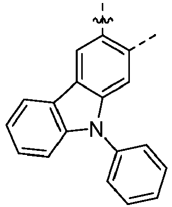 |
| 293 | N | CH | CH | CH | 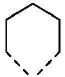 | | 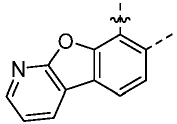 |
| 294 | N | CH | CH | CH | 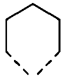 | | 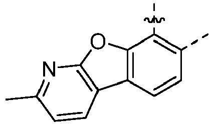 |
| 295 | N | CH | CH | CH | 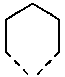 | | 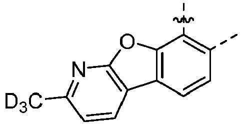 |
| 296 | N | CH | CH | CH | 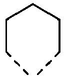 | | 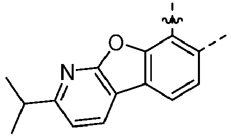 |
| 297 | N | CH | CH | CH | 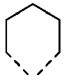 | | 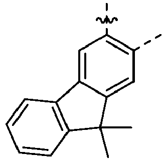 |
| 298 | N | CH | CH | CH | 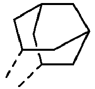 | | 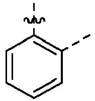 |
| 299 | N | CH | CH | CH | 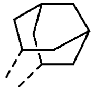 | | 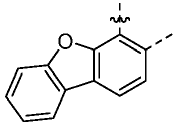 |
| 300 | N | CH | CH | CH | 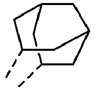 | | 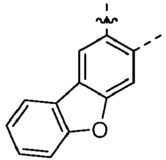 |
| 301 | N | CH | CH | CH | 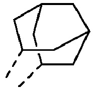 | | 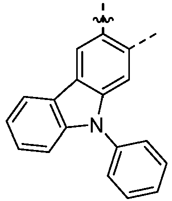 |
| 302 | N | CH | CH | CH | 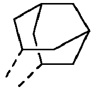 | | 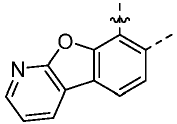 |
| 303 | N | CH | CH | CH | 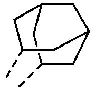 | | 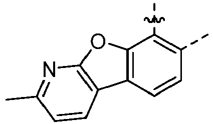 |
| 304 | N | CH | CH | CH | 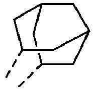 | | 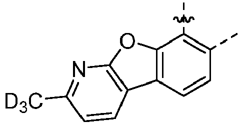 |
| 305 | N | CH | CH | CH | 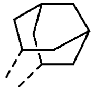 | | 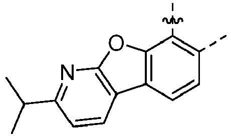 |
| 306 | N | CH | CH | CH | 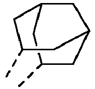 | | 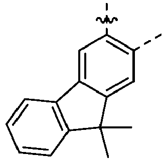 |
| 307 | CH | N | CH | CH | CH₃ | CH₃ | 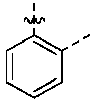 |
| 308 | CH | N | CH | CH | CH₃ | CH₃ | 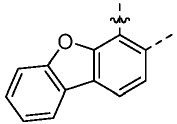 |
| 309 | CH | N | CH | CH | CH₃ | CH₃ | 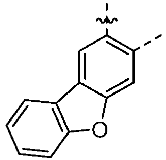 |
| 310 | CH | N | CH | CH | CH₃ | CH₃ | 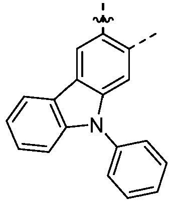 |
| 311 | CH | N | CH | CH | CH₃ | CH₃ | 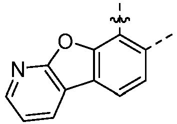 |
| 312 | CH | N | CH | CH | CH₃ | CH₃ | 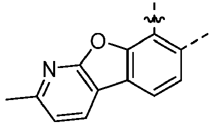 |
| 313 | CH | N | CH | CH | CH₃ | CH₃ | 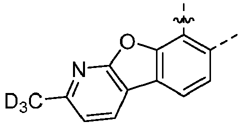 |
| 314 | CH | N | CH | CH | CH₃ | CH₃ | 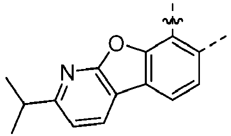 |
| 315 | CH | N | CH | CH | CH₃ | CH₃ | 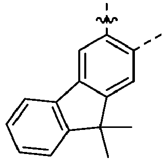 |
| 316 | CH | N | CH | CH | CH₃ | CH₂CH₃ | 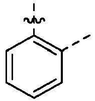 |
| 317 | CH | N | CH | CH | CH₃ | CH₂CH₃ | 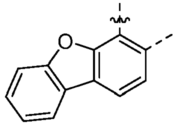 |
| 318 | CH | N | CH | CH | CH₃ | CH₂CH₃ | 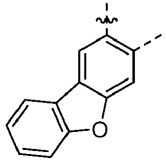 |
| 319 | CH | N | CH | CH | CH₃ | CH₂CH₃ | 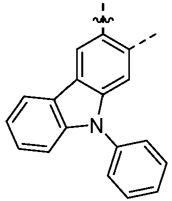 |
| 320 | CH | N | CH | CH | CH₃ | CH₂CH₃ | 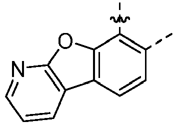 |
| 321 | CH | N | CH | CH | CH₃ | CH₂CH₃ | 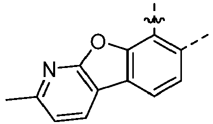 |
| 322 | CH | N | CH | CH | CH₃ | CH₂CH₃ | 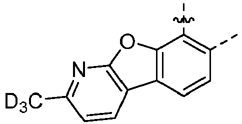 |
| 323 | CH | N | CH | CH | CH₃ | CH₂CH₃ | 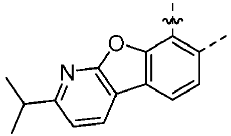 |
| 324 | CH | N | CH | CH | CH₃ | CH₂CH₃ | 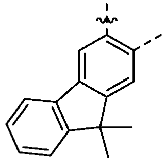 |
| 325 | CH | N | CH | CH | CH₃ | CH(CH₃)₂ | 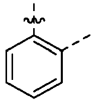 |
| 326 | CH | N | CH | CH | CH₃ | CH(CH₃)₂ | 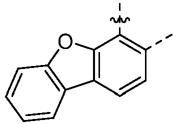 |
| 327 | CH | N | CH | CH | CH₃ | CH(CH₃)₂ | 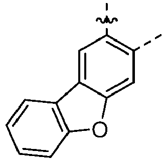 |
| 328 | CH | N | CH | CH | CH₃ | CH(CH₃)₂ | 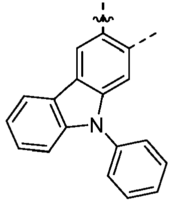 |
| 329 | CH | N | CH | CH | CH₃ | CH(CH₃)₂ | 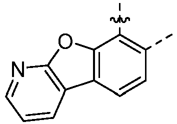 |
| 330 | CH | N | CH | CH | CH₃ | CH(CH₃)₂ | 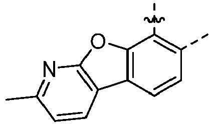 |
| 331 | CH | N | CH | CH | CH₃ | CH(CH₃)₂ | 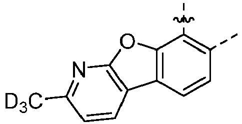 |
| 332 | CH | N | CH | CH | CH₃ | CH(CH₃)₂ | 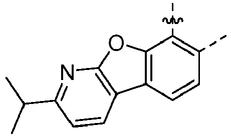 |
| 333 | CH | N | CH | CH | CH₃ | CH(CH₃)₂ | 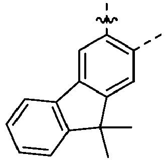 |
| 334 | CH | N | CH | CH | 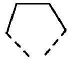 | | 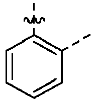 |
| 335 | CH | N | CH | CH | 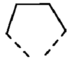 | | 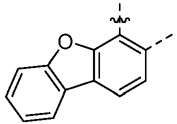 |
| 336 | CH | N | CH | CH | 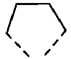 | | 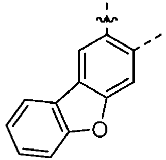 |
| 337 | CH | N | CH | CH | 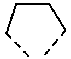 | | 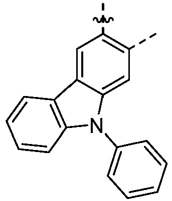 |
| 338 | CH | N | CH | CH | 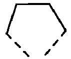 | | 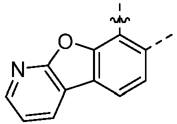 |
| 339 | CH | N | CH | CH | 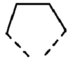 | | 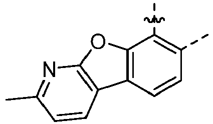 |
| 340 | CH | N | CH | CH | 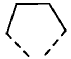 | | 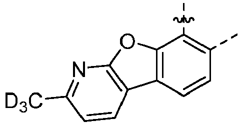 |
| 341 | CH | N | CH | CH | 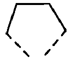 | | 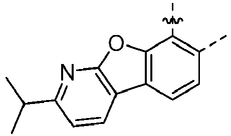 |
| 342 | CH | N | CH | CH | 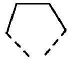 | | 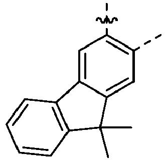 |
| 343 | CH | N | CH | CH | 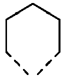 | | 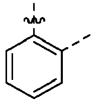 |
| 344 | CH | N | CH | CH | 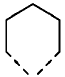 | | 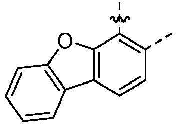 |
| 345 | CH | N | CH | CH | 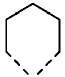 | | 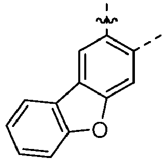 |
| 346 | CH | N | CH | CH | 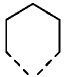 | | 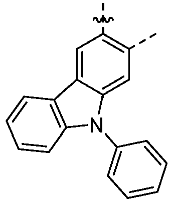 |
| 347 | CH | N | CH | CH | 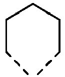 | | 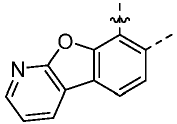 |
| 348 | CH | N | CH | CH | 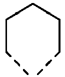 | | 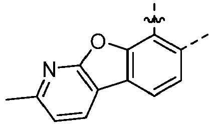 |
| 349 | CH | N | CH | CH | 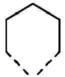 | | 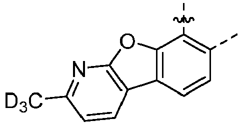 |
| 350 | CH | N | CH | CH | 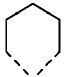 | | 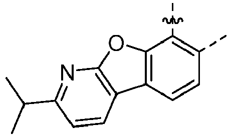 |
| 351 | CH | N | CH | CH | 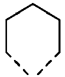 | | 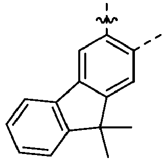 |
| 352 | CH | N | CH | CH | 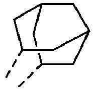 | | 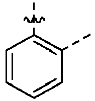 |
| 353 | CH | N | CH | CH | 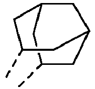 | | 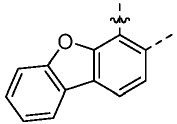 |
| 354 | CH | N | CH | CH | 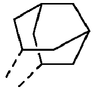 | | 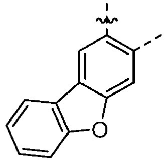 |
| 355 | CH | N | CH | CH | 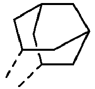 | | 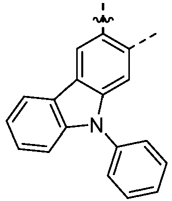 |
| 356 | CH | N | CH | CH | 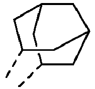 | | 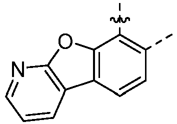 |
| 357 | CH | N | CH | CH | 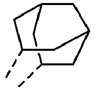 | | 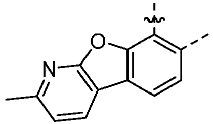 |
| 358 | CH | N | CH | CH | 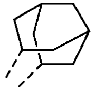 | | 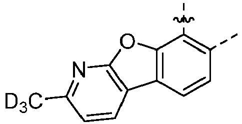 |
| 359 | CH | N | CH | CH | 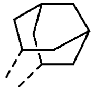 | | 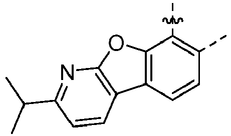 |
| 360 | CH | N | CH | CH | 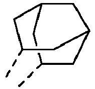 | | 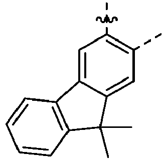 |
| 361 | N | CH | N | CH | CH₃ | CH₃ | 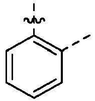 |
| 362 | N | CH | N | CH | CH₃ | CH₃ | 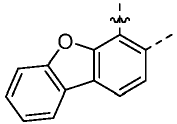 |
| 363 | N | CH | N | CH | CH₃ | CH₃ | 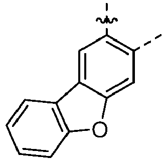 |
| 364 | N | CH | N | CH | CH₃ | CH₃ | 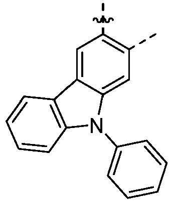 |
| 365 | N | CH | N | CH | CH₃ | CH₃ | 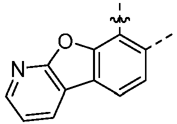 |
| 366 | N | CH | N | CH | CH₃ | CH₃ | 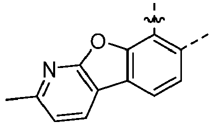 |
| 367 | N | CH | N | CH | CH₃ | CH₃ | 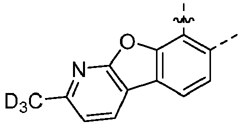 |
| 368 | N | CH | N | CH | CH₃ | CH₃ | 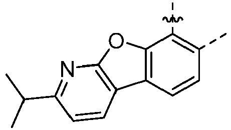 |
| 369 | N | CH | N | CH | CH₃ | CH₃ | 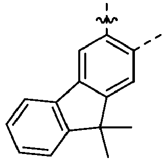 |
| 370 | N | CH | N | CH | CH₃ | CH₂CH₃ | 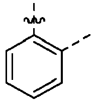 |
| 371 | N | CH | N | CH | CH₃ | CH₂CH₃ | 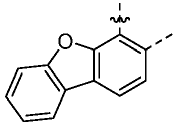 |
| 372 | N | CH | N | CH | CH₃ | CH₂CH₃ | 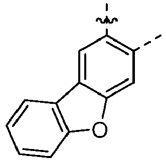 |
| 373 | N | CH | N | CH | CH₃ | CH₂CH₃ | 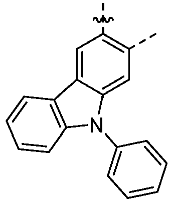 |
| 374 | N | CH | N | CH | CH₃ | CH₂CH₃ | 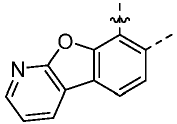 |
| 375 | N | CH | N | CH | CH₃ | CH₂CH₃ | 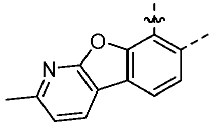 |
| 376 | N | CH | N | CH | CH₃ | CH₂CH₃ | 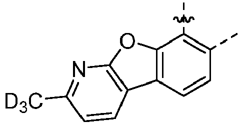 |
| 377 | N | CH | N | CH | CH₃ | CH₂CH₃ | 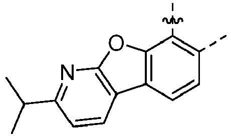 |
| 378 | N | CH | N | CH | CH₃ | CH₂CH₃ | 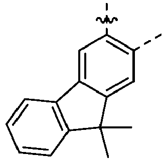 |
| 379 | N | CH | N | CH | CH₃ | CH(CH₃)₂ | 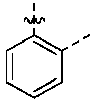 |
| 380 | N | CH | N | CH | CH₃ | CH(CH₃)₂ | 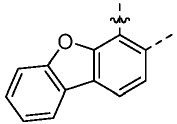 |
| 381 | N | CH | N | CH | CH₃ | CH(CH₃)₂ | 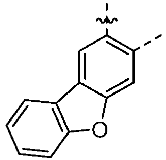 |
| 382 | N | CH | N | CH | CH₃ | CH(CH₃)₂ | 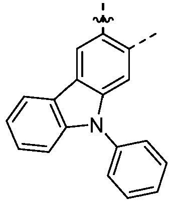 |
| 383 | N | CH | N | CH | CH₃ | CH(CH₃)₂ | 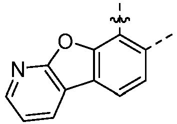 |
| 384 | N | CH | N | CH | CH₃ | CH(CH₃)₂ | 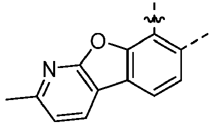 |
| 385 | N | CH | N | CH | CH₃ | CH(CH₃)₂ | 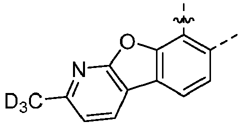 |
| 386 | N | CH | N | CH | CH₃ | CH(CH₃)₂ | 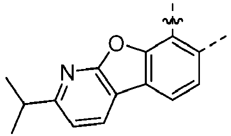 |
| 387 | N | CH | N | CH | CH₃ | CH(CH₃)₂ | 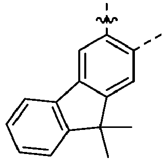 |
| 388 | CH | CH | N | CH | 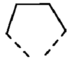 | | 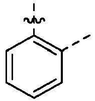 |
| 389 | CH | CH | N | CH | 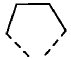 | | 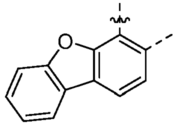 |
| 390 | CH | CH | N | CH | 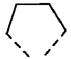 | | 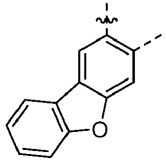 |
| 391 | CH | CH | N | CH | 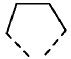 | | 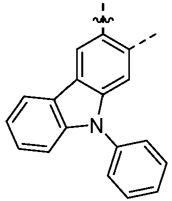 |
| 392 | CH | CH | N | CH | 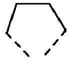 | | 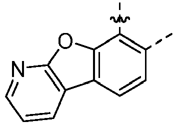 |
| 393 | CH | CH | N | CH | 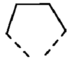 | | 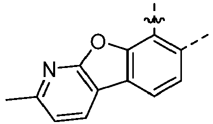 |
| 394 | CH | CH | N | CH | 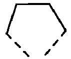 | | 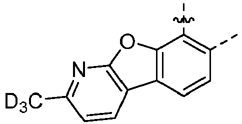 |
| 395 | CH | CH | N | CH | 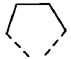 | | 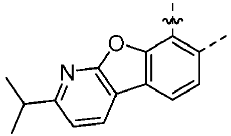 |
| 396 | CH | CH | N | CH | 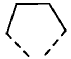 | | 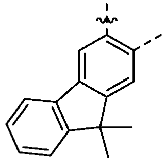 |
| 397 | CH | CH | N | CH | 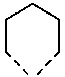 | | 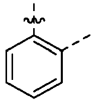 |
| 398 | CH | CH | N | CH | 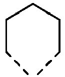 | | 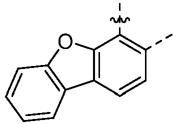 |
| 399 | CH | CH | N | CH | 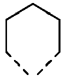 | | 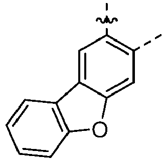 |
| 400 | CH | CH | N | CH | 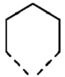 | | 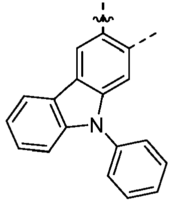 |
| 401 | CH | CH | N | CH | 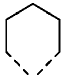 | | 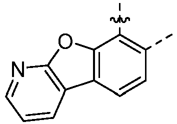 |
| 402 | CH | CH | N | CH | 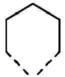 | | 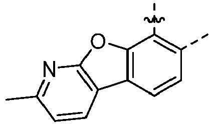 |
| 403 | CH | CH | N | CH | 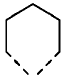 | | 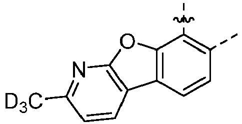 |
| 404 | CH | CH | N | CH | 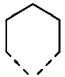 | | 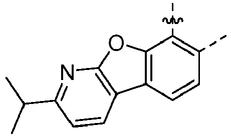 |
| 405 | CH | CH | N | CH | 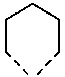 | | 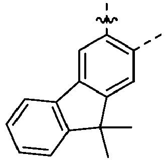 |
| 406 | CH | CH | N | CH | 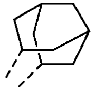 | | 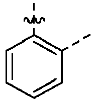 |
| 407 | CH | CH | N | CH | 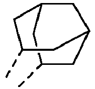 | | 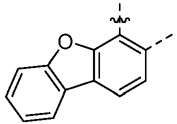 |
| 408 | CH | CH | N | CH | 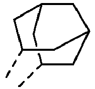 | | 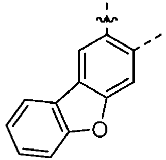 |
| 409 | CH | CH | N | CH | 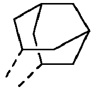 | | 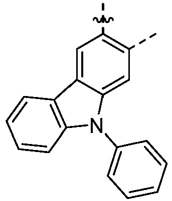 |
| 410 | CH | CH | N | CH | 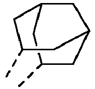 | | 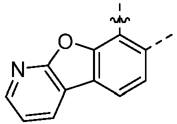 |
| 411 | CH | CH | N | CH | 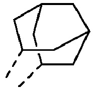 | | 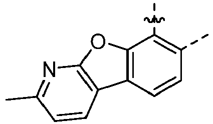 |
| 412 | CH | CH | N | CH | 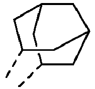 | | 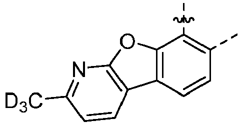 |
| 413 | CH | CH | N | CH | 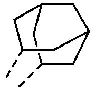 | | 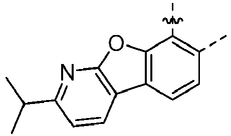 |
| 414 | CH | CH | N | CH | 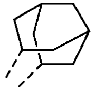 | | 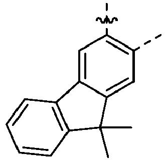 |
| 415 | CH | CH | CH | N | CH₃ | CH₃ | 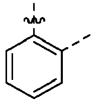 |
| 416 | CH | CH | CH | N | CH₃ | CH₃ | 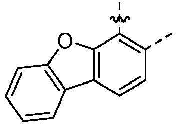 |
| 417 | CH | CH | CH | N | CH₃ | CH₃ | 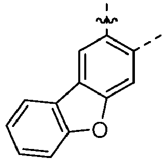 |
| 418 | CH | CH | CH | N | CH₃ | CH₃ | 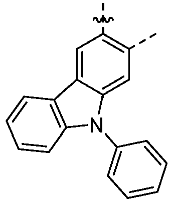 |
| 419 | CH | CH | CH | N | CH₃ | CH₃ | 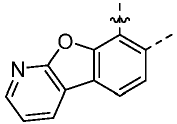 |
| 420 | CH | CH | CH | N | CH₃ | CH₃ | 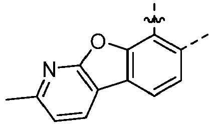 |
| 421 | CH | CH | CH | N | CH₃ | CH₃ | 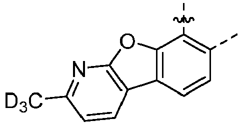 |
| 422 | CH | CH | CH | N | CH₃ | CH₃ | 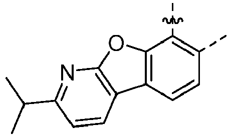 |
| 423 | CH | CH | CH | N | CH₃ | CH₃ | 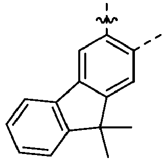 |
| 424 | CH | CH | CH | N | CH₃ | CH₂CH₃ | 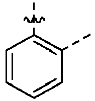 |
| 425 | CH | CH | CH | N | CH₃ | CH₂CH₃ | 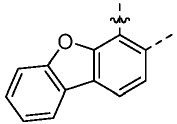 |
| 426 | CH | CH | CH | N | CH₃ | CH₂CH₃ | 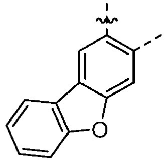 |
| 427 | CH | CH | CH | N | CH₃ | CH₂CH₃ | 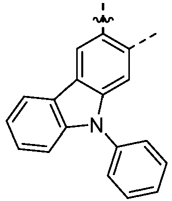 |
| 428 | CH | CH | CH | N | CH₃ | CH₂CH₃ | 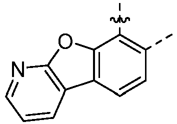 |
| 429 | CH | CH | CH | N | CH₃ | CH₂CH₃ | 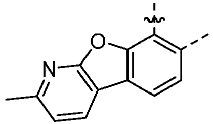 |
| 430 | CH | CH | CH | N | CH₃ | CH₂CH₃ | 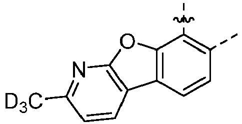 |
| 431 | CH | CH | CH | N | CH₃ | CH₂CH₃ | 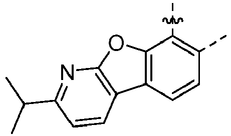 |
| 432 | CH | CH | CH | N | CH₃ | CH₂CH₃ | 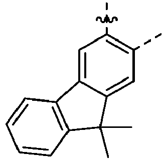 |
| 433 | CH | CH | CH | N | CH₃ | CH(CH₃)₂ | 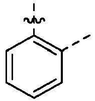 |
| 434 | CH | CH | CH | N | CH₃ | CH(CH₃)₂ | 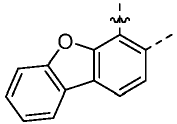 |
| 435 | CH | CH | CH | N | CH₃ | CH(CH₃)₂ | 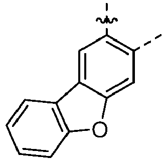 |
| 436 | CH | CH | CH | N | CH₃ | CH(CH₃)₂ | 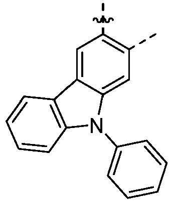 |
| 437 | CH | CH | CH | N | CH₃ | CH(CH₃)₂ | 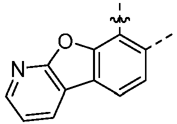 |
| 438 | CH | CH | CH | N | CH₃ | CH(CH₃)₂ | 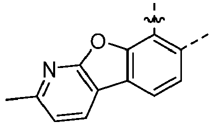 |
| 439 | CH | CH | CH | N | CH₃ | CH(CH₃)₂ | 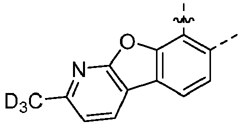 |
| 440 | CH | CH | CH | N | CH₃ | CH(CH₃)₂ | 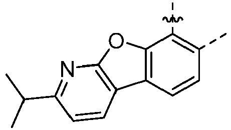 |
| 441 | CH | CH | CH | N | CH₃ | CH(CH₃)₂ | 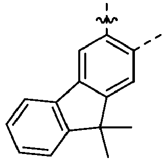 |
| 442 | CH | CH | CH | N | 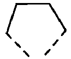 | | 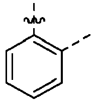 |
| 443 | CH | CH | CH | N | 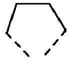 | | 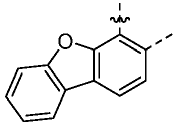 |
| 444 | CH | CH | CH | N | 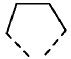 | | 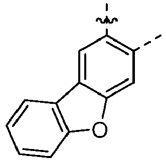 |
| 445 | CH | CH | CH | N | 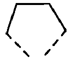 | | 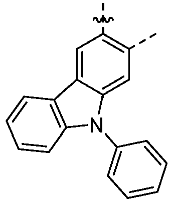 |
| 446 | CH | CH | CH | N | 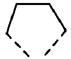 | | 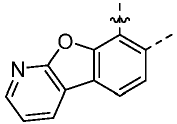 |
| 447 | CH | CH | CH | N | 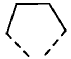 | | 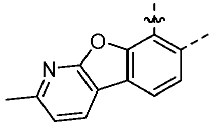 |
| 448 | CH | CH | CH | N | 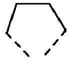 | | 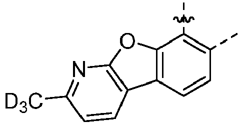 |
| 449 | CH | CH | CH | N | 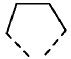 | | 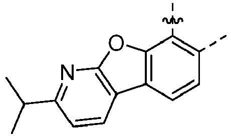 |
| 450 | CH | CH | CH | N | 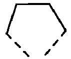 | | 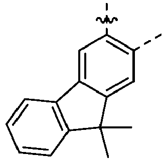 |
| 451 | CH | CH | CH | N | 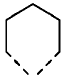 | | 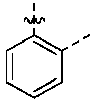 |
| 452 | CH | CH | CH | N | 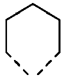 | | 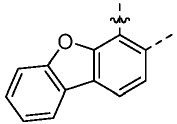 |
| 453 | CH | CH | CH | N | 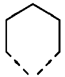 | | 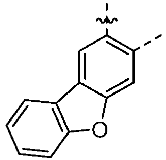 |
| 454 | CH | CH | CH | N | 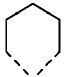 | | 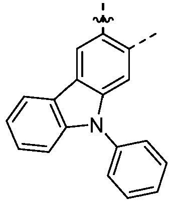 |
| 455 | CH | CH | CH | N | 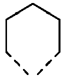 | | 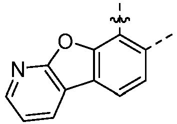 |
| 456 | CH | CH | CH | N | 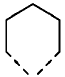 | | 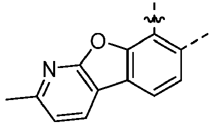 |
| 457 | CH | CH | CH | N | 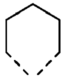 | | 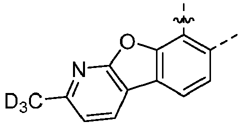 |
| 458 | CH | CH | CH | N | 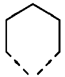 | | 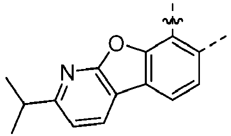 |
| 459 | CH | CH | CH | N | 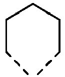 | | 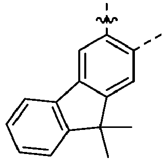 |
| 460 | CH | CH | CH | N | 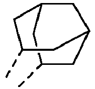 | | 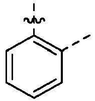 |
| 461 | CH | CH | CH | N | 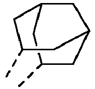 | | 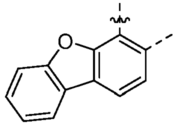 |
| 462 | CH | CH | CH | N | 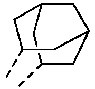 | | 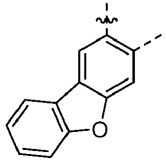 |
| 463 | CH | CH | CH | N | 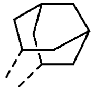 | | 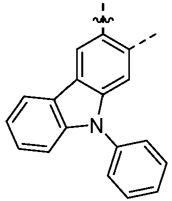 |
| 464 | CH | CH | CH | N | 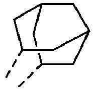 | | 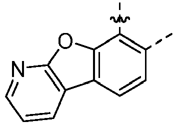 |
| 465 | CH | CH | CH | N | 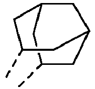 | | 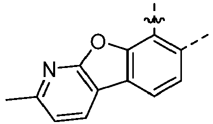 |
| 466 | CH | CH | CH | N | 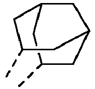 | | 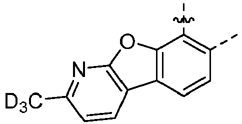 |
| 467 | CH | CH | CH | N | 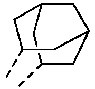 | | 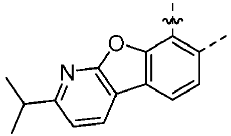 |
| 468 | CH | CH | CH | N | 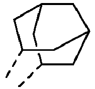 | | 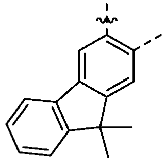 |
| 469 | N | CH | CH | N | CH₃ | CH₃ | 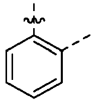 |
| 470 | N | CH | CH | N | CH₃ | CH₃ | 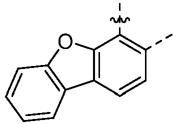 |
| 471 | N | CH | CH | N | CH₃ | CH₃ | 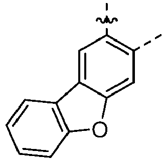 |
| 472 | N | CH | CH | N | CH₃ | CH₃ | 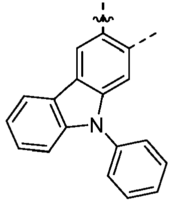 |
| 473 | N | CH | CH | N | CH₃ | CH₃ | 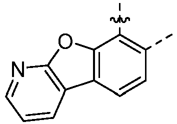 |
| 474 | N | CH | CH | N | CH₃ | CH₃ | 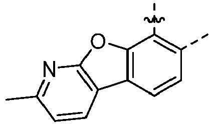 |
| 475 | N | CH | CH | N | CH₃ | CH₃ | 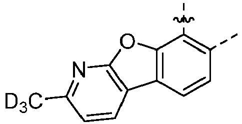 |
| 476 | N | CH | CH | N | CH₃ | CH₃ | 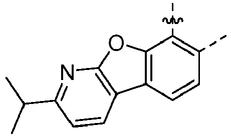 |
| 477 | N | CH | CH | N | CH₃ | CH₃ | 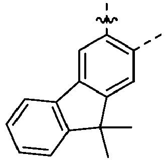 |
| 478 | N | CH | CH | N | CH₃ | CH₂CH₃ | 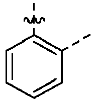 |
| 479 | N | CH | CH | N | CH₃ | CH₂CH₃ | 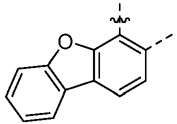 |
| 480 | N | CH | CH | N | CH₃ | CH₂CH₃ | 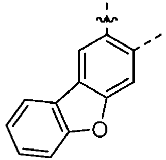 |
| 481 | N | CH | CH | N | CH₃ | CH₂CH₃ | 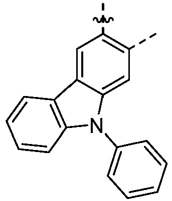 |
| 482 | N | CH | CH | N | CH₃ | CH₂CH₃ | 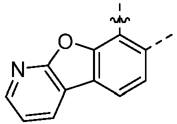 |
| 483 | N | CH | CH | N | CH₃ | CH₂CH₃ | 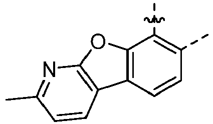 |
| 484 | N | CH | CH | N | CH₃ | CH₂CH₃ | 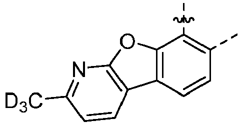 |
| 485 | N | CH | CH | N | CH₃ | CH₂CH₃ | 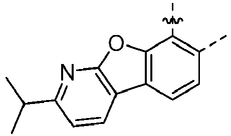 |
| 486 | N | CH | CH | N | CH₃ | CH₂CH₃ | 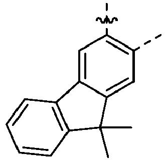 |
| 487 | N | CH | CH | N | CH₃ | CH(CH₃)₂ | 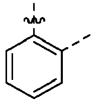 |
| 488 | N | CH | CH | N | CH₃ | CH(CH₃)₂ | 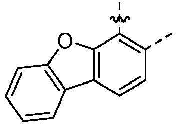 |
| 489 | N | CH | CH | N | CH₃ | CH(CH₃)₂ | 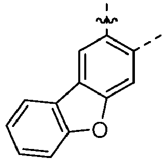 |
| 490 | N | CH | CH | N | CH₃ | CH(CH₃)₂ | 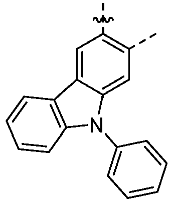 |
| 491 | N | CH | CH | N | CH₃ | CH(CH₃)₂ | 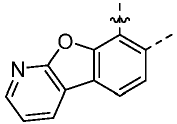 |
| 492 | N | CH | CH | N | CH₃ | CH(CH₃)₂ | 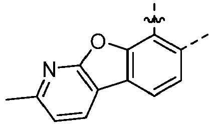 |
| 493 | N | CH | CH | N | CH₃ | CH(CH₃)₂ | 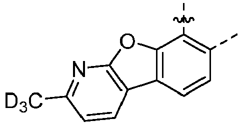 |
| 494 | N | CH | CH | N | CH₃ | CH(CH₃)₂ | 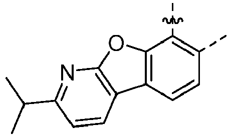 |
| 495 | N | CH | CH | N | CH₃ | CH(CH₃)₂ | 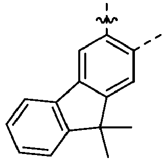 |
| 496 | N | CH | CH | N | 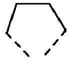 | | 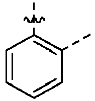 |
| 497 | N | CH | CH | N | 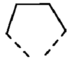 | | 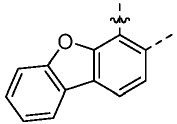 |
| 498 | N | CH | CH | N | 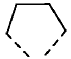 | | 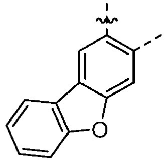 |
| 499 | N | CH | CH | N | 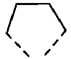 | | 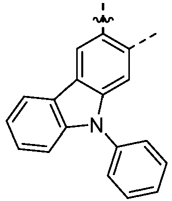 |
| 500 | N | CH | CH | N | 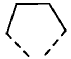 | | 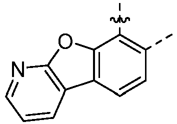 |
| 501 | N | CH | CH | N | 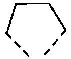 | | 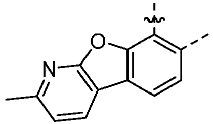 |
| 502 | N | CH | CH | N | 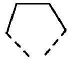 | | 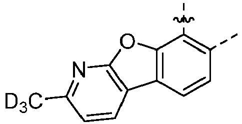 |
| 503 | N | CH | CH | N | 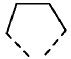 | | 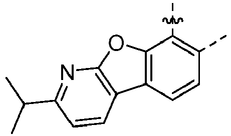 |
| 504 | N | CH | CH | N | 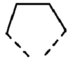 | | 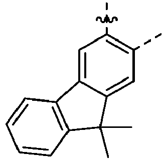 |
| 505 | N | CH | CH | N | 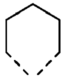 | | 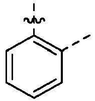 |
| 506 | N | CH | CH | N | 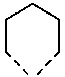 | | 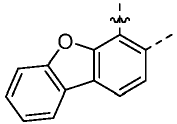 |
| 507 | N | CH | CH | N | 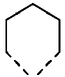 | | 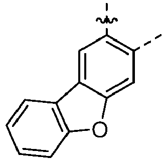 |
| 508 | N | CH | CH | N | 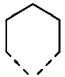 | | 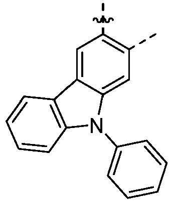 |
| 509 | N | CH | CH | N | 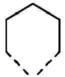 | | 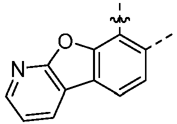 |
| 510 | N | CH | CH | N | 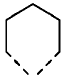 | | 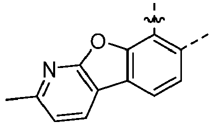 |
| 511 | N | CH | CH | N | 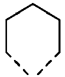 | | 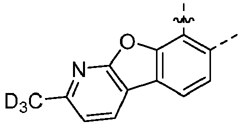 |
| 512 | N | CH | CH | N | 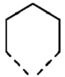 | | 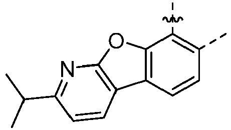 |
| 513 | N | CH | CH | N | 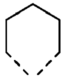 | | 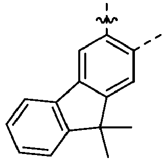 |
| 514 | N | CH | CH | N | 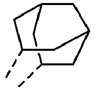 | | 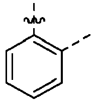 |
| 515 | N | CH | CH | N | 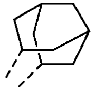 | | 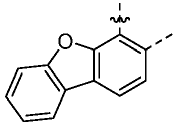 |
| 516 | N | CH | CH | N | 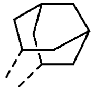 | | 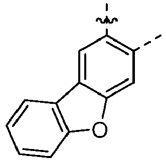 |
| 517 | N | CH | CH | N | 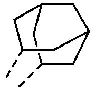 | | 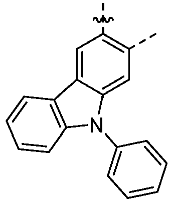 |
| 518 | N | CH | CH | N | 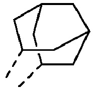 | | 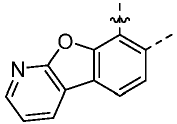 |
| 519 | N | CH | CH | N | 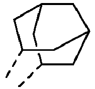 | | 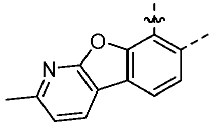 |
| 520 | N | CH | CH | N | 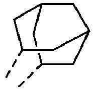 | | 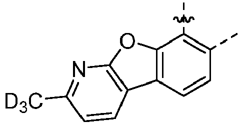 |
| 521 | N | CH | CH | N | 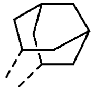 | | 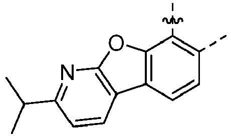 |
| 522 | N | CH | CH | N | 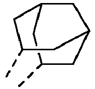 | | 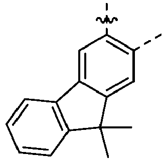 |
| 523 | CH | CH | CH | CH | CD₃ | CD₃ | 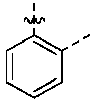 |
| 524 | CH | CH | CH | CH | CD₃ | CD₃ | 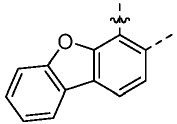 |
| 525 | N | CH | CH | CH | CD₃ | CD₃ | 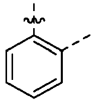 |
| 526 | N | CH | CH | CH | CD₃ | CD₃ | 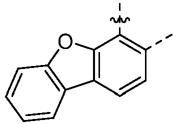 |
| 527 | CH | N | CH | CH | CD₃ | CD₃ | 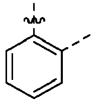 |
| 528 | CH | N | CH | CH | CD₃ | CD₃ | 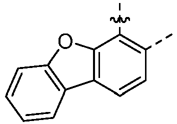 |
| 529 | CH | CH | N | CH | CD₃ | CD₃ | 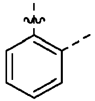 |
| 530 | CH | CH | N | CH | CD₃ | CD₃ | 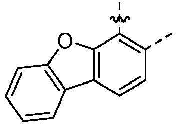 |
| 531 | CH | CH | CH | N | CD₃ | CD₃ | 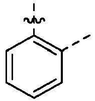 |
| 532 | CH | CH | CH | N | CD₃ | CD₃ | 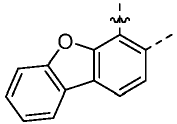 |
| 533 | N | CH | CH | N | CD₃ | CD₃ | 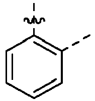 |
| 534 | N | CH | CH | N | CD₃ | CD₃ | 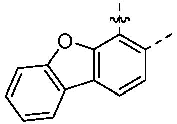 |

10. The compound of claim 1, wherein the ligand L_{A} is selected from the group consisting of:

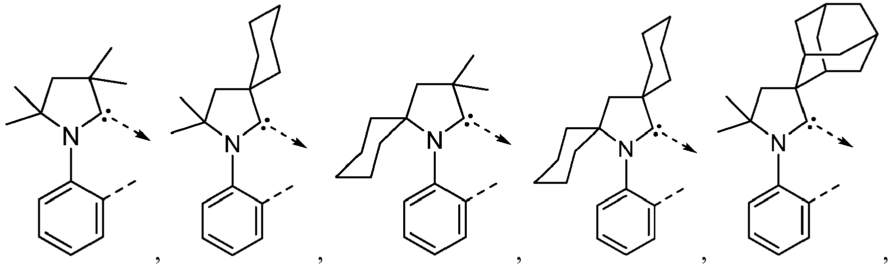

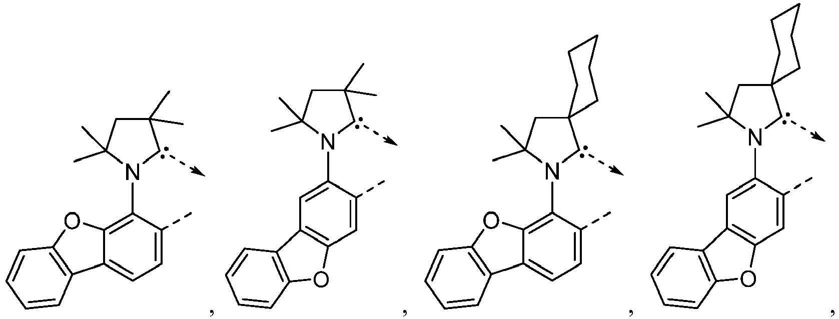

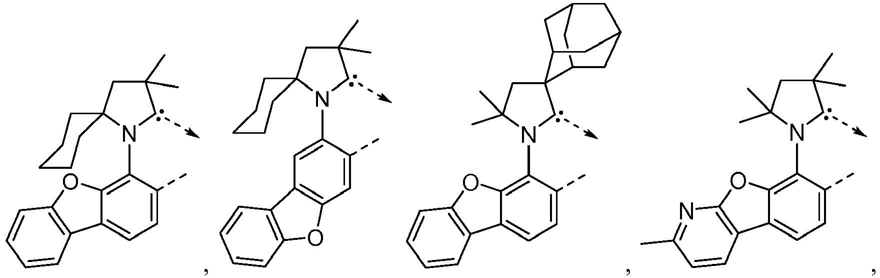

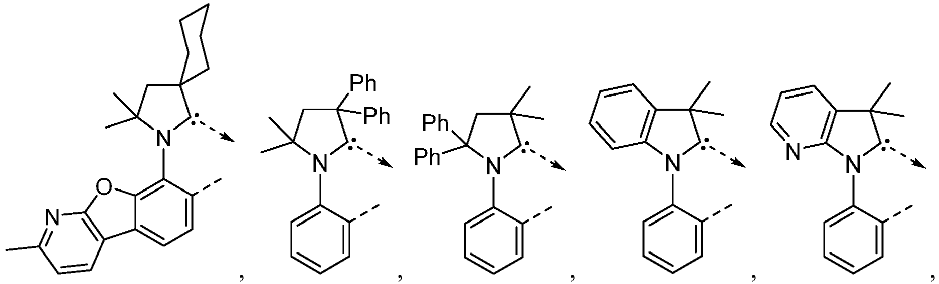

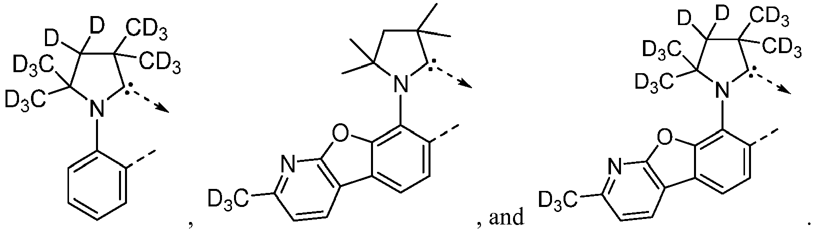

11. The compound of claim 1, wherein the compound has a formula M(L_{A})ₙ(L_{B})ₘ₋ₙ;
wherein M is Ir or Pt;
wherein L_{B} is a bidentate ligand;
wherein, when M is Ir, m is 3, and n is 1, 2, or 3; and
wherein, when M is Pt, m is 2, and n is 1, or 2.

12. The compound of claim 11, wherein L_{B} is another carbene ligand.

13. The compound of claim 11, wherein L_{B} is selected from the group consisting of:

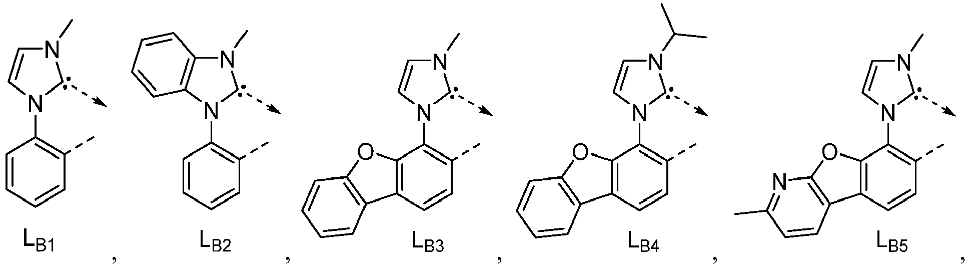

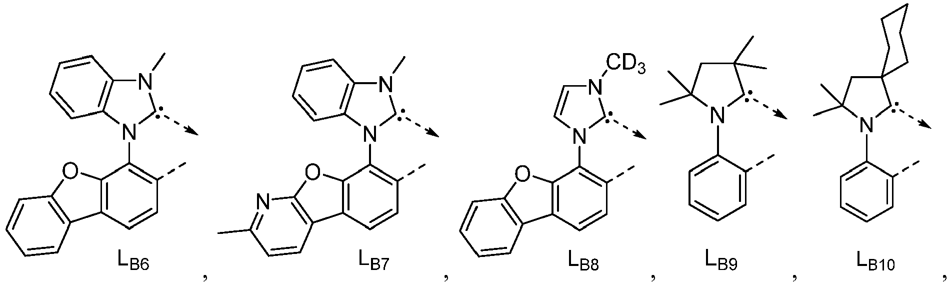

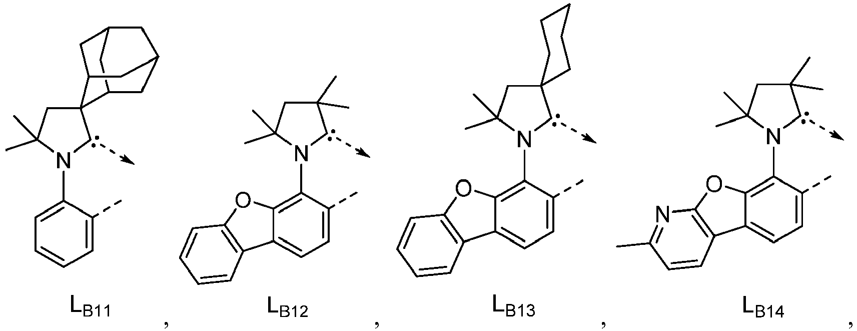

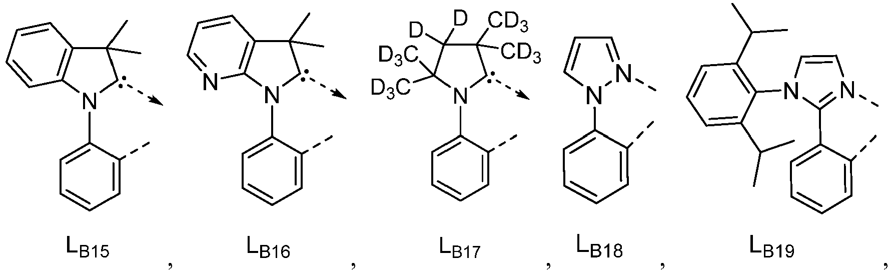

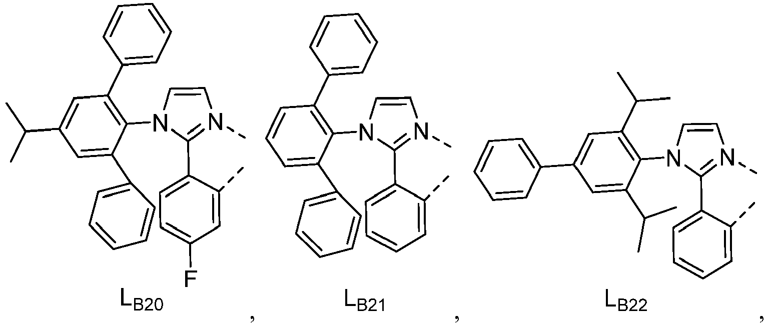

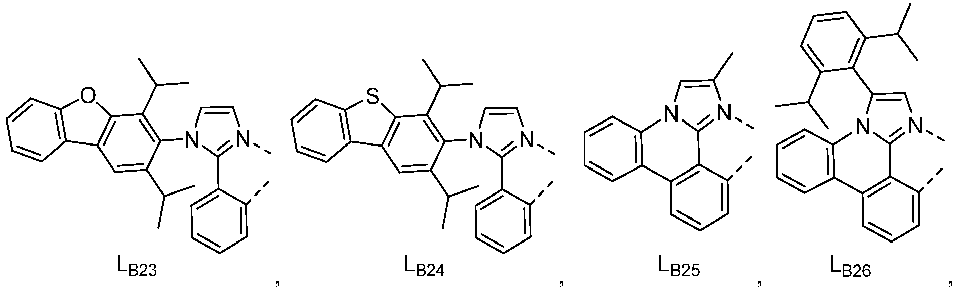

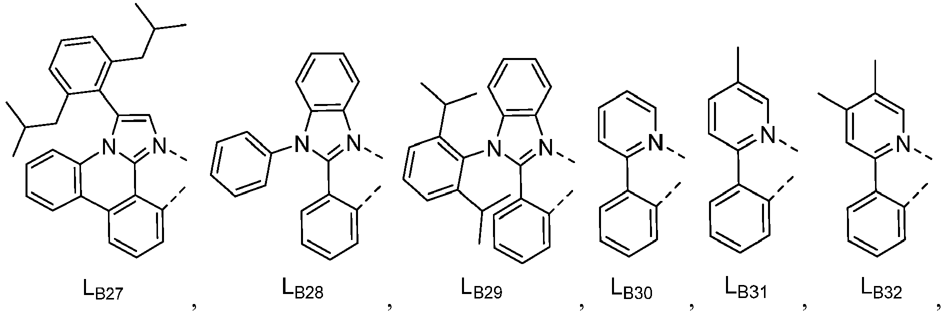

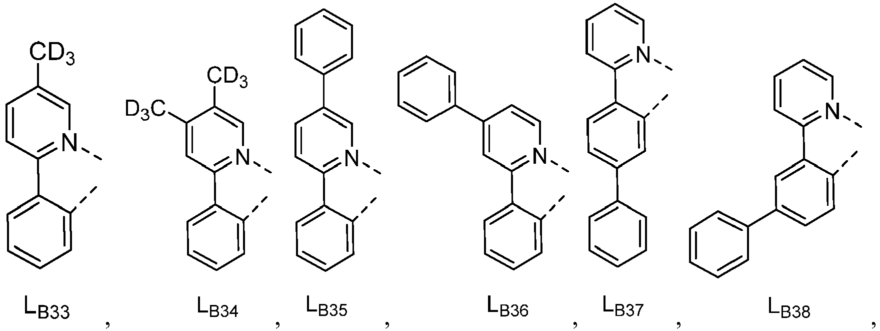

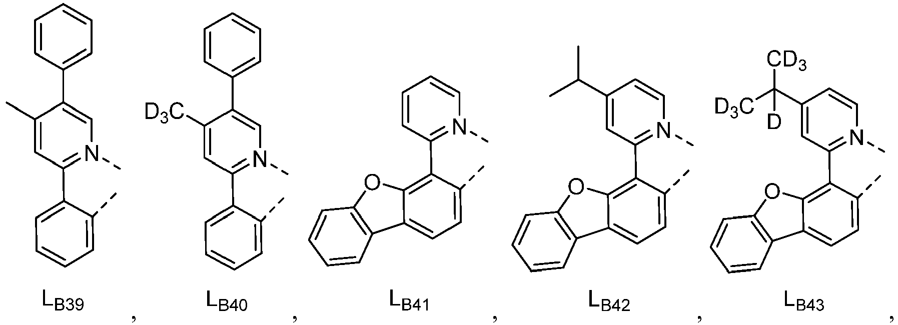

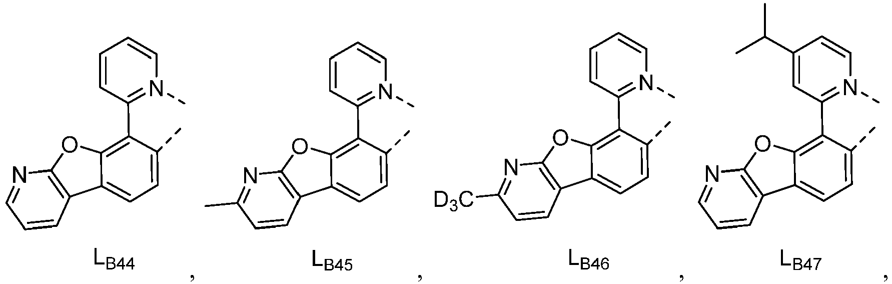

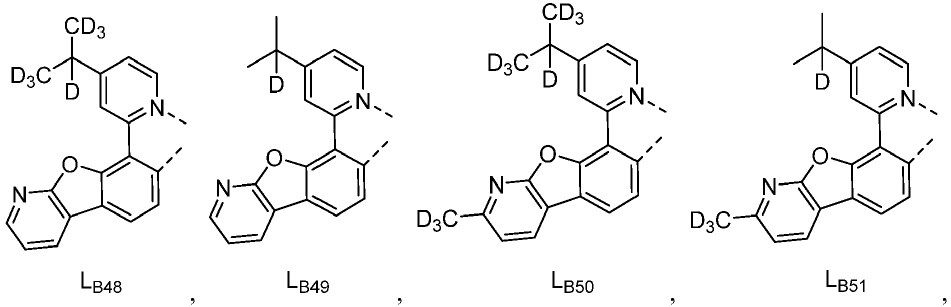

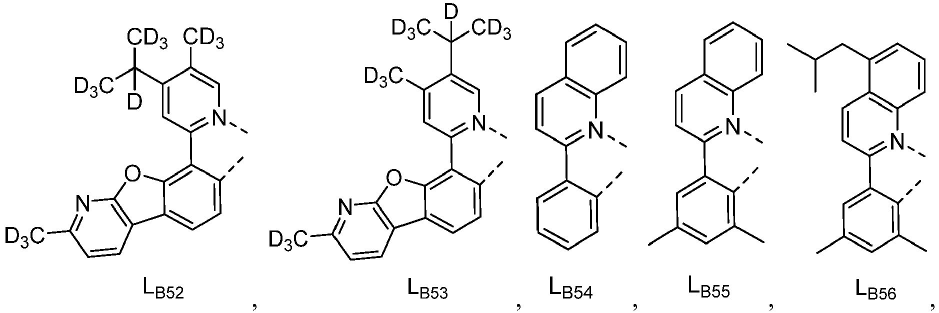

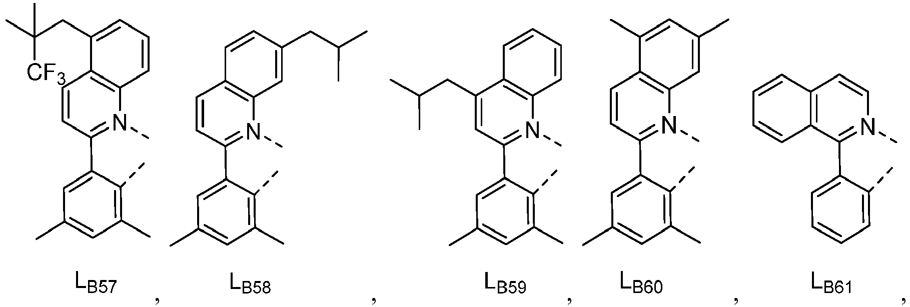

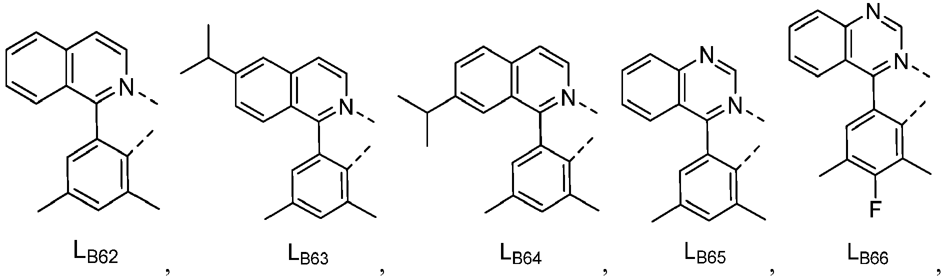

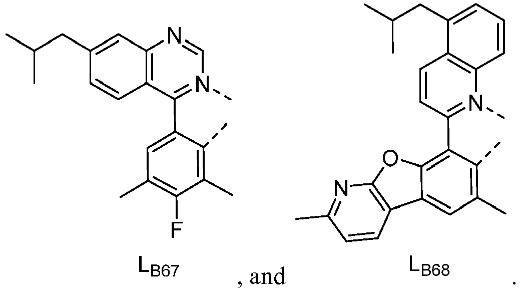

14. The compound of claim 9, wherein the compound is selected from the group consisting of Compound A1 through Compound A534;
wherein each Compound Ax has the formula Ir(L_{A*i*})₃; and
wherein *x* = *i; i* is an integer from 1 to 534.

15. The compound of claim 9, wherein the compound is selected from the group consisting of Compound B1 through Compound B36,312 and Compound C1 through Compound C36,312;
wherein, for Compound B1 through Compound B36,312, each Compound By has the formula Ir(L_{A*i*})(L_{B*j*})₂, wherein *y* = 534*j* + *i* - 533 *i* is an integer from 1 to 534, and *j* is an integer from 1 to 68;
wherein, for Compound C1 through Compound C36,312, each Compound Cz has the formula Ir(L_{A*i*})₂(L_{B*j*}), wherein *z* = 534*j* + *i*+533; *i* is an integer from 1 to 534, and *j* is an integer from 1 to 68; and
wherein L_{B} is selected from the group consisting of:

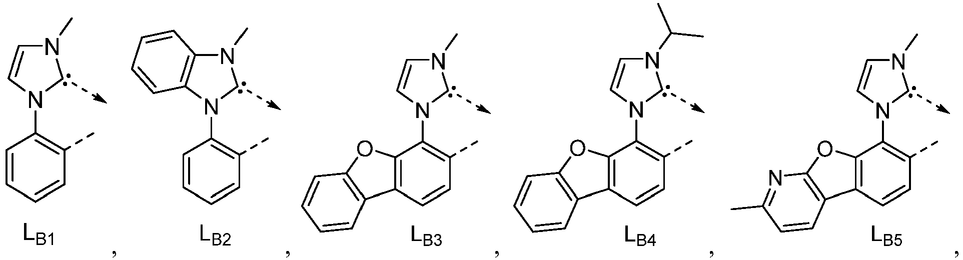

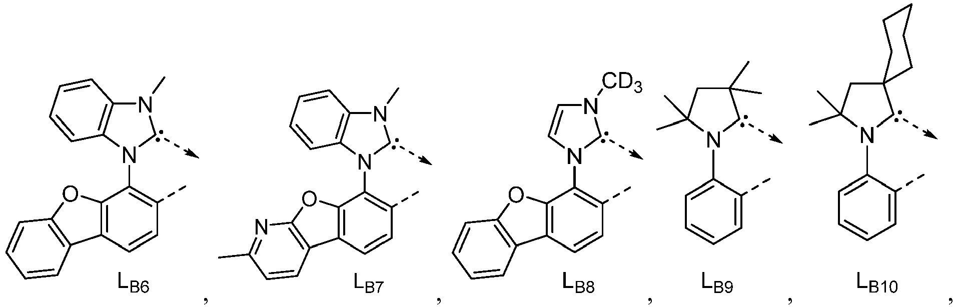

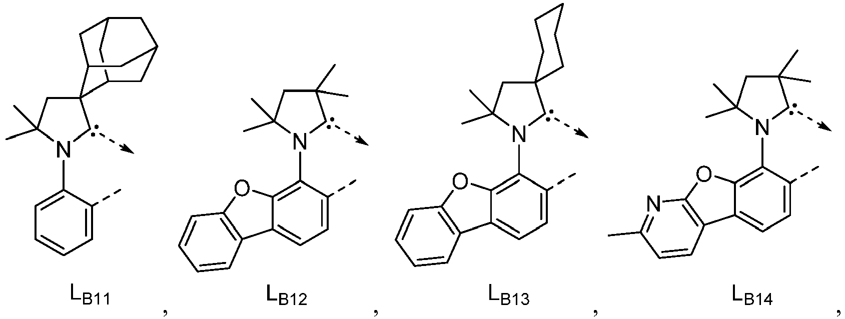

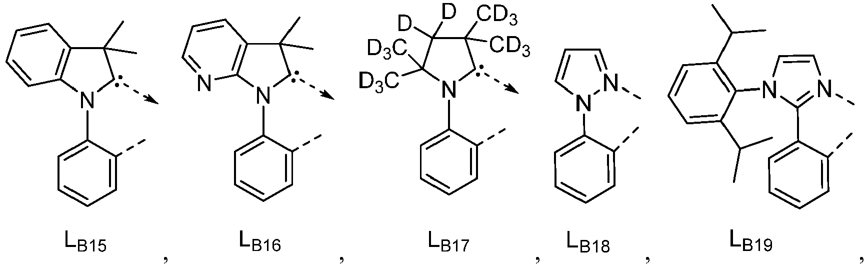

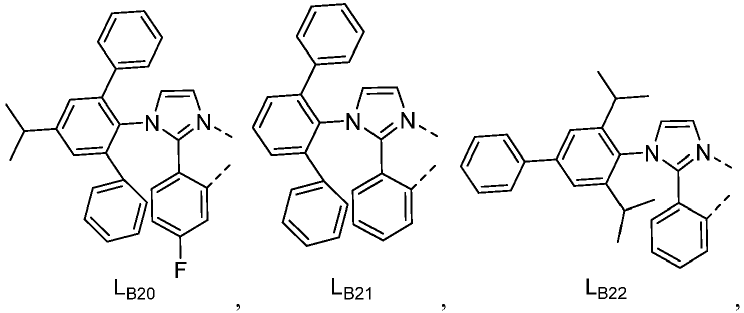

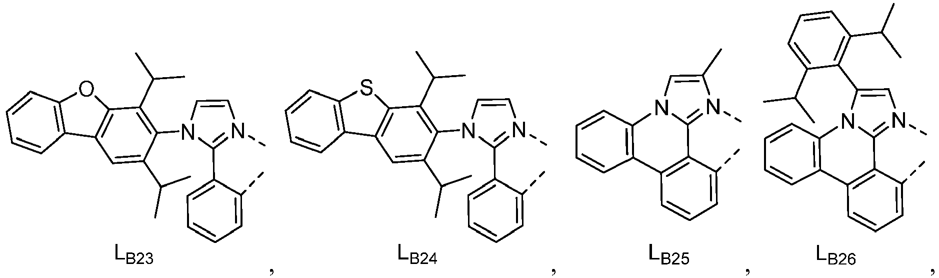

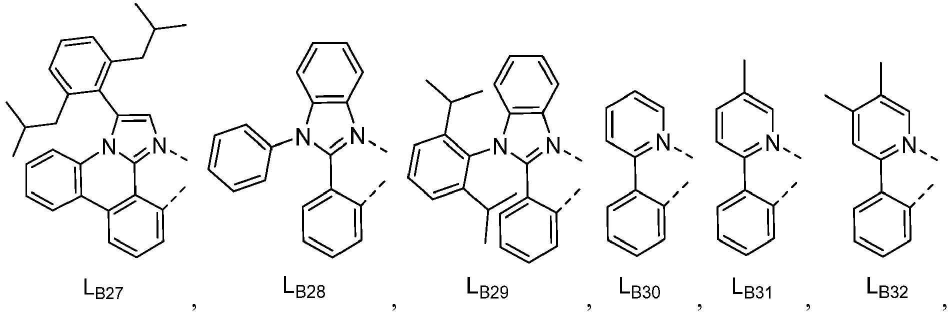

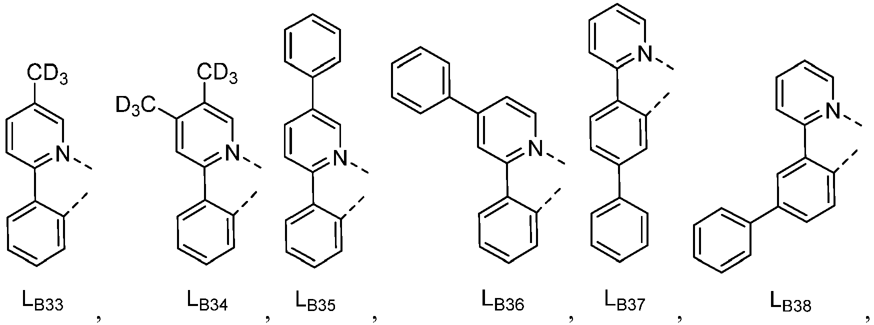

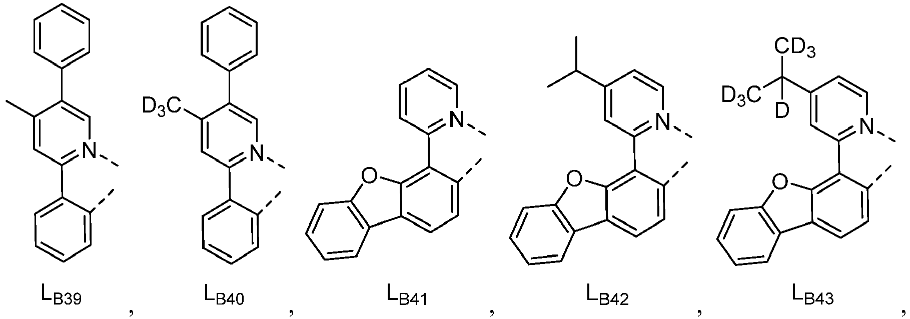

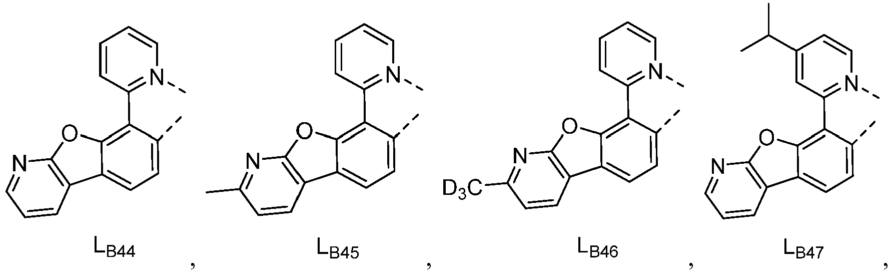

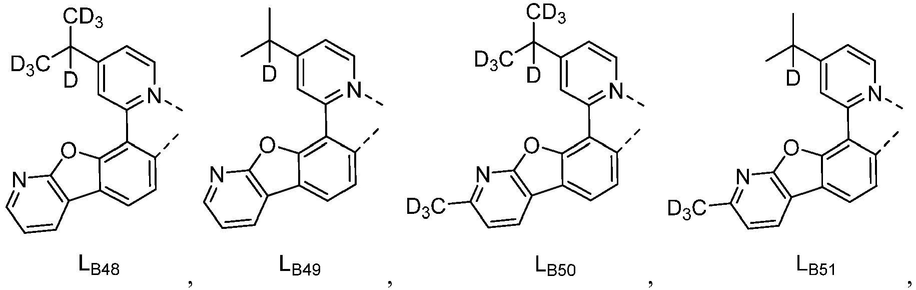

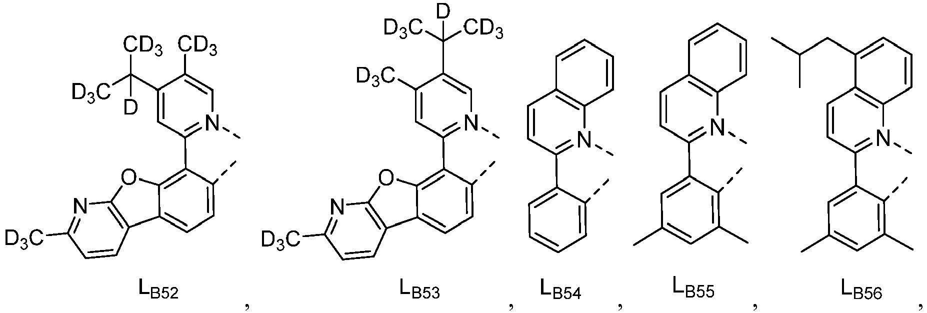

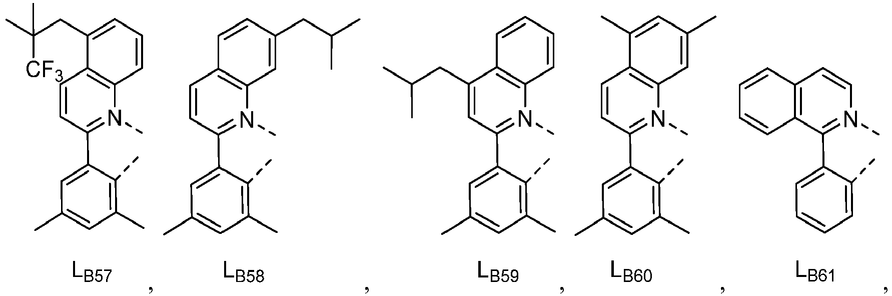

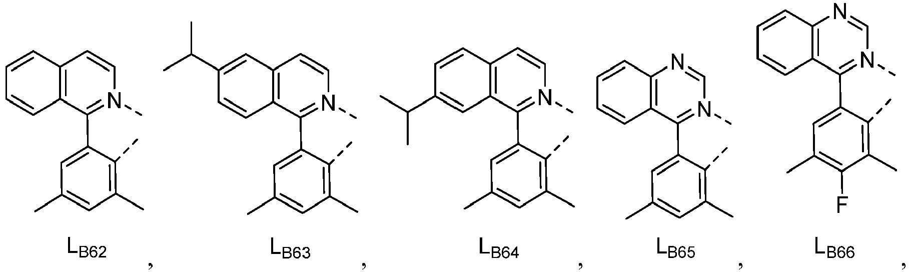

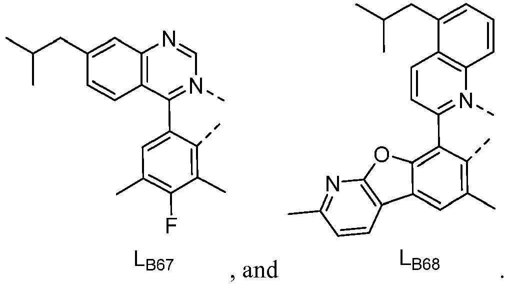

16. A first organic light emitting device comprising:
an anode;
a cathode; and
an organic layer, disposed between the anode and the cathode, comprising a compound comprising a carbene ligand L_{A} of Formula I: 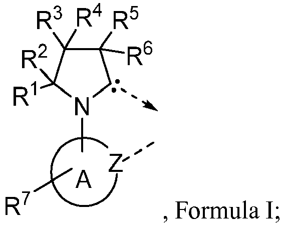
wherein ring A is a 5-membered or 6-membered carbocyclic or heterocyclic ring;
wherein Z is nitrogen or carbon;
wherein R⁷ represents from mono-substitution to the possible maximum number of substitution, or no substitution;
wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein any adjacent substituents of R¹, R², R³, R⁴, R⁵, R⁶, and R⁷ are optionally joined or fused into a ring or a double bond;
wherein the ligand L_{A} is coordinated to a metal M through the carbene carbon and Z; and
wherein the ligand L_{A} is optionally linked with other ligands to comprise a tridentate, tetradentate, pentadentate or hexadentate ligand.

17. The first organic light emitting device of claim 16, wherein the first organic light emitting device is incorporated into a device selected from the group consisting of a consumer product, an electronic component module, an organic light-emitting device, and a lighting panel.

18. The first organic light emitting device of claim 16, wherein the organic layer is an emissive layer and the compound is an emissive dopant or a non-emissive dopant.

19. The first organic light emitting device of claim 16, wherein the organic layer further comprises a host, wherein the host comprises at least one chemical group selected from the group consisting of triphenylene, carbazole, dibenzothiphene, dibenzofuran, dibenzoselenophene, azatriphenylene, azacarbazole, aza-dibenzothiophene, aza-dibenzofuran, and aza-dibenzoselenophene.

20. A formulation comprising a compound comprising a carbene ligand L_{A} of Formula I: 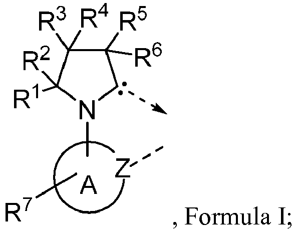
wherein ring A is a 5-membered or 6-membered carbocyclic or heterocyclic ring;
wherein Z is nitrogen or carbon;
wherein R⁷ represents from mono-substitution to the possible maximum number of substitution, or no substitution;
wherein R¹, R², R³, R⁴, R⁵, R⁶, and R⁷ are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein any adjacent substituents of R¹, R², R³, R⁴, R⁵, R⁶, and R⁷ are optionally joined or fused into a ring or a double bond;
wherein the ligand L_{A} is coordinated to a metal M through the carbene carbon and Z; and
wherein the ligand L_{A} is optionally linked with other ligands to comprise a tridentate, tetradentate, pentadentate or hexadentate ligand.

## Patentansprüche

1. Eine Verbindung umfassend einen Carbenliganden L_{A} gemäß Formel I: 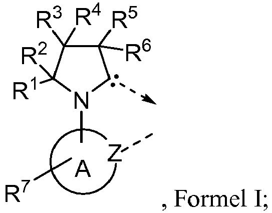
wobei Ring A ein 5-gliedriger oder 6-gliedriger carbozyklischer oder heterozyklischer Ring ist;
wobei Z Stickstoff oder Kohlenstoff ist;
wobei R⁷ für Monosubstitution bis zur maximal möglichen Anzahl von Substitutionen oder keine Substitution steht;
wobei R¹, R², R³, R⁴, R⁵, R⁶ und R⁷ unabhängig voneiander ausgewählt sind aus der Gruppe bestehend aus Wasserstoff, Deuterium, Halogenid, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen;
wobei beliebige benachbarte Substituenten aus R¹, R², R³, R⁴, R⁵, R⁶ und R⁷ gegebenenfalls miteinander verknüpft oder fusioniert sind zu einem Ring oder einer Doppelbindung;
wobei der Ligand L_{A} an ein Metal M koordiniert ist über einenCarbenkohlenstoff und Z; und
wobei der Ligand L_{A} gegebenenfalls mit anderen Liganden verknüpft ist um dreizähnige, vierzähnige, fünfzähnige oder sechszähnige Liganden zu bilden,
mit Ausnahme von 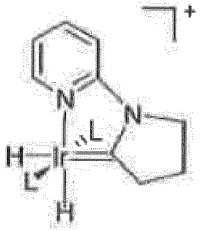 worin L für PPh₃ steht.

2. Die Verbindung nach Anspruch 1, wobei M ausgewählt ist aus der Gruppe bestehend aus Ir, Rh, Re, Ru, Os, Pt, Au und Cu.

3. Die Verbindung nach Anspruch 1 oder 2, wobei Ring A Phenyl ist.

4. Die Verbindung nach einem der Ansprüche 1 bis 3, wobei R¹, R², R³, R⁴, R⁵ und R⁶ unabhängig voneinander ausgewählt sind aus der Gruppe bestehend aus Wasserstoff, Deuterium, Alkyl, Cycloalkyl, Aryl, Heteroaryl und deren Kombinationen.

5. Die Verbindung nach einem der Ansprüche 1 bis 4, wobei beliebige benachbarte Substituenten aus R¹, R², R³, R⁴, R⁵, R⁶ und R⁷ gegebenenfalls verknüpft sind oder fusioniert zu einem nicht aromatischen Ring.

6. Die Verbindung nach einem der Ansprüche 1 bis 4, wobei beliebige benachbare Substituenten aus R¹, R², R³, R⁴, R⁵, R⁶ und R⁷ gegebenfalls verknüpft sind oder zu einem aromatischen Ring fusioniert sind.

7. Die Verbindung nach einem der Ansprüche 1 bis 4, wobei R³ und R⁴ Wasserstoff oder Deuterium sind.

8. Die Verbindung nach Anspruch 1, wobei der Ligand L_{A} die folgende Struktur aufweist: 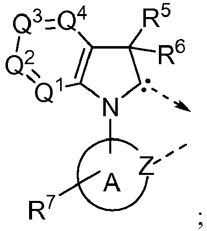
wobei Q¹, Q², Q³ und Q⁴ jeweils unabhängig voneinander ausgewählt sind aus der Gruppe bestehend aus N und CR; und
wobei jedes R unabhängig ausgewählt ist aus der Gruppe bestehend aus Wasserstoff, Deuterium, Halogenid, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino und deren Kombinationen.

9. Die Verbindung nach Anspruch 1, wobei der Ligand L_{A} ausgewählt ist aus der Gruppe bestehend aus L_{A1} bis L_{A534},
wobei die Substituenten R¹, R², R³, R⁴, R⁵, R⁶ und Ring A in L_{A*i*} für *i* = 1 bis 198 wie in Tabelle 1 unten angegeben sind:
**Tabelle 1**
| *i* | R¹ | R² | R³ | R⁴ | R⁵ | R⁶ | Ring A |
|---|---|---|---|---|---|---|---|
| 1 | CH₃ | CH₃ | H | H | CH₃ | CH₃ | 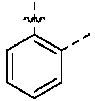 |
| 2 | CH₃ | CH₃ | H | H | CH₃ | CH₃ | 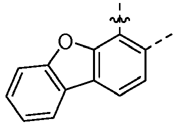 |
| 3 | CH₃ | CH₃ | H | H | CH₃ | CH₃ | 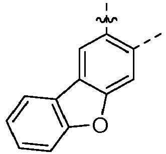 |
| 4 | CH₃ | CH₃ | H | H | CH₃ | CH₃ | 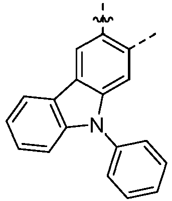 |
| 5 | CH₃ | CH₃ | H | H | CH₃ | CH₃ | 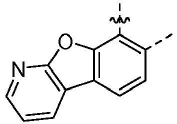 |
| 6 | CH₃ | CH₃ | H | H | CH₃ | CH₃ | 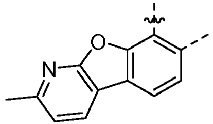 |
| 7 | CH₃ | CH₃ | H | H | CH₃ | CH₃ | 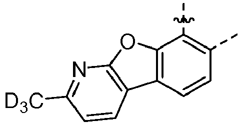 |
| 8 | CH₃ | CH₃ | H | H | CH₃ | CH₃ | 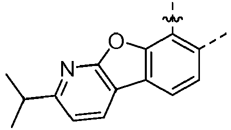 |
| 9 | CH₃ | CH₃ | H | H | CH₃ | CH₃ | 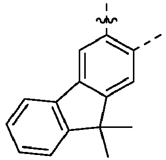 |
| 10 | CH₃ | CH₃ | H | H | CH₃ | CH₂CH₃ | 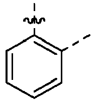 |
| 11 | CH₃ | CH₃ | H | H | CH₃ | CH₂CH₃ | 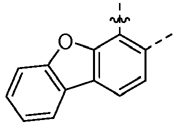 |
| 12 | CH₃ | CH₃ | H | H | CH₃ | CH₂CH₃ | 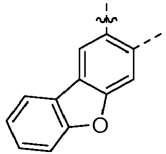 |
| 13 | CH₃ | CH₃ | H | H | CH₃ | CH₂CH₃ | 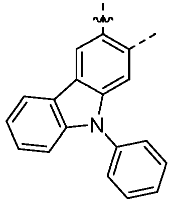 |
| 14 | CH₃ | CH₃ | H | H | CH₃ | CH₂CH₃ | 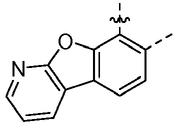 |
| 15 | CH₃ | CH₃ | H | H | CH₃ | CH₂CH₃ | 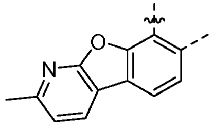 |
| 16 | CH₃ | CH₃ | H | H | CH₃ | CH₂CH₃ | 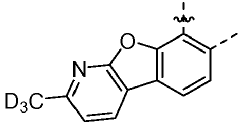 |
| 17 | CH₃ | CH₃ | H | H | CH₃ | CH₂CH₃ | 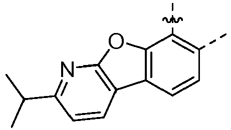 |
| 18 | CH₃ | CH₃ | H | H | CH₃ | CH₂CH₃ | 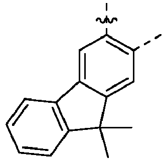 |
| 19 | CH₃ | CH₃ | H | H | CH₃ | CH(CH₃)₂ | 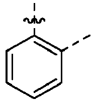 |
| 20 | CH₃ | CH₃ | H | H | CH₃ | CH(CH₃)₂ | 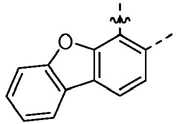 |
| 21 | CH₃ | CH₃ | H | H | CH₃ | CH(CH₃)₂ | 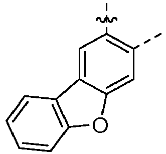 |
| 22 | CH₃ | CH₃ | H | H | CH₃ | CH(CH₃)₂ | 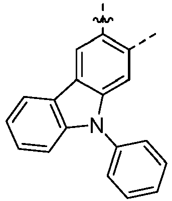 |
| 23 | CH₃ | CH₃ | H | H | CH₃ | CH(CH₃)₂ | 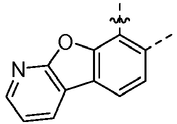 |
| 24 | CH₃ | CH₃ | H | H | CH₃ | CH(CH₃)₂ | 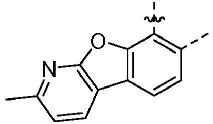 |
| 25 | CH₃ | CH₃ | H | H | CH₃ | CH(CH₃)₂ | 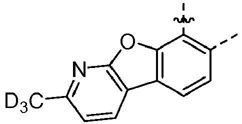 |
| 26 | CH₃ | CH₃ | H | H | CH₃ | CH(CH₃)₂ | 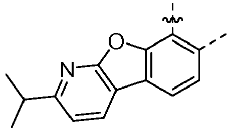 |
| 27 | CH₃ | CH₃ | H | H | CH₃ | CH(CH₃)₂ | 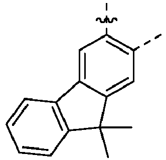 |
| 28 | CH₃ | CH₃ | H | H | CH₂CH₃ | CH₂CH₃ | 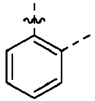 |
| 29 | CH₃ | CH₃ | H | H | CH₂CH₃ | CH₂CH₃ | 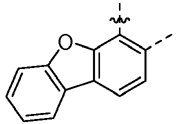 |
| 30 | CH₃ | CH₃ | H | H | CH₂CH₃ | CH₂CH₃ | 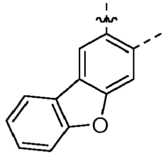 |
| 31 | CH₃ | CH₃ | H | H | CH₂CH₃ | CH₂CH₃ | 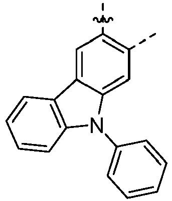 |
| 32 | CH₃ | CH₃ | H | H | CH₂CH₃ | CH₂CH₃ | 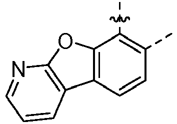 |
| 33 | CH₃ | CH₃ | H | H | CH₂CH₃ | CH₂CH₃ | 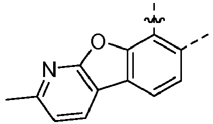 |
| 34 | CH₃ | CH₃ | H | H | CH₂CH₃ | CH₂CH₃ | 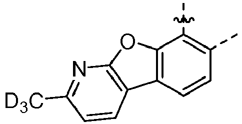 |
| 35 | CH₃ | CH₃ | H | H | CH₂CH₃ | CH₂CH₃ | 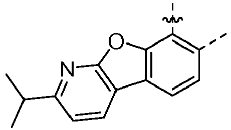 |
| 36 | CH₃ | CH₃ | H | H | CH₂CH₃ | CH₂CH₃ | 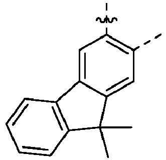 |
| 37 | CH₂CH₃ | CH₃ | H | H | CH₃ | CH₃ | 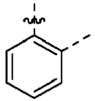 |
| 38 | CH₂CH₃ | CH₃ | H | H | CH₃ | CH₃ | 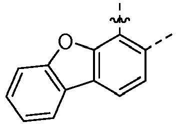 |
| 39 | CH₂CH₃ | CH₃ | H | H | CH₃ | CH₃ | 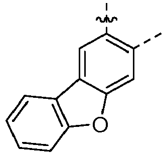 |
| 40 | CH₂CH₃ | CH₃ | H | H | CH₃ | CH₃ | 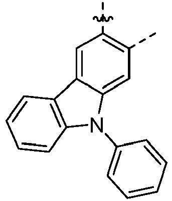 |
| 41 | CH₂CH₃ | CH₃ | H | H | CH₃ | CH₃ | 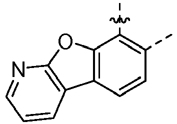 |
| 42 | CH₂CH₃ | CH₃ | H | H | CH₃ | CH₃ | 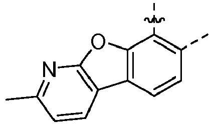 |
| 43 | CH₂CH₃ | CH₃ | H | H | CH₃ | CH₃ | 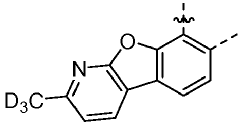 |
| 44 | CH₂CH₃ | CH₃ | H | H | CH₃ | CH₃ | 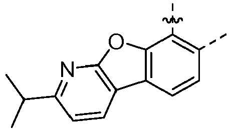 |
| 45 | CH₂CH₃ | CH₃ | H | H | CH₃ | CH₃ | 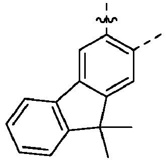 |
| 46 | CH(CH₃)₂ | CH₃ | H | H | CH₃ | CH₃ | 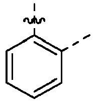 |
| 47 | CH(CH₃)₂ | CH₃ | H | H | CH₃ | CH₃ | 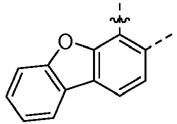 |
| 48 | CH(CH₃)₂ | CH₃ | H | H | CH₃ | CH₃ | 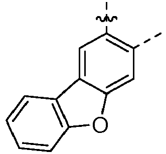 |
| 49 | CH(CH₃)₂ | CH₃ | H | H | CH₃ | CH₃ | 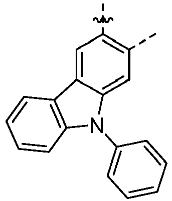 |
| 50 | CH(CH₃)₂ | CH₃ | H | H | CH₃ | CH₃ | 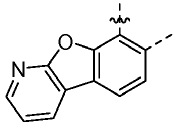 |
| 51 | CH(CH₃)₂ | CH₃ | H | H | CH₃ | CH₃ | 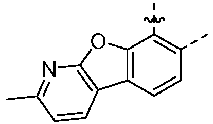 |
| 52 | CH(CH₃)₂ | CH₃ | H | H | CH₃ | CH₃ | 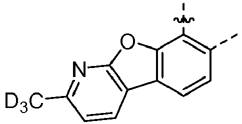 |
| 53 | CH(CH₃)₂ | CH₃ | H | H | CH₃ | CH₃ | 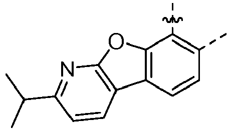 |
| 54 | CH(CH₃)₂ | CH₃ | H | H | CH₃ | CH₃ | 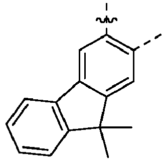 |
| 55 | CH₂CH₃ | CH₂CH₃ | H | H | CH₃ | CH₃ | 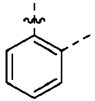 |
| 56 | CH₂CH₃ | CH₂CH₃ | H | H | CH₃ | CH₃ | 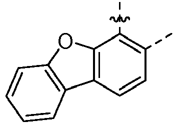 |
| 57 | CH₂CH₃ | CH₂CH₃ | H | H | CH₃ | CH₃ | 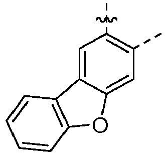 |
| 58 | CH₂CH₃ | CH₂CH₃ | H | H | CH₃ | CH₃ | 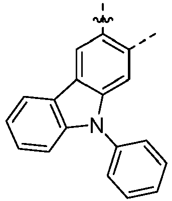 |
| 59 | CH₂CH₃ | CH₂CH₃ | H | H | CH₃ | CH₃ | 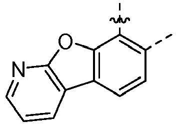 |
| 60 | CH₂CH₃ | CH₂CH₃ | H | H | CH₃ | CH₃ | 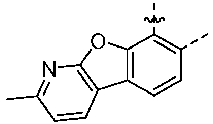 |
| 61 | CH₂CH₃ | CH₂CH₃ | H | H | CH₃ | CH₃ | 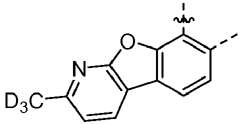 |
| 62 | CH₂CH₃ | CH₂CH₃ | H | H | CH₃ | CH₃ | 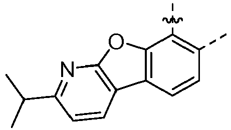 |
| 63 | CH₂CH₃ | CH₂CH₃ | H | H | CH₃ | CH₃ | 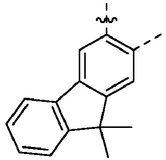 |
| 64 | CH₃ | CH₃ | H | H | 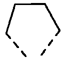 | | 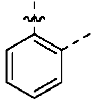 |
| 65 | CH₃ | CH₃ | H | H | 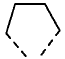 | | 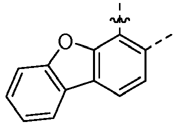 |
| 66 | CH₃ | CH₃ | H | H | 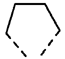 | | 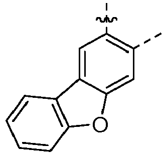 |
| 67 | CH₃ | CH₃ | H | H | 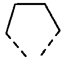 | | 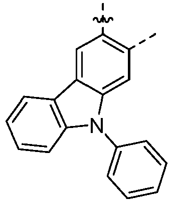 |
| 68 | CH₃ | CH₃ | H | H | 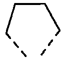 | | 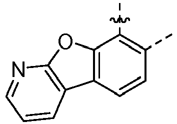 |
| 69 | CH₃ | CH₃ | H | H | 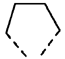 | | 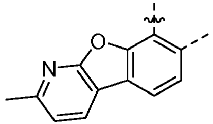 |
| 70 | CH₃ | CH₃ | H | H | 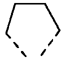 | | 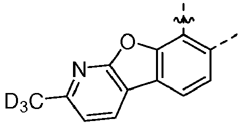 |
| 71 | CH₃ | CH₃ | H | H | 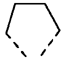 | | 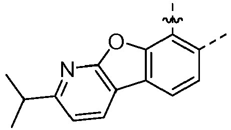 |
| 72 | CH₃ | CH₃ | H | H | 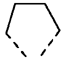 | | 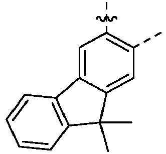 |
| 73 | CH₃ | CH₃ | H | H | 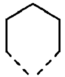 | | 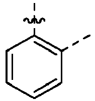 |
| 74 | CH₃ | CH₃ | H | H | 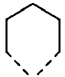 | | 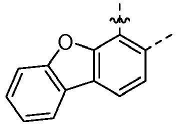 |
| 75 | CH₃ | CH₃ | H | H | 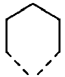 | | 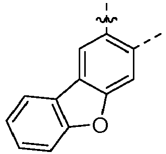 |
| 76 | CH₃ | CH₃ | H | H | 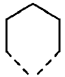 | | 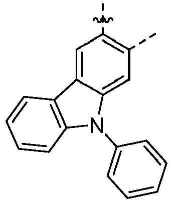 |
| 77 | CH₃ | CH₃ | H | H | 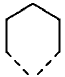 | | 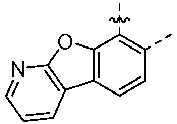 |
| 78 | CH₃ | CH₃ | H | H | 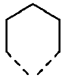 | | 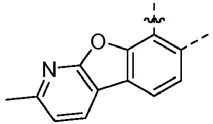 |
| 79 | CH₃ | CH₃ | H | H | 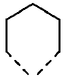 | | 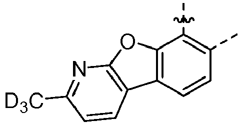 |
| 80 | CH₃ | CH₃ | H | H | 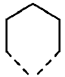 | | 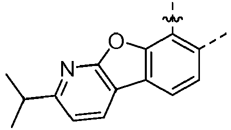 |
| 81 | CH₃ | CH₃ | H | H | 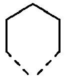 | | 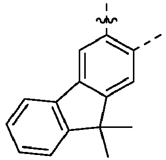 |
| 82 | CH₃ | CH₃ | H | H | 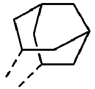 | | 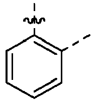 |
| 83 | CH₃ | CH₃ | H | H | 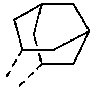 | | 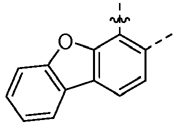 |
| 84 | CH₃ | CH₃ | H | H | 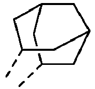 | | 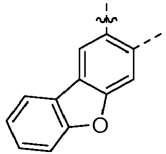 |
| 85 | CH₃ | CH₃ | H | H | 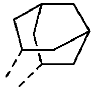 | | 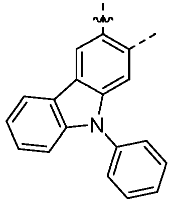 |
| 86 | CH₃ | CH₃ | H | H | 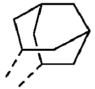 | | 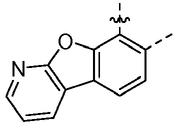 |
| 87 | CH₃ | CH₃ | H | H | 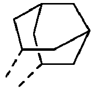 | | 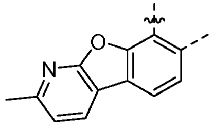 |
| 88 | CH₃ | CH₃ | H | H | 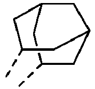 | | 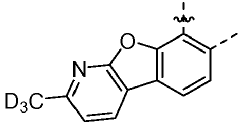 |
| 89 | CH₃ | CH₃ | H | H | 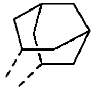 | | 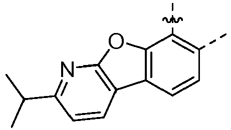 |
| 90 | CH₃ | CH₃ | H | H | 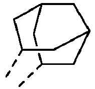 | | 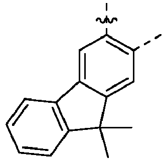 |
| 91 | 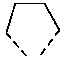 | | H | H | CH₃ | CH₃ | 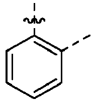 |
| 92 | 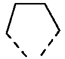 | | H | H | CH₃ | CH₃ | 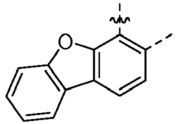 |
| 93 | 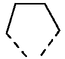 | | H | H | CH₃ | CH₃ | 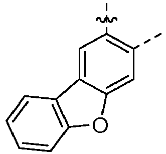 |
| 94 | 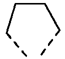 | | H | H | CH₃ | CH₃ | 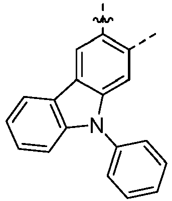 |
| 95 | 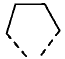 | | H | H | CH₃ | CH₃ | 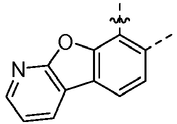 |
| 96 | 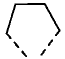 | | H | H | CH₃ | CH₃ | 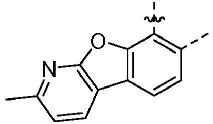 |
| 97 | 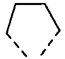 | | H | H | CH₃ | CH₃ | 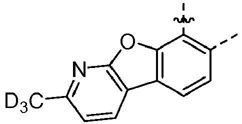 |
| 98 | 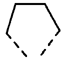 | | H | H | CH₃ | CH₃ | 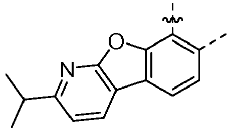 |
| 99 | 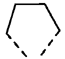 | | H | H | CH₃ | CH₃ | 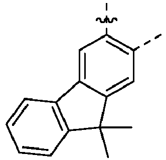 |
| 100 | 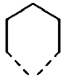 | | H | H | CH₃ | CH₃ | 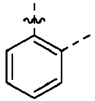 |
| 101 | 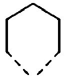 | | H | H | CH₃ | CH₃ | 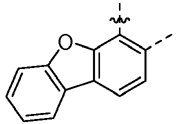 |
| 102 | 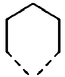 | | H | H | CH₃ | CH₃ | 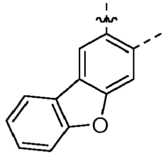 |
| 103 | 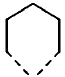 | | H | H | CH₃ | CH₃ | 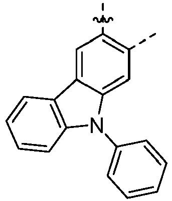 |
| 104 | 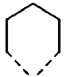 | | H | H | CH₃ | CH₃ | 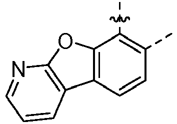 |
| 105 | 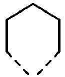 | | H | H | CH₃ | CH₃ | 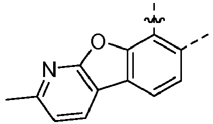 |
| 106 | 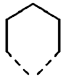 | | H | H | CH₃ | CH₃ | 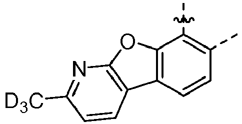 |
| 107 | 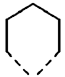 | | H | H | CH₃ | CH₃ | 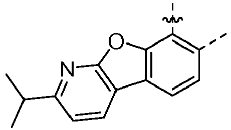 |
| 108 | 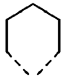 | | H | H | CH₃ | CH₃ | 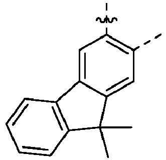 |
| 109 | 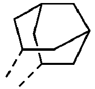 | | H | H | CH₃ | CH₃ | 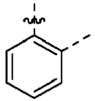 |
| 110 | 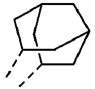 | | H | H | CH₃ | CH₃ | 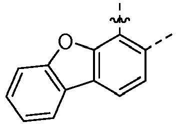 |
| 111 | 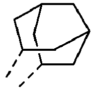 | | H | H | CH₃ | CH₃ | 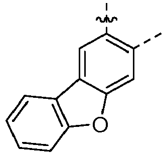 |
| 112 | 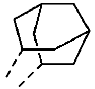 | | H | H | CH₃ | CH₃ | 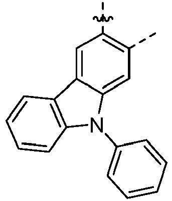 |
| 113 | 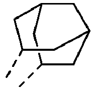 | | H | H | CH₃ | CH₃ | 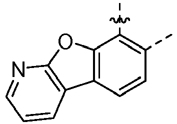 |
| 114 | 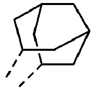 | | H | H | CH₃ | CH₃ | 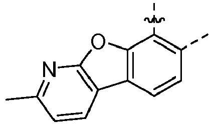 |
| 115 | 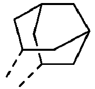 | | H | H | CH₃ | CH₃ | 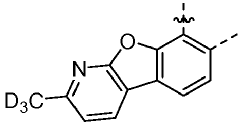 |
| 116 | 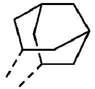 | | H | H | CH₃ | CH₃ | 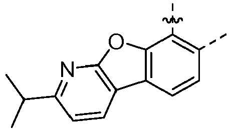 |
| 117 | 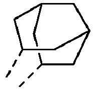 | | H | H | CH₃ | CH₃ | 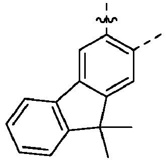 |
| 118 | 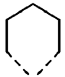 | | H | H | 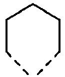 | | 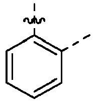 |
| 119 | 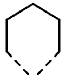 | | H | H | 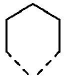 | | 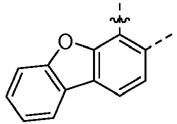 |
| 120 | 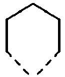 | | H | H | 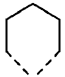 | | 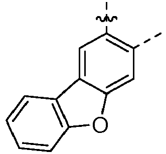 |
| 121 | 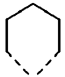 | | H | H | 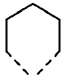 | | 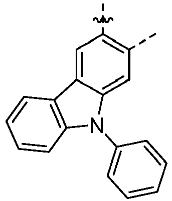 |
| 122 | 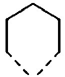 | | H | H | 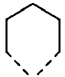 | | 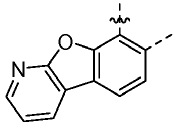 |
| 123 | 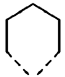 | | H | H | 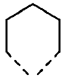 | | 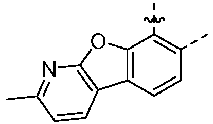 |
| 124 | 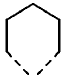 | | H | H | 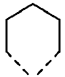 | | 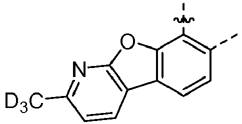 |
| 125 | 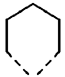 | | H | H | 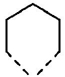 | | 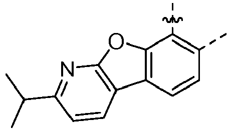 |
| 126 | 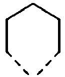 | | H | H | 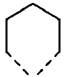 | | 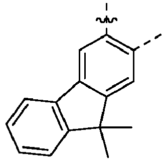 |
| 127 | CD₃ | CD₃ | H | H | CD₃ | CD₃ | 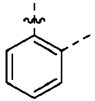 |
| 128 | CD₃ | CD₃ | H | H | CD₃ | CD₃ | 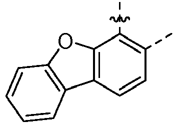 |
| 129 | CD₃ | CD₃ | H | H | CD₃ | CD₃ | 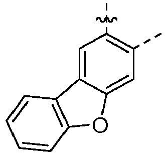 |
| 130 | CD₃ | CD₃ | H | H | CD₃ | CD₃ | 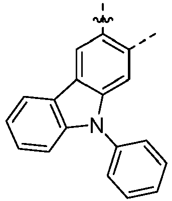 |
| 131 | CD₃ | CD₃ | H | H | CD₃ | CD₃ | 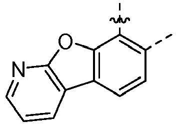 |
| 132 | CD₃ | CD₃ | H | H | CD₃ | CD₃ | 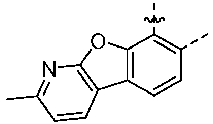 |
| 133 | CD₃ | CD₃ | H | H | CD₃ | CD₃ | 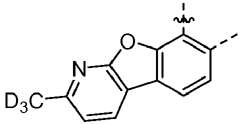 |
| 134 | CD₃ | CD₃ | H | H | CD₃ | CD₃ | 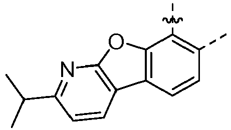 |
| 135 | CD₃ | CD₃ | H | H | CD₃ | CD₃ | 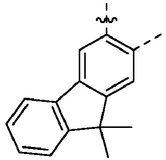 |
| 136 | CD₃ | CD₃ | D | D | CD₃ | CD₃ | 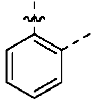 |
| 137 | CD₃ | CD₃ | D | D | CD₃ | CD₃ | 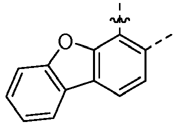 |
| 138 | CD₃ | CD₃ | D | D | CD₃ | CD₃ | 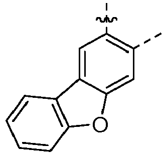 |
| 139 | CD₃ | CD₃ | D | D | CD₃ | CD₃ | 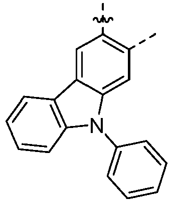 |
| 140 | CD₃ | CD₃ | D | D | CD₃ | CD₃ | 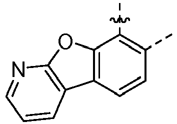 |
| 141 | CD₃ | CD₃ | D | D | CD₃ | CD₃ | 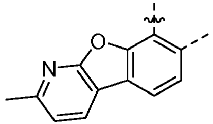 |
| 142 | CD₃ | CD₃ | D | D | CD₃ | CD₃ | 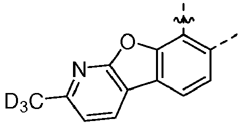 |
| 143 | CD₃ | CD₃ | D | D | CD₃ | CD₃ | 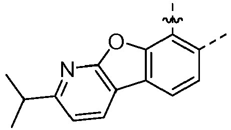 |
| 144 | CD₃ | CD₃ | D | D | CD₃ | CD₃ | 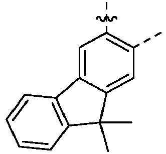 |
| 145 | CD₃ | CD₃ | D | D | CD₃ | CD(CD₃)₂ | 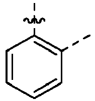 |
| 146 | CD₃ | CD₃ | D | D | CD₃ | CD(CD₃)₂ | 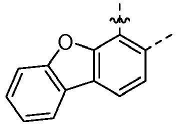 |
| 147 | CD₃ | CD₃ | D | D | CD₃ | CD(CD₃)₂ | 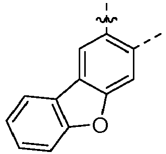 |
| 148 | CD₃ | CD₃ | D | D | CD₃ | CD(CD₃)₂ | 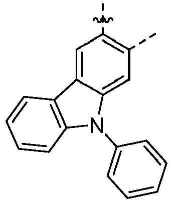 |
| 149 | CD₃ | CD₃ | D | D | CD₃ | CD(CD₃)₂ | 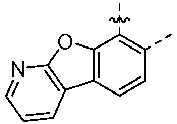 |
| 150 | CD₃ | CD₃ | D | D | CD₃ | CD(CD₃)₂ | 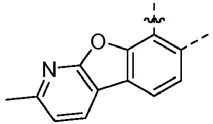 |
| 151 | CD₃ | CD₃ | D | D | CD₃ | CD(CD₃)₂ | 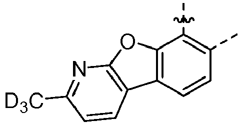 |
| 152 | CD₃ | CD₃ | D | D | CD₃ | CD(CD₃)₂ | 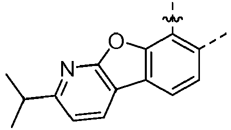 |
| 153 | CD₃ | CD₃ | D | D | CD₃ | CD(CD₃)₂ | 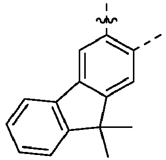 |
| 154 | CH₃ | CH₃ | H | H | CH₃ | CH₂CH₂CF₃ | 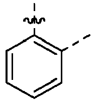 |
| 155 | CH₃ | CH₃ | H | H | CH₃ | CH₂CH₂CF₃ | 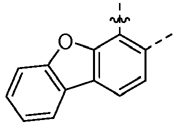 |
| 156 | CH₃ | CH₃ | H | H | CH₃ | CH₂CH₂CF₃ | 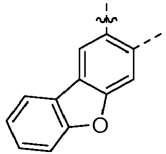 |
| 157 | CH₃ | CH₃ | H | H | CH₃ | CH₂CH₂CF₃ | 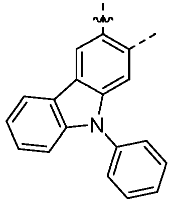 |
| 158 | CH₃ | CH₃ | H | H | CH₃ | CH₂CH₂CF₃ | 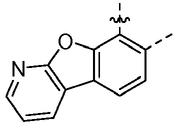 |
| 159 | CH₃ | CH₃ | H | H | CH₃ | CH₂CH₂CF₃ | 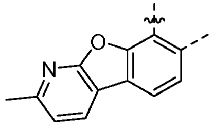 |
| 160 | CH₃ | CH₃ | H | H | CH₃ | CH₂CH₂CF₃ | 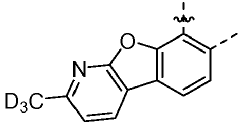 |
| 161 | CH₃ | CH₃ | H | H | CH₃ | CH₂CH₂CF₃ | 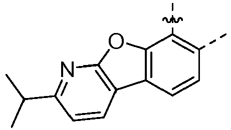 |
| 162 | CH₃ | CH₃ | H | H | CH₃ | CH₂CH₂CF₃ | 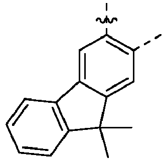 |
| 163 | CH₂CH₂CF₃ | CH₃ | H | H | CH₃ | CH₃ | 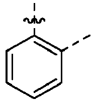 |
| 164 | CH₂CH₂CF₃ | CH₃ | H | H | CH₃ | CH₃ | 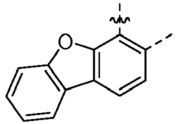 |
| 165 | CH₂CH₂CF₃ | CH₃ | H | H | CH₃ | CH₃ | 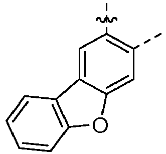 |
| 166 | CH₂CH₂CF₃ | CH₃ | H | H | CH₃ | CH₃ | 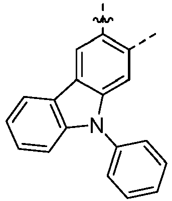 |
| 167 | CH₂CH₂CF₃ | CH₃ | H | H | CH₃ | CH₃ | 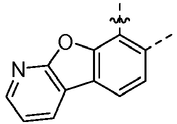 |
| 168 | CH₂CH₂CF₃ | CH₃ | H | H | CH₃ | CH₃ | 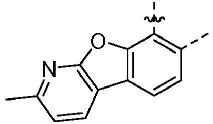 |
| 169 | CH₂CH₂CF₃ | CH₃ | H | H | CH₃ | CH₃ | 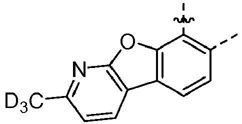 |
| 170 | CH₂CH₂CF₃ | CH₃ | H | H | CH₃ | CH₃ | 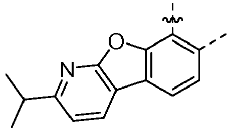 |
| 171 | CH₂CH₂CF₃ | CH₃ | H | H | CH₃ | CH₃ | 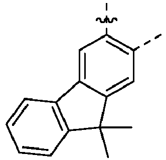 |
| 172 | CH₃ | CH₃ | H | H | CH₃ | CF₃ | 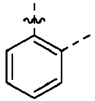 |
| 173 | CH₃ | CH₃ | H | H | CH₃ | CF₃ | 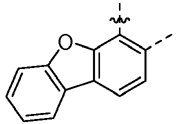 |
| 174 | CH₃ | CH₃ | H | H | CH₃ | CF₃ | 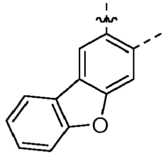 |
| 175 | CH₃ | CH₃ | H | H | CH₃ | CF₃ | 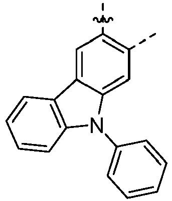 |
| 176 | CH₃ | CH₃ | H | H | CH₃ | CF₃ | 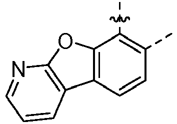 |
| 177 | CH₃ | CH₃ | H | H | CH₃ | CF₃ | 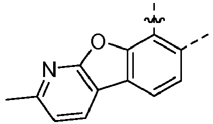 |
| 178 | CH₃ | CH₃ | H | H | CH₃ | CF₃ | 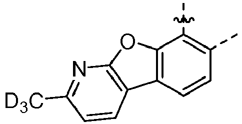 |
| 179 | CH₃ | CH₃ | H | H | CH₃ | CF₃ | 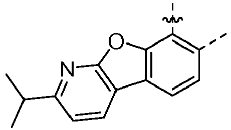 |
| 180 | CH₃ | CH₃ | H | H | CH₃ | CF₃ | 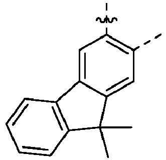 |
| 181 | CH₃ | CH₃ | H | H | CF₃ | CF₃ | 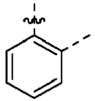 |
| 182 | CH₃ | CH₃ | H | H | CF₃ | CF₃ | 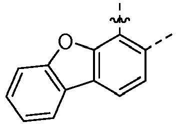 |
| 183 | CH₃ | CH₃ | H | H | CF₃ | CF₃ | 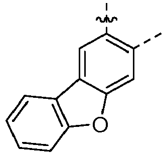 |
| 184 | CH₃ | CH₃ | H | H | CF₃ | CF₃ | 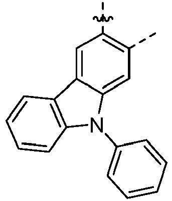 |
| 185 | CH₃ | CH₃ | H | H | CF₃ | CF₃ | 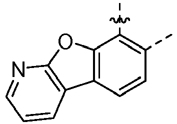 |
| 186 | CH₃ | CH₃ | H | H | CF₃ | CF₃ | 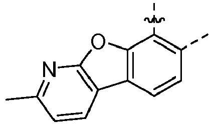 |
| 187 | CH₃ | CH₃ | H | H | CF₃ | CF₃ | 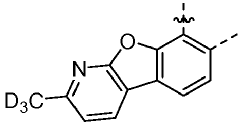 |
| 188 | CH₃ | CH₃ | H | H | CF₃ | CF₃ | 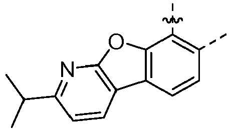 |
| 189 | CH₃ | CH₃ | H | H | CF₃ | CF₃ | 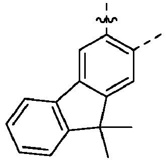 |
| 190 | CF₃ | CF₃ | H | H | CH₃ | CH₃ | 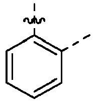 |
| 191 | CF₃ | CF₃ | H | H | CH₃ | CH₃ | 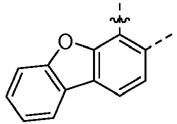 |
| 192 | CF₃ | CF₃ | H | H | CH₃ | CH₃ | 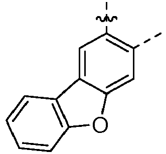 |
| 193 | CF₃ | CF₃ | H | H | CH₃ | CH₃ | 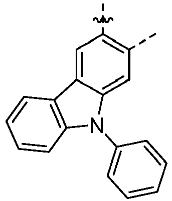 |
| 194 | CF₃ | CF₃ | H | H | CH₃ | CH₃ | 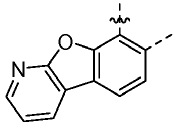 |
| 195 | CF₃ | CF₃ | H | H | CH₃ | CH₃ | 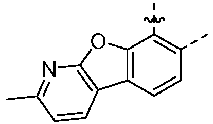 |
| 196 | CF₃ | CF₃ | H | H | CH₃ | CH₃ | 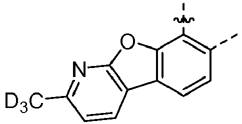 |
| 197 | CF₃ | CF₃ | H | H | CH₃ | CH₃ | 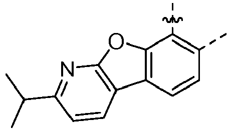 |
| 198 | CF₃ | CF₃ | H | H | CH₃ | CH₃ | 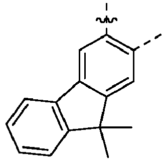 |
, und für *i* = 199 bis 534 L_{A*i*} hat L_{A*i*} die folgende Struktur: 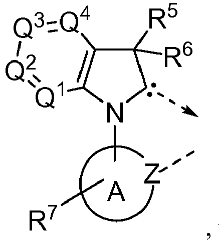 wobei die Substituenten Q¹, Q², Q³, Q⁴, R⁵, R⁶ und Ring A wie in Tabelle 2 unten definiert sind:
**Tabelle 2**
| *i* | Q¹ | Q² | Q³ | Q⁴ | R⁵ | R⁶ | Ring A |
|---|---|---|---|---|---|---|---|
| 199 | CH | CH | CH | CH | CH₃ | CH₃ | 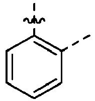 |
| 200 | CH | CH | CH | CH | CH₃ | CH₃ | 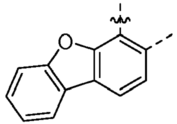 |
| 201 | CH | CH | CH | CH | CH₃ | CH₃ | 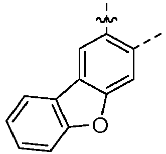 |
| 202 | CH | CH | CH | CH | CH₃ | CH₃ | 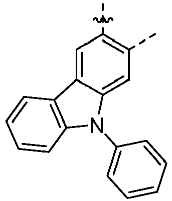 |
| 203 | CH | CH | CH | CH | CH₃ | CH₃ | 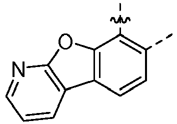 |
| 204 | CH | CH | CH | CH | CH₃ | CH₃ | 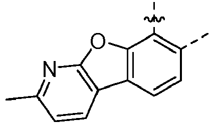 |
| 205 | CH | CH | CH | CH | CH₃ | CH₃ | 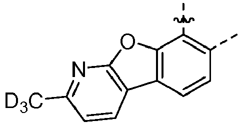 |
| 206 | CH | CH | CH | CH | CH₃ | CH₃ | 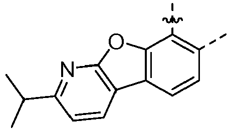 |
| 207 | CH | CH | CH | CH | CH₃ | CH₃ | 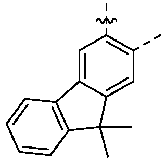 |
| 208 | CH | CH | CH | CH | CH₃ | CH₂CH₃ | 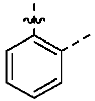 |
| 209 | CH | CH | CH | CH | CH₃ | CH₂CH₃ | 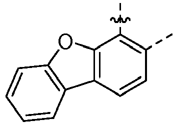 |
| 210 | CH | CH | CH | CH | CH₃ | CH₂CH₃ | 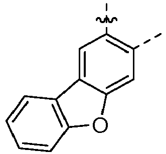 |
| 211 | CH | CH | CH | CH | CH₃ | CH₂CH₃ | 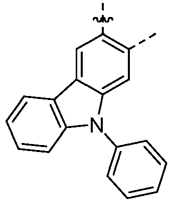 |
| 212 | CH | CH | CH | CH | CH₃ | CH₂CH₃ | 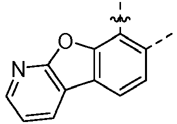 |
| 213 | CH | CH | CH | CH | CH₃ | CH₂CH₃ | 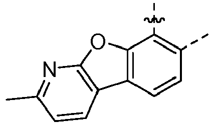 |
| 214 | CH | CH | CH | CH | CH₃ | CH₂CH₃ | 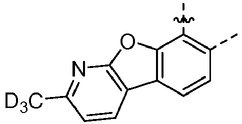 |
| 215 | CH | CH | CH | CH | CH₃ | CH₂CH₃ | 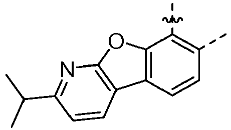 |
| 216 | CH | CH | CH | CH | CH₃ | CH₂CH₃ | 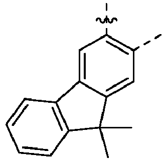 |
| 217 | CH | CH | CH | CH | CH₃ | CH(CH₃)₂ | 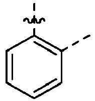 |
| 218 | CH | CH | CH | CH | CH₃ | CH(CH₃)₂ | 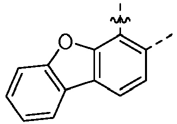 |
| 219 | CH | CH | CH | CH | CH₃ | CH(CH₃)₂ | 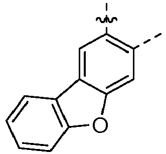 |
| 220 | CH | CH | CH | CH | CH₃ | CH(CH₃)₂ | 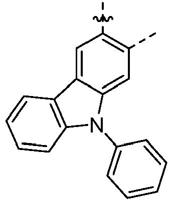 |
| 221 | CH | CH | CH | CH | CH₃ | CH(CH₃)₂ | 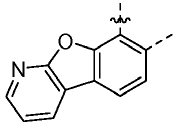 |
| 222 | CH | CH | CH | CH | CH₃ | CH(CH₃)₂ | 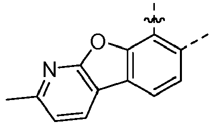 |
| 223 | CH | CH | CH | CH | CH₃ | CH(CH₃)₂ | 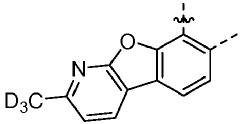 |
| 224 | CH | CH | CH | CH | CH₃ | CH(CH₃)₂ | 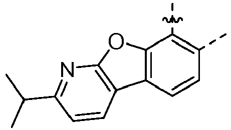 |
| 225 | CH | CH | CH | CH | CH₃ | CH(CH₃)₂ | 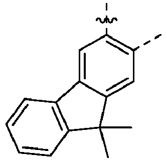 |
| 226 | CH | CH | CH | CH | 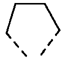 | | 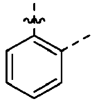 |
| 227 | CH | CH | CH | CH | 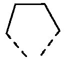 | | 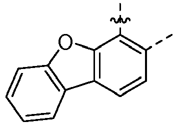 |
| 228 | CH | CH | CH | CH | 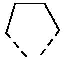 | | 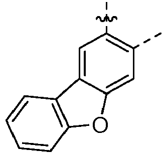 |
| 229 | CH | CH | CH | CH | 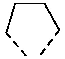 | | 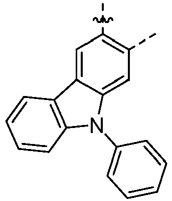 |
| 230 | CH | CH | CH | CH | 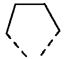 | | 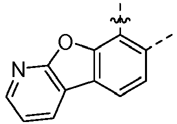 |
| 231 | CH | CH | CH | CH | 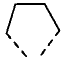 | | 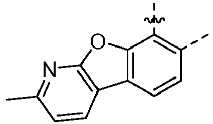 |
| 232 | CH | CH | CH | CH | 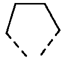 | | 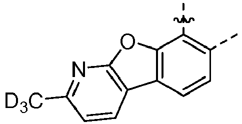 |
| 233 | CH | CH | CH | CH | 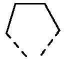 | | 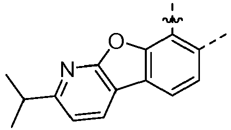 |
| 234 | CH | CH | CH | CH | 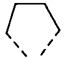 | | 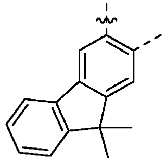 |
| 235 | CH | CH | CH | CH | 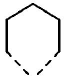 | | 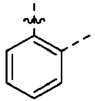 |
| 236 | CH | CH | CH | CH | 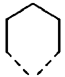 | | 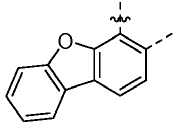 |
| 237 | CH | CH | CH | CH | 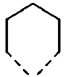 | | 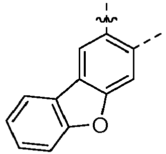 |
| 238 | CH | CH | CH | CH | 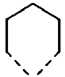 | | 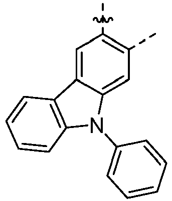 |
| 239 | CH | CH | CH | CH | 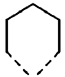 | | 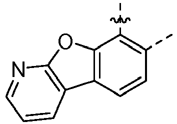 |
| 240 | CH | CH | CH | CH | 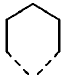 | | 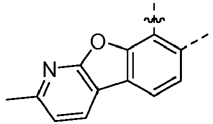 |
| 241 | CH | CH | CH | CH | 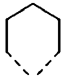 | | 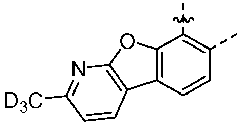 |
| 242 | CH | CH | CH | CH | 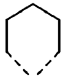 | | 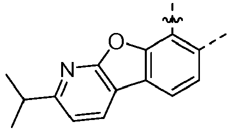 |
| 243 | CH | CH | CH | CH | 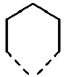 | | 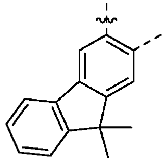 |
| 244 | CH | CH | CH | CH | 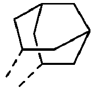 | | 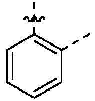 |
| 245 | CH | CH | CH | CH | 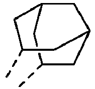 | | 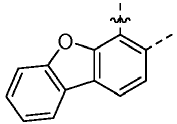 |
| 246 | CH | CH | CH | CH | 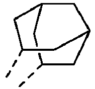 | | 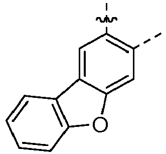 |
| 247 | CH | CH | CH | CH | 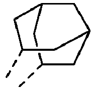 | | 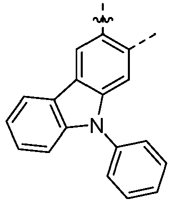 |
| 248 | CH | CH | CH | CH | 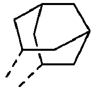 | | 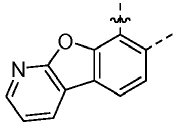 |
| 249 | CH | CH | CH | CH | 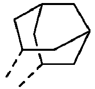 | | 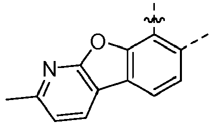 |
| 250 | CH | CH | CH | CH | 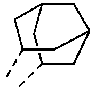 | | 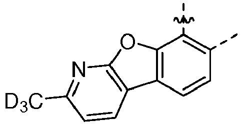 |
| 251 | CH | CH | CH | CH | 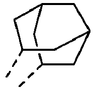 | | 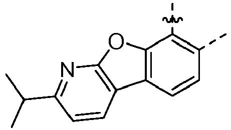 |
| 252 | CH | CH | CH | CH | 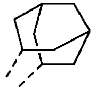 | | 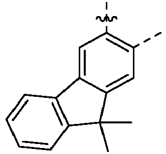 |
| 253 | N | CH | CH | CH | CH₃ | CH₃ | 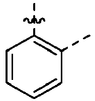 |
| 254 | N | CH | CH | CH | CH₃ | CH₃ | 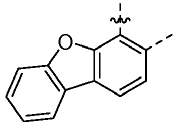 |
| 255 | N | CH | CH | CH | CH₃ | CH₃ | 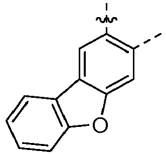 |
| 256 | N | CH | CH | CH | CH₃ | CH₃ | 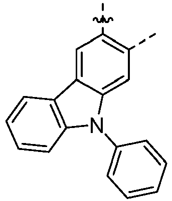 |
| 257 | N | CH | CH | CH | CH₃ | CH₃ | 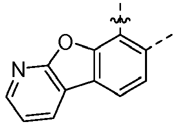 |
| 258 | N | CH | CH | CH | CH₃ | CH₃ | 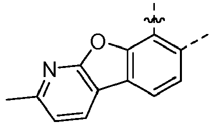 |
| 259 | N | CH | CH | CH | CH₃ | CH₃ | 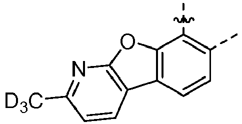 |
| 260 | N | CH | CH | CH | CH₃ | CH₃ | 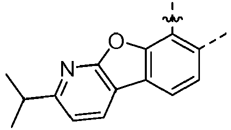 |
| 261 | N | CH | CH | CH | CH₃ | CH₃ | 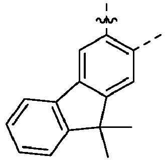 |
| 262 | N | CH | CH | CH | CH₃ | CH₂CH₃ | 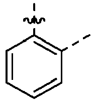 |
| 263 | N | CH | CH | CH | CH₃ | CH₂CH₃ | 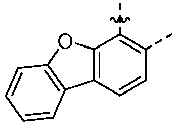 |
| 264 | N | CH | CH | CH | CH₃ | CH₂CH₃ | 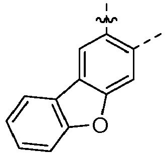 |
| 265 | N | CH | CH | CH | CH₃ | CH₂CH₃ | 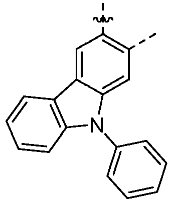 |
| 266 | N | CH | CH | CH | CH₃ | CH₂CH₃ | 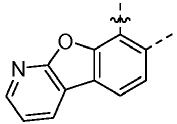 |
| 267 | N | CH | CH | CH | CH₃ | CH₂CH₃ | 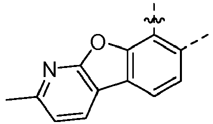 |
| 268 | N | CH | CH | CH | CH₃ | CH₂CH₃ | 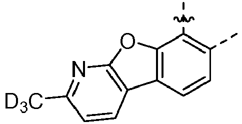 |
| 269 | N | CH | CH | CH | CH₃ | CH₂CH₃ | 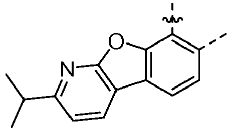 |
| 270 | N | CH | CH | CH | CH₃ | CH₂CH₃ | 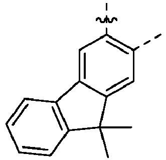 |
| 271 | N | CH | CH | CH | CH₃ | CH(CH₃)₂ | 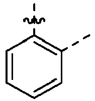 |
| 272 | N | CH | CH | CH | CH₃ | CH(CH₃)₂ | 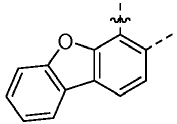 |
| 273 | N | CH | CH | CH | CH₃ | CH(CH₃)₂ | 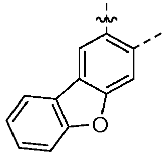 |
| 274 | N | CH | CH | CH | CH₃ | CH(CH₃)₂ | 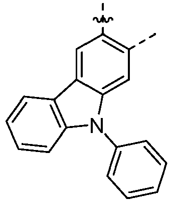 |
| 275 | N | CH | CH | CH | CH₃ | CH(CH₃)₂ | 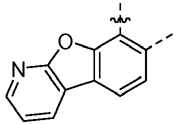 |
| 276 | N | CH | CH | CH | CH₃ | CH(CH₃)₂ | 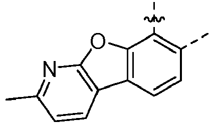 |
| 277 | N | CH | CH | CH | CH₃ | CH(CH₃)₂ | 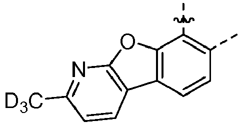 |
| 278 | N | CH | CH | CH | CH₃ | CH(CH₃)₂ | 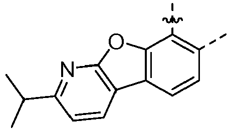 |
| 279 | N | CH | CH | CH | CH₃ | CH(CH₃)₂ | 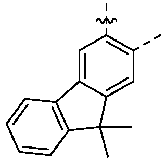 |
| 280 | N | CH | CH | CH | 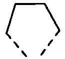 | | 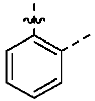 |
| 281 | N | CH | CH | CH | 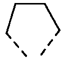 | | 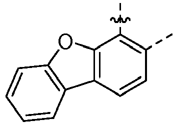 |
| 282 | N | CH | CH | CH | 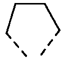 | | 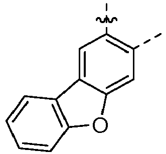 |
| 283 | N | CH | CH | CH | 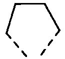 | | 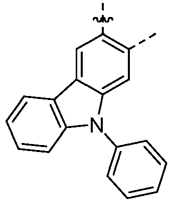 |
| 284 | N | CH | CH | CH | 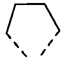 | | 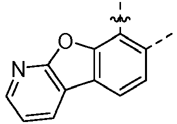 |
| 285 | N | CH | CH | CH | 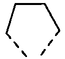 | | 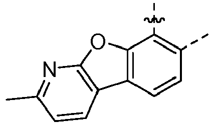 |
| 286 | N | CH | CH | CH | 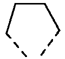 | | 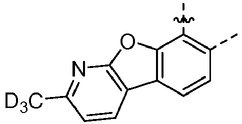 |
| 287 | N | CH | CH | CH | 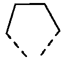 | | 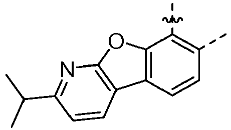 |
| 288 | N | CH | CH | CH | 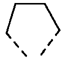 | | 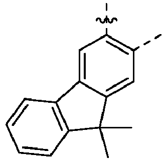 |
| 289 | N | CH | CH | CH | 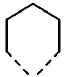 | | 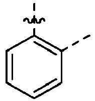 |
| 290 | N | CH | CH | CH | 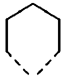 | | 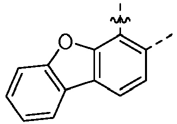 |
| 291 | N | CH | CH | CH | 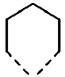 | | 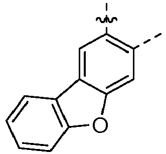 |
| 292 | N | CH | CH | CH | 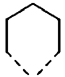 | | 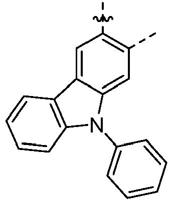 |
| 293 | N | CH | CH | CH | 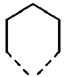 | | 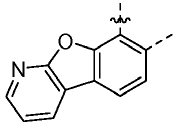 |
| 294 | N | CH | CH | CH | 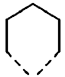 | | 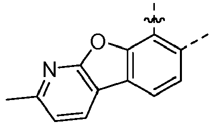 |
| 295 | N | CH | CH | CH | 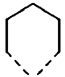 | | 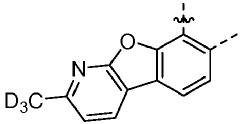 |
| 296 | N | CH | CH | CH | 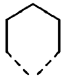 | | 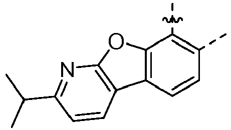 |
| 297 | N | CH | CH | CH | 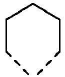 | | 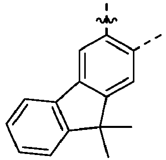 |
| 298 | N | CH | CH | CH | 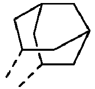 | | 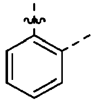 |
| 299 | N | CH | CH | CH | 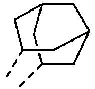 | | 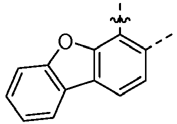 |
| 300 | N | CH | CH | CH | 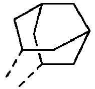 | | 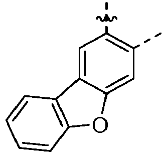 |
| 301 | N | CH | CH | CH | 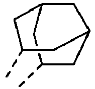 | | 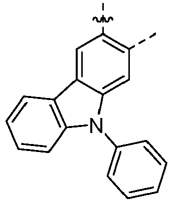 |
| 302 | N | CH | CH | CH | 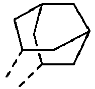 | | 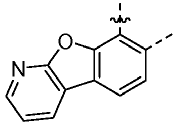 |
| 303 | N | CH | CH | CH | 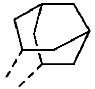 | | 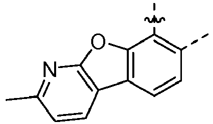 |
| 304 | N | CH | CH | CH | 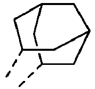 | | 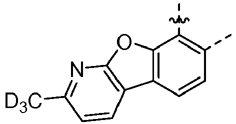 |
| 305 | N | CH | CH | CH | 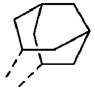 | | 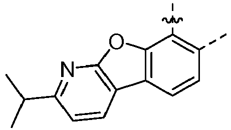 |
| 306 | N | CH | CH | CH | 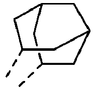 | | 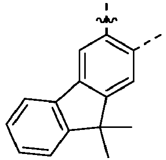 |
| 307 | CH | N | CH | CH | CH₃ | CH₃ | 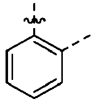 |
| 308 | CH | N | CH | CH | CH₃ | CH₃ | 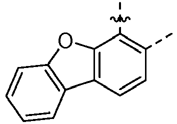 |
| 309 | CH | N | CH | CH | CH₃ | CH₃ | 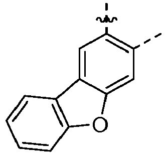 |
| 310 | CH | N | CH | CH | CH₃ | CH₃ | 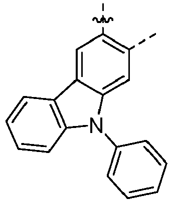 |
| 311 | CH | N | CH | CH | CH₃ | CH₃ | 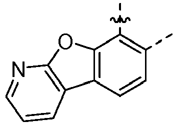 |
| 312 | CH | N | CH | CH | CH₃ | CH₃ | 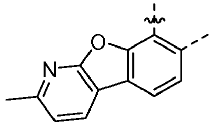 |
| 313 | CH | N | CH | CH | CH₃ | CH₃ | 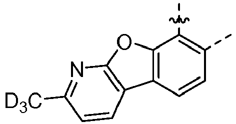 |
| 314 | CH | N | CH | CH | CH₃ | CH₃ | 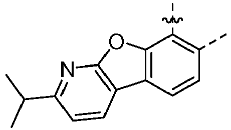 |
| 315 | CH | N | CH | CH | CH₃ | CH₃ | 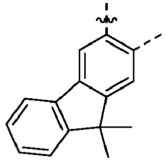 |
| 316 | CH | N | CH | CH | CH₃ | CH₂CH₃ | 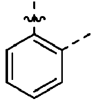 |
| 317 | CH | N | CH | CH | CH₃ | CH₂CH₃ | 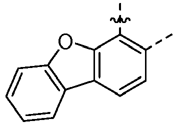 |
| 318 | CH | N | CH | CH | CH₃ | CH₂CH₃ | 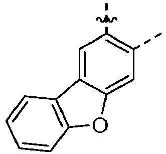 |
| 319 | CH | N | CH | CH | CH₃ | CH₂CH₃ | 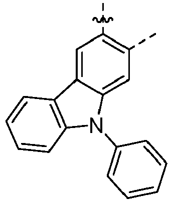 |
| 320 | CH | N | CH | CH | CH₃ | CH₂CH₃ | 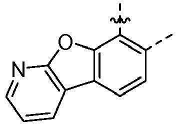 |
| 321 | CH | N | CH | CH | CH₃ | CH₂CH₃ | 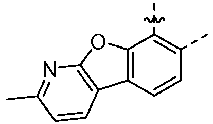 |
| 322 | CH | N | CH | CH | CH₃ | CH₂CH₃ | 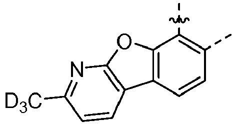 |
| 323 | CH | N | CH | CH | CH₃ | CH₂CH₃ | 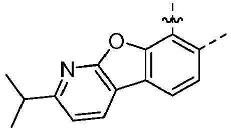 |
| 324 | CH | N | CH | CH | CH₃ | CH₂CH₃ | 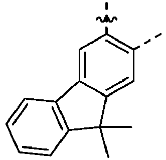 |
| 325 | CH | N | CH | CH | CH₃ | CH(CH₃)₂ | 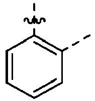 |
| 326 | CH | N | CH | CH | CH₃ | CH(CH₃)₂ | 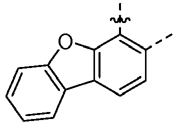 |
| 327 | CH | N | CH | CH | CH₃ | CH(CH₃)₂ | 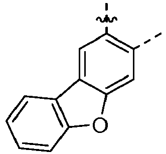 |
| 328 | CH | N | CH | CH | CH₃ | CH(CH₃)₂ | 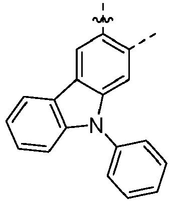 |
| 329 | CH | N | CH | CH | CH₃ | CH(CH₃)₂ | 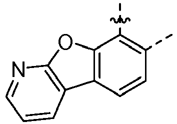 |
| 330 | CH | N | CH | CH | CH₃ | CH(CH₃)₂ | 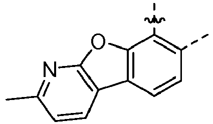 |
| 331 | CH | N | CH | CH | CH₃ | CH(CH₃)₂ | 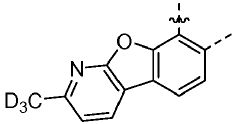 |
| 332 | CH | N | CH | CH | CH₃ | CH(CH₃)₂ | 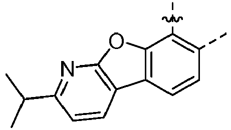 |
| 333 | CH | N | CH | CH | CH₃ | CH(CH₃)₂ | 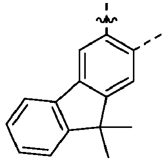 |
| 334 | CH | N | CH | CH | 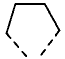 | | 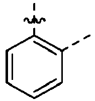 |
| 335 | CH | N | CH | CH | 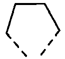 | | 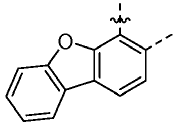 |
| 336 | CH | N | CH | CH | 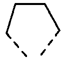 | | 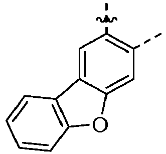 |
| 337 | CH | N | CH | CH | 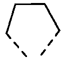 | | 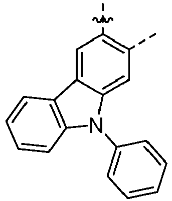 |
| 338 | CH | N | CH | CH | 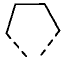 | | 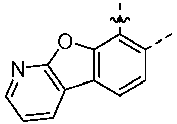 |
| 339 | CH | N | CH | CH | 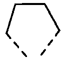 | | 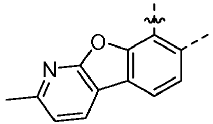 |
| 340 | CH | N | CH | CH | 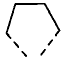 | | 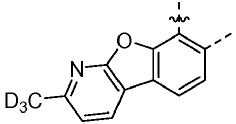 |
| 341 | CH | N | CH | CH | 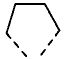 | | 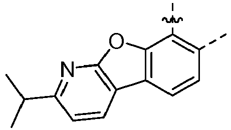 |
| 342 | CH | N | CH | CH | 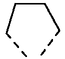 | | 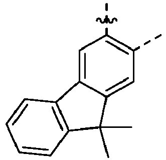 |
| 343 | CH | N | CH | CH | 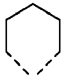 | | 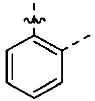 |
| 344 | CH | N | CH | CH | 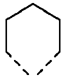 | | 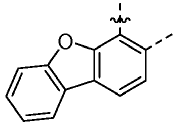 |
| 345 | CH | N | CH | CH | 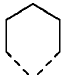 | | 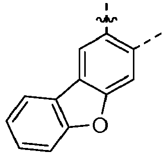 |
| 346 | CH | N | CH | CH | 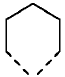 | | 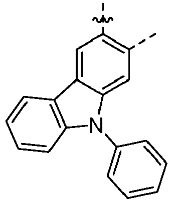 |
| 347 | CH | N | CH | CH | 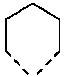 | | 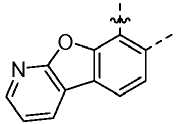 |
| 348 | CH | N | CH | CH | 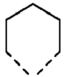 | | 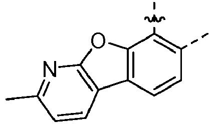 |
| 349 | CH | N | CH | CH | 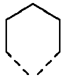 | | 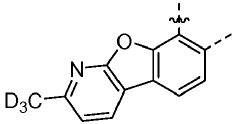 |
| 350 | CH | N | CH | CH | 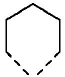 | | 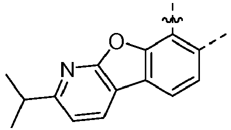 |
| 351 | CH | N | CH | CH | 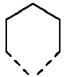 | | 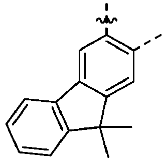 |
| 352 | CH | N | CH | CH | 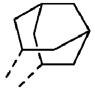 | | 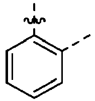 |
| 353 | CH | N | CH | CH | 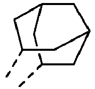 | | 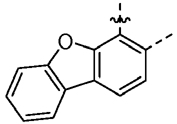 |
| 354 | CH | N | CH | CH | 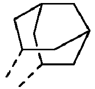 | | 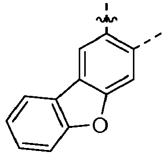 |
| 355 | CH | N | CH | CH | 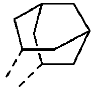 | | 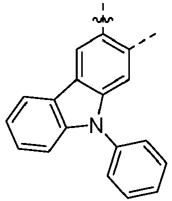 |
| 356 | CH | N | CH | CH | 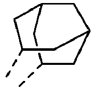 | | 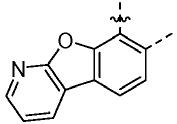 |
| 357 | CH | N | CH | CH | 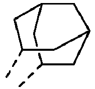 | | 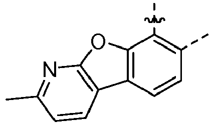 |
| 358 | CH | N | CH | CH | 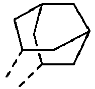 | | 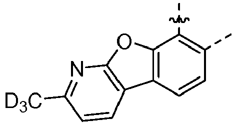 |
| 359 | CH | N | CH | CH | 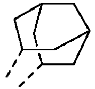 | | 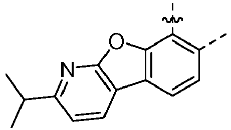 |
| 360 | CH | N | CH | CH | 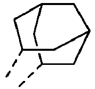 | | 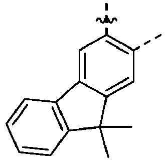 |
| 361 | N | CH | N | CH | CH₃ | CH₃ | 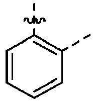 |
| 362 | N | CH | N | CH | CH₃ | CH₃ | 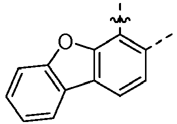 |
| 363 | N | CH | N | CH | CH₃ | CH₃ | 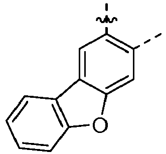 |
| 364 | N | CH | N | CH | CH₃ | CH₃ | 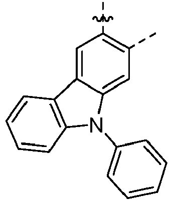 |
| 365 | N | CH | N | CH | CH₃ | CH₃ | 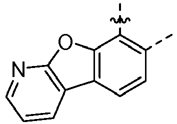 |
| 366 | N | CH | N | CH | CH₃ | CH₃ | 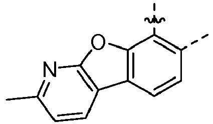 |
| 367 | N | CH | N | CH | CH₃ | CH₃ | 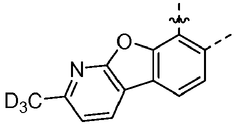 |
| 368 | N | CH | N | CH | CH₃ | CH₃ | 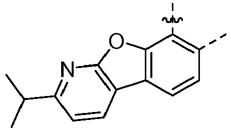 |
| 369 | N | CH | N | CH | CH₃ | CH₃ | 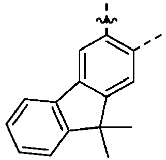 |
| 370 | N | CH | N | CH | CH₃ | CH₂CH₃ | 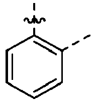 |
| 371 | N | CH | N | CH | CH₃ | CH₂CH₃ | 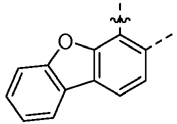 |
| 372 | N | CH | N | CH | CH₃ | CH₂CH₃ | 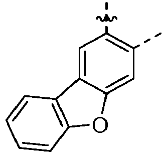 |
| 373 | N | CH | N | CH | CH₃ | CH₂CH₃ | 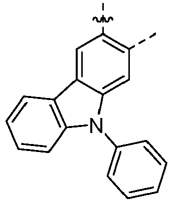 |
| 374 | N | CH | N | CH | CH₃ | CH₂CH₃ | 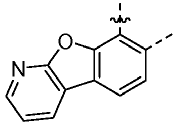 |
| 375 | N | CH | N | CH | CH₃ | CH₂CH₃ | 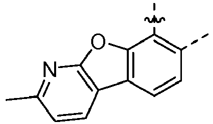 |
| 376 | N | CH | N | CH | CH₃ | CH₂CH₃ | 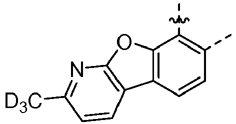 |
| 377 | N | CH | N | CH | CH₃ | CH₂CH₃ | 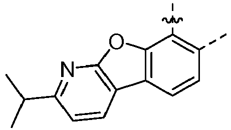 |
| 378 | N | CH | N | CH | CH₃ | CH₂CH₃ | 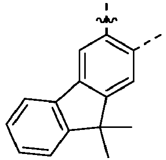 |
| 379 | N | CH | N | CH | CH₃ | CH(CH₃)₂ | 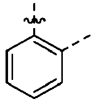 |
| 380 | N | CH | N | CH | CH₃ | CH(CH₃)₂ | 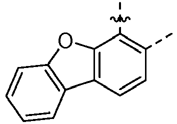 |
| 381 | N | CH | N | CH | CH₃ | CH(CH₃)₂ | 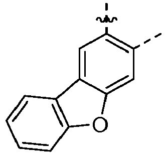 |
| 382 | N | CH | N | CH | CH₃ | CH(CH₃)₂ | 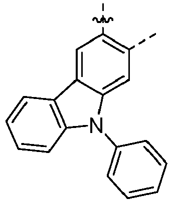 |
| 383 | N | CH | N | CH | CH₃ | CH(CH₃)₂ | 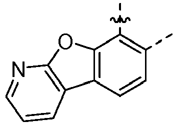 |
| 384 | N | CH | N | CH | CH₃ | CH(CH₃)₂ | 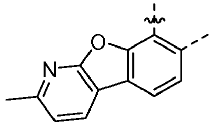 |
| 385 | N | CH | N | CH | CH₃ | CH(CH₃)₂ | 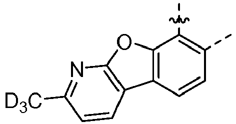 |
| 386 | N | CH | N | CH | CH₃ | CH(CH₃)₂ | 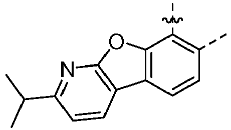 |
| 387 | N | CH | N | CH | CH₃ | CH(CH₃)₂ | 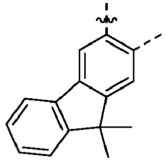 |
| 388 | CH | CH | N | CH | 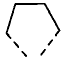 | | 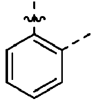 |
| 389 | CH | CH | N | CH | 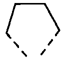 | | 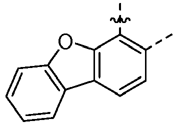 |
| 390 | CH | CH | N | CH | 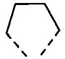 | | 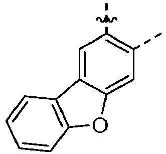 |
| 391 | CH | CH | N | CH | 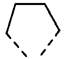 | | 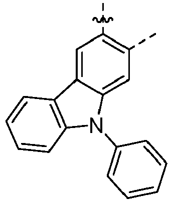 |
| 392 | CH | CH | N | CH | 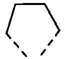 | | 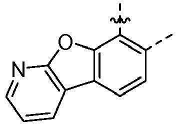 |
| 393 | CH | CH | N | CH | 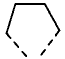 | | 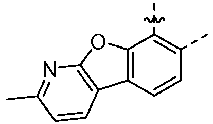 |
| 394 | CH | CH | N | CH | 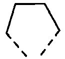 | | 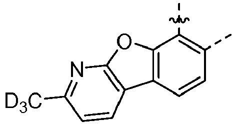 |
| 395 | CH | CH | N | CH | 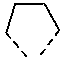 | | 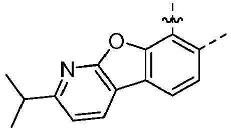 |
| 396 | CH | CH | N | CH | 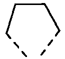 | | 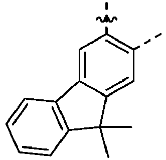 |
| 397 | CH | CH | N | CH | 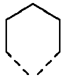 | | 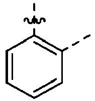 |
| 398 | CH | CH | N | CH | 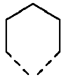 | | 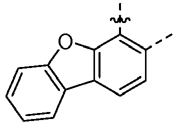 |
| 399 | CH | CH | N | CH | 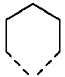 | | 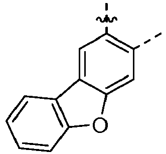 |
| 400 | CH | CH | N | CH | 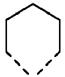 | | 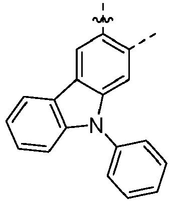 |
| 401 | CH | CH | N | CH | 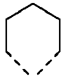 | | 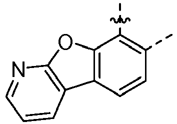 |
| 402 | CH | CH | N | CH | 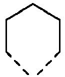 | | 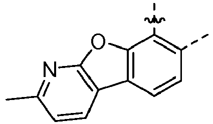 |
| 403 | CH | CH | N | CH | 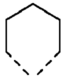 | | 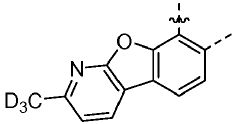 |
| 404 | CH | CH | N | CH | 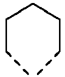 | | 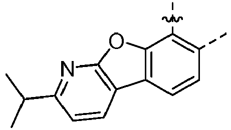 |
| 405 | CH | CH | N | CH | 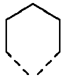 | | 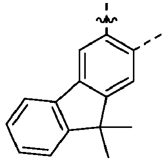 |
| 406 | CH | CH | N | CH | 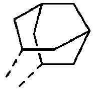 | | 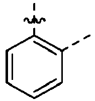 |
| 407 | CH | CH | N | CH | 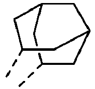 | | 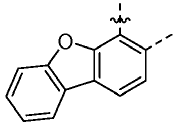 |
| 408 | CH | CH | N | CH | 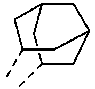 | | 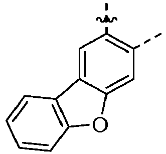 |
| 409 | CH | CH | N | CH | 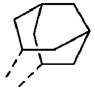 | | 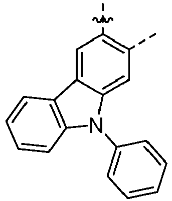 |
| 410 | CH | CH | N | CH | 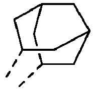 | | 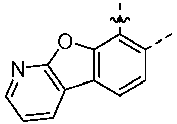 |
| 411 | CH | CH | N | CH | 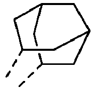 | | 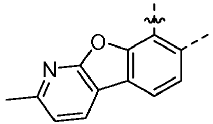 |
| 412 | CH | CH | N | CH | 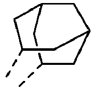 | | 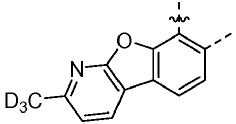 |
| 413 | CH | CH | N | CH | 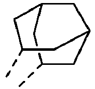 | | 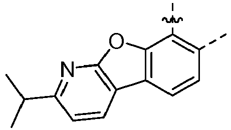 |
| 414 | CH | CH | N | CH | 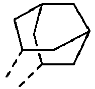 | | 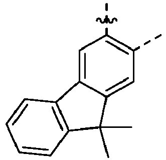 |
| 415 | CH | CH | CH | N | CH₃ | CH₃ | 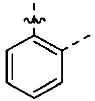 |
| 416 | CH | CH | CH | N | CH₃ | CH₃ | 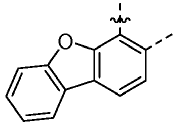 |
| 417 | CH | CH | CH | N | CH₃ | CH₃ | 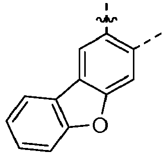 |
| 418 | CH | CH | CH | N | CH₃ | CH₃ | 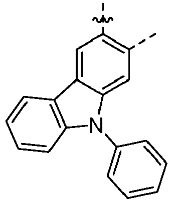 |
| 419 | CH | CH | CH | N | CH₃ | CH₃ | 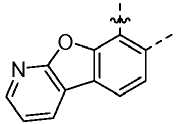 |
| 420 | CH | CH | CH | N | CH₃ | CH₃ | 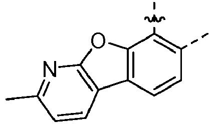 |
| 421 | CH | CH | CH | N | CH₃ | CH₃ | 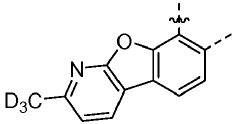 |
| 422 | CH | CH | CH | N | CH₃ | CH₃ | 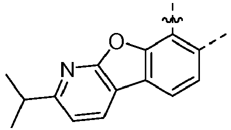 |
| 423 | CH | CH | CH | N | CH₃ | CH₃ | 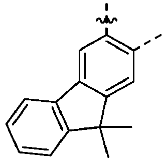 |
| 424 | CH | CH | CH | N | CH₃ | CH₂CH₃ | 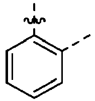 |
| 425 | CH | CH | CH | N | CH₃ | CH₂CH₃ | 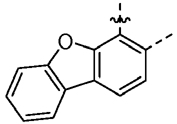 |
| 426 | CH | CH | CH | N | CH₃ | CH₂CH₃ | 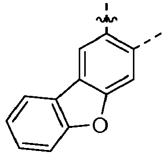 |
| 427 | CH | CH | CH | N | CH₃ | CH₂CH₃ | 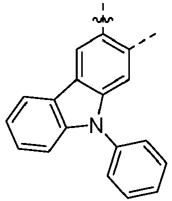 |
| 428 | CH | CH | CH | N | CH₃ | CH₂CH₃ | 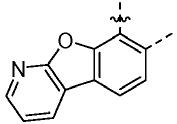 |
| 429 | CH | CH | CH | N | CH₃ | CH₂CH₃ | 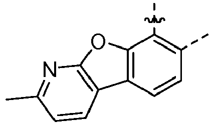 |
| 430 | CH | CH | CH | N | CH₃ | CH₂CH₃ | 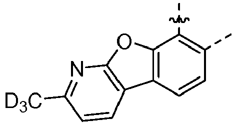 |
| 431 | CH | CH | CH | N | CH₃ | CH₂CH₃ | 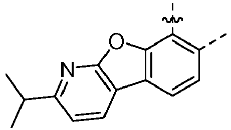 |
| 432 | CH | CH | CH | N | CH₃ | CH₂CH₃ | 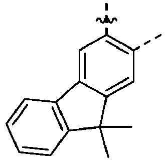 |
| 433 | CH | CH | CH | N | CH₃ | CH(CH₃)₂ | 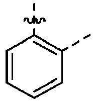 |
| 434 | CH | CH | CH | N | CH₃ | CH(CH₃)₂ | 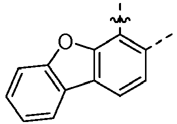 |
| 435 | CH | CH | CH | N | CH₃ | CH(CH₃)₂ | 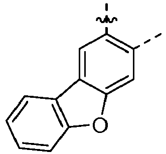 |
| 436 | CH | CH | CH | N | CH₃ | CH(CH₃)₂ | 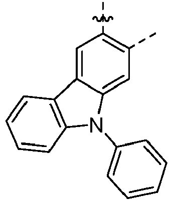 |
| 437 | CH | CH | CH | N | CH₃ | CH(CH₃)₂ | 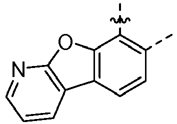 |
| 438 | CH | CH | CH | N | CH₃ | CH(CH₃)₂ | 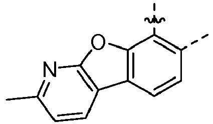 |
| 439 | CH | CH | CH | N | CH₃ | CH(CH₃)₂ | 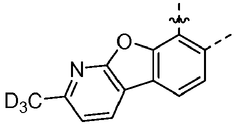 |
| 440 | CH | CH | CH | N | CH₃ | CH(CH₃)₂ | 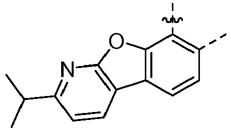 |
| 441 | CH | CH | CH | N | CH₃ | CH(CH₃)₂ | 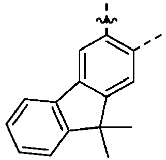 |
| 442 | CH | CH | CH | N | 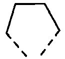 | | 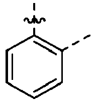 |
| 443 | CH | CH | CH | N | 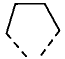 | | 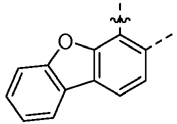 |
| 444 | CH | CH | CH | N | 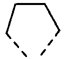 | | 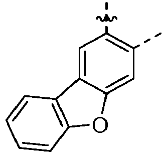 |
| 445 | CH | CH | CH | N | 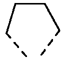 | | 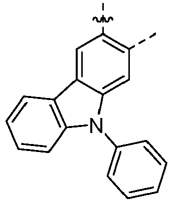 |
| 446 | CH | CH | CH | N | 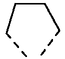 | | 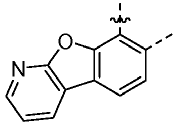 |
| 447 | CH | CH | CH | N | 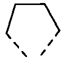 | | 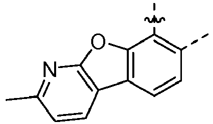 |
| 448 | CH | CH | CH | N | 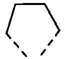 | | 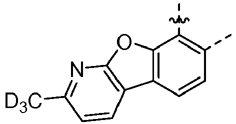 |
| 449 | CH | CH | CH | N | 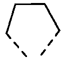 | | 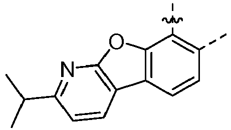 |
| 450 | CH | CH | CH | N | 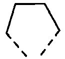 | | 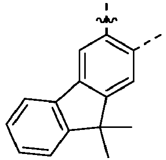 |
| 451 | CH | CH | CH | N | 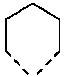 | | 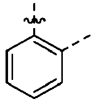 |
| 452 | CH | CH | CH | N | 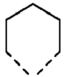 | | 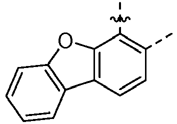 |
| 453 | CH | CH | CH | N | 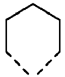 | | 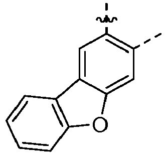 |
| 454 | CH | CH | CH | N | 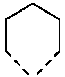 | | 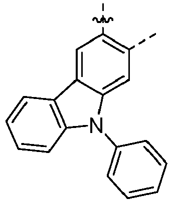 |
| 455 | CH | CH | CH | N | 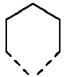 | | 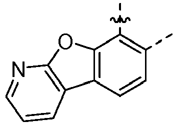 |
| 456 | CH | CH | CH | N | 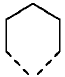 | | 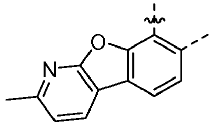 |
| 457 | CH | CH | CH | N | 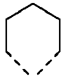 | | 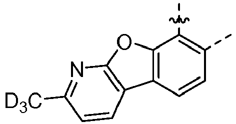 |
| 458 | CH | CH | CH | N | 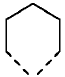 | | 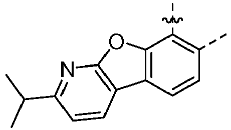 |
| 459 | CH | CH | CH | N | 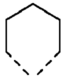 | | 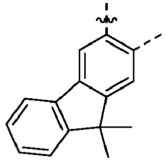 |
| 460 | CH | CH | CH | N | 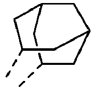 | | 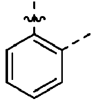 |
| 461 | CH | CH | CH | N | 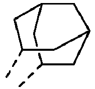 | | 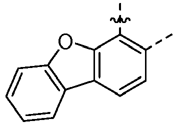 |
| 462 | CH | CH | CH | N | 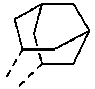 | | 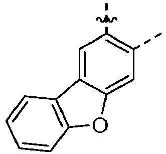 |
| 463 | CH | CH | CH | N | 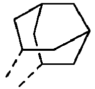 | | 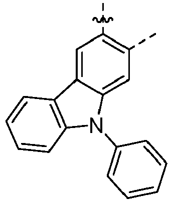 |
| 464 | CH | CH | CH | N | 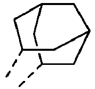 | | 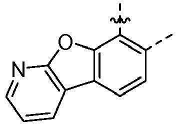 |
| 465 | CH | CH | CH | N | 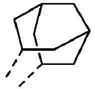 | | 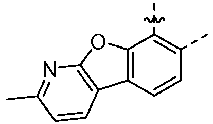 |
| 466 | CH | CH | CH | N | 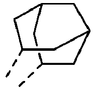 | | 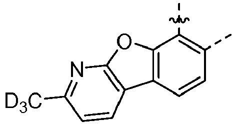 |
| 467 | CH | CH | CH | N | 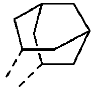 | | 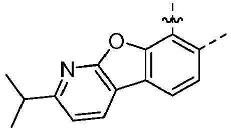 |
| 468 | CH | CH | CH | N | 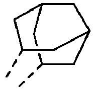 | | 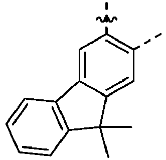 |
| 469 | N | CH | CH | N | CH₃ | CH₃ | 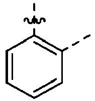 |
| 470 | N | CH | CH | N | CH₃ | CH₃ | 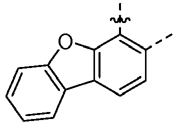 |
| 471 | N | CH | CH | N | CH₃ | CH₃ | 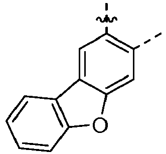 |
| 472 | N | CH | CH | N | CH₃ | CH₃ | 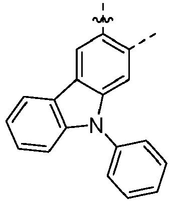 |
| 473 | N | CH | CH | N | CH₃ | CH₃ | 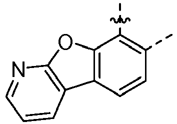 |
| 474 | N | CH | CH | N | CH₃ | CH₃ | 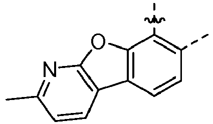 |
| 475 | N | CH | CH | N | CH₃ | CH₃ | 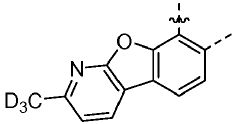 |
| 476 | N | CH | CH | N | CH₃ | CH₃ | 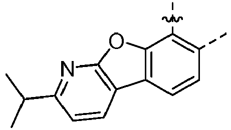 |
| 477 | N | CH | CH | N | CH₃ | CH₃ | 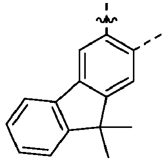 |
| 478 | N | CH | CH | N | CH₃ | CH₂CH₃ | 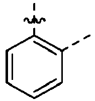 |
| 479 | N | CH | CH | N | CH₃ | CH₂CH₃ | 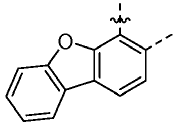 |
| 480 | N | CH | CH | N | CH₃ | CH₂CH₃ | 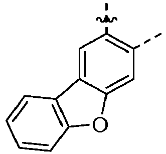 |
| 481 | N | CH | CH | N | CH₃ | CH₂CH₃ | 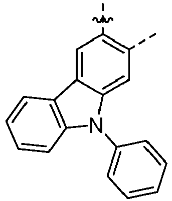 |
| 482 | N | CH | CH | N | CH₃ | CH₂CH₃ | 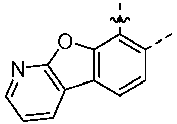 |
| 483 | N | CH | CH | N | CH₃ | CH₂CH₃ | 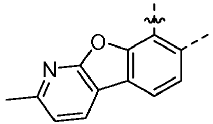 |
| 484 | N | CH | CH | N | CH₃ | CH₂CH₃ | 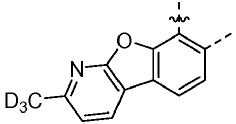 |
| 485 | N | CH | CH | N | CH₃ | CH₂CH₃ | 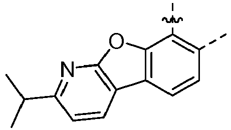 |
| 486 | N | CH | CH | N | CH₃ | CH₂CH₃ | 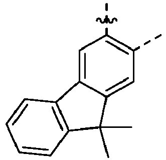 |
| 487 | N | CH | CH | N | CH₃ | CH(CH₃)₂ | 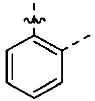 |
| 488 | N | CH | CH | N | CH₃ | CH(CH₃)₂ | 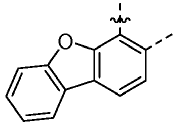 |
| 489 | N | CH | CH | N | CH₃ | CH(CH₃)₂ | 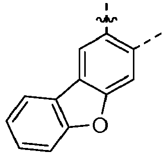 |
| 490 | N | CH | CH | N | CH₃ | CH(CH₃)₂ | 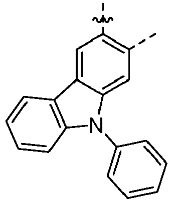 |
| 491 | N | CH | CH | N | CH₃ | CH(CH₃)₂ | 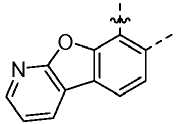 |
| 492 | N | CH | CH | N | CH₃ | CH(CH₃)₂ | 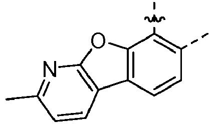 |
| 493 | N | CH | CH | N | CH₃ | CH(CH₃)₂ | 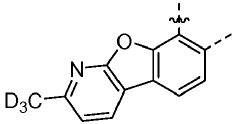 |
| 494 | N | CH | CH | N | CH₃ | CH(CH₃)₂ | 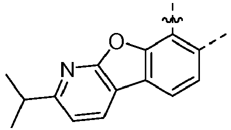 |
| 495 | N | CH | CH | N | CH₃ | CH(CH₃)₂ | 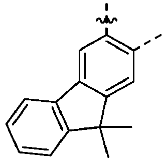 |
| 496 | N | CH | CH | N | 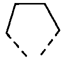 | | 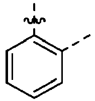 |
| 497 | N | CH | CH | N | 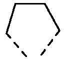 | | 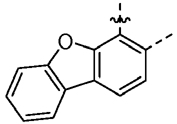 |
| 498 | N | CH | CH | N | 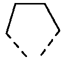 | | 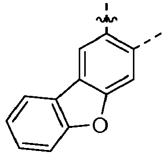 |
| 499 | N | CH | CH | N | 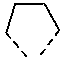 | | 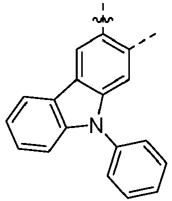 |
| 500 | N | CH | CH | N | 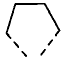 | | 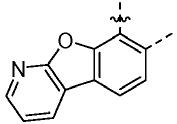 |
| 501 | N | CH | CH | N | 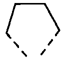 | | 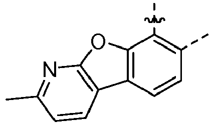 |
| 502 | N | CH | CH | N | 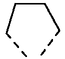 | | 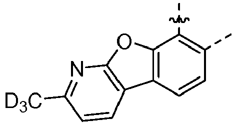 |
| 503 | N | CH | CH | N | 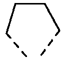 | | 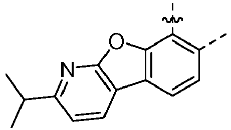 |
| 504 | N | CH | CH | N | 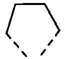 | | 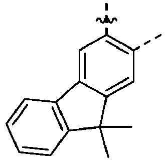 |
| 505 | N | CH | CH | N | 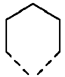 | | 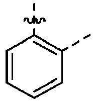 |
| 506 | N | CH | CH | N | 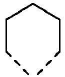 | | 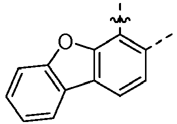 |
| 507 | N | CH | CH | N | 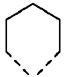 | | 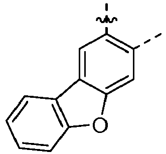 |
| 508 | N | CH | CH | N | 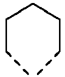 | | 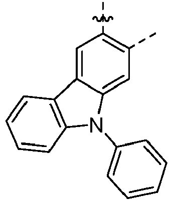 |
| 509 | N | CH | CH | N | 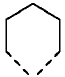 | | 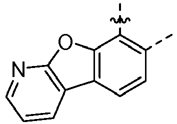 |
| 510 | N | CH | CH | N | 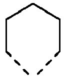 | | 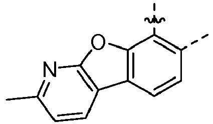 |
| 511 | N | CH | CH | N | 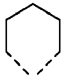 | | 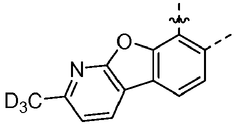 |
| 512 | N | CH | CH | N | 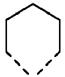 | | 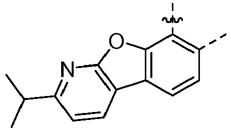 |
| 513 | N | CH | CH | N | 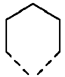 | | 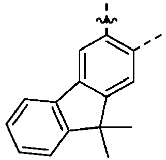 |
| 514 | N | CH | CH | N | 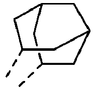 | | 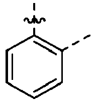 |
| 515 | N | CH | CH | N | 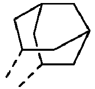 | | 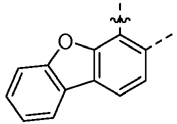 |
| 516 | N | CH | CH | N | 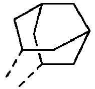 | | 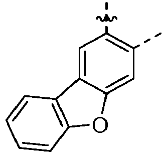 |
| 517 | N | CH | CH | N | 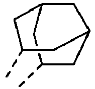 | | 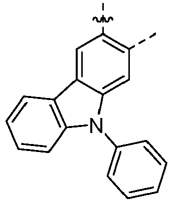 |
| 518 | N | CH | CH | N | 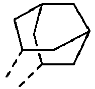 | | 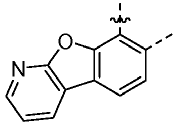 |
| 519 | N | CH | CH | N | 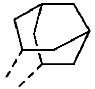 | | 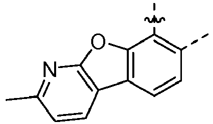 |
| 520 | N | CH | CH | N | 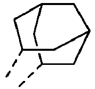 | | 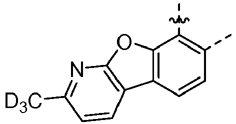 |
| 521 | N | CH | CH | N | 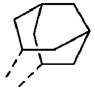 | | 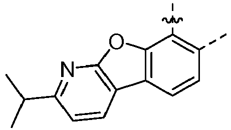 |
| 522 | N | CH | CH | N | 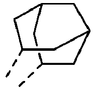 | | 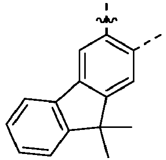 |
| 523 | CH | CH | CH | CH | CD₃ | CD₃ | 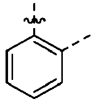 |
| 524 | CH | CH | CH | CH | CD₃ | CD₃ | 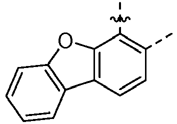 |
| 525 | N | CH | CH | CH | CD₃ | CD₃ | 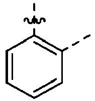 |
| 526 | N | CH | CH | CH | CD₃ | CD₃ | 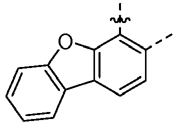 |
| 527 | CH | N | CH | CH | CD₃ | CD₃ | 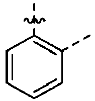 |
| 528 | CH | N | CH | CH | CD₃ | CD₃ | 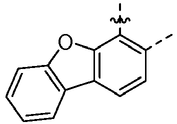 |
| 529 | CH | CH | N | CH | CD₃ | CD₃ | 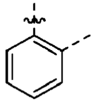 |
| 530 | CH | CH | N | CH | CD₃ | CD₃ | 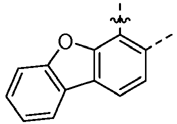 |
| 531 | CH | CH | CH | N | CD₃ | CD₃ | 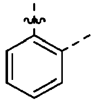 |
| 532 | CH | CH | CH | N | CD₃ | CD₃ | 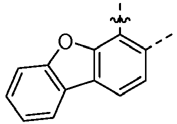 |
| 533 | N | CH | CH | N | CD₃ | CD₃ | 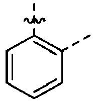 |
| 534 | N | CH | CH | N | CD₃ | CD₃ | 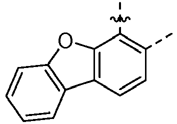 |

10. Die Verbindung nach Anspruch 1, wobei der Ligand L_{A} ausgewählt ist aus der Gruppe bestehend aus:

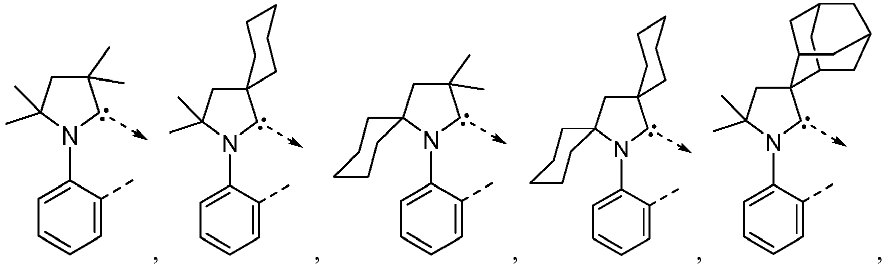

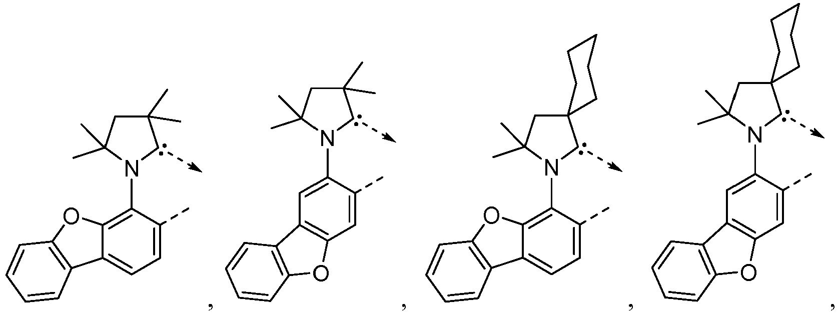

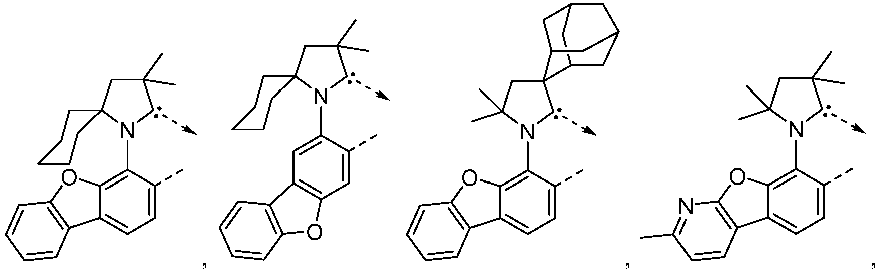

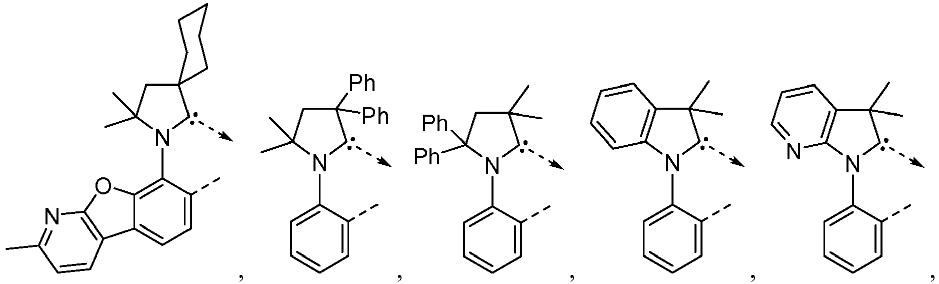

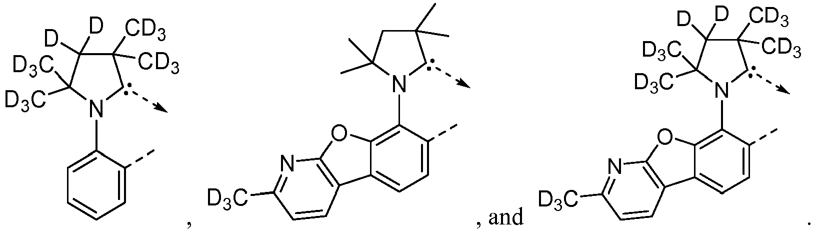

11. Die Verbindung nach Anspruch 1, wobei die Verbindung eine Formel M(L_{A})ₙ(L_{B})ₘ₋ₙ aufweist;
wobei M Ir oder Pt ist;
wobei L_{B} ein zweizähniger Ligand ist;
wobei, wenn M Ir ist, ist m gleich 3, und n ist 1, 2, oder 3; und
wobei, wenn M Pt ist, ist m 2, und n ist 1, oder 2.

12. Die Verbindung nach Anspruch 11, wobei L_{B} ein anderer Carbenligand ist.

13. Die Verbindung nach Anspruch 11, wobei L_{B} ausgewählt ist aus der Gruppe bestehend aus:

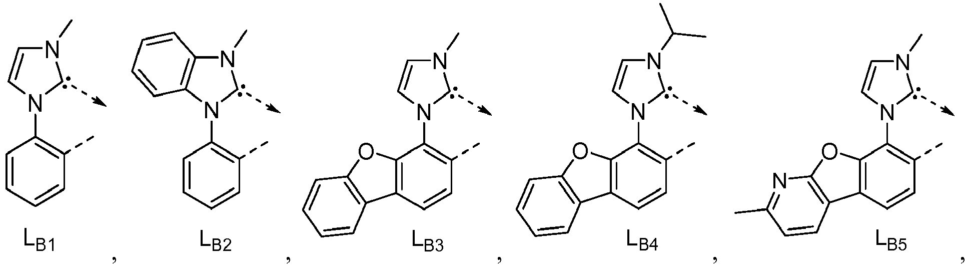

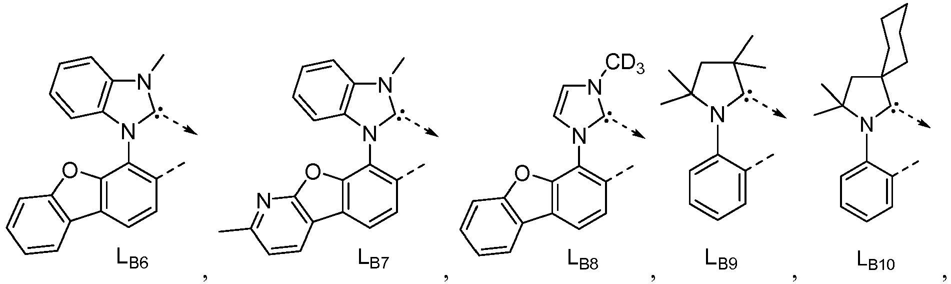

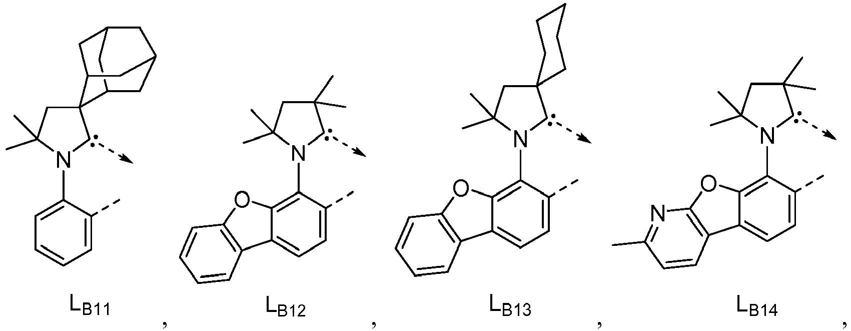

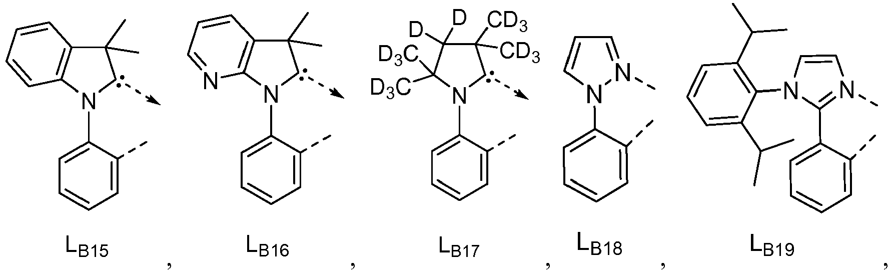

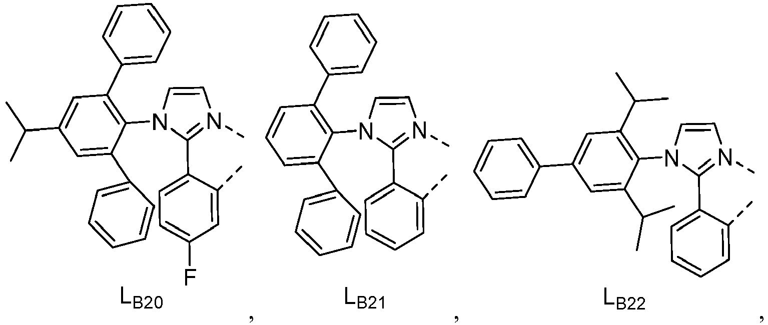

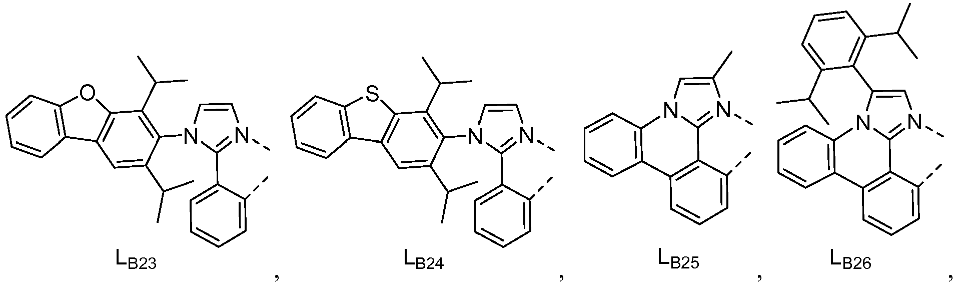

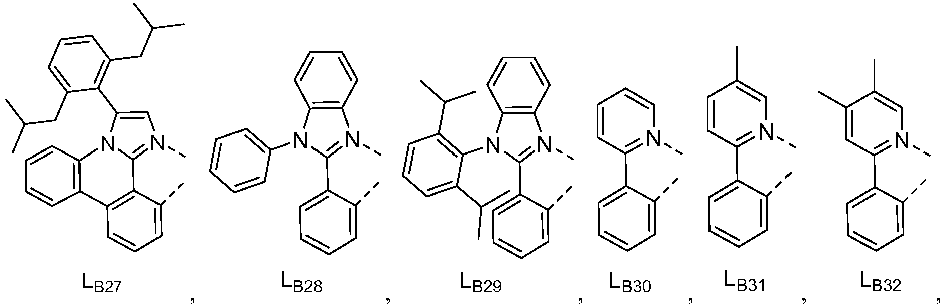

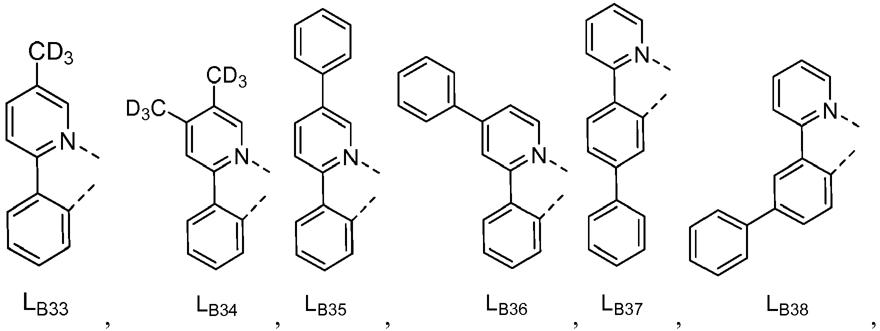

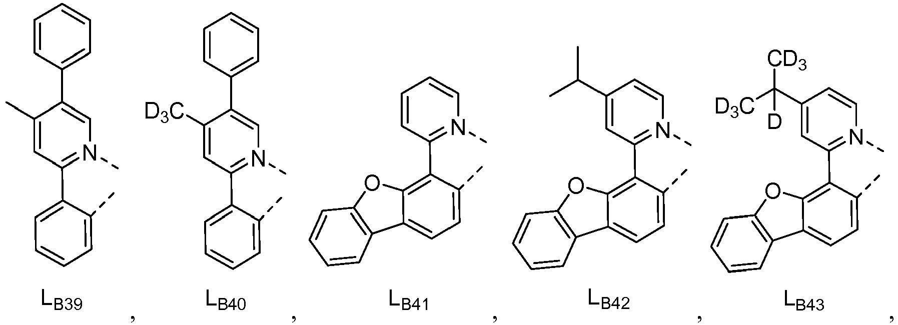

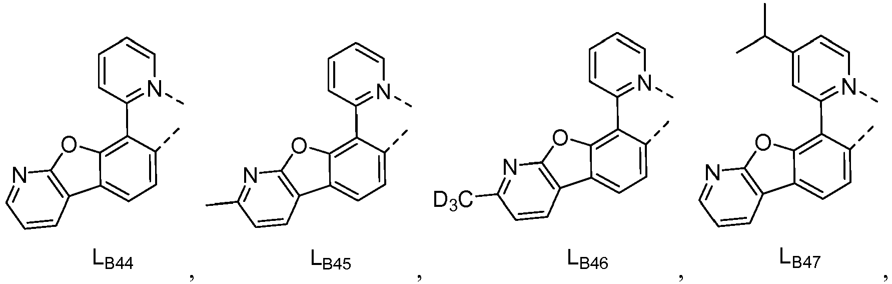

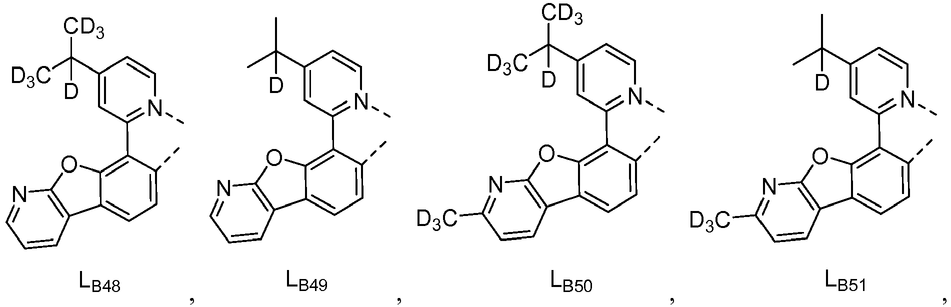

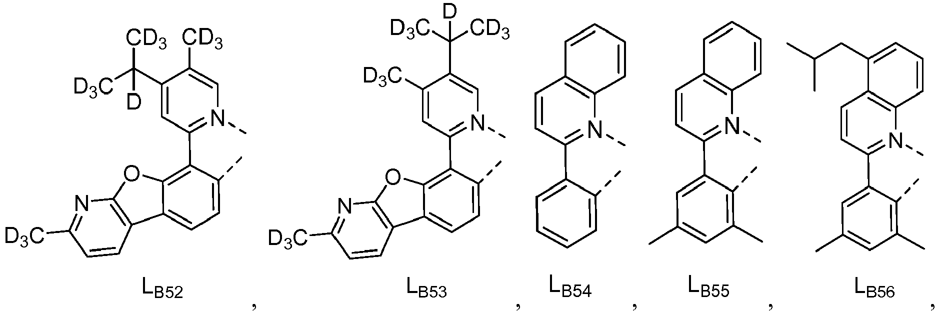

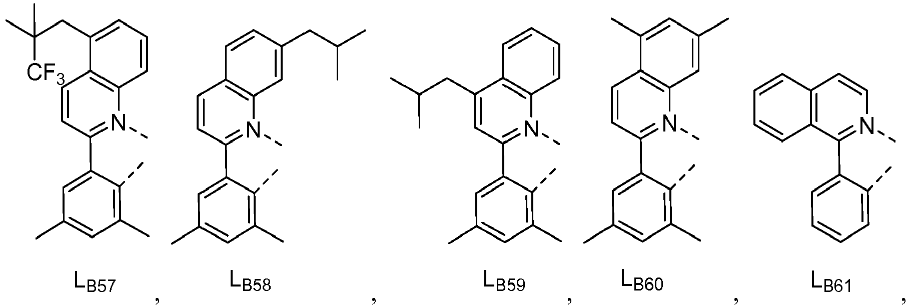

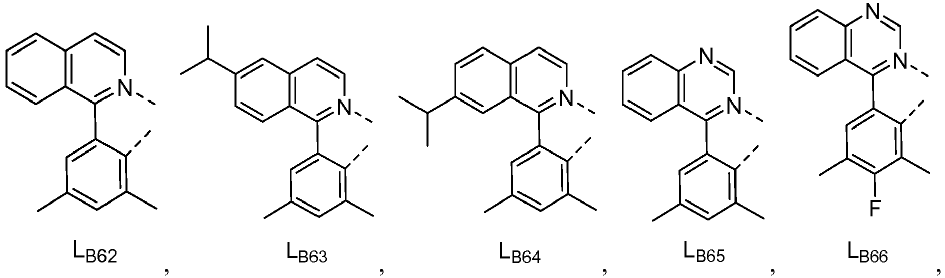

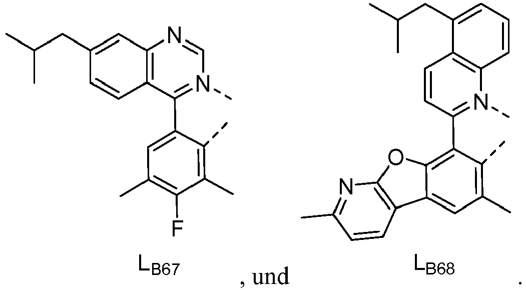

14. Die Verbindung nach Anspruch 9, wobei die Verbindung ausgewählt ist aus der Gruppe bestehend aus Verbindung A1 bis Verbindung A534;
wobei jede Verbindung A*x* die Formel Ir(L_{A*i*})₃ aufweist; und
wobei x = *i*; *i* ist eine ganze Zahl von 1 bis 534.

15. Die Verbindung nach Anspruch 9, wobei die Verbindung ausgewählt ist aus der Gruppe bestehend aus Verbindung B1 bis Verbindung B36312 und Verbindung C1 bis C36312;
wobei für die Verbindung B1 bis Verbindung B36312 jede Verbindung B*y* die Formel Ir(L_{A*i*})(L_{B*j*})₂ aufweist, wobei *y* = 534*j* + *i* - 533, *i* ist eine ganze Zahl von 1 bis 534, und *j* ist eine ganze Zahl von 1 bis 68;
wobei für die Verbindung C1 bis Verbindung C36312 jede Verbindung C*z* die Formel Ir(L_{A*i*})₂(L_{B*j*}) aufweist, wobei *z* = 534*j* + *i*+533; *i* ist eine ganze Zahl von 1 bis 534, und *j* ist eine ganze Zahl von 1 to 68; und
wobei L_{B} ausgewählt ist aus der Gruppe bestehend aus:

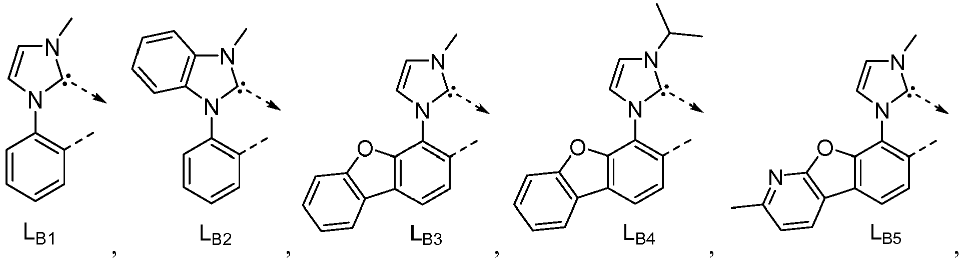

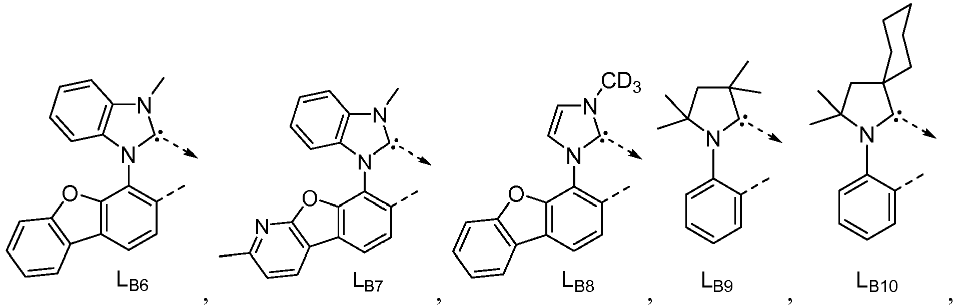

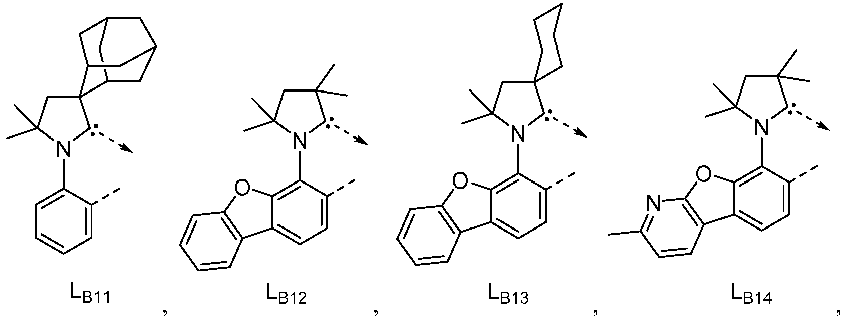

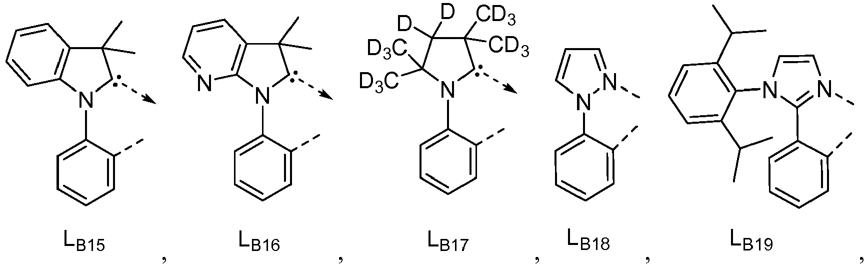

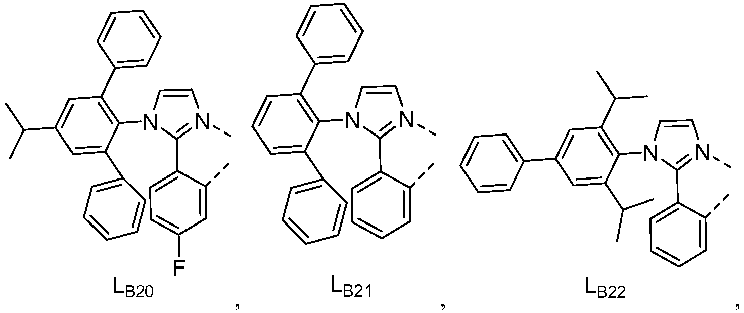

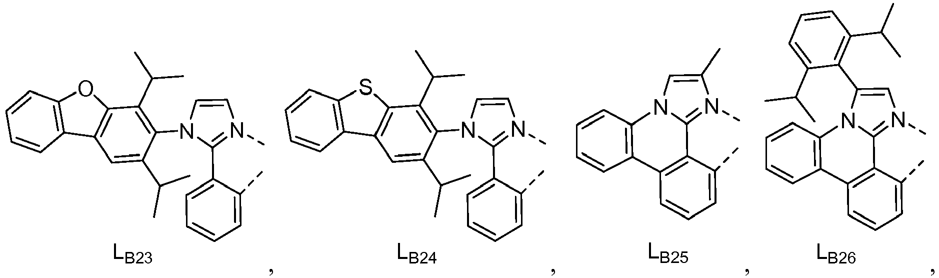

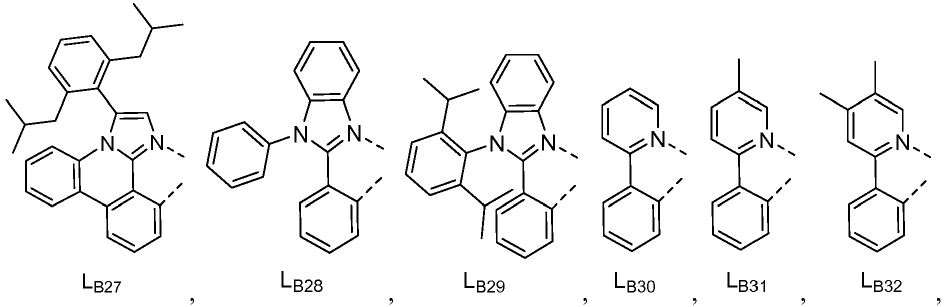

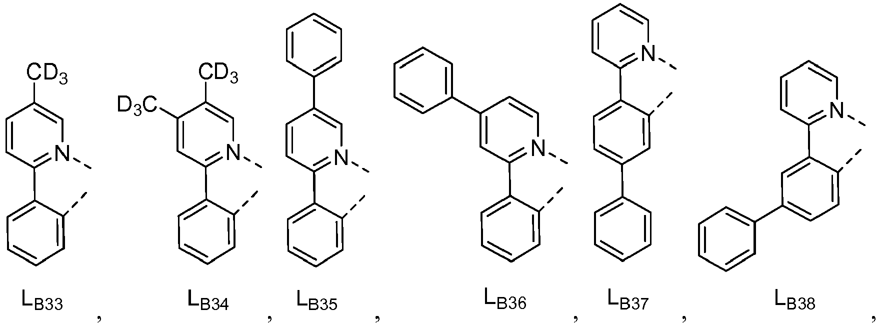

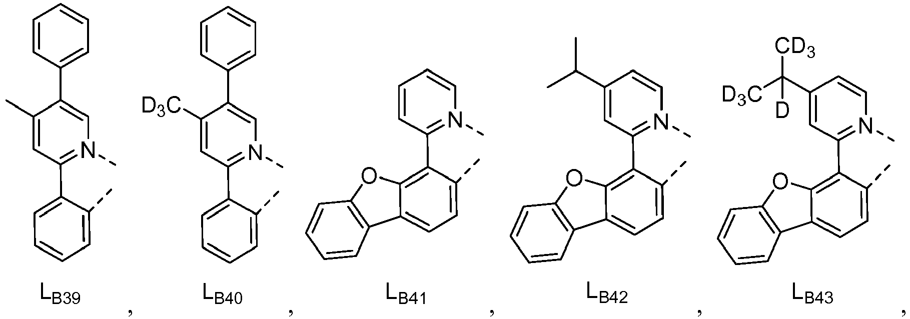

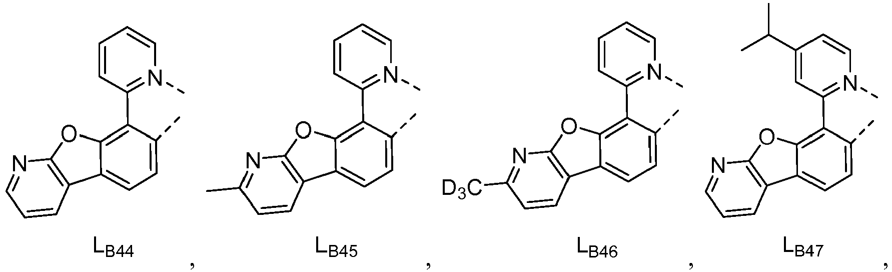

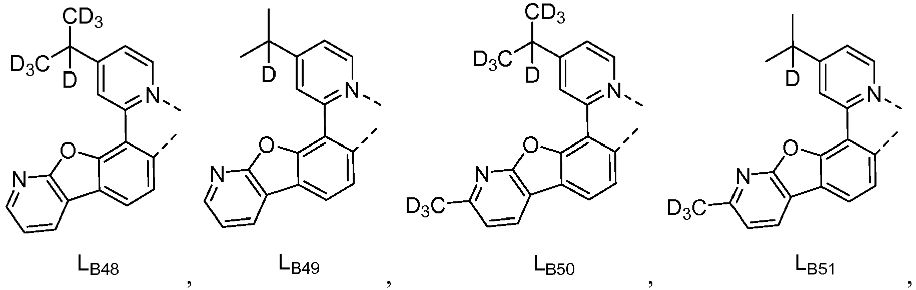

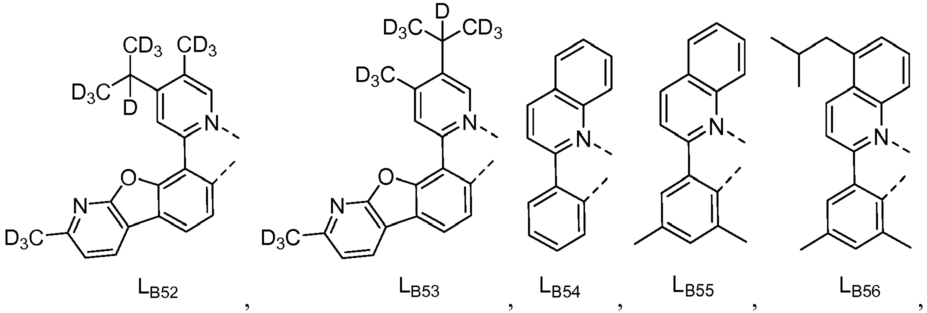

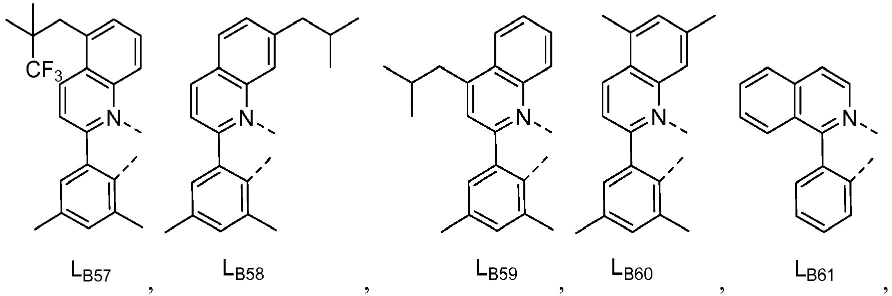

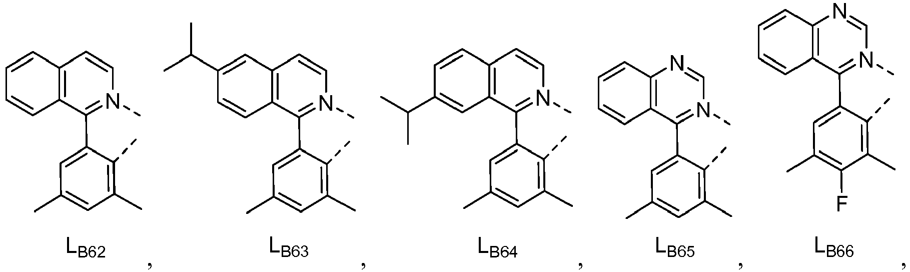

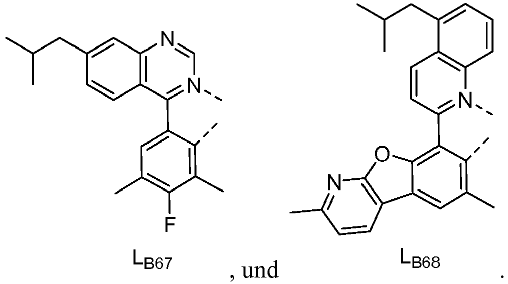

16. Eine erste organische Licht emittierende Vorrichtung umfassend:
eine Anode;
eine Kathode; und
eine organische Schicht, angeordnet zwischen der Anode und der Kathode, umfassend eine Verbindung umfassend einen Carbenliganden L_{A} gemäß Formel I: 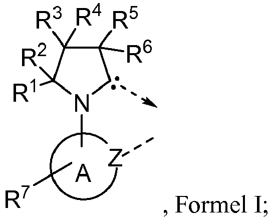
wobei Ring A ein 5-gliedriger oder 6-gliedriger carbozyklischer oder heterozyklischer Ring ist;
wobei Z Stickstoff oder Kohlenstoff ist;
wobei R⁷ für Monosubstitution bis zur maximal möglichen Anzahl von Substitutionen oder keine Substitution steht;
wobei R¹, R², R³, R⁴, R⁵, R⁶ und R⁷ unabhängig voneiander ausgewählt sind aus der Gruppe bestehend aus Wasserstoff, Deuterium, Halogenid, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen;
wobei beliebige benachbarte Substituenten aus R¹, R², R³, R⁴, R⁵, R⁶ und R⁷ gegebenenfalls miteinander verknüpft oder fusioniert sind zu einem Ring oder einer Doppelbindung;
wobei der Ligand L_{A} an ein Metal M koordiniert ist über einenCarbenkohlenstoff und Z; und
wobei der Ligand L_{A} gegebenenfalls mit anderen Liganden verknüpft ist um dreizähnige, vierzähnige, fünfzähnige oder sechszähnige Liganden zu bilden.

17. Die erste organische Licht emittierende Vorrichtung nach Anspruch 16, wobei die erste organische Licht emittierende Vorrichtung in eine Vorrichtung eingebaut ist, die ausgewählt ist aus der Gruppe bestehend aus einem Konsumentenprodukt, einem elektronischen Komponentenmodul, einer organischen Licht emittierenden Vorrichtung, und einer Lichtleiste.

18. Die erste organische Licht emittierende Vorrichtung nach Anspruch 16, wboei die organische Schicht eine emittierende Schicht und die Verbindung ein emittierender Dotierstoff oder ein nicht emittierender Dotierstoff ist.

19. Die erste organische Licht emittierende Vorrichtung nach Anspruch 16, wobei die organische Schicht ferner einen Wirt umfasst, wobei der Wirt mindestens eine chemische Gruppe umfasst, die ausgewählt ist aus der Gruppe bestehend aus Triphenylen, Carbazol, Dibenzothiphen, Dibenzofuran, Dibenzoselenophen, Azatriphenylen, Azacarbazol, Azadibenzothiophen, Aza-dibenzofuran, und Aza-dibenzoselenophen.

20. Eine Formulierung umfassend eine Verbindung umfassend einen Carbenliganden L_{A} gemäß Formel I: 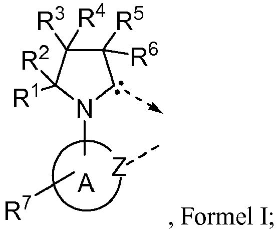
wobei Ring A ein 5-gliedriger oder 6-gliedriger carbozyklischer oder heterozyklischer Ring ist;
wobei Z Stickstoff oder Kohlenstoff ist;
wobei R⁷ für Monosubstitution bis zur maximal möglichen Anzahl von Substitutionen oder keine Substitution steht;
wobei R¹, R², R³, R⁴, R⁵, R⁶ und R⁷ unabhängig voneiander ausgewählt sind aus der Gruppe bestehend aus Wasserstoff, Deuterium, Halogenid, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Carbonsäuren, Ester, Nitril, Isonitril, Sulfanyl, Sulfinyl, Sulfonyl, Phosphino, und deren Kombinationen;
wobei beliebige benachbarte Substituenten aus R¹, R², R³, R⁴, R⁵, R⁶ und R⁷ gegebenenfalls miteinander verknüpft oder fusioniert sind zu einem Ring oder einer Doppelbindung;
wobei der Ligand L_{A} an ein Metal M koordiniert ist über einen Carbenkohlenstoff und Z; und
wobei der Ligand L_{A} gegebenenfalls mit anderen Liganden verknüpft ist um dreizähnige, vierzähnige, fünfzähnige oder sechszähnige Liganden zu bilden.

## Revendications

1. Composé comprenant un ligand carbène L_{A} de Formule I : 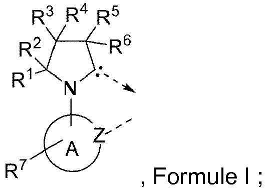
où le cycle A est un cycle carbocyclique ou hétérocyclique à 5 chaînons ou 6 chaînons ;
où Z est l'azote ou le carbone ;
où R⁷ **représente d'une mono**-substitution au nombre maximal possible de substitution, ou aucune substitution ;
où R¹, R², R³, R⁴, R⁵, R⁶ et R⁷ sont indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ;
où tous substituants adjacents de R¹, R², R³, R⁴, R⁵, R⁶ et R⁷ sont facultativement attachés ou fusionnés en un cycle ou une double liaison ;
où le ligand L_{A} est coordonné à un métal M par l'intermédiaire du carbone de carbène et Z ; et
où le ligand L_{A} **est facultativement lié à d'autres ligands pour comprendre un ligand** tridentate, tétradentate, pentadentate ou hexadentate
à l'exception de 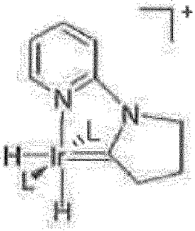 où L est PPh₃.

2. Composé de la revendication 1, où M est choisi dans le groupe constitué par Ir, Rh, Re, Ru, Os, Pt, Au et Cu.

3. Composé de la revendication 1 ou 2, où le cycle A est un phényle.

4. Composé de l'une quelconque des revendications 1 à 3, où R¹, R², R³, R⁴, R⁵ et R⁶ sont indépendamment choisis dans le groupe constitué par hydrogène, deutérium, alkyle, cycloalkyle, aryle, hétéroaryle, et leurs combinaisons.

5. Composé de l'une quelconque des revendications 1 à 4, où tous substituants adjacents de R¹, R², R³, R⁴, R⁵, R⁶ et R⁷ sont facultativement attachés ou fusionnés en un cycle non aromatique.

6. Composé de l'une quelconque des revendications 1 à 4, où tous substituants adjacents de R¹, R², R³, R⁴, R⁵, R⁶ et R⁷ sont facultativement attachés ou fusionnés en un cycle aromatique.

7. Composé de l'une quelconque des revendications 1 à 4, où R³ et R⁴ sont l'hydrogène ou le deutérium.

8. Composé de la revendication 1, où le ligand L_{A} a la structure : 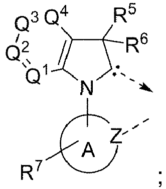
où Q¹, Q², Q³ et Q⁴ sont indépendamment choisis dans le groupe constitué par N et CR ; et
où chaque R est indépendamment choisi dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons.

9. Composé de la revendication 1, où le ligand L_{A} est L_{Ai} choisi dans le groupe constitué par L_{A1} à L_{A534},
où les substituants R¹, R², R³, R⁴, R⁵, R⁶ et le cycle A dans L_{A*i*} pour *i* = 1 à 198 sont tels que définis dans le Tableau 1 ci-après :
**Tableau 1**
| *i* | R¹ | R² | R³ | R⁴ | R⁵ | R⁶ | Cycle A |
|---|---|---|---|---|---|---|---|
| 1 | CH₃ | CH₃ | H | H | CH₃ | CH₃ | 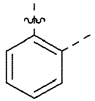 |
| 2 | CH₃ | CH₃ | H | H | CH₃ | CH₃ | 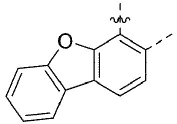 |
| 3 | CH₃ | CH₃ | H | H | CH₃ | CH₃ | 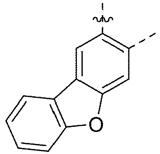 |
| 4 | CH₃ | CH₃ | H | H | CH₃ | CH₃ | 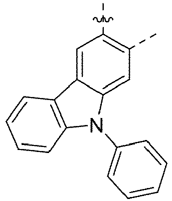 |
| 5 | CH₃ | CH₃ | H | H | CH₃ | CH₃ | 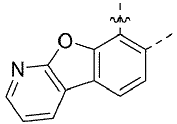 |
| 6 | CH₃ | CH₃ | H | H | CH₃ | CH₃ | 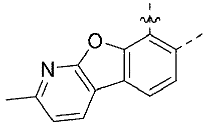 |
| 7 | CH₃ | CH₃ | H | H | CH₃ | CH₃ | 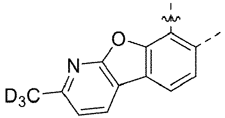 |
| 8 | CH₃ | CH₃ | H | H | CH₃ | CH₃ | 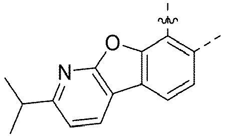 |
| 9 | CH₃ | CH₃ | H | H | CH₃ | CH₃ | 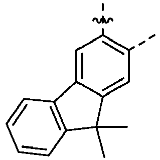 |
| 10 | CH₃ | CH₃ | H | H | CH₃ | CH₂CH₃ | 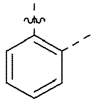 |
| 11 | CH₃ | CH₃ | H | H | CH₃ | CH₂CH₃ | 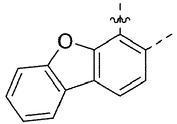 |
| 12 | CH₃ | CH₃ | H | H | CH₃ | CH₂CH₃ | 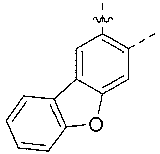 |
| 13 | CH₃ | CH₃ | H | H | CH₃ | CH₂CH₃ | 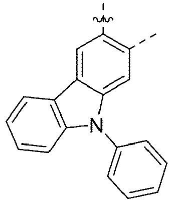 |
| 14 | CH₃ | CH₃ | H | H | CH₃ | CH₂CH₃ | 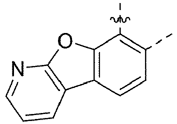 |
| 15 | CH₃ | CH₃ | H | H | CH₃ | CH₂CH₃ | 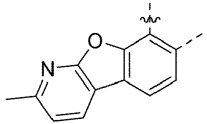 |
| 16 | CH₃ | CH₃ | H | H | CH₃ | CH₂CH₃ | 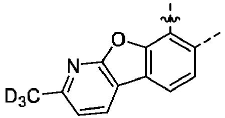 |
| 17 | CH₃ | CH₃ | H | H | CH₃ | CH₂CH₃ | 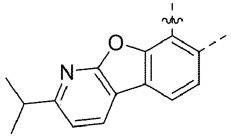 |
| 18 | CH₃ | CH₃ | H | H | CH₃ | CH₂CH₃ | 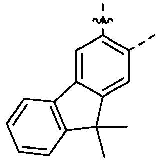 |
| 19 | CH₃ | CH₃ | H | H | CH₃ | CH(CH₃)₂ | 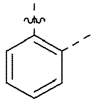 |
| 20 | CH₃ | CH₃ | H | H | CH₃ | CH(CH₃)₂ | 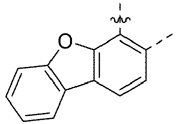 |
| 21 | CH₃ | CH₃ | H | H | CH₃ | CH(CH₃)₂ | 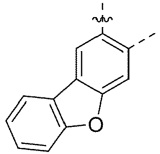 |
| 22 | CH₃ | CH₃ | H | H | CH₃ | CH(CH₃)₂ | 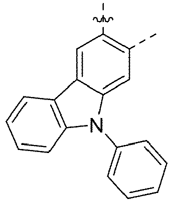 |
| 23 | CH₃ | CH₃ | H | H | CH₃ | CH(CH₃)₂ | 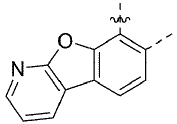 |
| 24 | CH₃ | CH₃ | H | H | CH₃ | CH(CH₃)₂ | 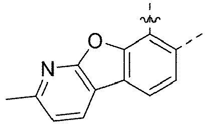 |
| 25 | CH₃ | CH₃ | H | H | CH₃ | CH(CH₃)₂ | 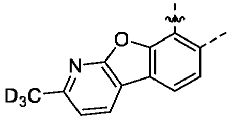 |
| 26 | CH₃ | CH₃ | H | H | CH₃ | CH(CH₃)₂ | 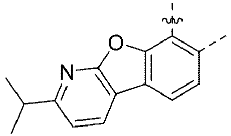 |
| 27 | CH₃ | CH₃ | H | H | CH₃ | CH(CH₃)₂ | 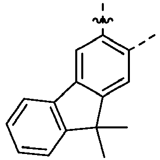 |
| 28 | CH₃ | CH₃ | H | H | CH₂CH₃ | CH₂CH₃ | 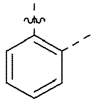 |
| 29 | CH₃ | CH₃ | H | H | CH₂CH₃ | CH₂CH₃ | 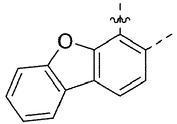 |
| 30 | CH₃ | CH₃ | H | H | CH₂CH₃ | CH₂CH₃ | 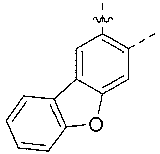 |
| 31 | CH₃ | CH₃ | H | H | CH₂CH₃ | CH₂CH₃ | 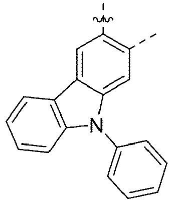 |
| 32 | CH₃ | CH₃ | H | H | CH₂CH₃ | CH₂CH₃ | 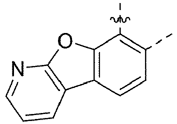 |
| 33 | CH₃ | CH₃ | H | H | CH₂CH₃ | CH₂CH₃ | 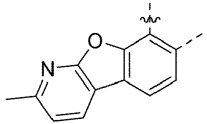 |
| 34 | CH₃ | CH₃ | H | H | CH₂CH₃ | CH₂CH₃ | 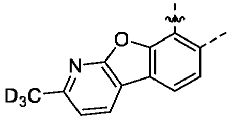 |
| 35 | CH₃ | CH₃ | H | H | CH₂CH₃ | CH₂CH₃ | 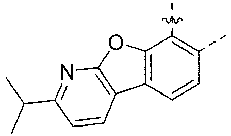 |
| 36 | CH₃ | CH₃ | H | H | CH₂CH₃ | CH₂CH₃ | 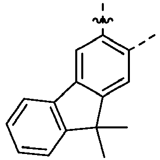 |
| 37 | CH₂CH₃ | CH₃ | H | H | CH₃ | CH₃ | 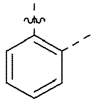 |
| 38 | CH₂CH₃ | CH₃ | H | H | CH₃ | CH₃ | 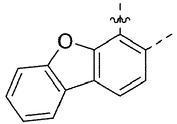 |
| 39 | CH₂CH₃ | CH₃ | H | H | CH₃ | CH₃ | 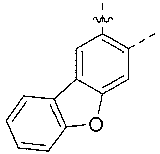 |
| 40 | CH₂CH₃ | CH₃ | H | H | CH₃ | CH₃ | 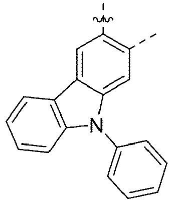 |
| 41 | CH₂CH₃ | CH₃ | H | H | CH₃ | CH₃ | 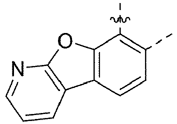 |
| 42 | CH₂CH₃ | CH₃ | H | H | CH₃ | CH₃ | 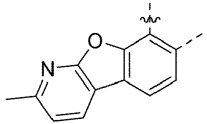 |
| 43 | CH₂CH₃ | CH₃ | H | H | CH₃ | CH₃ | 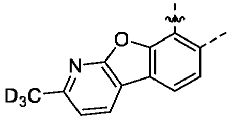 |
| 44 | CH₂CH₃ | CH₃ | H | H | CH₃ | CH₃ | 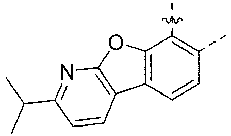 |
| 45 | CH₂CH₃ | CH₃ | H | H | CH₃ | CH₃ | 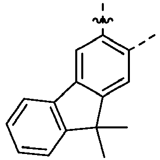 |
| 46 | CH(CH₃)₂ | CH₃ | H | H | CH₃ | CH₃ | 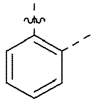 |
| 47 | CH(CH₃)₂ | CH₃ | H | H | CH₃ | CH₃ | 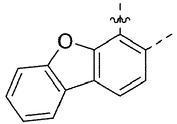 |
| 48 | CH(CH₃)₂ | CH₃ | H | H | CH₃ | CH₃ | 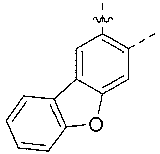 |
| 49 | CH(CH₃)₂ | CH₃ | H | H | CH₃ | CH₃ | 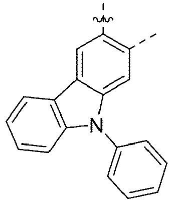 |
| 50 | CH(CH₃)₂ | CH₃ | H | H | CH₃ | CH₃ | 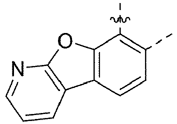 |
| 51 | CH(CH₃)₂ | CH₃ | H | H | CH₃ | CH₃ | 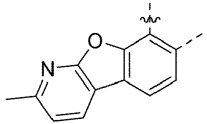 |
| 52 | CH(CH₃)₂ | CH₃ | H | H | CH₃ | CH₃ | 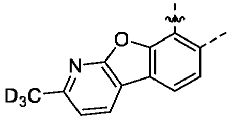 |
| 53 | CH(CH₃)₂ | CH₃ | H | H | CH₃ | CH₃ | 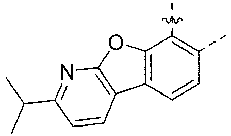 |
| 54 | CH(CH₃)₂ | CH₃ | H | H | CH₃ | CH₃ | 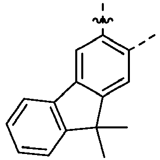 |
| 55 | CH₂CH₃ | CH₂CH₃ | H | H | CH₃ | CH₃ | 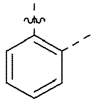 |
| 56 | CH₂CH₃ | CH₂CH₃ | H | H | CH₃ | CH₃ | 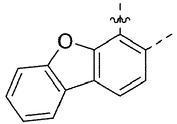 |
| 57 | CH₂CH₃ | CH₂CH₃ | H | H | CH₃ | CH₃ | 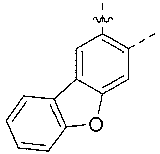 |
| 58 | CH₂CH₃ | CH₂CH₃ | H | H | CH₃ | CH₃ | 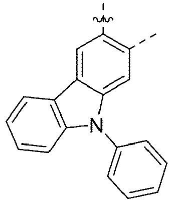 |
| 59 | CH₂CH₃ | CH₂CH₃ | H | H | CH₃ | CH₃ | 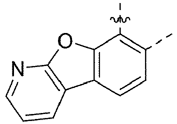 |
| 60 | CH₂CH₃ | CH₂CH₃ | H | H | CH₃ | CH₃ | 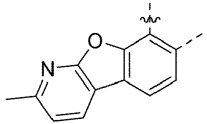 |
| 61 | CH₂CH₃ | CH₂CH₃ | H | H | CH₃ | CH₃ | 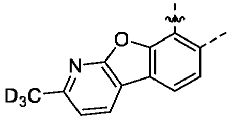 |
| 62 | CH₂CH₃ | CH₂CH₃ | H | H | CH₃ | CH₃ | 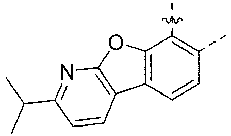 |
| 63 | CH₂CH₃ | CH₂CH₃ | H | H | CH₃ | CH₃ | 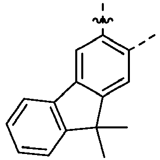 |
| 64 | CH₃ | CH₃ | H | H | 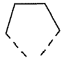 | | 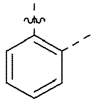 |
| 65 | CH₃ | CH₃ | H | H | 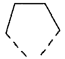 | | 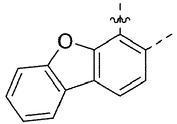 |
| 66 | CH₃ | CH₃ | H | H | 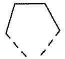 | | 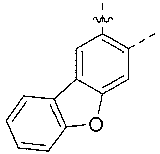 |
| 67 | CH₃ | CH₃ | H | H | 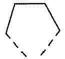 | | 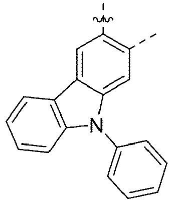 |
| 68 | CH₃ | CH₃ | H | H | 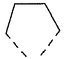 | | 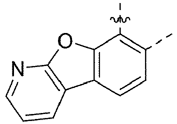 |
| 69 | CH₃ | CH₃ | H | H | 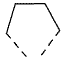 | | 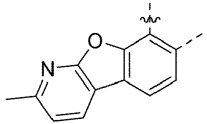 |
| 70 | CH₃ | CH₃ | H | H | 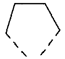 | | 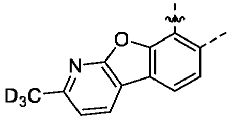 |
| 71 | CH₃ | CH₃ | H | H | 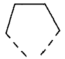 | | 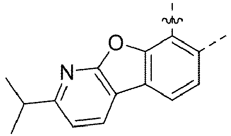 |
| 72 | CH₃ | CH₃ | H | H | 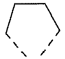 | | 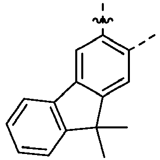 |
| 73 | CH₃ | CH₃ | H | H | 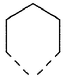 | | 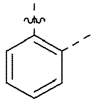 |
| 74 | CH₃ | CH₃ | H | H | 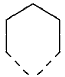 | | 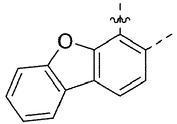 |
| 75 | CH₃ | CH₃ | H | H | 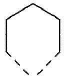 | | 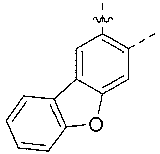 |
| 76 | CH₃ | CH₃ | H | H | 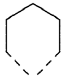 | | 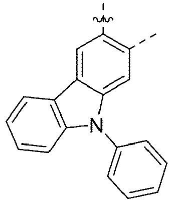 |
| 77 | CH₃ | CH₃ | H | H | 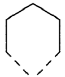 | | 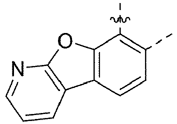 |
| 78 | CH₃ | CH₃ | H | H | 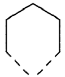 | | 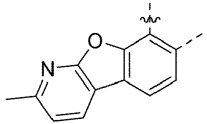 |
| 79 | CH₃ | CH₃ | H | H | 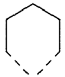 | | 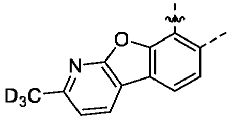 |
| 80 | CH₃ | CH₃ | H | H | 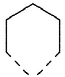 | | 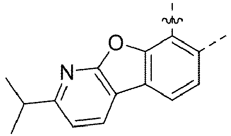 |
| 81 | CH₃ | CH₃ | H | H | 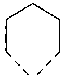 | | 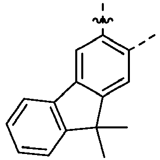 |
| 82 | CH₃ | CH₃ | H | H | 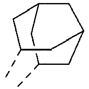 | | 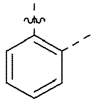 |
| 83 | CH₃ | CH₃ | H | H | 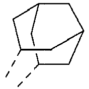 | | 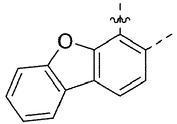 |
| 84 | CH₃ | CH₃ | H | H | 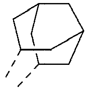 | | 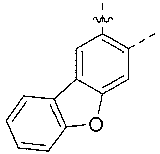 |
| 85 | CH₃ | CH₃ | H | H | 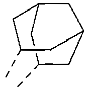 | | 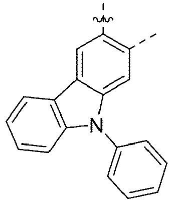 |
| 86 | CH₃ | CH₃ | H | H | 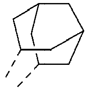 | | 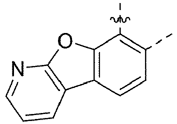 |
| 87 | CH₃ | CH₃ | H | H | 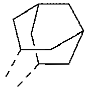 | | 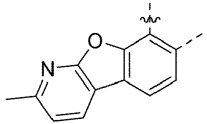 |
| 88 | CH₃ | CH₃ | H | H | 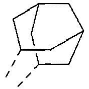 | | 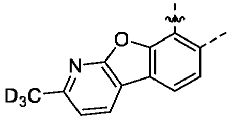 |
| 89 | CH₃ | CH₃ | H | H | 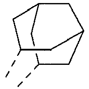 | | 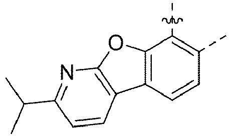 |
| 90 | CH₃ | CH₃ | H | H | 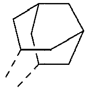 | | 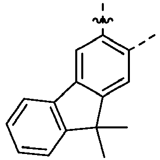 |
| 91 | 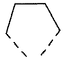 | H | H | CH₃ | CH₃ | | 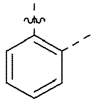 |
| 92 | 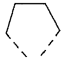 | H | H | CH₃ | CH₃ | | 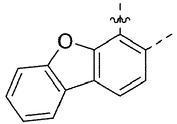 |
| 93 | 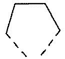 | H | H | CH₃ | CH₃ | | 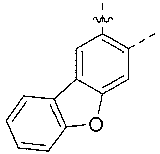 |
| 94 | 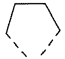 | H | H | CH₃ | CH₃ | | 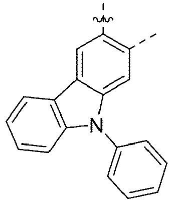 |
| 95 | 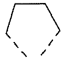 | H | H | CH₃ | CH₃ | | 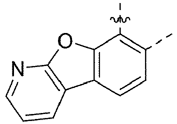 |
| 96 | 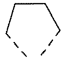 | H | H | CH₃ | CH₃ | | 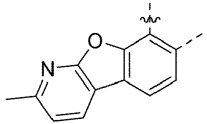 |
| 97 | 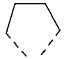 | H | H | CH₃ | CH₃ | | 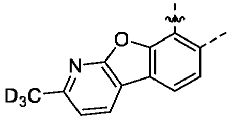 |
| 98 | 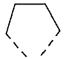 | H | H | CH₃ | CH₃ | | 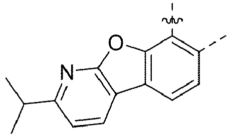 |
| 99 | 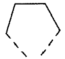 | H | H | CH₃ | CH₃ | | 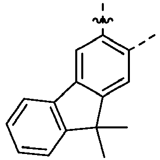 |
| 100 | 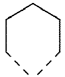 | H | H | CH₃ | CH₃ | | 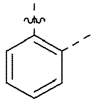 |
| 101 | 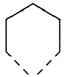 | H | H | CH₃ | CH₃ | | 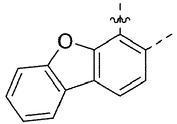 |
| 102 | 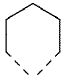 | H | H | CH₃ | CH₃ | | 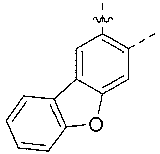 |
| 103 | 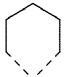 | H | H | CH₃ | CH₃ | | 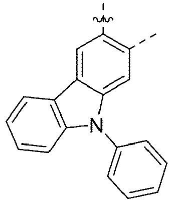 |
| 104 | 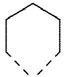 | H | H | CH₃ | CH₃ | | 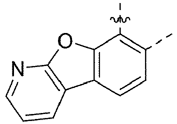 |
| 105 | 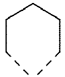 | H | H | CH₃ | CH₃ | | 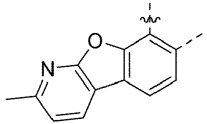 |
| 106 | 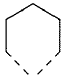 | H | H | CH₃ | CH₃ | | 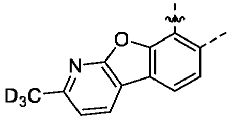 |
| 107 | 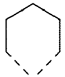 | H | H | CH₃ | CH₃ | | 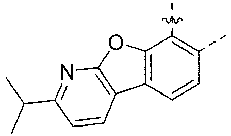 |
| 108 | 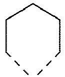 | H | H | CH₃ | CH₃ | | 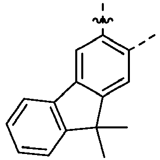 |
| 109 | 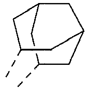 | H | H | CH₃ | CH₃ | | 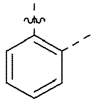 |
| 110 | 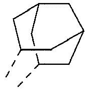 | H | H | CH₃ | CH₃ | | 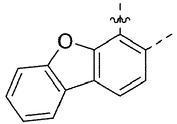 |
| 111 | 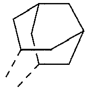 | H | H | CH₃ | CH₃ | | 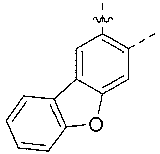 |
| 112 | 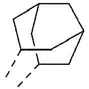 | H | H | CH₃ | CH₃ | | 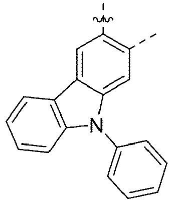 |
| 113 | 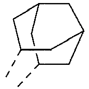 | H | H | CH₃ | CH₃ | | 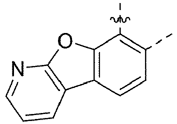 |
| 114 | 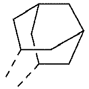 | H | H | CH₃ | CH₃ | | 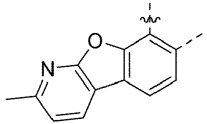 |
| 115 | 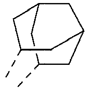 | H | H | CH₃ | CH₃ | | 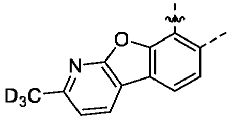 |
| 116 | 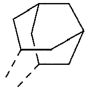 | H | H | CH₃ | CH₃ | | 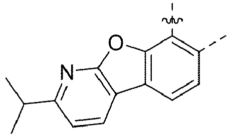 |
| 117 | 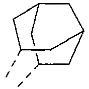 | H | H | CH₃ | CH₃ | | 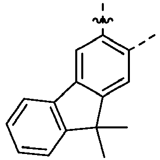 |
| 118 | 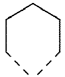 | H | H | | 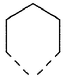 | | 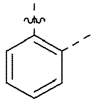 |
| 119 | 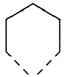 | H | H | | 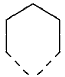 | | 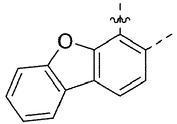 |
| 120 | 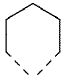 | H | H | | 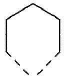 | | 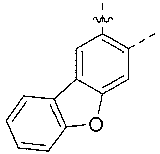 |
| 121 | 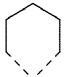 | H | H | | 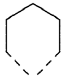 | | 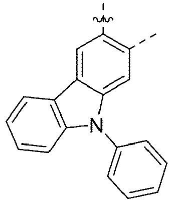 |
| 122 | 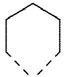 | H | H | | 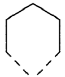 | | 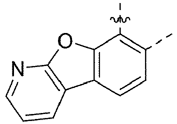 |
| 123 | 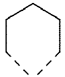 | H | H | | 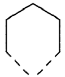 | | 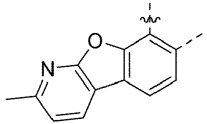 |
| 124 | 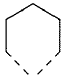 | H | H | | 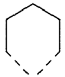 | | 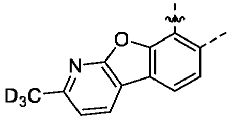 |
| 125 | 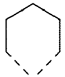 | H | H | | 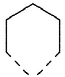 | | 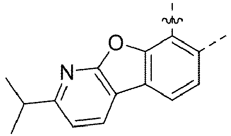 |
| 126 | 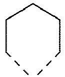 | H | H | | 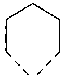 | | 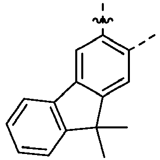 |
| 127 | CD₃ | CD₃ | H | H | CD₃ | CD₃ | 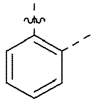 |
| 128 | CD₃ | CD₃ | H | H | CD₃ | CD₃ | 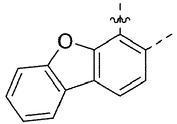 |
| 129 | CD₃ | CD₃ | H | H | CD₃ | CD₃ | 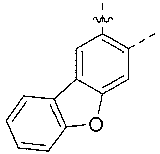 |
| 130 | CD₃ | CD₃ | H | H | CD₃ | CD₃ | 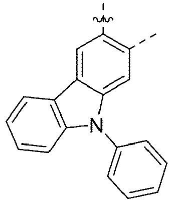 |
| 131 | CD₃ | CD₃ | H | H | CD₃ | CD₃ | 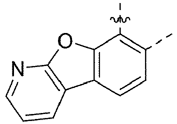 |
| 132 | CD₃ | CD₃ | H | H | CD₃ | CD₃ | 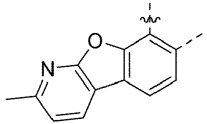 |
| 133 | CD₃ | CD₃ | H | H | CD₃ | CD₃ | 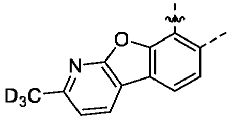 |
| 134 | CD₃ | CD₃ | H | H | CD₃ | CD₃ | 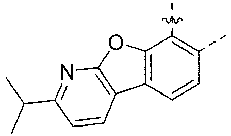 |
| 135 | CD₃ | CD₃ | H | H | CD₃ | CD₃ | 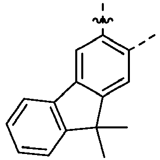 |
| 136 | CD₃ | CD₃ | D | D | CD₃ | CD₃ | 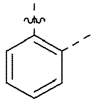 |
| 137 | CD₃ | CD₃ | D | D | CD₃ | CD₃ | 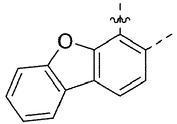 |
| 138 | CD₃ | CD₃ | D | D | CD₃ | CD₃ | 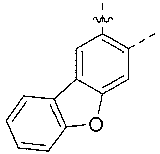 |
| 139 | CD₃ | CD₃ | D | D | CD₃ | CD₃ | 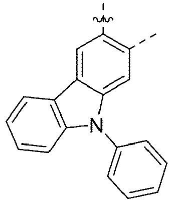 |
| 140 | CD₃ | CD₃ | D | D | CD₃ | CD₃ | 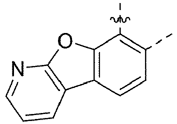 |
| 141 | CD₃ | CD₃ | D | D | CD₃ | CD₃ | 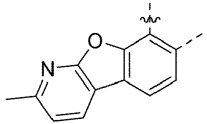 |
| 142 | CD₃ | CD₃ | D | D | CD₃ | CD₃ | 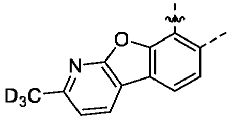 |
| 143 | CD₃ | CD₃ | D | D | CD₃ | CD₃ | 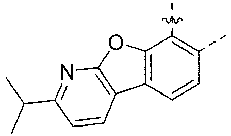 |
| 144 | CD₃ | CD₃ | D | D | CD₃ | CD₃ | 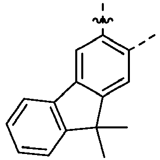 |
| 145 | CD₃ | CD₃ | D | D | CD₃ | CD(CD₃)₂ | 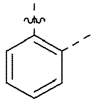 |
| 146 | CD₃ | CD₃ | D | D | CD₃ | CD(CD₃)₂ | 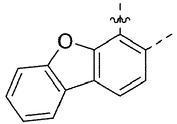 |
| 147 | CD₃ | CD₃ | D | D | CD₃ | CD(CD₃)₂ | 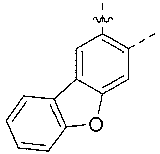 |
| 148 | CD₃ | CD₃ | D | D | CD₃ | CD(CD₃)₂ | 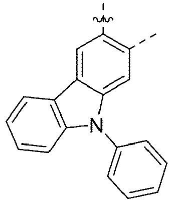 |
| 149 | CD₃ | CD₃ | D | D | CD₃ | CD(CD₃)₂ | 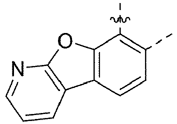 |
| 150 | CD₃ | CD₃ | D | D | CD₃ | CD(CD₃)₂ | 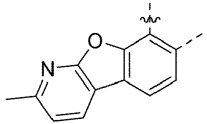 |
| 151 | CD₃ | CD₃ | D | D | CD₃ | CD(CD₃)₂ | 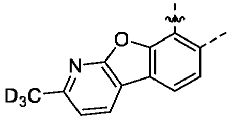 |
| 152 | CD₃ | CD₃ | D | D | CD₃ | CD(CD₃)₂ | 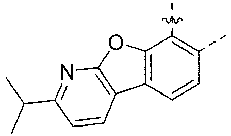 |
| 153 | CD₃ | CD₃ | D | D | CD₃ | CD(CD₃)₂ | 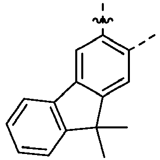 |
| 154 | CH₃ | CH₃ | H | H | CH₃ | CH₂CH₂CF₃ | 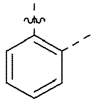 |
| 155 | CH₃ | CH₃ | H | H | CH₃ | CH₂CH₂CF₃ | 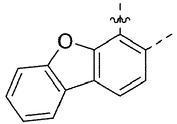 |
| 156 | CH₃ | CH₃ | H | H | CH₃ | CH₂CH₂CF₃ | 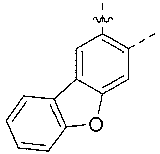 |
| 157 | CH₃ | CH₃ | H | H | CH₃ | CH₂CH₂CF₃ | 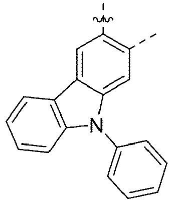 |
| 158 | CH₃ | CH₃ | H | H | CH₃ | CH₂CH₂CF₃ | 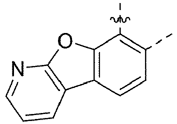 |
| 159 | CH₃ | CH₃ | H | H | CH₃ | CH₂CH₂CF₃ | 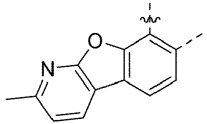 |
| 160 | CH₃ | CH₃ | H | H | CH₃ | CH₂CH₂CF₃ | 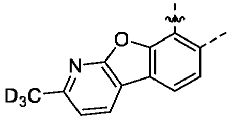 |
| 161 | CH₃ | CH₃ | H | H | CH₃ | CH₂CH₂CF₃ | 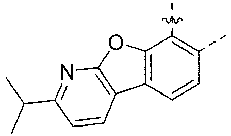 |
| 162 | CH₃ | CH₃ | H | H | CH₃ | CH₂CH₂CF₃ | 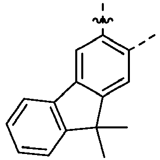 |
| 163 | CH₂CH₂CF₃ | CH₃ | H | H | CH₃ | CH₃ | 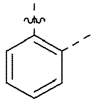 |
| 164 | CH₂CH₂CF₃ | CH₃ | H | H | CH₃ | CH₃ | 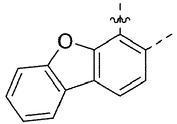 |
| 165 | CH₂CH₂CF₃ | CH₃ | H | H | CH₃ | CH₃ | 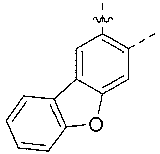 |
| 166 | CH₂CH₂CF₃ | CH₃ | H | H | CH₃ | CH₃ | 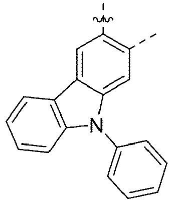 |
| 167 | CH₂CH₂CF₃ | CH₃ | H | H | CH₃ | CH₃ | 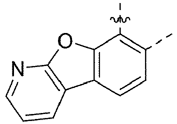 |
| 168 | CH₂CH₂CF₃ | CH₃ | H | H | CH₃ | CH₃ | 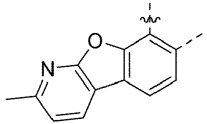 |
| 169 | CH₂CH₂CF₃ | CH₃ | H | H | CH₃ | CH₃ | 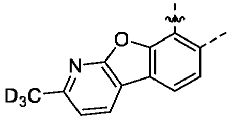 |
| 170 | CH₂CH₂CF₃ | CH₃ | H | H | CH₃ | CH₃ | 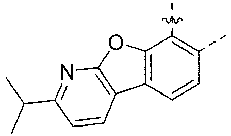 |
| 171 | CH₂CH₂CF₃ | CH₃ | H | H | CH₃ | CH₃ | 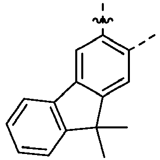 |
| 172 | CH₃ | CH₃ | H | H | CH₃ | CF₃ | 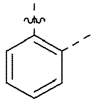 |
| 173 | CH₃ | CH₃ | H | H | CH₃ | CF₃ | 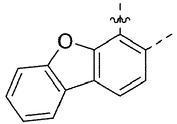 |
| 174 | CH₃ | CH₃ | H | H | CH₃ | CF₃ | 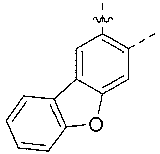 |
| 175 | CH₃ | CH₃ | H | H | CH₃ | CF₃ | 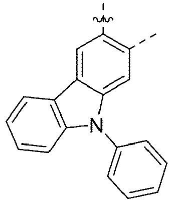 |
| 176 | CH₃ | CH₃ | H | H | CH₃ | CF₃ | 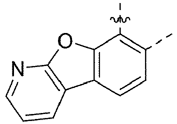 |
| 177 | CH₃ | CH₃ | H | H | CH₃ | CF₃ | 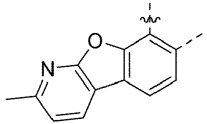 |
| 178 | CH₃ | CH₃ | H | H | CH₃ | CF₃ | 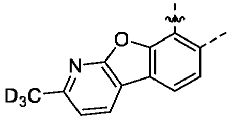 |
| 179 | CH₃ | CH₃ | H | H | CH₃ | CF₃ | 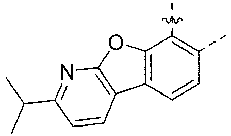 |
| 180 | CH₃ | CH₃ | H | H | CH₃ | CF₃ | 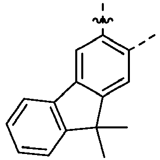 |
| 181 | CH₃ | CH₃ | H | H | CF₃ | CF₃ | 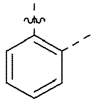 |
| 182 | CH₃ | CH₃ | H | H | CF₃ | CF₃ | 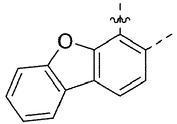 |
| 183 | CH₃ | CH₃ | H | H | CF₃ | CF₃ | 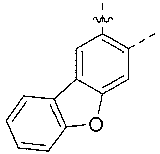 |
| 184 | CH₃ | CH₃ | H | H | CF₃ | CF₃ | 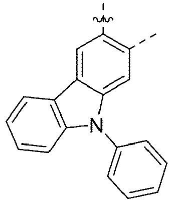 |
| 185 | CH₃ | CH₃ | H | H | CF₃ | CF₃ | 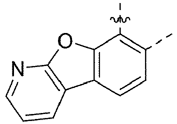 |
| 186 | CH₃ | CH₃ | H | H | CF₃ | CF₃ | 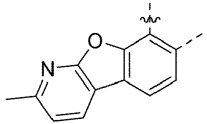 |
| 187 | CH₃ | CH₃ | H | H | CF₃ | CF₃ | 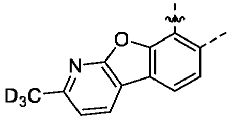 |
| 188 | CH₃ | CH₃ | H | H | CF₃ | CF₃ | 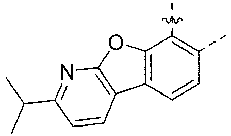 |
| 189 | CH₃ | CH₃ | H | H | CF₃ | CF₃ | 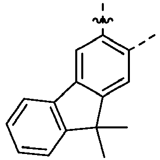 |
| 190 | CF₃ | CF₃ | H | H | CH₃ | CH₃ | 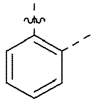 |
| 191 | CF₃ | CF₃ | H | H | CH₃ | CH₃ | 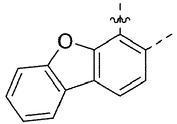 |
| 192 | CF₃ | CF₃ | H | H | CH₃ | CH₃ | 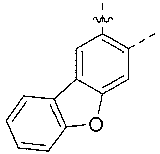 |
| 193 | CF₃ | CF₃ | H | H | CH₃ | CH₃ | 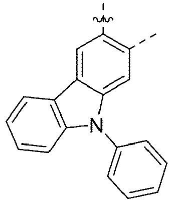 |
| 194 | CF₃ | CF₃ | H | H | CH₃ | CH₃ | 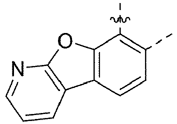 |
| 195 | CF₃ | CF₃ | H | H | CH₃ | CH₃ | 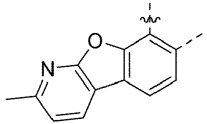 |
| 196 | CF₃ | CF₃ | H | H | CH₃ | CH₃ | 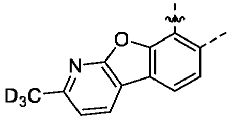 |
| 197 | CF₃ | CF₃ | H | H | CH₃ | CH₃ | 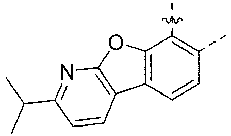 |
| 198 | CF₃ | CF₃ | H | H | CH₃ | CH₃ | 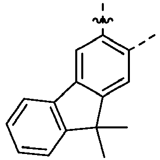 |
, et pour *i* = 199 à 534 L*_{Ai}* a la structure 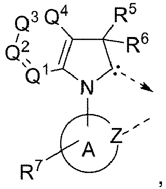 où les substituants Q¹, Q², Q³, Q⁴, R⁵, R⁶ et le cycle A sont tels que définis dans le Tableau 2 ci-après :
**Tableau 2**
| *i* | Q¹ | Q² | Q³ | Q⁴ | R⁵ | R⁶ | Cycle A |
|---|---|---|---|---|---|---|---|
| 199 | CH | CH | CH | CH | CH₃ | CH₃ | 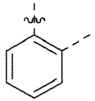 |
| 200 | CH | CH | CH | CH | CH₃ | CH₃ | 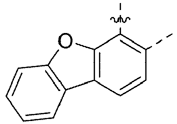 |
| 201 | CH | CH | CH | CH | CH₃ | CH₃ | 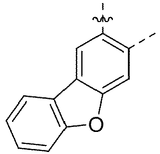 |
| 202 | CH | CH | CH | CH | CH₃ | CH₃ | 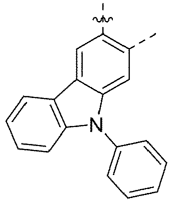 |
| 203 | CH | CH | CH | CH | CH₃ | CH₃ | 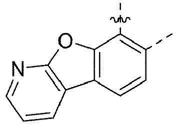 |
| 204 | CH | CH | CH | CH | CH₃ | CH₃ | 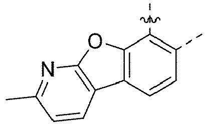 |
| 205 | CH | CH | CH | CH | CH₃ | CH₃ | 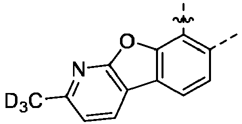 |
| 206 | CH | CH | CH | CH | CH₃ | CH₃ | 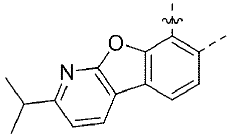 |
| 207 | CH | CH | CH | CH | CH₃ | CH₃ | 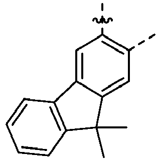 |
| 208 | CH | CH | CH | CH | CH₃ | CH₂CH₃ | 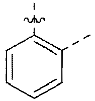 |
| 209 | CH | CH | CH | CH | CH₃ | CH₂CH₃ | 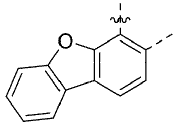 |
| 210 | CH | CH | CH | CH | CH₃ | CH₂CH₃ | 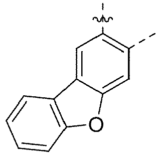 |
| 211 | CH | CH | CH | CH | CH₃ | CH₂CH₃ | 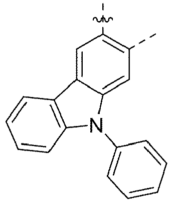 |
| 212 | CH | CH | CH | CH | CH₃ | CH₂CH₃ | 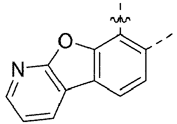 |
| 213 | CH | CH | CH | CH | CH₃ | CH₂CH₃ | 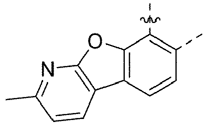 |
| 214 | CH | CH | CH | CH | CH₃ | CH₂CH₃ | 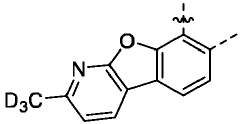 |
| 215 | CH | CH | CH | CH | CH₃ | CH₂CH₃ | 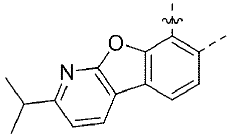 |
| 216 | CH | CH | CH | CH | CH₃ | CH₂CH₃ | 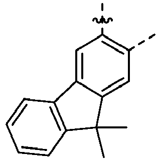 |
| 217 | CH | CH | CH | CH | CH₃ | CH(CH₃)₂ | 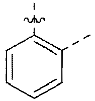 |
| 218 | CH | CH | CH | CH | CH₃ | CH(CH₃)₂ | 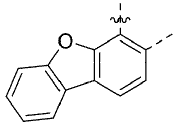 |
| 219 | CH | CH | CH | CH | CH₃ | CH(CH₃)₂ | 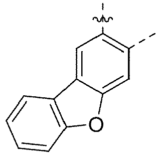 |
| 220 | CH | CH | CH | CH | CH₃ | CH(CH₃)₂ | 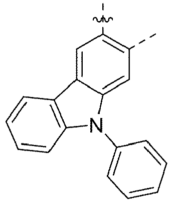 |
| 221 | CH | CH | CH | CH | CH₃ | CH(CH₃)₂ | 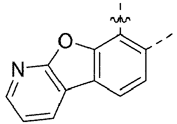 |
| 222 | CH | CH | CH | CH | CH₃ | CH(CH₃)₂ | 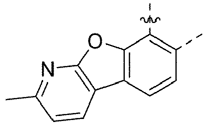 |
| 223 | CH | CH | CH | CH | CH₃ | CH(CH₃)₂ | 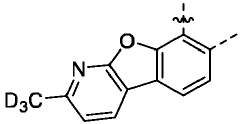 |
| 224 | CH | CH | CH | CH | CH₃ | CH(CH₃)₂ | 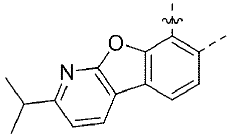 |
| 225 | CH | CH | CH | CH | CH₃ | CH(CH₃)₂ | 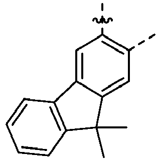 |
| 226 | CH | CH | CH | CH | 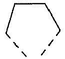 | | 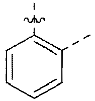 |
| 227 | CH | CH | CH | CH | 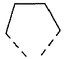 | | 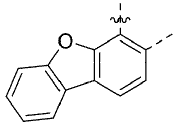 |
| 228 | CH | CH | CH | CH | 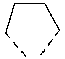 | | 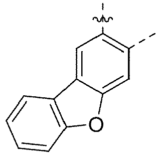 |
| 229 | CH | CH | CH | CH | 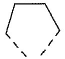 | | 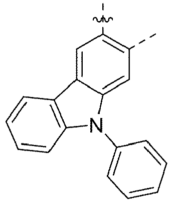 |
| 230 | CH | CH | CH | CH | 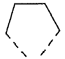 | | 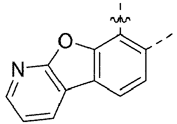 |
| 231 | CH | CH | CH | CH | 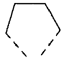 | | 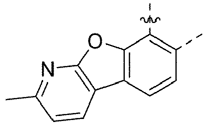 |
| 232 | CH | CH | CH | CH | 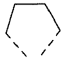 | | 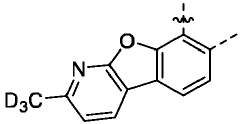 |
| 233 | CH | CH | CH | CH | 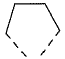 | | 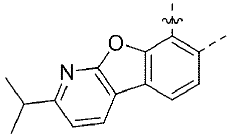 |
| 234 | CH | CH | CH | CH | 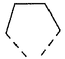 | | 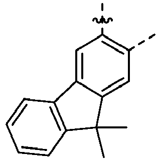 |
| 235 | CH | CH | CH | CH | 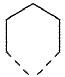 | | 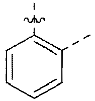 |
| 236 | CH | CH | CH | CH | 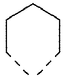 | | 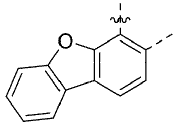 |
| 237 | CH | CH | CH | CH | 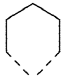 | | 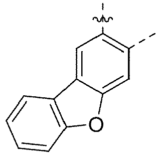 |
| 238 | CH | CH | CH | CH | 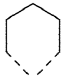 | | 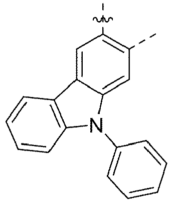 |
| 239 | CH | CH | CH | CH | 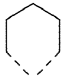 | | 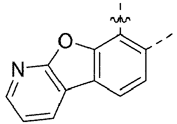 |
| 240 | CH | CH | CH | CH | 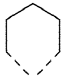 | | 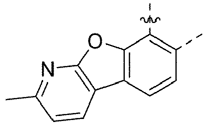 |
| 241 | CH | CH | CH | CH | 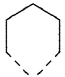 | | 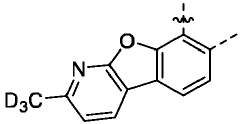 |
| 242 | CH | CH | CH | CH | 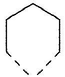 | | 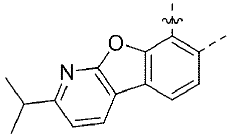 |
| 243 | CH | CH | CH | CH | 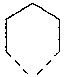 | | 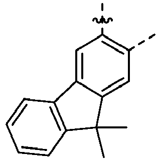 |
| 244 | CH | CH | CH | CH | 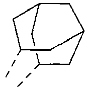 | | 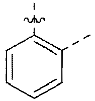 |
| 245 | CH | CH | CH | CH | 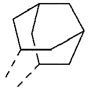 | | 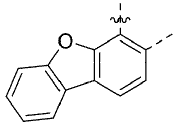 |
| 246 | CH | CH | CH | CH | 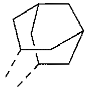 | | 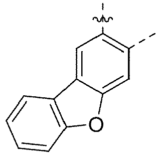 |
| 247 | CH | CH | CH | CH | 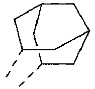 | | 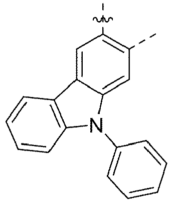 |
| 248 | CH | CH | CH | CH | 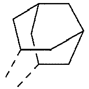 | | 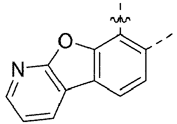 |
| 249 | CH | CH | CH | CH | 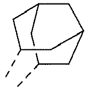 | | 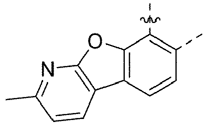 |
| 250 | CH | CH | CH | CH | 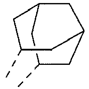 | | 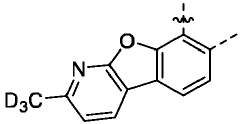 |
| 251 | CH | CH | CH | CH | 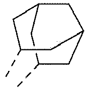 | | 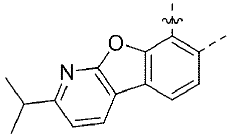 |
| 252 | CH | CH | CH | CH | 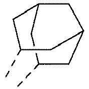 | | 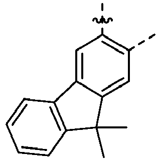 |
| 253 | N | CH | CH | CH | CH₃ | CH₃ | 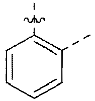 |
| 254 | N | CH | CH | CH | CH₃ | CH₃ | 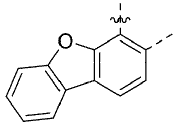 |
| 255 | N | CH | CH | CH | CH₃ | CH₃ | 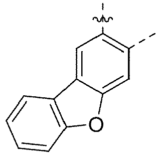 |
| 256 | N | CH | CH | CH | CH₃ | CH₃ | 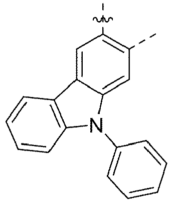 |
| 257 | N | CH | CH | CH | CH₃ | CH₃ | 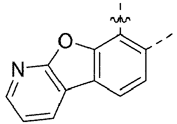 |
| 258 | N | CH | CH | CH | CH₃ | CH₃ | 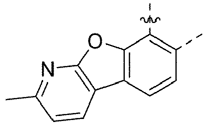 |
| 259 | N | CH | CH | CH | CH₃ | CH₃ | 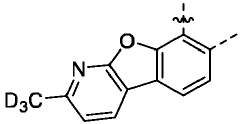 |
| 260 | N | CH | CH | CH | CH₃ | CH₃ | 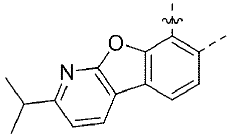 |
| 261 | N | CH | CH | CH | CH₃ | CH₃ | 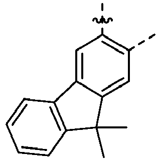 |
| 262 | N | CH | CH | CH | CH₃ | CH₂CH₃ | 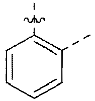 |
| 263 | N | CH | CH | CH | CH₃ | CH₂CH₃ | 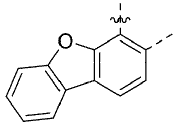 |
| 264 | N | CH | CH | CH | CH₃ | CH₂CH₃ | 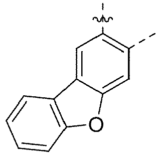 |
| 265 | N | CH | CH | CH | CH₃ | CH₂CH₃ | 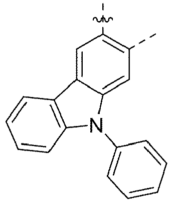 |
| 266 | N | CH | CH | CH | CH₃ | CH₂CH₃ | 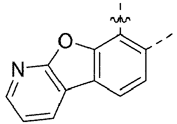 |
| 267 | N | CH | CH | CH | CH₃ | CH₂CH₃ | 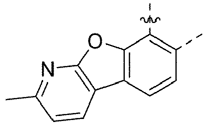 |
| 268 | N | CH | CH | CH | CH₃ | CH₂CH₃ | 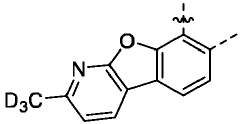 |
| 269 | N | CH | CH | CH | CH₃ | CH₂CH₃ | 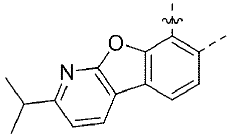 |
| 270 | N | CH | CH | CH | CH₃ | CH₂CH₃ | 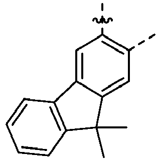 |
| 271 | N | CH | CH | CH | CH₃ | CH(CH₃)₂ | 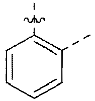 |
| 272 | N | CH | CH | CH | CH₃ | CH(CH₃)₂ | 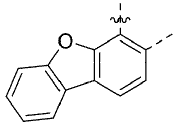 |
| 273 | N | CH | CH | CH | CH₃ | CH(CH₃)₂ | 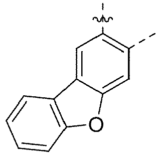 |
| 274 | N | CH | CH | CH | CH₃ | CH(CH₃)₂ | 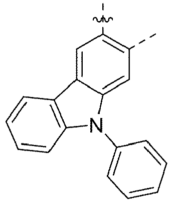 |
| 275 | N | CH | CH | CH | CH₃ | CH(CH₃)₂ | 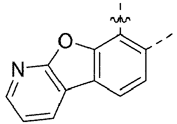 |
| 276 | N | CH | CH | CH | CH₃ | CH(CH₃)₂ | 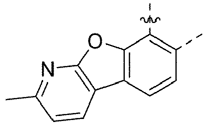 |
| 277 | N | CH | CH | CH | CH₃ | CH(CH₃)₂ | 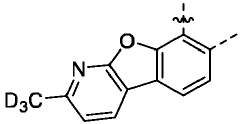 |
| 278 | N | CH | CH | CH | CH₃ | CH(CH₃)₂ | 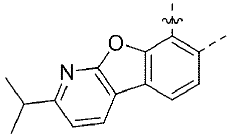 |
| 279 | N | CH | CH | CH | CH₃ | CH(CH₃)₂ | 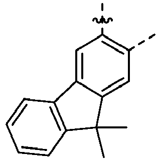 |
| 280 | N | CH | CH | CH | 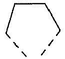 | | 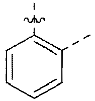 |
| 281 | N | CH | CH | CH | 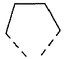 | | 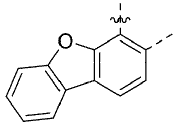 |
| 282 | N | CH | CH | CH | 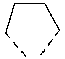 | | 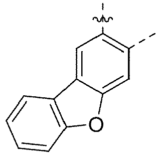 |
| 283 | N | CH | CH | CH | 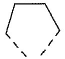 | | 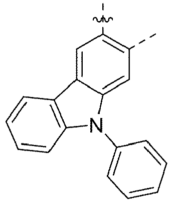 |
| 284 | N | CH | CH | CH | 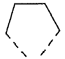 | | 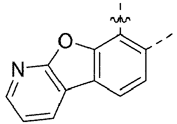 |
| 285 | N | CH | CH | CH | 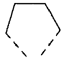 | | 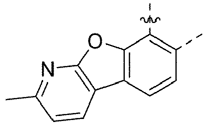 |
| 286 | N | CH | CH | CH | 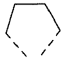 | | 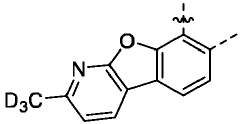 |
| 287 | N | CH | CH | CH | 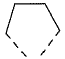 | | 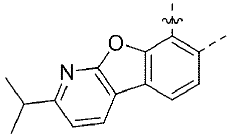 |
| 288 | N | CH | CH | CH | 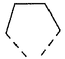 | | 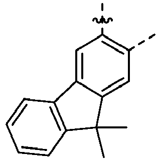 |
| 289 | N | CH | CH | CH | 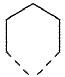 | | 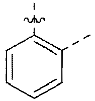 |
| 290 | N | CH | CH | CH | 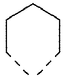 | | 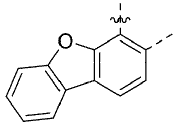 |
| 291 | N | CH | CH | CH | 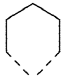 | | 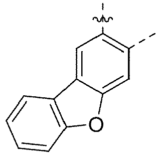 |
| 292 | N | CH | CH | CH | 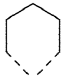 | | 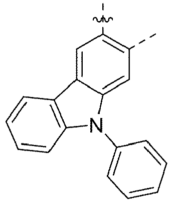 |
| 293 | N | CH | CH | CH | 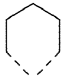 | | 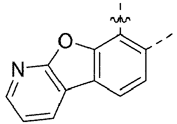 |
| 294 | N | CH | CH | CH | 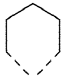 | | 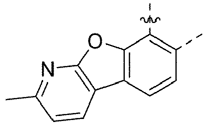 |
| 295 | N | CH | CH | CH | 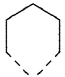 | | 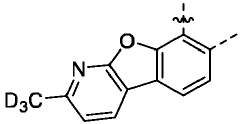 |
| 296 | N | CH | CH | CH | 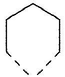 | | 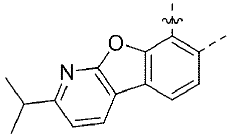 |
| 297 | N | CH | CH | CH | 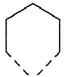 | | 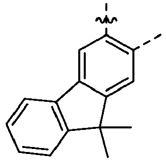 |
| 298 | N | CH | CH | CH | 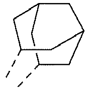 | | 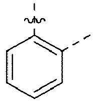 |
| 299 | N | CH | CH | CH | 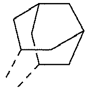 | | 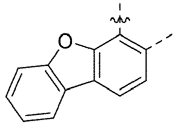 |
| 300 | N | CH | CH | CH | 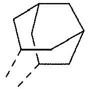 | | 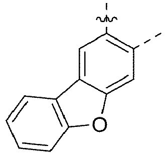 |
| 301 | N | CH | CH | CH | 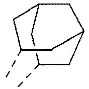 | | 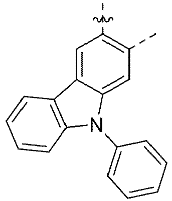 |
| 302 | N | CH | CH | CH | 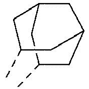 | | 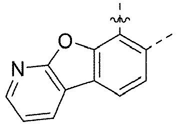 |
| 303 | N | CH | CH | CH | 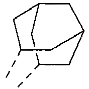 | | 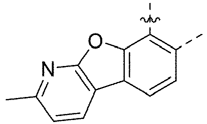 |
| 304 | N | CH | CH | CH | 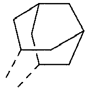 | | 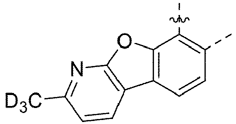 |
| 305 | N | CH | CH | CH | 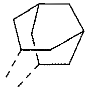 | | 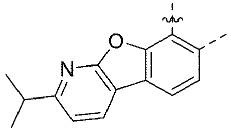 |
| 306 | N | CH | CH | CH | 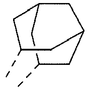 | | 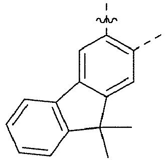 |
| 307 | CH | N | CH | CH | CH₃ | CH₃ | 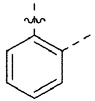 |
| 308 | CH | N | CH | CH | CH₃ | CH₃ | 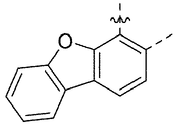 |
| 309 | CH | N | CH | CH | CH₃ | CH₃ | 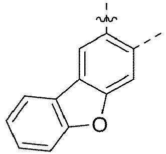 |
| 310 | CH | N | CH | CH | CH₃ | CH₃ | 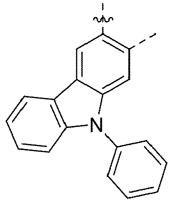 |
| 311 | CH | N | CH | CH | CH₃ | CH₃ | 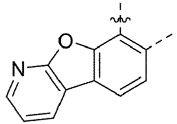 |
| 312 | CH | N | CH | CH | CH₃ | CH₃ | 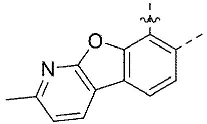 |
| 313 | CH | N | CH | CH | CH₃ | CH₃ | 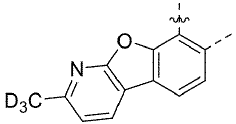 |
| 314 | CH | N | CH | CH | CH₃ | CH₃ | 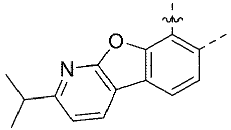 |
| 315 | CH | N | CH | CH | CH₃ | CH₃ | 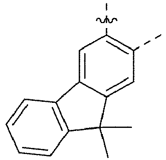 |
| 316 | CH | N | CH | CH | CH₃ | CH₂CH₃ | 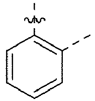 |
| 317 | CH | N | CH | CH | CH₃ | CH₂CH₃ | 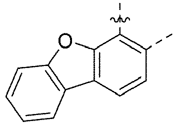 |
| 318 | CH | N | CH | CH | CH₃ | CH₂CH₃ | 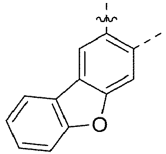 |
| 319 | CH | N | CH | CH | CH₃ | CH₂CH₃ | 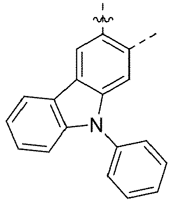 |
| 320 | CH | N | CH | CH | CH₃ | CH₂CH₃ | 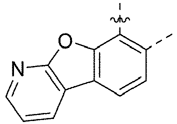 |
| 321 | CH | N | CH | CH | CH₃ | CH₂CH₃ | 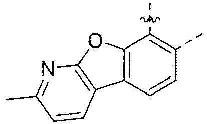 |
| 322 | CH | N | CH | CH | CH₃ | CH₂CH₃ | 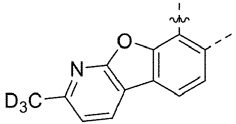 |
| 323 | CH | N | CH | CH | CH₃ | CH₂CH₃ | 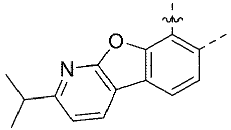 |
| 324 | CH | N | CH | CH | CH₃ | CH₂CH₃ | 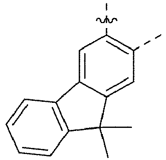 |
| 325 | CH | N | CH | CH | CH₃ | CH(CH₃)₂ | 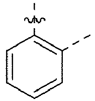 |
| 326 | CH | N | CH | CH | CH₃ | CH(CH₃)₂ | 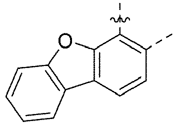 |
| 327 | CH | N | CH | CH | CH₃ | CH(CH₃)₂ | 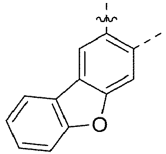 |
| 328 | CH | N | CH | CH | CH₃ | CH(CH₃)₂ | 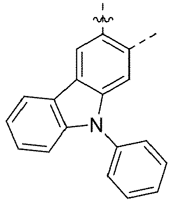 |
| 329 | CH | N | CH | CH | CH₃ | CH(CH₃)₂ | 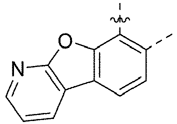 |
| 330 | CH | N | CH | CH | CH₃ | CH(CH₃)₂ | 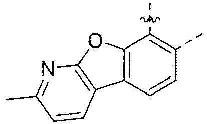 |
| 331 | CH | N | CH | CH | CH₃ | CH(CH₃)₂ | 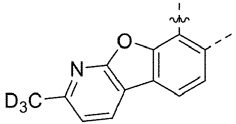 |
| 332 | CH | N | CH | CH | CH₃ | CH(CH₃)₂ | 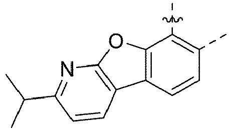 |
| 333 | CH | N | CH | CH | CH₃ | CH(CH₃)₂ | 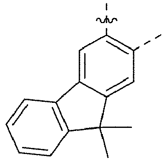 |
| 334 | CH | N | CH | CH | 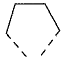 | | 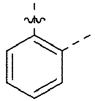 |
| 335 | CH | N | CH | CH | 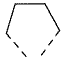 | | 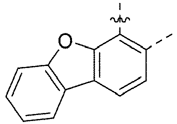 |
| 336 | CH | N | CH | CH | 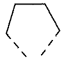 | | 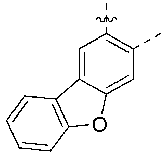 |
| 337 | CH | N | CH | CH | 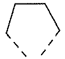 | | 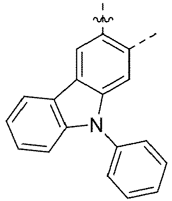 |
| 338 | CH | N | CH | CH | 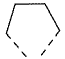 | | 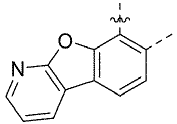 |
| 339 | CH | N | CH | CH | 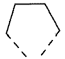 | | 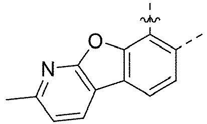 |
| 340 | CH | N | CH | CH | 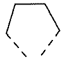 | | 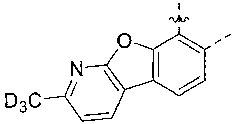 |
| 341 | CH | N | CH | CH | 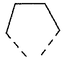 | | 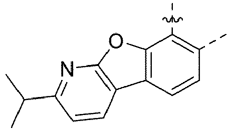 |
| 342 | CH | N | CH | CH | 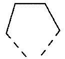 | | 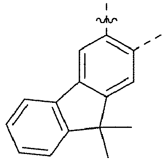 |
| 343 | CH | N | CH | CH | 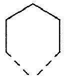 | | 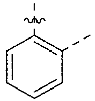 |
| 344 | CH | N | CH | CH | 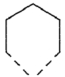 | | 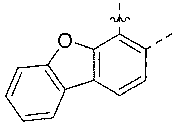 |
| 345 | CH | N | CH | CH | 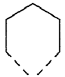 | | 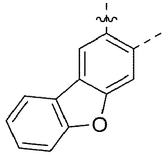 |
| 346 | CH | N | CH | CH | 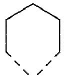 | | 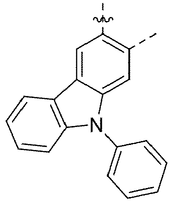 |
| 347 | CH | N | CH | CH | 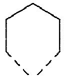 | | 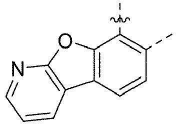 |
| 348 | CH | N | CH | CH | 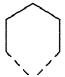 | | 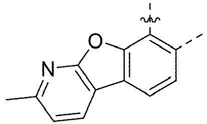 |
| 349 | CH | N | CH | CH | 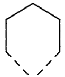 | | 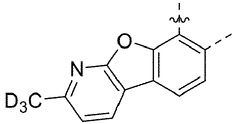 |
| 350 | CH | N | CH | CH | 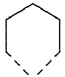 | | 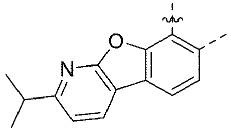 |
| 351 | CH | N | CH | CH | 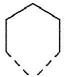 | | 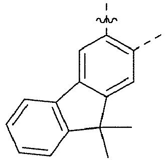 |
| 352 | CH | N | CH | CH | 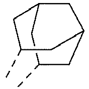 | | 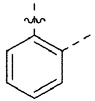 |
| 353 | CH | N | CH | CH | 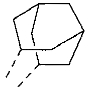 | | 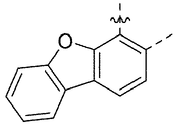 |
| 354 | CH | N | CH | CH | 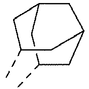 | | 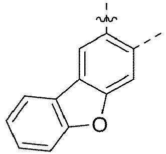 |
| 355 | CH | N | CH | CH | 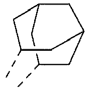 | | 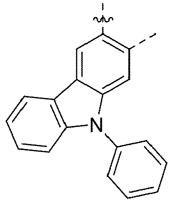 |
| 356 | CH | N | CH | CH | 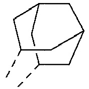 | | 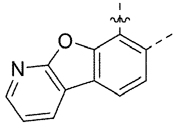 |
| 357 | CH | N | CH | CH | 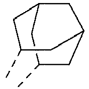 | | 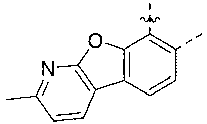 |
| 358 | CH | N | CH | CH | 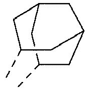 | | 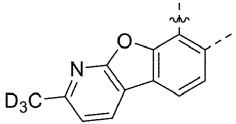 |
| 359 | CH | N | CH | CH | 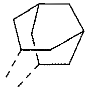 | | 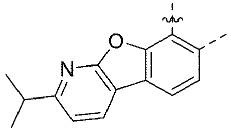 |
| 360 | CH | N | CH | CH | 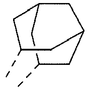 | | 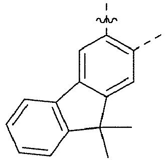 |
| 361 | N | CH | N | CH | CH₃ | CH₃ | 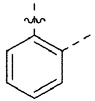 |
| 362 | N | CH | N | CH | CH₃ | CH₃ | 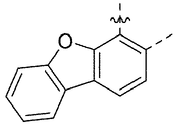 |
| 363 | N | CH | N | CH | CH₃ | CH₃ | 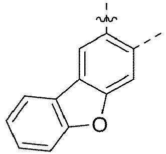 |
| 364 | N | CH | N | CH | CH₃ | CH₃ | 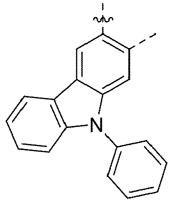 |
| 365 | N | CH | N | CH | CH₃ | CH₃ | 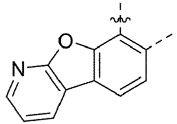 |
| 366 | N | CH | N | CH | CH₃ | CH₃ | 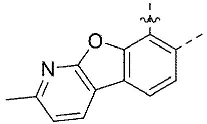 |
| 367 | N | CH | N | CH | CH₃ | CH₃ | 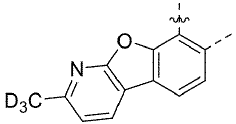 |
| 368 | N | CH | N | CH | CH₃ | CH₃ | 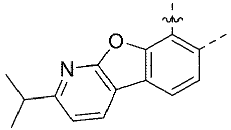 |
| 369 | N | CH | N | CH | CH₃ | CH₃ | 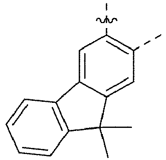 |
| 370 | N | CH | N | CH | CH₃ | CH₂CH₃ | 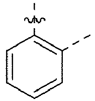 |
| 371 | N | CH | N | CH | CH₃ | CH₂CH₃ | 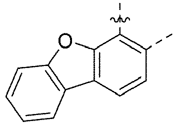 |
| 372 | N | CH | N | CH | CH₃ | CH₂CH₃ | 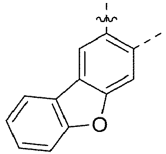 |
| 373 | N | CH | N | CH | CH₃ | CH₂CH₃ | 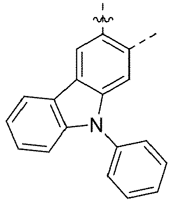 |
| 374 | N | CH | N | CH | CH₃ | CH₂CH₃ | 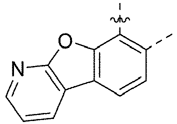 |
| 375 | N | CH | N | CH | CH₃ | CH₂CH₃ | 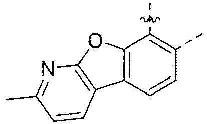 |
| 376 | N | CH | N | CH | CH₃ | CH₂CH₃ | 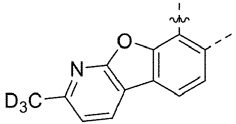 |
| 377 | N | CH | N | CH | CH₃ | CH₂CH₃ | 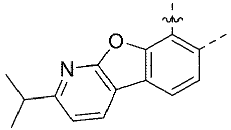 |
| 378 | N | CH | N | CH | CH₃ | CH₂CH₃ | 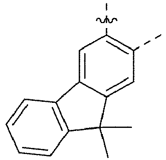 |
| 379 | N | CH | N | CH | CH₃ | CH(CH₃)₂ | 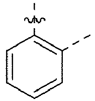 |
| 380 | N | CH | N | CH | CH₃ | CH(CH₃)₂ | 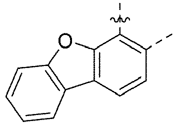 |
| 381 | N | CH | N | CH | CH₃ | CH(CH₃)₂ | 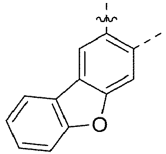 |
| 382 | N | CH | N | CH | CH₃ | CH(CH₃)₂ | 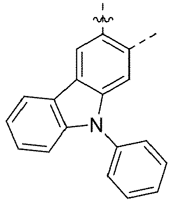 |
| 383 | N | CH | N | CH | CH₃ | CH(CH₃)₂ | 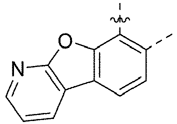 |
| 384 | N | CH | N | CH | CH₃ | CH(CH₃)₂ | 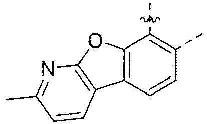 |
| 385 | N | CH | N | CH | CH₃ | CH(CH₃)₂ | 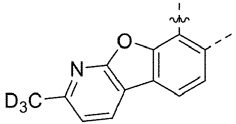 |
| 386 | N | CH | N | CH | CH₃ | CH(CH₃)₂ | 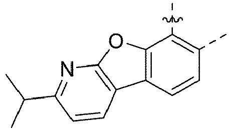 |
| 387 | N | CH | N | CH | CH₃ | CH(CH₃)₂ | 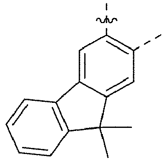 |
| 388 | CH | CH | N | CH | 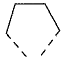 | | 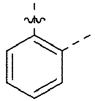 |
| 389 | CH | CH | N | CH | 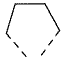 | | 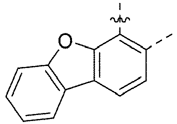 |
| 390 | CH | CH | N | CH | 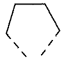 | | 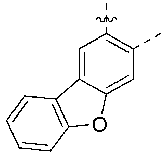 |
| 391 | CH | CH | N | CH | 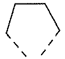 | | 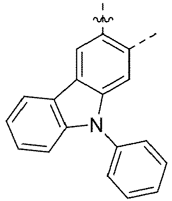 |
| 392 | CH | CH | N | CH | 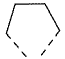 | | 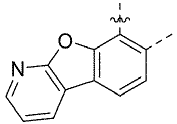 |
| 393 | CH | CH | N | CH | 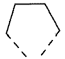 | | 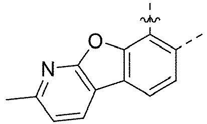 |
| 394 | CH | CH | N | CH | 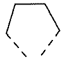 | | 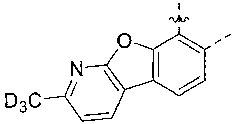 |
| 395 | CH | CH | N | CH | 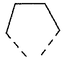 | | 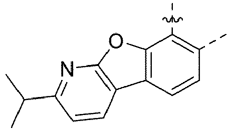 |
| 396 | CH | CH | N | CH | 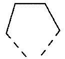 | | 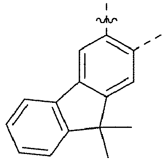 |
| 397 | CH | CH | N | CH | 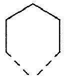 | | 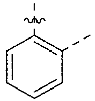 |
| 398 | CH | CH | N | CH | 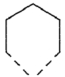 | | 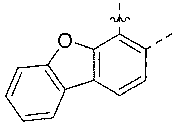 |
| 399 | CH | CH | N | CH | 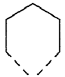 | | 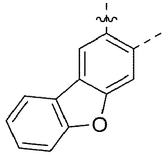 |
| 400 | CH | CH | N | CH | 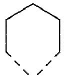 | | 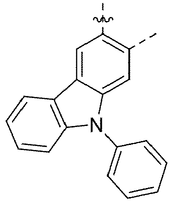 |
| 401 | CH | CH | N | CH | 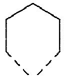 | | 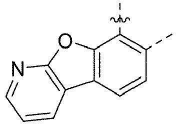 |
| 402 | CH | CH | N | CH | 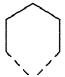 | | 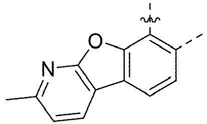 |
| 403 | CH | CH | N | CH | 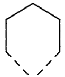 | | 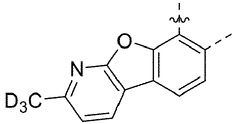 |
| 404 | CH | CH | N | CH | 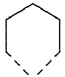 | | 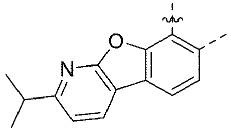 |
| 405 | CH | CH | N | CH | 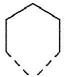 | | 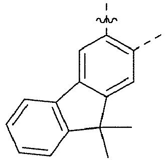 |
| 406 | CH | CH | N | CH | 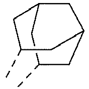 | | 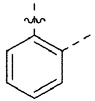 |
| 407 | CH | CH | N | CH | 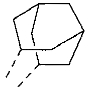 | | 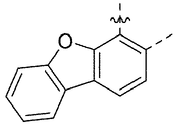 |
| 408 | CH | CH | N | CH | 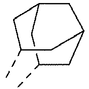 | | 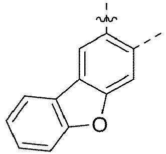 |
| 409 | CH | CH | N | CH | 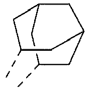 | | 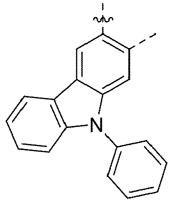 |
| 410 | CH | CH | N | CH | 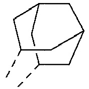 | | 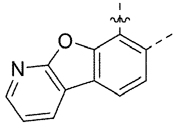 |
| 411 | CH | CH | N | CH | 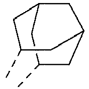 | | 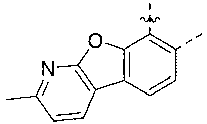 |
| 412 | CH | CH | N | CH | 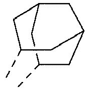 | | 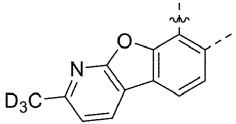 |
| 413 | CH | CH | N | CH | 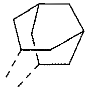 | | 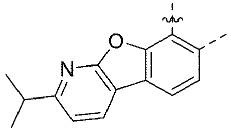 |
| 414 | CH | CH | N | CH | 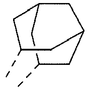 | | 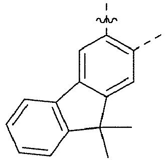 |
| 415 | CH | CH | CH | N | CH₃ | CH₃ | 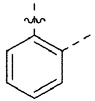 |
| 416 | CH | CH | CH | N | CH₃ | CH₃ | 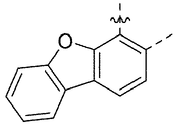 |
| 417 | CH | CH | CH | N | CH₃ | CH₃ | 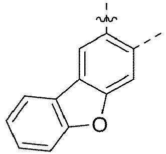 |
| 418 | CH | CH | CH | N | CH₃ | CH₃ | 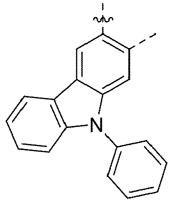 |
| 419 | CH | CH | CH | N | CH₃ | CH₃ | 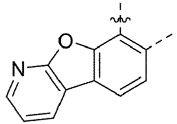 |
| 420 | CH | CH | CH | N | CH₃ | CH₃ | 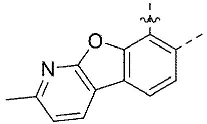 |
| 421 | CH | CH | CH | N | CH₃ | CH₃ | 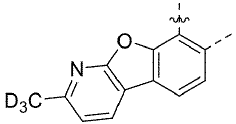 |
| 422 | CH | CH | CH | N | CH₃ | CH₃ | 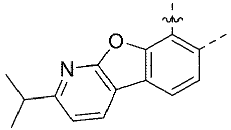 |
| 423 | CH | CH | CH | N | CH₃ | CH₃ | 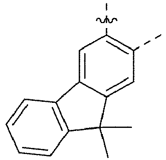 |
| 424 | CH | CH | CH | N | CH₃ | CH₂CH₃ | 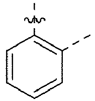 |
| 425 | CH | CH | CH | N | CH₃ | CH₂CH₃ | 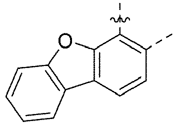 |
| 426 | CH | CH | CH | N | CH₃ | CH₂CH₃ | 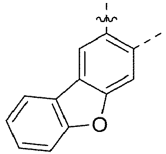 |
| 427 | CH | CH | CH | N | CH₃ | CH₂CH₃ | 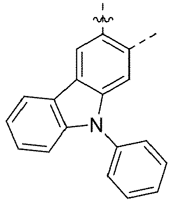 |
| 428 | CH | CH | CH | N | CH₃ | CH₂CH₃ | 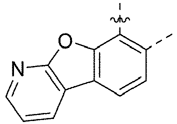 |
| 429 | CH | CH | CH | N | CH₃ | CH₂CH₃ | 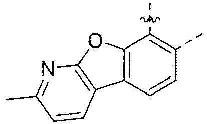 |
| 430 | CH | CH | CH | N | CH₃ | CH₂CH₃ | 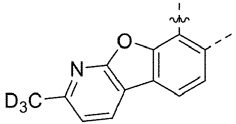 |
| 431 | CH | CH | CH | N | CH₃ | CH₂CH₃ | 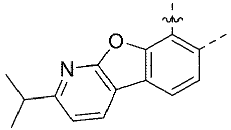 |
| 432 | CH | CH | CH | N | CH₃ | CH₂CH₃ | 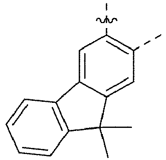 |
| 433 | CH | CH | CH | N | CH₃ | CH(CH₃)₂ | 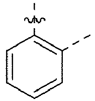 |
| 434 | CH | CH | CH | N | CH₃ | CH(CH₃)₂ | 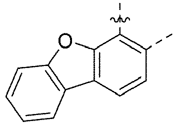 |
| 435 | CH | CH | CH | N | CH₃ | CH(CH₃)₂ | 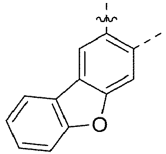 |
| 436 | CH | CH | CH | N | CH₃ | CH(CH₃)₂ | 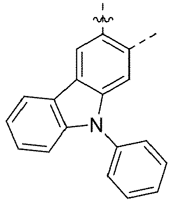 |
| 437 | CH | CH | CH | N | CH₃ | CH(CH₃)₂ | 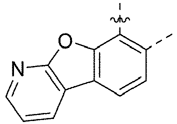 |
| 438 | CH | CH | CH | N | CH₃ | CH(CH₃)₂ | 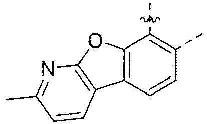 |
| 439 | CH | CH | CH | N | CH₃ | CH(CH₃)₂ | 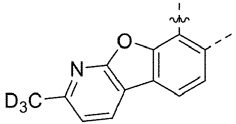 |
| 440 | CH | CH | CH | N | CH₃ | CH(CH₃)₂ | 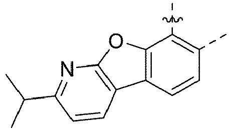 |
| 441 | CH | CH | CH | N | CH₃ | CH(CH₃)₂ | 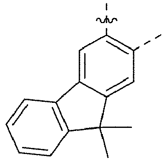 |
| 442 | CH | CH | CH | N | 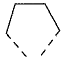 | | 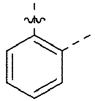 |
| 443 | CH | CH | CH | N | 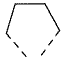 | | 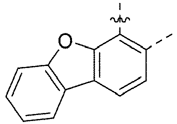 |
| 444 | CH | CH | CH | N | 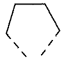 | | 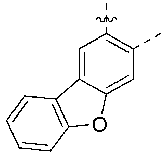 |
| 445 | CH | CH | CH | N | 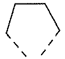 | | 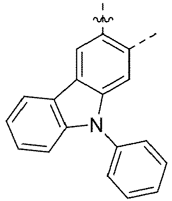 |
| 446 | CH | CH | CH | N | 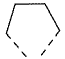 | | 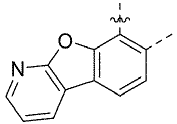 |
| 447 | CH | CH | CH | N | 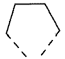 | | 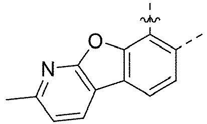 |
| 448 | CH | CH | CH | N | 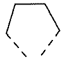 | | 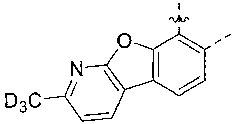 |
| 449 | CH | CH | CH | N | 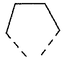 | | 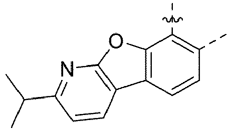 |
| 450 | CH | CH | CH | N | 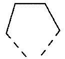 | | 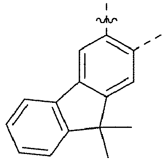 |
| 451 | CH | CH | CH | N | 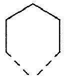 | | 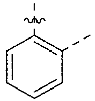 |
| 452 | CH | CH | CH | N | 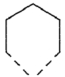 | | 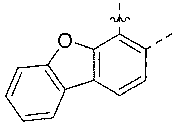 |
| 453 | CH | CH | CH | N | 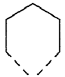 | | 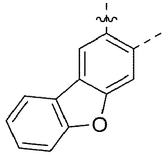 |
| 454 | CH | CH | CH | N | 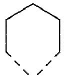 | | 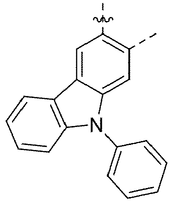 |
| 455 | CH | CH | CH | N | 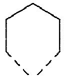 | | 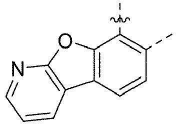 |
| 456 | CH | CH | CH | N | 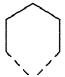 | | 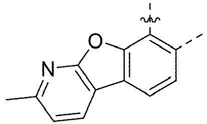 |
| 457 | CH | CH | CH | N | 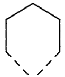 | | 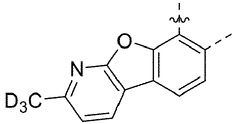 |
| 458 | CH | CH | CH | N | 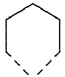 | | 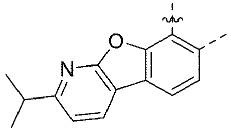 |
| 459 | CH | CH | CH | N | 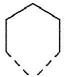 | | 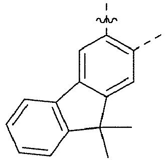 |
| 460 | CH | CH | CH | N | 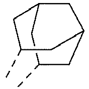 | | 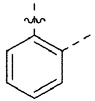 |
| 461 | CH | CH | CH | N | 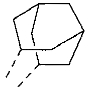 | | 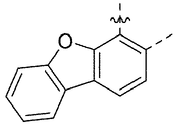 |
| 462 | CH | CH | CH | N | 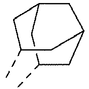 | | 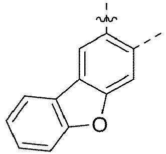 |
| 463 | CH | CH | CH | N | 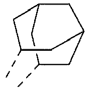 | | 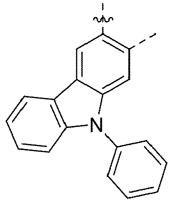 |
| 464 | CH | CH | CH | N | 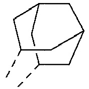 | | 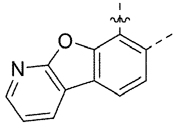 |
| 465 | CH | CH | CH | N | 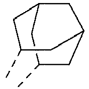 | | 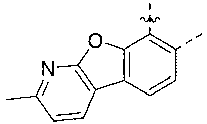 |
| 466 | CH | CH | CH | N | 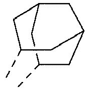 | | 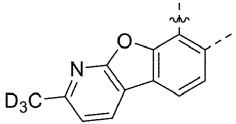 |
| 467 | CH | CH | CH | N | 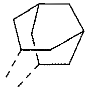 | | 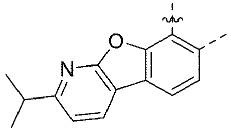 |
| 468 | CH | CH | CH | N | 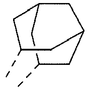 | | 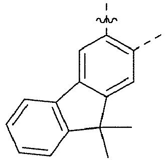 |
| 469 | N | CH | CH | N | CH₃ | CH₃ | 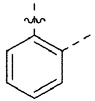 |
| 470 | N | CH | CH | N | CH₃ | CH₃ | 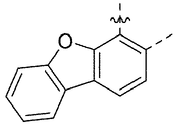 |
| 471 | N | CH | CH | N | CH₃ | CH₃ | 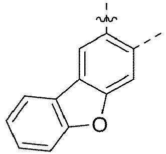 |
| 472 | N | CH | CH | N | CH₃ | CH₃ | 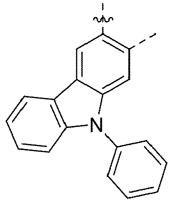 |
| 473 | N | CH | CH | N | CH₃ | CH₃ | 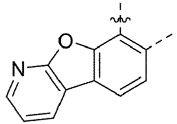 |
| 474 | N | CH | CH | N | CH₃ | CH₃ | 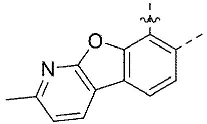 |
| 475 | N | CH | CH | N | CH₃ | CH₃ | 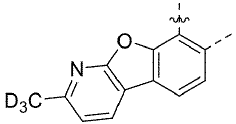 |
| 476 | N | CH | CH | N | CH₃ | CH₃ | 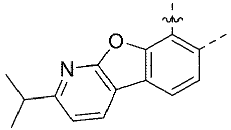 |
| 477 | N | CH | CH | N | CH₃ | CH₃ | 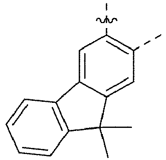 |
| 478 | N | CH | CH | N | CH₃ | CH₂CH₃ | 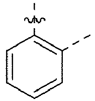 |
| 479 | N | CH | CH | N | CH₃ | CH₂CH₃ | 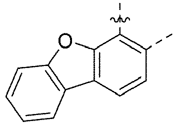 |
| 480 | N | CH | CH | N | CH₃ | CH₂CH₃ | 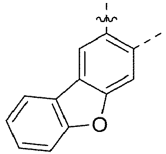 |
| 481 | N | CH | CH | N | CH₃ | CH₂CH₃ | 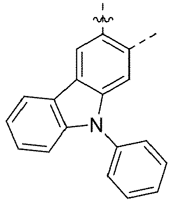 |
| 482 | N | CH | CH | N | CH₃ | CH₂CH₃ | 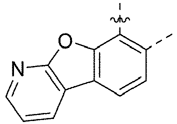 |
| 483 | N | CH | CH | N | CH₃ | CH₂CH₃ | 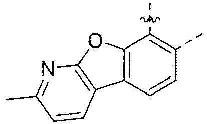 |
| 484 | N | CH | CH | N | CH₃ | CH₂CH₃ | 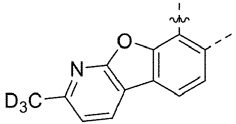 |
| 485 | N | CH | CH | N | CH₃ | CH₂CH₃ | 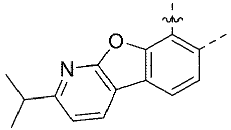 |
| 486 | N | CH | CH | N | CH₃ | CH₂CH₃ | 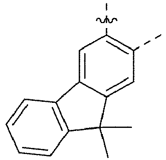 |
| 487 | N | CH | CH | N | CH₃ | CH(CH₃)₂ | 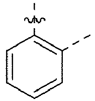 |
| 488 | N | CH | CH | N | CH₃ | CH(CH₃)₂ | 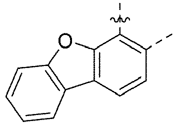 |
| 489 | N | CH | CH | N | CH₃ | CH(CH₃)₂ | 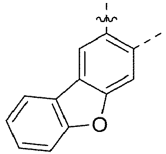 |
| 490 | N | CH | CH | N | CH₃ | CH(CH₃)₂ | 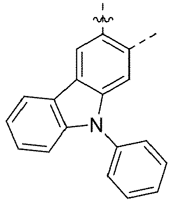 |
| 491 | N | CH | CH | N | CH₃ | CH(CH₃)₂ | 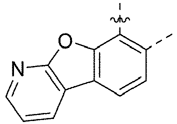 |
| 492 | N | CH | CH | N | CH₃ | CH(CH₃)₂ | 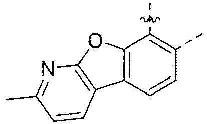 |
| 493 | N | CH | CH | N | CH₃ | CH(CH₃)₂ | 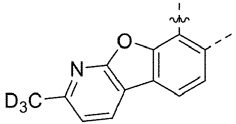 |
| 494 | N | CH | CH | N | CH₃ | CH(CH₃)₂ | 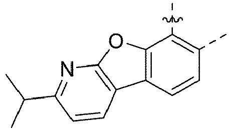 |
| 495 | N | CH | CH | N | CH₃ | CH(CH₃)₂ | 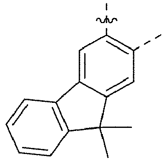 |
| 496 | N | CH | CH | N | 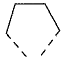 | | 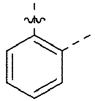 |
| 497 | N | CH | CH | N | 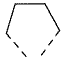 | | 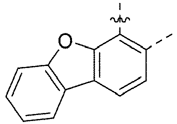 |
| 498 | N | CH | CH | N | 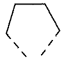 | | 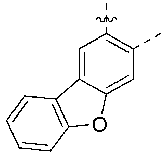 |
| 499 | N | CH | CH | N | 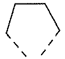 | | 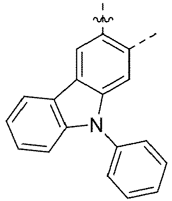 |
| 500 | N | CH | CH | N | 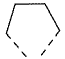 | | 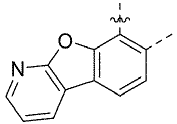 |
| 501 | N | CH | CH | N | 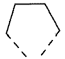 | | 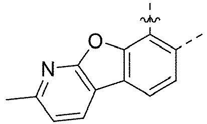 |
| 502 | N | CH | CH | N | 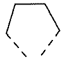 | | 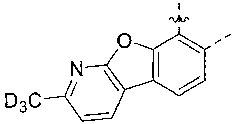 |
| 503 | N | CH | CH | N | 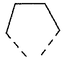 | | 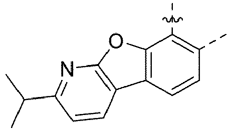 |
| 504 | N | CH | CH | N | 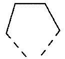 | | 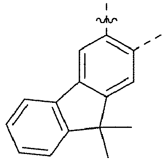 |
| 505 | N | CH | CH | N | 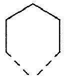 | | 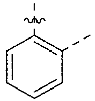 |
| 506 | N | CH | CH | N | 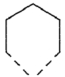 | | 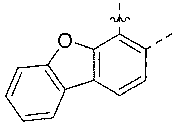 |
| 507 | N | CH | CH | N | 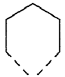 | | 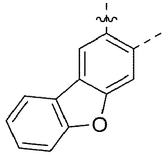 |
| 508 | N | CH | CH | N | 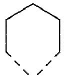 | | 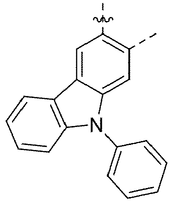 |
| 509 | N | CH | CH | N | 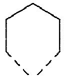 | | 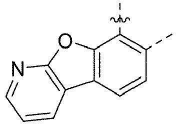 |
| 510 | N | CH | CH | N | 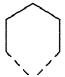 | | 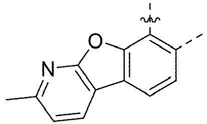 |
| 511 | N | CH | CH | N | 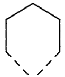 | | 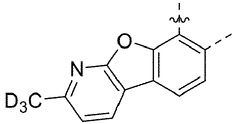 |
| 512 | N | CH | CH | N | 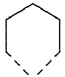 | | 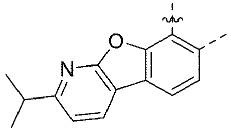 |
| 513 | N | CH | CH | N | 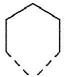 | | 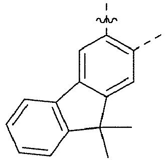 |
| 514 | N | CH | CH | N | 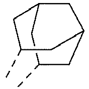 | | 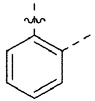 |
| 515 | N | CH | CH | N | 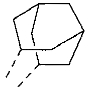 | | 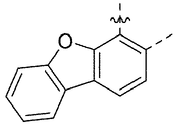 |
| 516 | N | CH | CH | N | 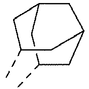 | | 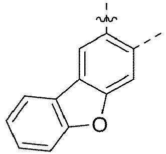 |
| 517 | N | CH | CH | N | 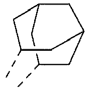 | | 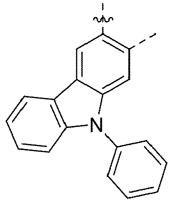 |
| 518 | N | CH | CH | N | 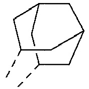 | | 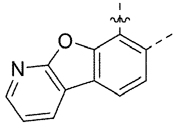 |
| 519 | N | CH | CH | N | 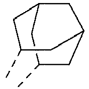 | | 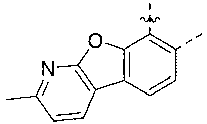 |
| 520 | N | CH | CH | N | 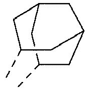 | | 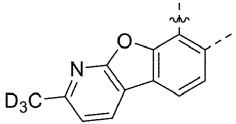 |
| 521 | N | CH | CH | N | 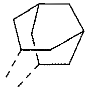 | | 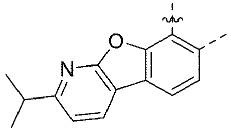 |
| 522 | N | CH | CH | N | 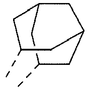 | | 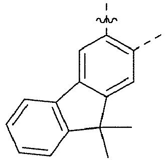 |
| 523 | CH | CH | CH | CH | CD₃ | CD₃ | 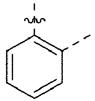 |
| 524 | CH | CH | CH | CH | CD₃ | CD₃ | 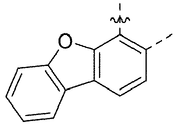 |
| 525 | N | CH | CH | CH | CD₃ | CD₃ | 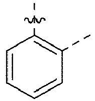 |
| 526 | N | CH | CH | CH | CD₃ | CD₃ | 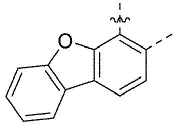 |
| 527 | CH | N | CH | CH | CD₃ | CD₃ | 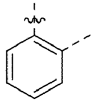 |
| 528 | CH | N | CH | CH | CD₃ | CD₃ | 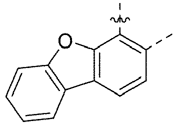 |
| 529 | CH | CH | N | CH | CD₃ | CD₃ | 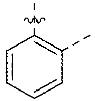 |
| 530 | CH | CH | N | CH | CD₃ | CD₃ | 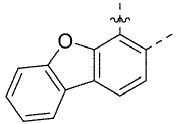 |
| 531 | CH | CH | CH | N | CD₃ | CD₃ | 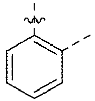 |
| 532 | CH | CH | CH | N | CD₃ | CD₃ | 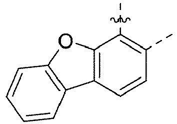 |
| 533 | N | CH | CH | N | CD₃ | CD₃ | 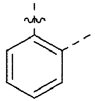 |
| 534 | N | CH | CH | N | CD₃ | CD₃ | 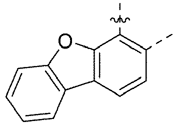 |

10. Composé de la revendication 1, où le ligand L_{A} est choisi dans le groupe constitué par :

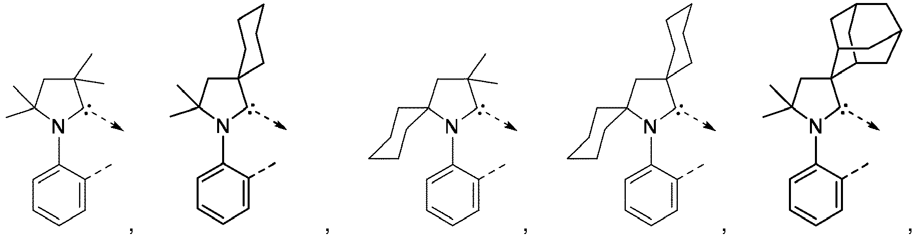

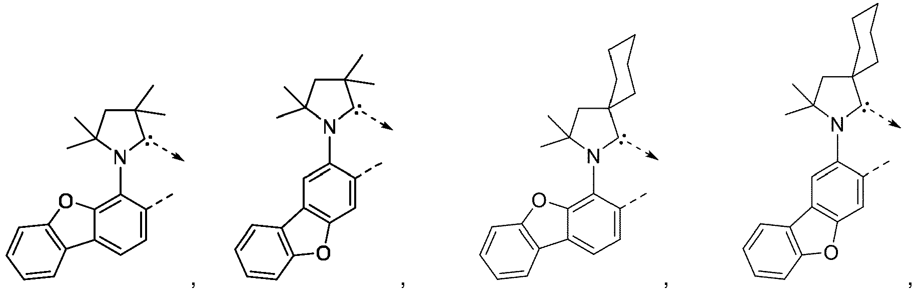

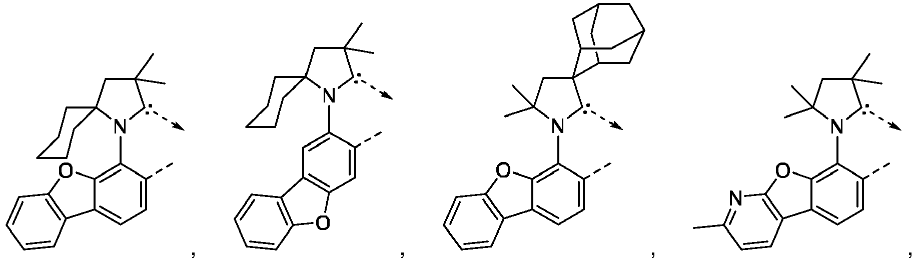

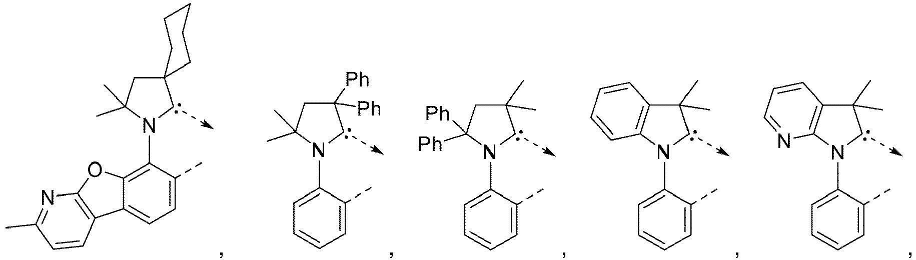

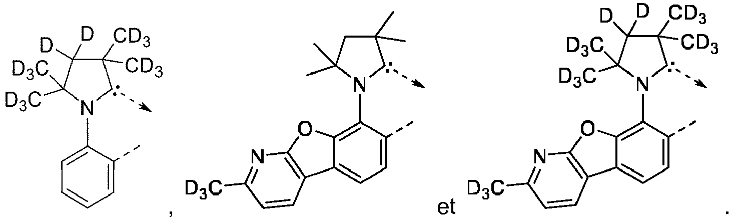

11. Composé de la revendication 1, le composé ayant une formule M(L_{A})ₙ(L_{B})ₘ₋ₙ ;
où M est Ir ou Pt ;
où L_{B} est un ligand bidentate ;
où, lorsque M est Ir, m est 3, et n est 1, 2 ou 3 ; et
où, lorsque M est Pt, m est 2, et n est 1 ou 2.

12. Composé de la revendication 11, où L_{B} est un autre ligand carbène.

13. Composé de la revendication 11, où L_{B} est choisi dans le groupe constitué par :

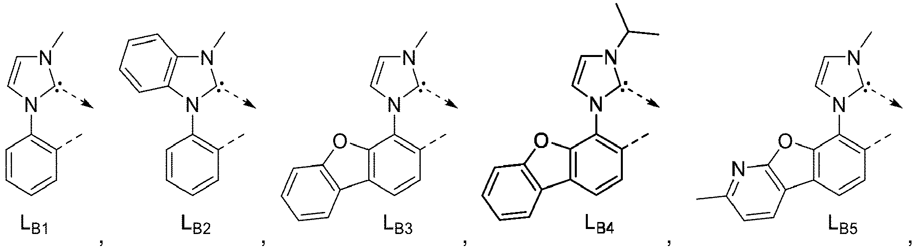

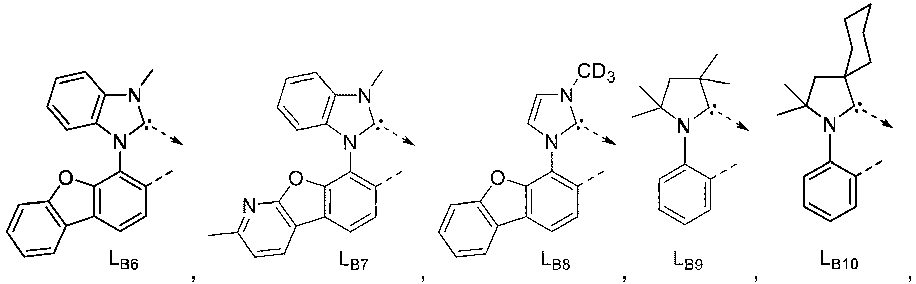

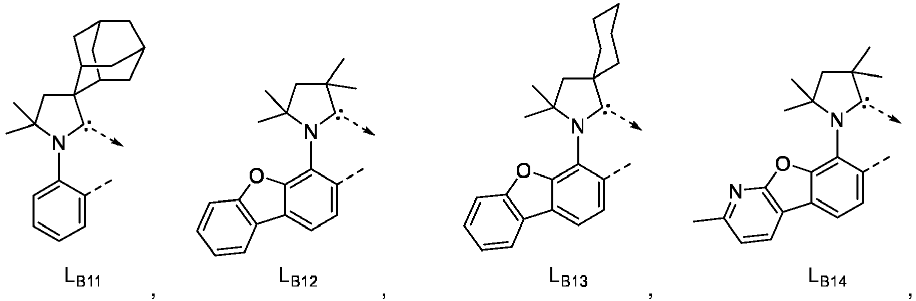

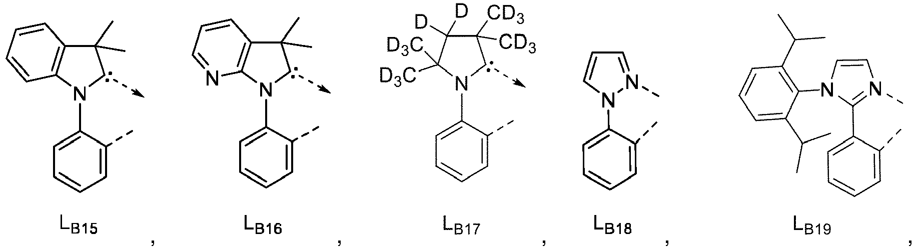

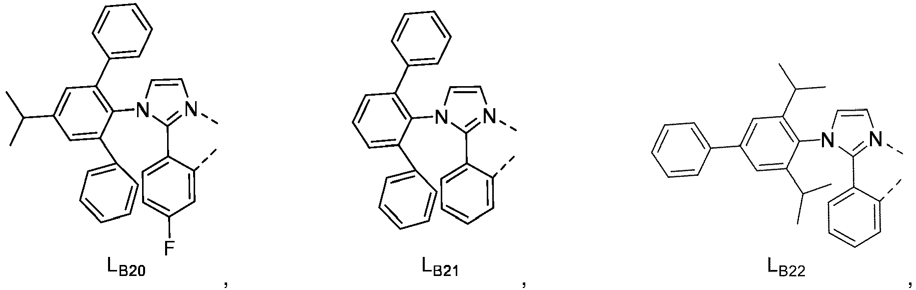

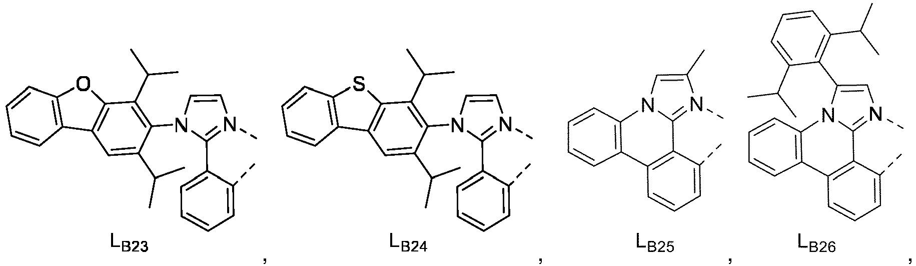

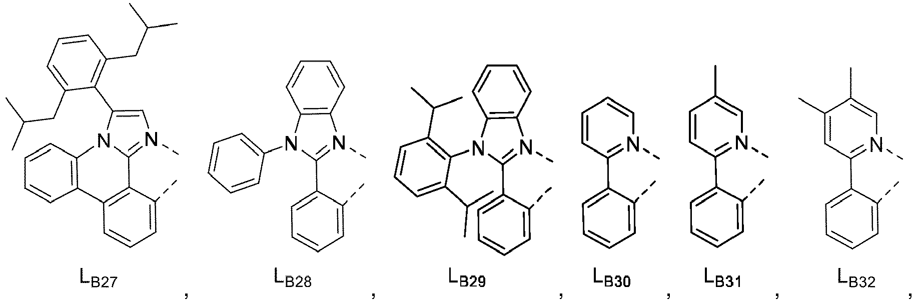

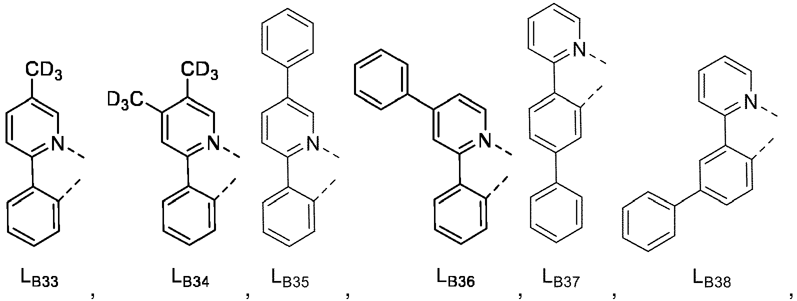

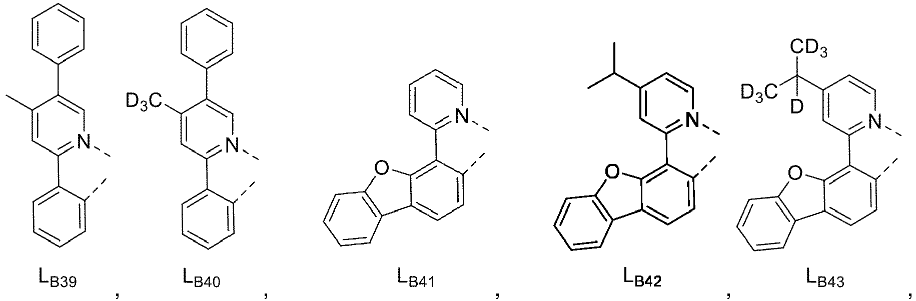

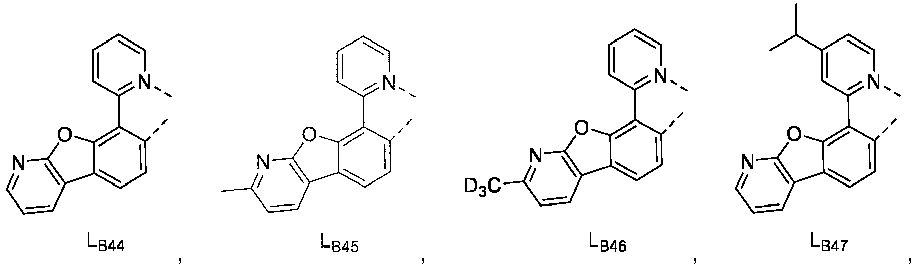

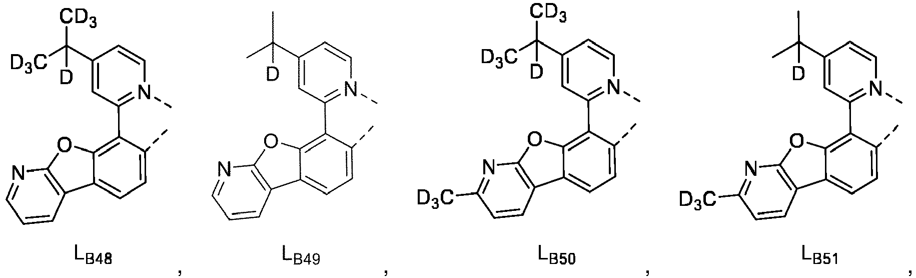

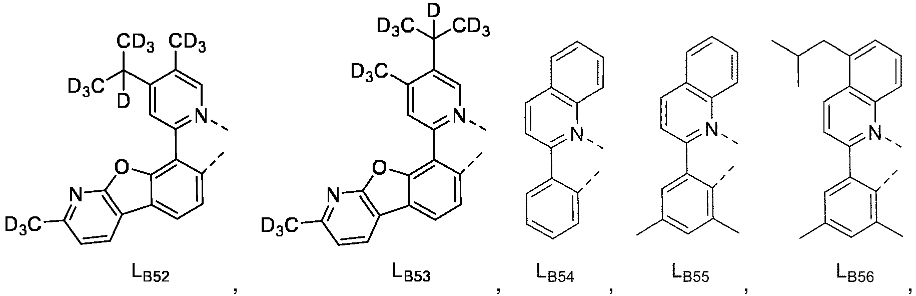

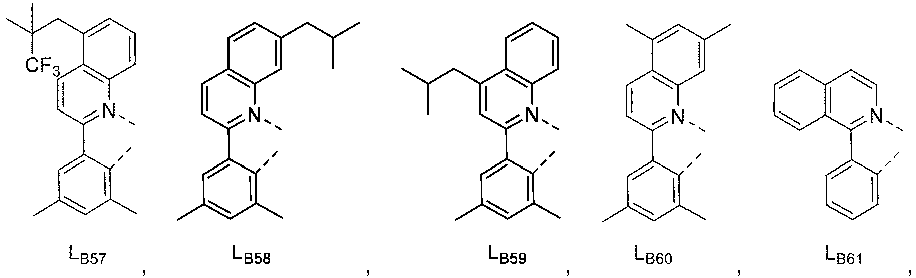

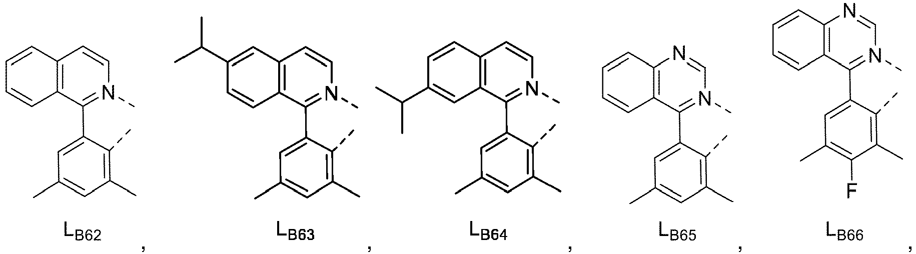

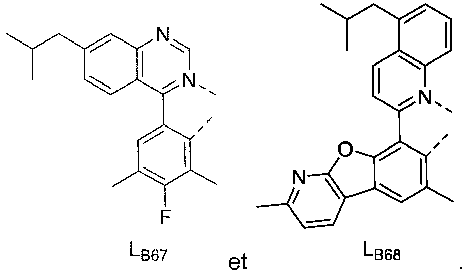

14. Composé de la revendication 9, le composé étant choisi dans le groupe constitué par le Composé A1 au Composé A534 ;
où chaque Composé A*x* a la formule Ir(L_{A*i*})₃ ; et
où x = *i* ; *i* est un entier allant de 1 à 534.

15. Composé de la revendication 9, le composé étant choisi dans le groupe constitué par le Composé B1 au Composé B36 312 et le Composé C1 au Composé C36 312 ;
où, pour le Composé B1 au Composé B36 312, chaque Composé B*y* a la formule Ir(L_{A*i*})(L_{B*j*})₂, où *y* = 534*j* + *i* - 533 ; *i* est un entier allant de 1 à 534, et *j* est un entier allant de 1 à 68 ;
où, pour le Composé C1 au Composé C36 312, chaque Composé C*z* a la formule Ir(L_{A*i*})₂(L_{B*j*}), où *z* = 534*j* + *i* + 533 ; *i* est un entier allant de 1 à 534, et *j* est un entier allant de 1 à 68 ; et
où L_{B} est choisi dans le groupe constitué par :

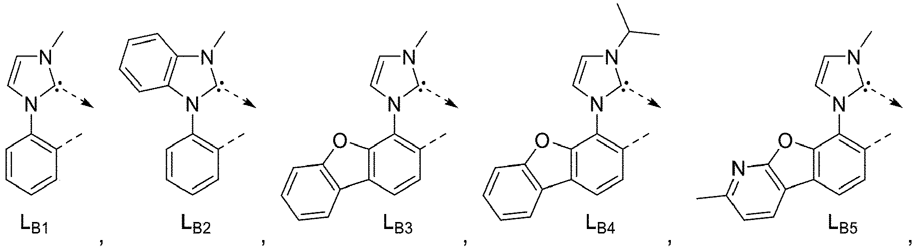

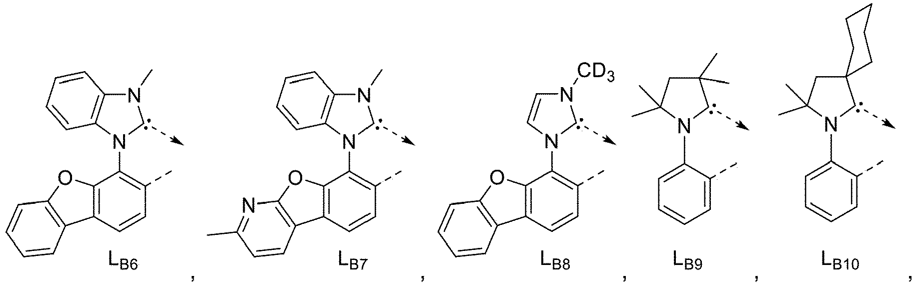

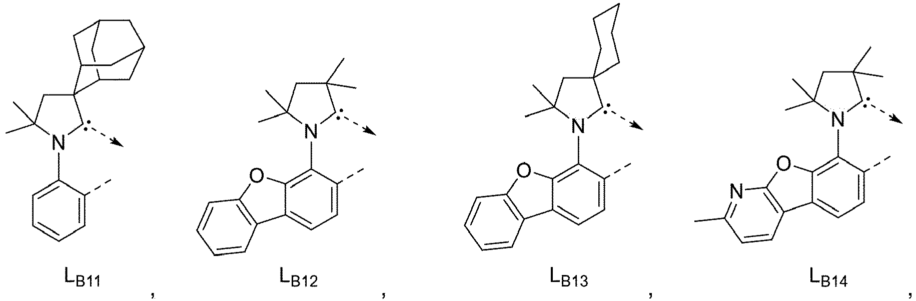

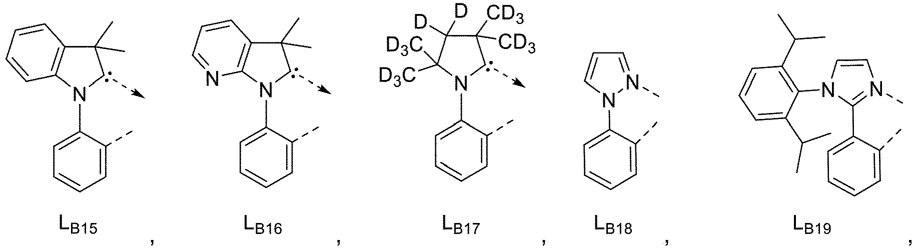

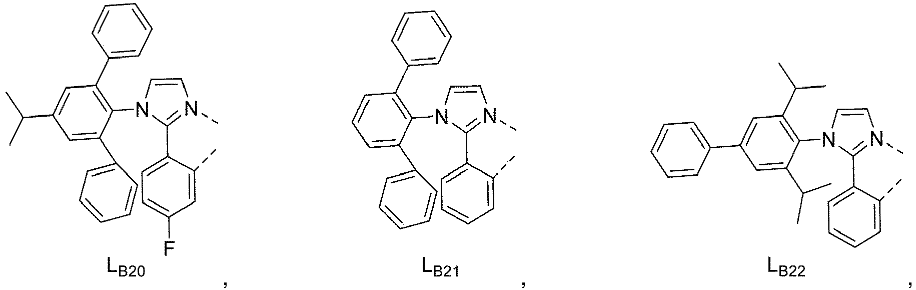

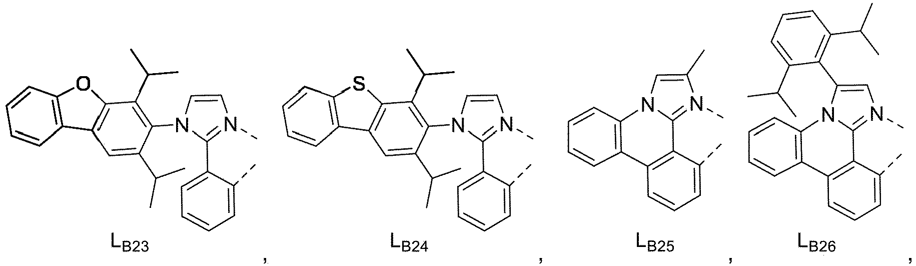

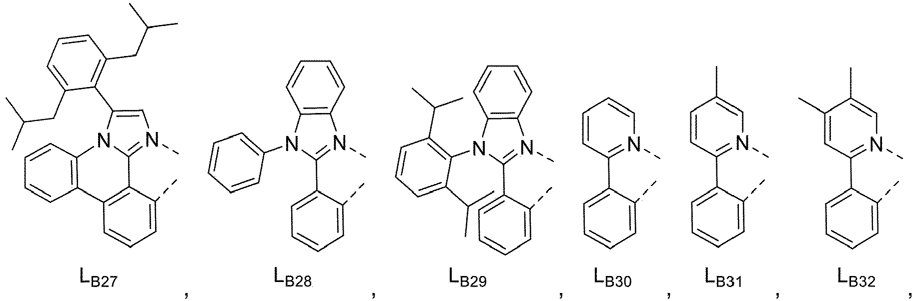

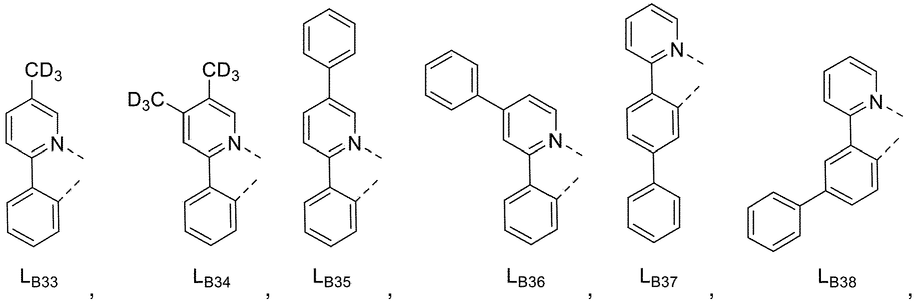

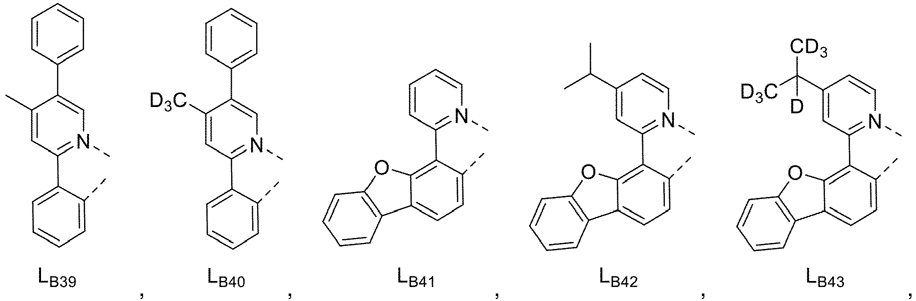

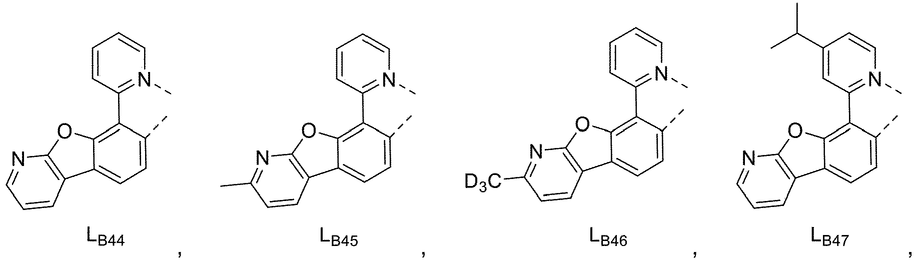

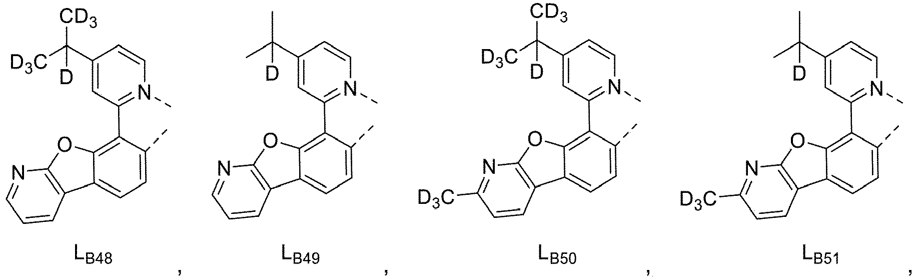

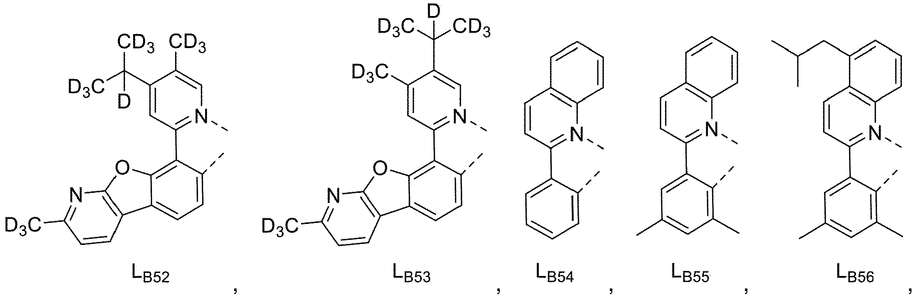

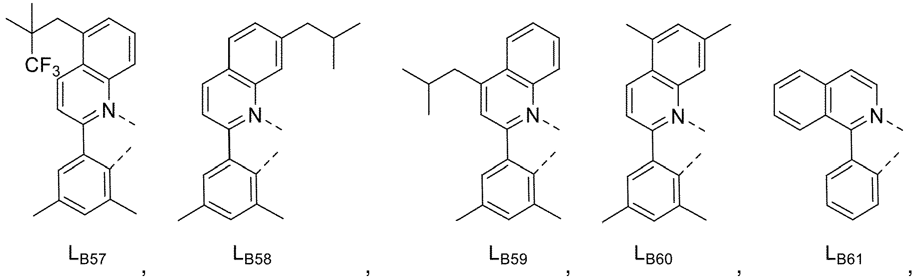

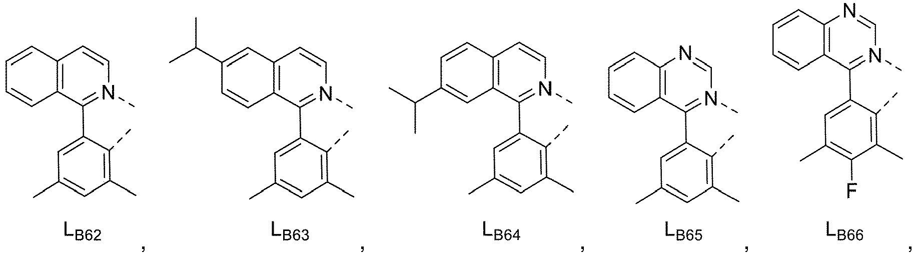

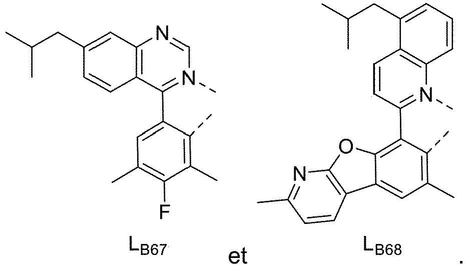

16. Premier dispositif électroluminescent organique comprenant :
une anode ;
une cathode ; et
une couche organique, disposée **entre l'anode et la cathode, comprenant un** composé comprenant un ligand carbène L_{A} de Formule I : 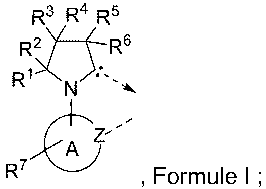
où le cycle A est un cycle carbocyclique ou hétérocyclique à 5 chaînons ou 6 chaînons ;
où Z est l'azote ou le carbone ;
où R⁷ **représente d'une mono**-substitution au nombre maximal possible de substitution, ou aucune substitution ;
où R¹, R², R³, R⁴, R⁵, R⁶ et R⁷ sont indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ;
où tous substituants adjacents de R¹, R², R³, R⁴, R⁵, R⁶ et R⁷ sont facultativement attachés ou fusionnés en un cycle ou une double liaison ;
où le ligand L_{A} est coordonné à un métal M par l'intermédiaire du carbone de carbène et Z ; et
où le ligand L_{A} **est facultativement lié à d'autres ligands pour comprendre un ligand** tridentate, tétradentate, pentadentate ou hexadentate.

17. Premier dispositif électroluminescent organique de la revendication 16, le premier dispositif électroluminescent organique étant incorporé dans un dispositif choisi dans le groupe constitué par un produit de consommation, un module de composant électronique, **un dispositif électroluminescent organique et un panneau d'éclairage.**

18. Premier dispositif électroluminescent organique de la revendication 16, dans lequel la couche organique est une couche émissive et le composé est un dopant émissif ou un dopant non émissif.

19. Premier dispositif électroluminescent organique de la revendication 16, dans lequel **la couche organique comprend en outre un hôte, l'hôte comprenant au moins un groupe** chimique choisi dans le groupe constitué par triphénylène, carbazole, dibenzothiophène, dibenzofurane, dibenzosélénophène, azatriphénylène, azacarbazole, aza-dibenzothiophène, aza-dibenzofurane et aza-dibenzosélénophène.

20. Formulation comprenant un composé comprenant un ligand carbène L_{A} de Formule I : 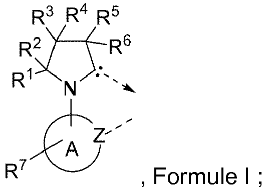
où le cycle A est un cycle carbocyclique ou hétérocyclique à 5 chaînons ou 6 chaînons ;
où Z est l'azote ou le carbone ;
où R⁷ **représente d'une mono**-substitution au nombre maximal possible de substitution, ou aucune substitution ;
où R¹, R², R³, R⁴, R⁵, R⁶ et R⁷ sont indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ;
où tous substituants adjacents de R¹, R², R³, R⁴, R⁵, R⁶ et R⁷ sont facultativement attachés ou fusionnés en un cycle ou une double liaison ;
où le ligand L_{A} est coordonné à un métal M par l'intermédiaire du carbone de carbène et Z ; et
où le ligand L_{A} **est facultativement lié à d'autres ligands pour comprendre un ligand** tridentate, tétradentate, pentadentate ou hexadentate.
